# EUROPEAN PATENT SPECIFICATION

(11) **EP 3 188 277 B1**
(45) Date of publication and mention of the grant of the patent: **30.11.2022**
(21) Application number: 16186691.8
(22) Date of filing: 31.08.2016
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 29.12.2015 KR 20150188914
(43) Date of publication of application: 05.07.2017
(73) Proprietor: Samsung Display Co., Ltd., Yongin-si, Gyeonggi-do (KR)
(72) Inventor: KIM, Younsun, Gyeonggi-do, (KR); KIM, Seulong, Gyeonggi-do, (KR); LEE, Jungsub, Gyeonggi-do, (KR); LIM, Jino, Gyeonggi-do, (KR); JEONG, Hyein, Gyeonggi-do, (KR); SHIN, Dongwoo, Gyeonggi-do, (KR)
(74) Representative: Russell, Tim

(56) References cited:
- EP-A1- 2 581 957
- WO-A1-2015/190718
- US-A1- 2013 234 119
- US-A1- 2014 367 654

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and excellent luminance, driving voltage, and response speed characteristics, and can produce full-color images.

An organic light-emitting device may comprise a first electrode disposed (e.g., positioned) on a substrate, and a hole transport region, an emission layer, an electron transport region, and a second electrode, which are sequentially disposed on the first electrode. Holes provided from, for example, the first electrode may move toward the emission layer through the hole transport region, and electrons provided from, for example, the second electrode may move toward the emission layer through the electron transport region. Carriers, such as holes and electrons, may then recombine in the emission layer to produce excitons. These excitons transition from an excited state to a ground state, thereby generating light.

### SUMMARY OF THE INVENTION

The present invention provides an organic light-emitting device comprising a first electrode, a second electrode, and an organic layer between the first electrode and the second electrode, the organic layer comprising an emission layer, and further comprising an electron transporting region between the emission layer and the second electrode, wherein the emission layer comprises a first compound represented by Formula 1:
the organic layer comprising an emission layer,
wherein the organic layer comprises a first compound represented by Formula 1: 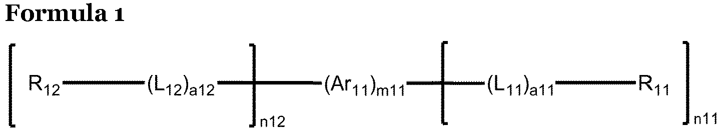
in which Ar₁₁ is a group represented by Formula 1-1, 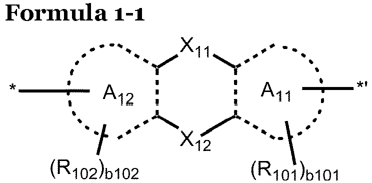
provided that the first compound is not 4,4'-bis(N-carbazolyl)-1,1'-biphenyl (CBP);
and wherein the electron transporting region comprises a second compound represented by Formula 2, wherein the second compound comprises a group represented by Formula 9-1 and/or a group represented by Formula 9-2, and the second compound comprises an alkyl group and/or a cycloalkyl group,

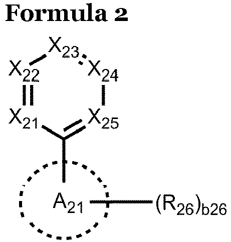

In Formulae 1,1-1, and 2
m11 is selected from 1 and 2,
X₁₁ may be selected from N[(L₁₃)ₐ₁₃-R₁₃], C[(L₁₃)ₐ₁₃-R₁₃][(L₁₄)ₐ₁₄R₁₄], O, and S,
X12 may be selected from a single bond, N[(L₁₅)ₐ₁₅-R₁₅], C[(L₁₅)ₐ₁₅-R₁₅][(L₁₆)ₐ₁₆-R₁₆], O, and S,
X₂₁ is selected from N and C(R₂₁), X₂₂ is selected from N and C(R₂₂), X₂₃ is selected from N and C(R₂₃), X₂₄ is selected from N and C(R₂₄), X₂₅ is selected from N and C(R₂₅), at least one selected from X₂₁ to X₂₅ is N,
R₁₁ to R₁₆ are each independently selected from a group represented by Formula 8-1, a group represented by Formula 8-2, hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and -P(=O)(Q₁)(Q₂), wherein when R₁₃ and R₁₄ are both present and a13 and a14 are both equal to zero, R₁₃ and R₁₄ are optionally connected to each other to form a C₅-C₂₀ carbocyclic group or a C₁-C₂₀ heterocyclic group, and when R₁₅ and R₁₆ are both present and a15 and a16 are both equal to zero, R₁₅ and R₁₆ are optionally connected to each other to form a C₅-C₂₀ carbocyclic group or a C₁-C₂₀ heterocyclic group, 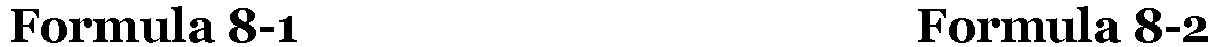 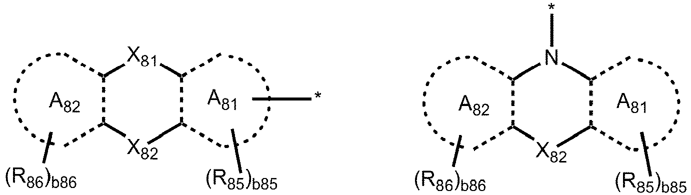
R₂₁ to R₂₆ are each independently selected from a group represented by any of Formulae 9-1 to 9-3, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), and at least one selected from R₂₁ to R₂₆ is selected from a group represented by Formula 9-1 and a group represented by Formula 9-2,

   **Formula 9-1** ^{∗}-(L₉₁)ₐ₉₁-R₉₁

   **Formula 9-2** ^{∗}-(L₉₂)ₐ₉₂-R₉₂

   **Formula 9-3** ^{∗}-(L₉₃)ₐ₉₃-R₉₃,
X₈₁ is N[(L₈₁)ₐ₈₁-R₈₁], C[(L₈₁)ₐ₈₁-R₈₁][(L₈₂)ₐ₈₂-R₈₂], O, or S,
Xs2 is selected from a single bond, N[(L₈₃)ₐ₈₃-R₈₃], C[(L₈₃)ₐ₈₃-R₈₃][(L₈₄)ₐ₈₄-R₈₄], O, and S,
A₁₁, A₁₂, A₈₁, and A₈₂ are each independently selected from a C₅-C₂₀ carbocyclic group and a C₁-C₂₀ heterocyclic group,
L₁₁ to L₁₆ and L₈₁ to L₈₄ are each independently selected from ^{∗}-O-^{∗}', ^{∗}-S-^{∗}', ^{∗}-C(=O)-^{∗}', ^{∗}-P(=O)(Q₁)-^{∗}', ^{∗}-Si(Q₁)(Q₂)-^{∗}', a substituted or unsubstituted C₆-C₆₀ arylene group, and a substituted or unsubstituted C₁-C₆₀ heteroarylene group,
a11 to a16 and a81 to a84 are each independently selected from 0, 1, 2, and 3,
n11 and n12 are each independently selected from 0, 1, 2, 3, and 4,
R₈₁ to R₈₄ are each independently selected from hydrogen, deuterium, -F, -Cl, - Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and -P(=O)(Q₁)(Q₂), wherein when R₈₁ and R₈₂ are both present and a81 and a82 are both equal to zero, R₈₁ and R₈₂ are optionally connected to each other to form a C₅-C₂₀ carbocyclic group or a C₁-C₂₀ heterocyclic group, and when R₈₃ and R₈₄ are both present and a83 and a84 are both equal to zero, R₈₃ and R₈₄ are optionally connected to each other to form a C₅-C₂₀ carbocyclic group or a C₁-C₂₀ heterocyclic group,
R₁₀₁, R₁₀₂, R₈₅, and R₈₆ are each independently selected from hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and - P(=O)(Q₁)(Q₂),
b101, b102, b26 b85, and b86 are each independently selected from 1, 2, 3, 4, 5, and 6,
A21 is selected from a C₆-C₂₀ arene group and a C₁-C₂₀ heteroarene group,
L₉₁ is selected from a C₆-C₆₀ arylene group and a C₁-C₆₀ heteroarylene group, each substituted with at least one selected from a C₁-C₆₀ alkyl group and a C₃-C₁₀ cycloalkyl group,
L₉₂ is selected from a substituted or unsubstituted C₆-C₆₀ arylene group and a substituted or unsubstituted C₁-C₆₀ heteroarylene group,
a91 is selected from 1 and 2,
a92 is selected from 0, 1, and 2,
R₉₁ is selected from a substituted or unsubstituted C₆-C₆₀ aryl group and a substituted or unsubstituted C₁-C₆₀ heteroaryl group,
R₉₂ is selected from a C₆-C₆₀ aryl group and a C₁-C₆₀ heteroaryl group, each substituted with at least one selected from a C₁-C₆₀ alkyl group and a C₃-C₁₀ cycloalkyl group,
Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, and
^{∗}and ^{∗}'each independently indicate a binding site to a neighboring atom US 2014/367654 A1 and EP 2 581 957 A1 both disclose OLEDs comprising a light emitting layer and an electron transporting region.

### BRIEF DESCRIPTION OF THE DRAWINGS

FIG. 1 is a schematic cross-sectional view of an organic light-emitting device according to an embodiment.
FIG. 2 is a schematic cross-sectional view of an organic light-emitting device according to another embodiment.
FIG. 3 is a schematic cross-sectional view of an organic light-emitting device according to another embodiment.
FIG. 4 is a schematic cross-sectional view of an organic light-emitting device according to another embodiment.

### DETAILED DESCRIPTION OF THE INVENTION

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. That is, for example, intervening layers, regions, or components may be present. In contrast, when an element is referred to as being "directly on" or "directly contacting" another element, there are no intervening elements present.

Sizes of components in the drawings may be exaggerated for convenience of explanation. In other words, since sizes and thicknesses of components in the drawings are arbitrarily illustrated for convenience of explanation, the following embodiments are not limited thereto.

The expression "an (organic layer) comprises a first compound" may refer to a case in which an (organic layer) comprises a first compound represented by Formula 1 and a case in which an (organic layer) comprises two or more different first compounds represented by Formula 1.

The term "organic layer" used herein refers to a single and/or a plurality of layers between a first electrode and a second electrode in an organic light-emitting device. A material comprised in the "organic layer" is not limited to an organic material.

Expressions such as "at least one of," "one of," and "selected from," when preceding a list of elements, modify the entire list of elements and do not modify the individual elements of the list. Further, the use of "may" when describing embodiments of the present invention refers to "one or more embodiments of the present invention."

The organic light-emitting device of the present invention comprises a first electrode, a second electrode, and an organic layer between the first electrode and the second electrode, the organic layer comprising an emission layer, and further comprising an electron transporting region between the emission layer and the second electrode, wherein the emission layer comprises a first compound represented by Formula 1: 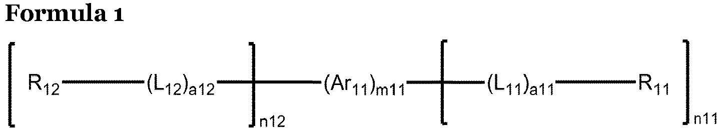 in which Ar₁₁ is a group represented by Formulae 1-1 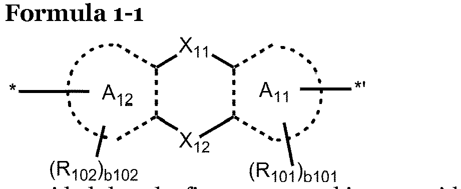 provided that the first compound is not 4,4'-bis(N-carbazolyl)-1,1'-biphenyl (CBP);
and wherein the electron transporting region comprises a second compound represented by Formula 2, wherein the second compound comprises a group represented by Formula 9-1 and/or a group represented by Formula 9-2, and the second compound comprises an alkyl group and/or a cycloalkyl group,

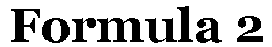

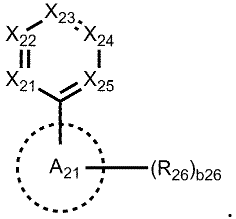

As indicated elsewhere herein, certain groups in Formulae 1, 1-1 and 2 may be represented by Formulae 8-1, 8-2, 9-1, 9-2 and 9-3:

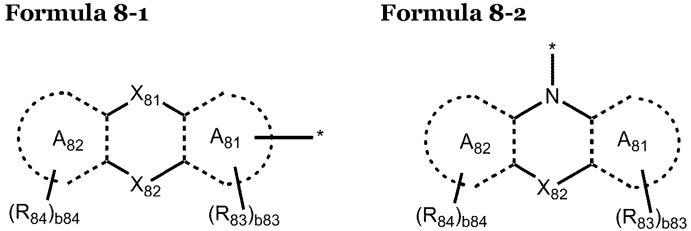

**Formula 9-1** ^{∗}-(L₉₁)ₐ₉₁-R₉₁

**Formula 9-2** ^{∗-}(L₉₂)ₐ₉₂-R₉₂

**Formula 9-3** ^{∗}-(L₉₃)ₐ₉₃-R₉₃.

A₁₁, A₁₂, X₁₁, X₁₂, R₁₀₁, R₁₀₂, b₁₀₁, and b102 in Formula 1-1 are described below, and ^{∗} and ^{∗}' each independently indicate a binding site to a neighboring atom.

In Formula 1, m11 indicates the number of Ar₁₁(s), and m11 is be selected from 1 and 2.

A₁₁, A₁₂, A₈₁, and A₈₂ in Formulae 1-1, 8-1, and 8-2 are each independently be selected from a C₅-C₂₀ carbocyclic group and a C₁-C₂₀ heterocyclic group.

For example, A₁₁, A₁₂, A₈₁, and A₈₂ in Formulae 1-1, 8-1, and 8-2 may each independently be selected from a benzene group, a naphthalene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, a phenanthroline group, a benzofuran group, a benzothiophene group, an indene group, an indole group, a furopyridine group, a thienopyridine group, a cyclopentapyridine group, a pyrrolopyridine group, a dibenzofuran group, a dibenzothiophene group, a fluorene group, a carbazole group, a benzofuropyrrole group, a benzothienopyrrole group, an indenopyrrole group, an indolopyrrole group, a benzofurothiophene group, a benzothienothiophene group, an indenothiophene group, an indolothiophene group, a benzofurofuran group, a benzothienofuran group, an indenofuran group, an indolofuran group, a benzofuropyridine group, a benzothienopyridine group, an indenopyridine group, an indolopyridine group, a benzofuropyrimidine group, a benzothienopyrimidine group, an indenopyrimidine group, an indolopyrimidine group, a benzofuroindole group, a benzothienoindole group, an indenoindole group, an indoloindole group, a benzofurobenzofuran group, a benzothienobenzofuran group, an indenobenzofuran group, an indolobenzofuran group, a benzofurobenzothiophene group, a benzothienobenzothiophene group, an indenobenzothiophene group, an indolobenzothiophene group, a benzofuroquinoline group, a benzothienoquinoline group, an indenoquinoline group, an indoloquinoline group, a benzonaphthofuran group, a benzonaphthothiophene group, a benzofluorene group, a benzocarbazole group, a dinaphthofuran group, a dinaphthothiophene group, a dibenzofluorene group, a dibenzocarbazole group, a benzoxazole group, a benzothiazole group, a benzimidazole group, a naphthofuran group, a naphthothiophene group, a cyclopentanaphthalene group, a spiro-bifluorene group, and a spiro-fluorene-indene group, but are not limited thereto.

In various embodiments, A₁₁ and A₈₁ in Formulae 1-1, 8-1, and 8-2 may each independently be selected from a benzene group, a naphthalene group, a pyridine group, a pyrimidine group, a pyrazine group, a quinoline group, an isoquinoline group, and a phenanthroline group, and

A₁₂ and A₈₂ may each independently be selected from a benzene group, a naphthalene group, a pyridine group, a pyrimidine group, a pyrazine group, a quinoline group, an isoquinoline group, a phenanthroline group, a benzofuran group, a benzothiophene group, an indene group, an indole group, a furopyridine group, a thienopyridine group, a cyclopentapyridine group, a pyrrolopyridine group, a dibenzofuran group, a dibenzothiophene group, a fluorene group, a carbazole group, a benzofuropyridine group, a benzothienopyridine group, an indenopyridine group, an indolopyridine group, a benzofuropyrimidine group, a benzothienopyrimidine group, an indenopyrimidine group, an indolopyrimidine group, a benzonaphthofuran group, a benzonaphthothiophene group, a benzofluorene group, a benzocarbazole group, a dinaphthofuran group, a dinaphthothiophene group, a dibenzofluorene group, a dibenzocarbazole group, a benzoxazole group, a benzothiazole group, a benzimidazole group, a naphthofuran group, and a naphthothiophene group, but are not limited thereto.

X₁₁ in Formula 1-1 is selected from N[(L₁₃)ₐ₁₃-R₁₃], C[(L₁₃)ₐ₁₃-R₁₃][(L₁₄)ₐ₁₄R₁₄], O, and S,
X₁₂ is selected from a single bond, N[(L₁₅)ₐ₁₅R₁₅], C[(L₁₅)ₐ₁₅R₁₅][(L₁₆)ₐ₁₆-R₁₆], O, and S,
where L₁₃ to L₁₆, a13 to ai6, R₁₃, and R₁₆ are described below.

For example, X₁₁ in Formula 1-1 may be N[(L₁₃)ₐ₁₃-R₁₃], and
X₁₂ may be a single bond, but embodiments are not limited thereto.

In various embodiments, X₁₁ in Formula 1-1 may be C[(L₁₃)ₐ₁₃-R₁₃][(L₁₄)ₐ₁₄R₁₄], and
X₁₂ may be a single bond, but embodiments are not limited thereto.

In various embodiments, X₁₁ in Formula 1-1 may be O, and
X₁₂ may be a single bond, but embodiments are not limited thereto.

In various embodiments, X₁₁ in Formula 1-1 may be S, and
X₁₂ may be a single bond, but embodiments are not limited thereto.

X₈₁ in Formulae 8-1 and 8-2 is selected from N[(L₈₁)ₐ₈₁-R₈₁], C[(L₈₁)ₐ₈₈-R₈₁][(L₈₂)ₐ₈₂-R₈₂], O, and S,
Xs2 is selected from a single bond, N[(L₈₃)ₐ₈₃-R₈₃], C[(L₈₃)ₐ₈₃-R₈₃][(L₈₄)ₐ₈₄-R₈₄], O, and S,
where L₈₁ to L₈₄, a81 to a84, and R₈₁ to R₈₄ are described below.

For example, X₈₁ in Formulae 8-1 and 8-2 may be N[(L₈₁)ₐ₈₁-R₈₁], and
X₈₂ may be a single bond, but embodiments are not limited thereto.

L₁₁ to L₁₆ and L₈₁ to L₈₄ in Formulae 1, 1-1, 1-2, 8-1, and 8-2 are each independently selected from ^{∗}-O-^{∗}', ^{∗}-S-^{∗}', ^{∗}-C(=O)-^{∗}', ^{∗}-P( =O)(Q₁)-^{∗}', ^{∗}-Si(Q₁)(Q₂)-^{∗}', a substituted or unsubstituted C₆-C₆₀ arylene group, and a substituted or unsubstituted C₁-C₆₀ heteroarylene group,
wherein Q₁ and Q₂ are each independently selected from hydrogen, deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

For example, L₁₁ to L₁₆ and L₈₁ to L₈₄ in Formulae 1, 1-1, 1-2, 8-1, and 8-2 may each independently be selected from the group consisting of:
^{∗}-Si(CH₃)₂^{∗}', ^{∗}-Si(CH₃)(Ph)-^{∗}', ^{∗}-Si(Ph)₂-^{∗}', a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group;
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂); and
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one substituent selected from a cyclopentyl group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each of which at least one substituent being substituted with at least one selected from deuterium, -F, -Cl, -Br, -I, a cyano group, a C₁-C₂₀ alkyl group, a C₁-C₂₀ alkoxy group, a phenyl group, a biphenyl group, and a terphenyl group,
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group, but embodiments are not limited thereto.

In various embodiments, L₁₁ to L₁₆ and L₈₁ to L₈₄ in Formulae 1, 1-1, 1-2, 8-1, and 8-2 may each independently be selected from the group consisting of:
^{∗}-Si(CH₃)₂^{∗}', ^{∗}-Si(Ph)₂-^{∗}', a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group;
a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group, each substituted with at least one selected from deuterium, -F, -Cl, -Br, -I, a cyano group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, a triazinyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂); and
a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group, each substituted with at least one substituent selected from a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, and a triazinyl group, each of which at least one substituent being substituted with at least one selected from deuterium, -F, - Cl, -Br, -I, a cyano group, a C₁-C₂₀ alkyl group, a C₁-C₂₀ alkoxy group, and a phenyl group,
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group, but embodiments are not limited thereto.

In various embodiments, L₁₁ to L₁₆ and L₈₁ to L₈₄ in Formulae 1, 1-1, 1-2, 8-1, and 8-2 may each independently be selected from ^{∗}-Si(CH₃)₂^{∗}', ^{∗}-Si(Ph)₂-^{∗}', and a group represented by any of Formulae 3-1 to 3-13 and 3-16 to 3-163, but are not limited thereto: 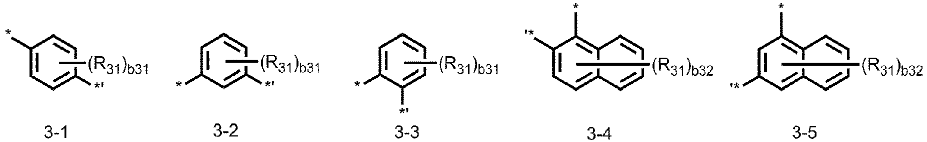 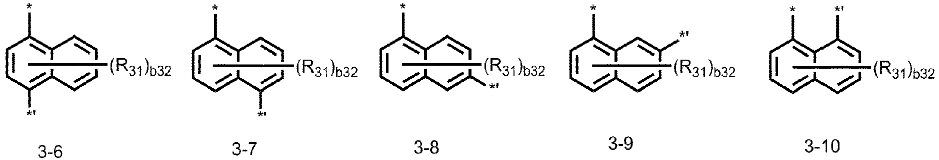 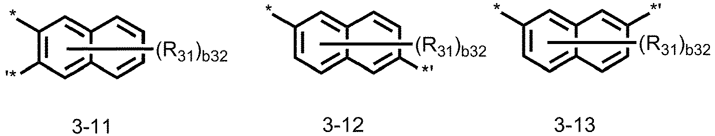 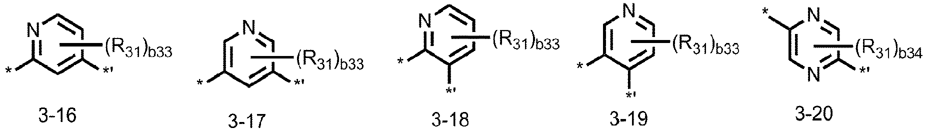 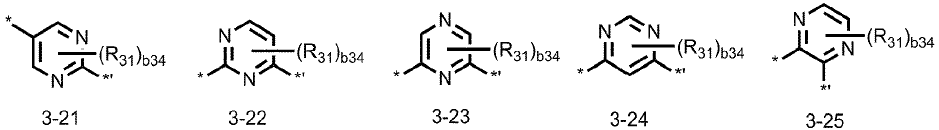 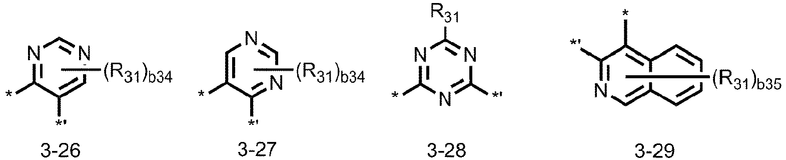 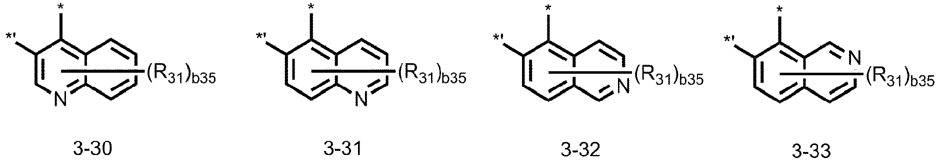 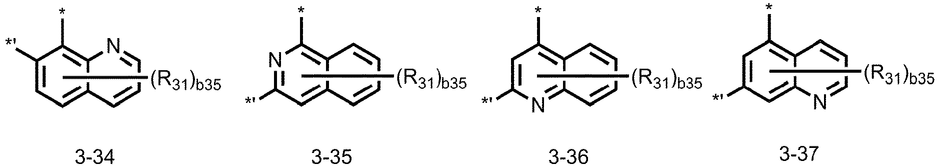 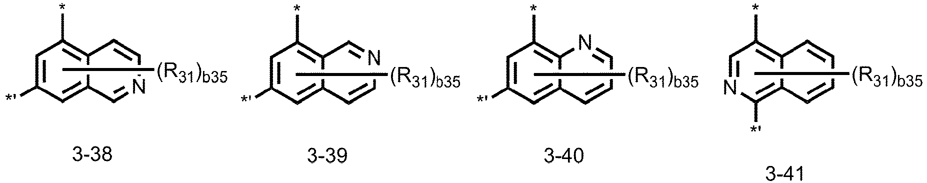 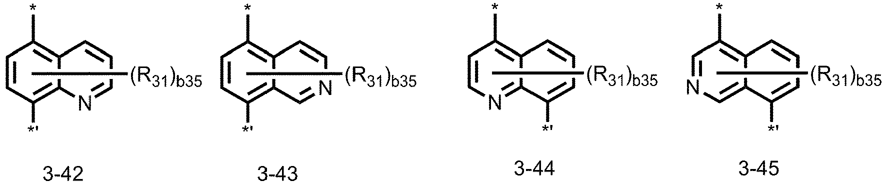 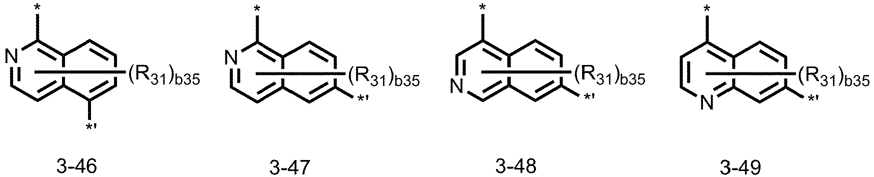 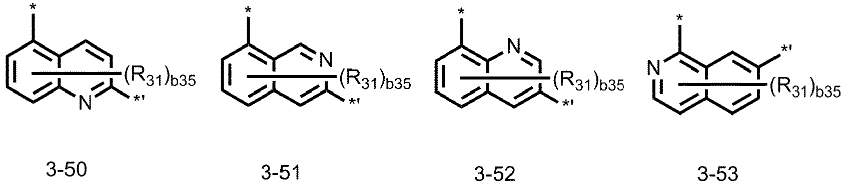 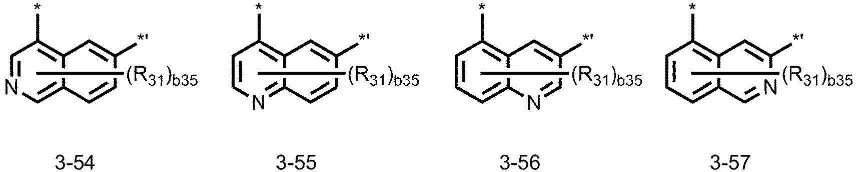 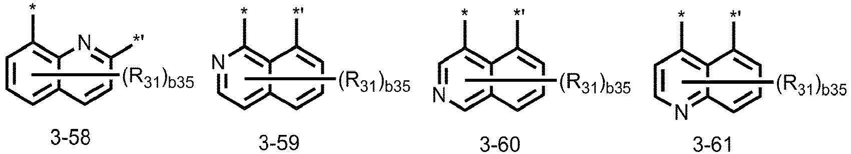 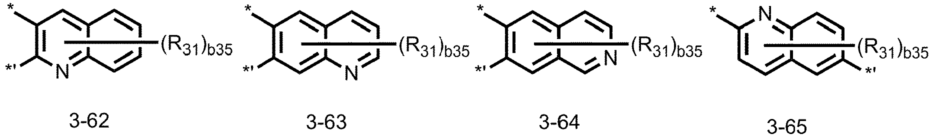 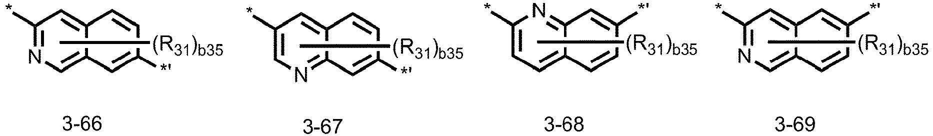 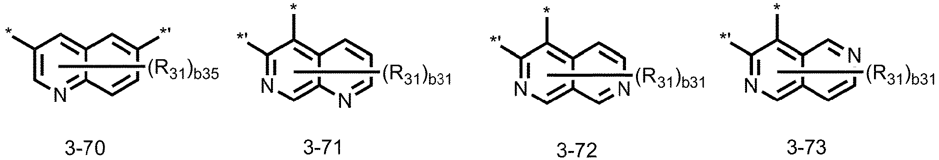 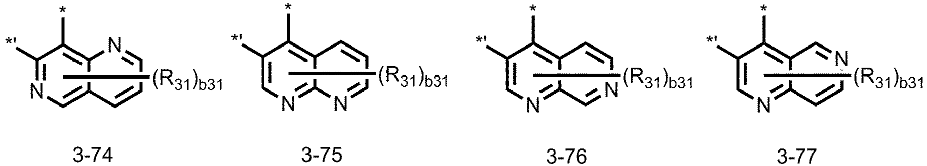 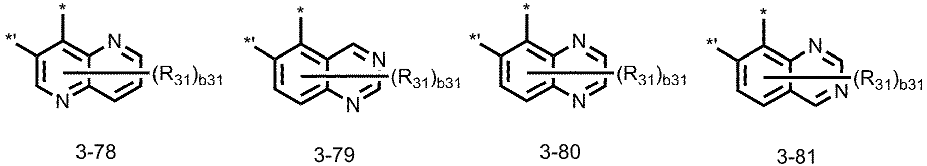 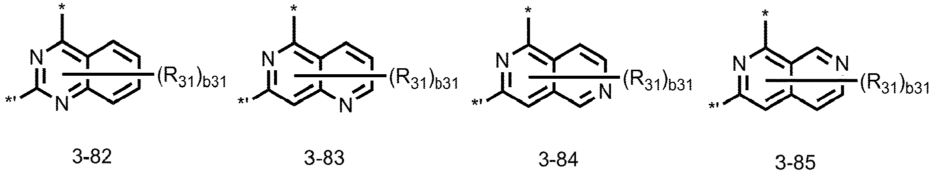 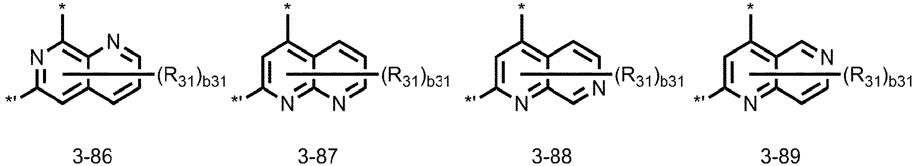 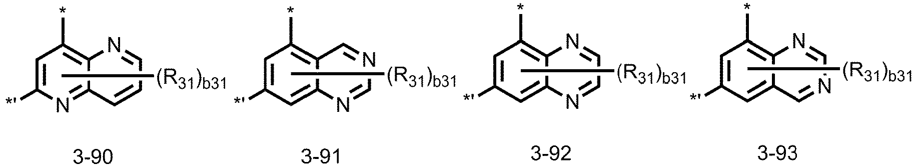 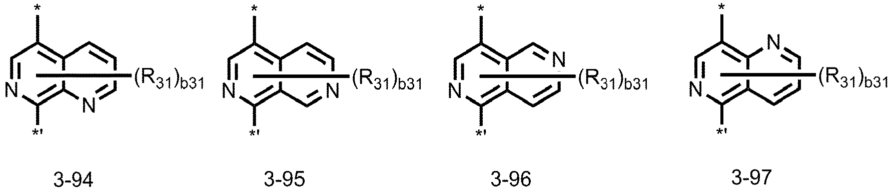 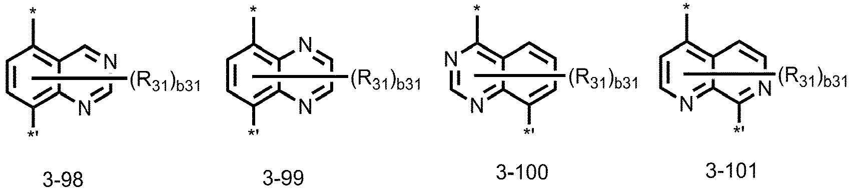 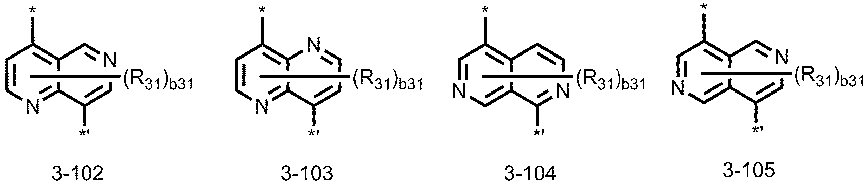 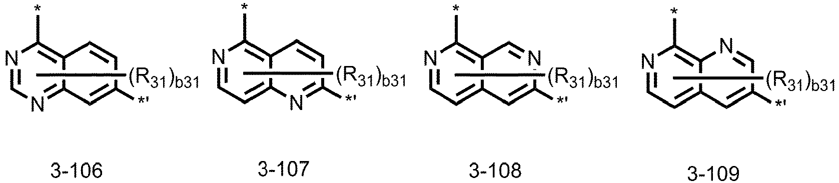 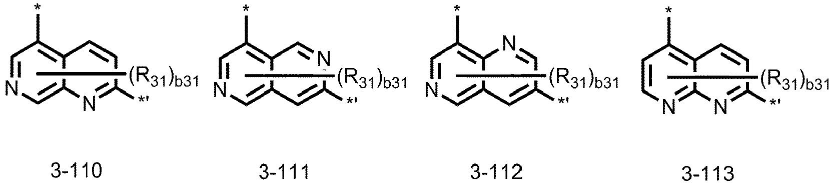 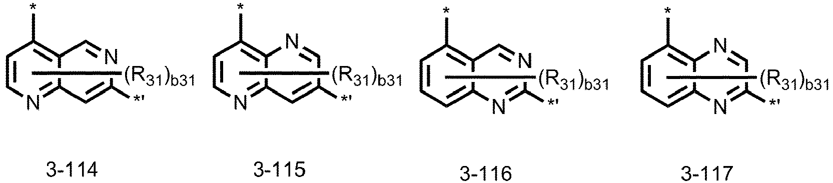 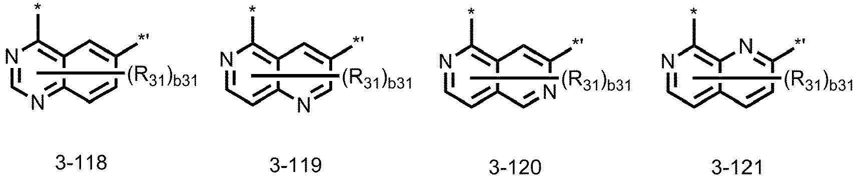 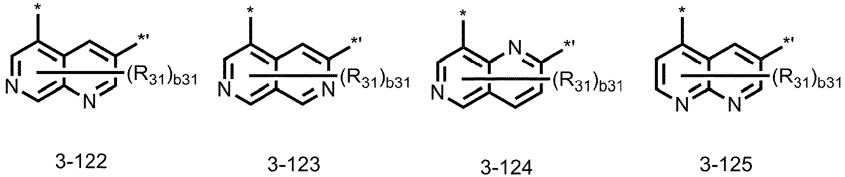 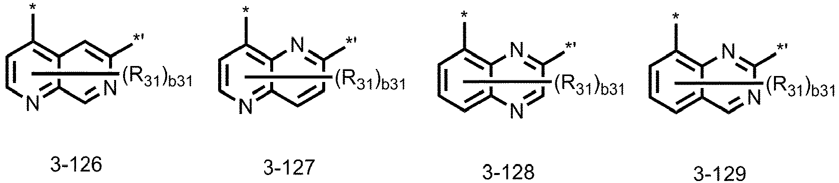 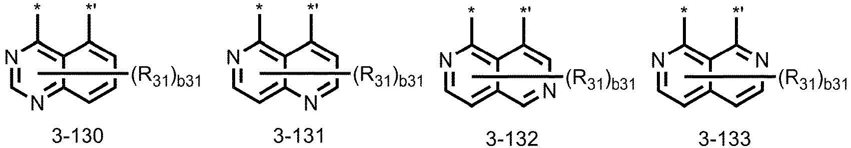 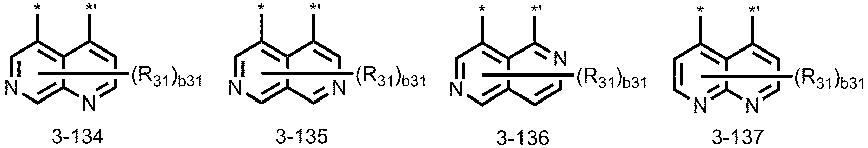 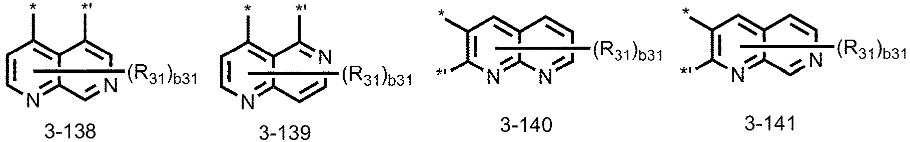 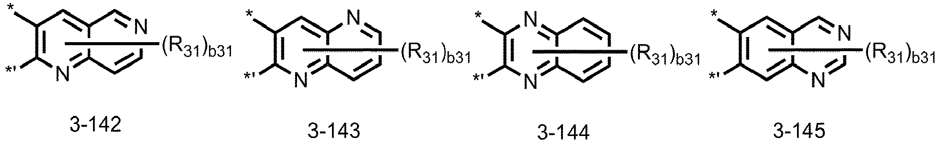 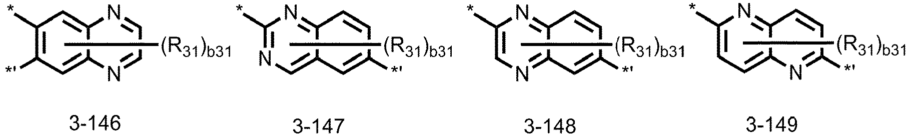 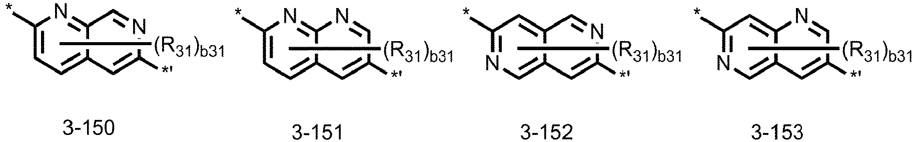 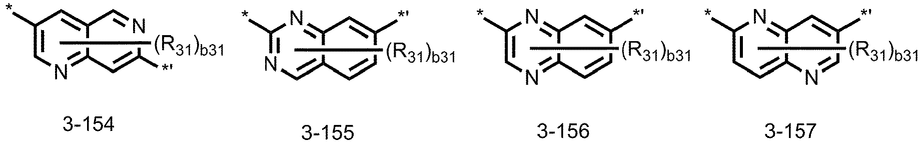 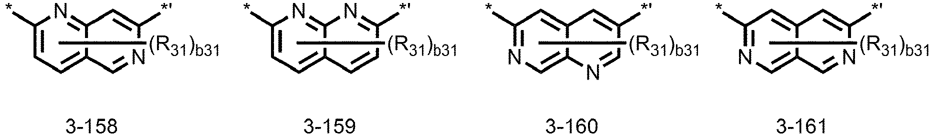 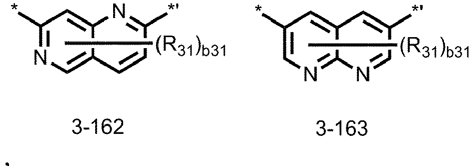 wherein, in Formulae 3-1 to 3-13 and 3-16 to 3-163,
R₃₁ may be selected from the group consisting of:
hydrogen, deuterium, -F, -Cl, -Br, -I, a cyano group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, a triazinyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂); and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, and a triazinyl group, each substituted with at least one selected from deuterium, -F, -Cl, -Br, -I, a cyano group, a C₁-C₂₀ alkyl group, a C₁-C₂₀ alkoxy group, a phenyl group, a biphenyl group, and a terphenyl group,
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group,
b31 may be selected from 1, 2, 3, and 4,
b32 may be selected from 1, 2, 3, 4, 5, and 6,
b33 may be selected from 1, 2, and 3,
b34 may be selected from 1 and 2,
b35 may be 1, 2, 3, 4, and 5, and
^{∗} and ^{∗}' may each independently indicate a binding site to a neighboring atom.

a11 to a16 and a81 to a84 in Formulae 1, 1-1, 1-2, 8-1, and 8-2 are each independently selected from 0, 1, 2, and 3. When a11 is zero, (L₁₁)ₐ₁₁ may be a single bond, and when a11 is two or more, a plurality of L₁₁(s) may be identical to or different from each other. Descriptions of a12 to a16 and a81 to a84 may be the same as those provided in connection with a11.

For example, a11 to a16 and a81 to a84 in Formulae 1, 1-1, 1-2, 8-1, and 8-2 may each independently be selected from 0, 1, and 2, but are not limited thereto.

R₁₁ to R₁₆ in Formulae 1 and 1-1 are each independently be selected from a group represented by Formula 8-1, a group represented by Formula 8-2, hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and - P(=O)(Q₁)(Q₂), wherein when R₁₃ and R₁₄ are both present and a13 and a14 are both equal to zero, R₁₃ and R₁₄ are optionally connected to each other to form a C₅-C₂₀ carbocyclic group or a C₁-C₂₀ heterocyclic group, and when R₁₅ and R₁₆ are both present and a15 and a16 are both equal to zero, R₁₅ and R₁₆ are optionally connected to each other to form a C₅-C₂₀ carbocyclic group or a C₁-C₂₀ heterocyclic group,wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

For example, R₁₁ to R₁₆ in Formulae 1 and 1-1 may each independently be selected from the group consisting of:
a group represented by Formula 8-1, a group represented by Formula 8-2, a C₁-C₂₀ alkyl group, a C₆-C₃₀ aryl group, and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one selected from a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, - N(Q₂₁)(Q₂₂), and -Si(Q₂₁)(Q₂₂)(Q₂₃),
wherein Q₂₁ to Q₂₃ and Q₃₁ to Q₃₃ may each independently be selected from a C₁-C₂₀ alkyl group and a C₆-C₃₀ aryl group, but embodiments are not limited thereto.

In various embodiments, R₁₁ to R₁₆ in Formulae 1 and 1-1 may each independently be selected from the group consisting of:
a group represented by Formula 8-1, a group represented by Formula 8-2, a methyl group, an ethyl group, an n-propyl group, a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group;
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, - N(Q₃₁)(Q₃₂), and -Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group, each substituted with at least one substituent selected from a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each of which at least one substituent being substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₂₁)(Q₂₂), and -Si(Q₂₁)(Q₂₂)(Q₂₃),
wherein Q₂₁ to Q₂₃ and Q₃₁ to Q₃₃ may each independently be selected from a phenyl group, a biphenyl group, a terphenyl group, and a naphthyl group, but embodiments are not limited thereto.

In various embodiments, R₁₁ to R₁₆ in Formulae 1 and 1-1 may each independently be selected from a group represented by Formula 8-1, a group represented by Formula 8-2, a methyl group, an ethyl group, an n-propyl group, and a group represented by any of Formulae 5-1 to 5-55 and 5-80 to 5-92, but are not limited thereto: 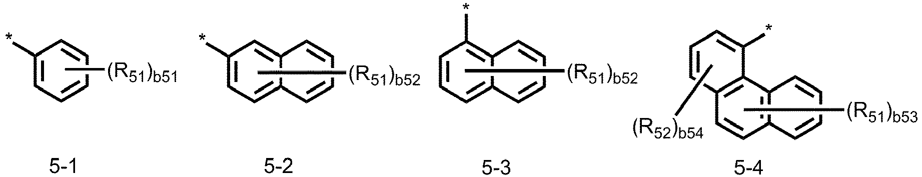 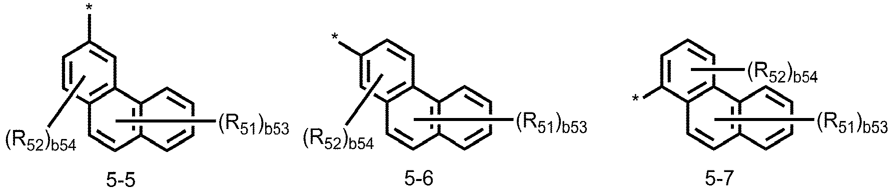 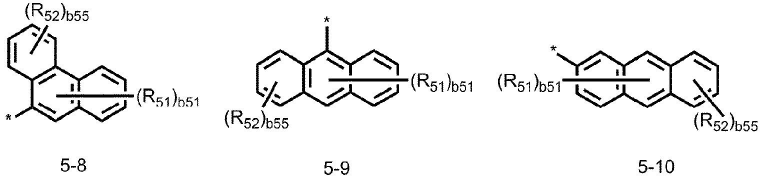 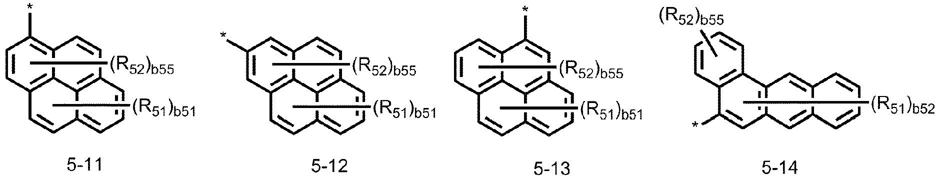 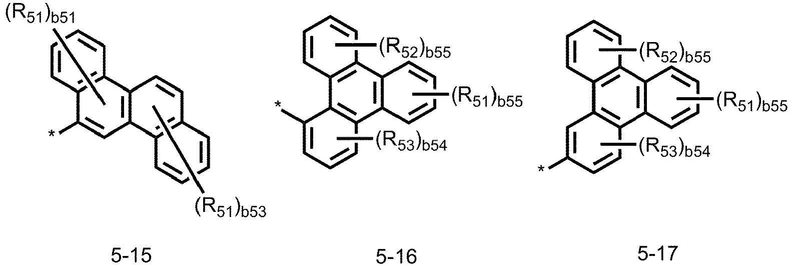 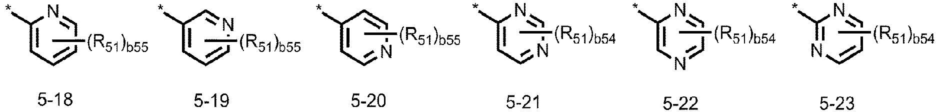 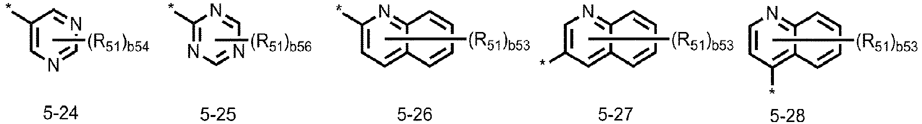 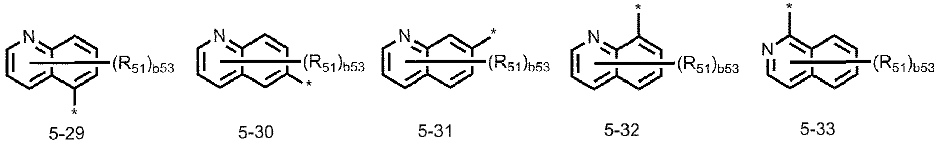 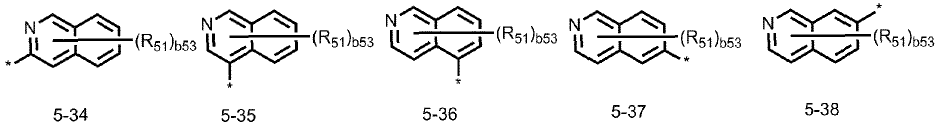 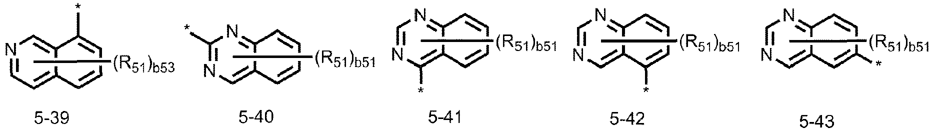 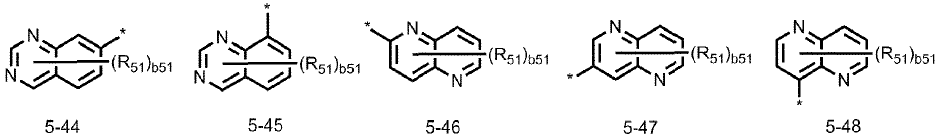 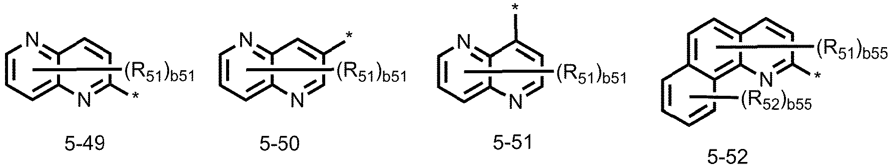 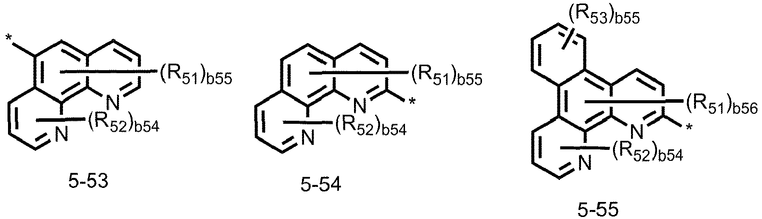 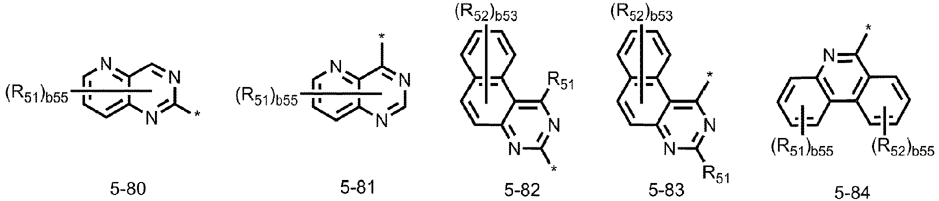 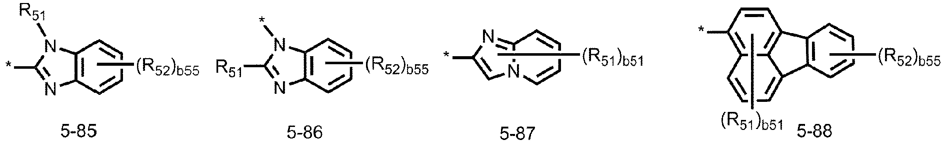 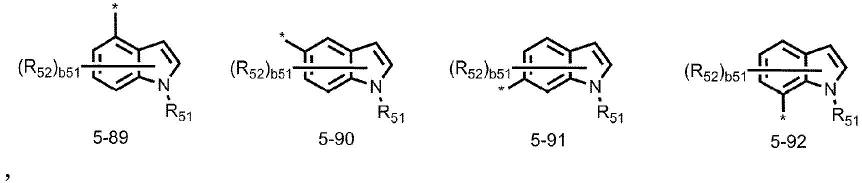 wherein, in Formulae 5-1 to 5-55 and 5-80 to 5-92,
R₅₁ to R₅₃ may each independently be selected from the group consisting of:
hydrogen, deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₃₁)(Q₃₂), and -Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₂₁)(Q₂₂), and -Si(Q₂₁)(Q₂₂)(Q₂₃),
wherein Q₂₁ to Q₂₃ and Q₃₁ to Q₃₃ may each independently be selected from a phenyl group, a biphenyl group, a terphenyl group, and a naphthyl group,
b51 may be selected from 1, 2, 3, 4, and 5,
b52 may be selected from 1, 2, 3, 4, 5, 6, and 7,
b53 may be selected from 1, 2, 3, 4, 5, and 6,
b54 may be selected from 1, 2, and 3,
b55 may be selected from 1, 2, 3, and 4,
b56 may be 1 or 2, and
^{∗} indicates a binding site to a neighboring atom.
n11 in Formula 1 indicates the number of moieties represented by ^{∗}-(L₁₁)ₐ₁₁-R₁₁, wherein n11 is selected from 0, 1, 2, 3, and 4. When n11 is zero, A₁₁ in Formula 1-1 (where compound represented by Formula 1-1 represents Ar₁₁ in Formula 1) is not substituted with a moiety represented by ^{∗}-(L₁₁)ₐ₁₁-R₁₁. When n11 is two or more, a plurality of moieties represented by ^{∗}-(L₁₁)ₐ₁₁-R₁₁ may be identical to or different from each other.
n12 in Formula 1 indicates the number of moieties represented by ^{∗}-(L₁₂)ₐ₁₂-R₁₂, wherein n12 is selected from 0, 1, 2, 3, and 4. When n12 is zero, A₁₂ in Formula 1-1 (where compound represented by Formula 1-1 represents Ar₁₁ in Formula 1) is not substituted with a moiety represented by ^{∗}-(L₁₂)ₐ₁₂-R₁₂. When n12 is two or more, a plurality of moieties represented by ^{∗}-(L₁₂)ₐ₁₂-R₁₂ may be identical to or different from each other.

For example, the sum of n11 and n12 in Formula 1 may be selected from 0 and 1, but is not limited thereto.

R₈₁ to R₈₄ in Formulae 8-1 and 8-2 are each independently be selected from hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and-P(=O)(Q₁)(Q₂),
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

For example, R₈₁ to R₈₄ in Formulae 8-1 and 8-2 may each independently be selected from the group consisting of:
a C₁-C₂₀ alkyl group, a C₆-C₃₀ aryl group, and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one substituent selected from a C₆-C₃₀ aryl group and a C₁-C₃₀ heteroaryl group, each of which at least one substituent being substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₂₁)(Q₂₂), and - Si(Q₂₁)(Q₂₂)(Q₂₃),
wherein Q₂₁ to Q₂₃ and Q₃₁ to Q₃₃ may each independently be selected from a C₁-C₂₀ alkyl group and a C₆-C₃₀ aryl group, but embodiments are not limited thereto.

In various embodiments, R₈₁ to R₈₄ in Formulae 8-1 and 8-2 may each independently be selected from the group consisting of:
a methyl group, an ethyl group, an n-propyl group, a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group;
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, - N(Q₃₁)(Q₃₂), and -Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a fluoranthenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a pyridopyrimidinyl group, a phenanthridinyl group, an acridinyl group, a phenanthrolinyl group, a phenazinyl group, a benzonaphthyridinyl group, a benzoquinoxalinyl group, a benzoquinazolinyl group, a benzophenanthrolinyl group, a thiazolyl group, an oxazolyl group, an imidazolyl group, a triazolyl group, an indolyl group, a benzimidazolyl group, an imidazopyridinyl group, a benzofuranyl group, a benzothiophenyl group, and a benzoxazolyl group, each substituted with at least one substituent selected from a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₂₁)(Q₂₂), and -Si(Q₂₁)(Q₂₂)(Q₂₃),
wherein Q₂₁ to Q₂₃ and Q₃₁ to Q₃₃ may each independently be selected from a phenyl group, a biphenyl group, a terphenyl group, and a naphthyl group, but embodiments are not limited thereto.

In various embodiments, R₈₁ to R₈₄ in Formulae 8-1 and 8-2 may each independently be selected from a methyl group, an ethyl group, an n-propyl group, and a group represented by any of Formulae 5-1 to 5-55 and 5-80 to 5-92, but are not limited thereto: 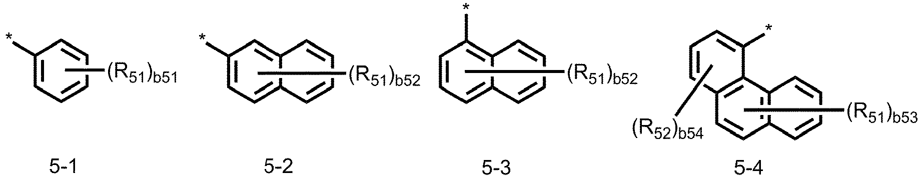 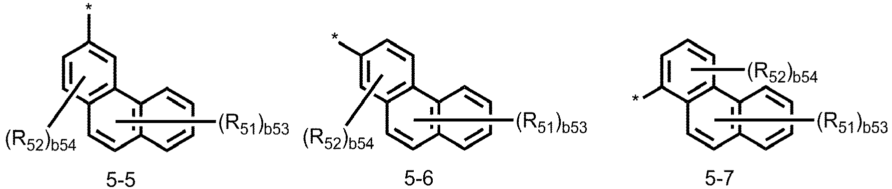 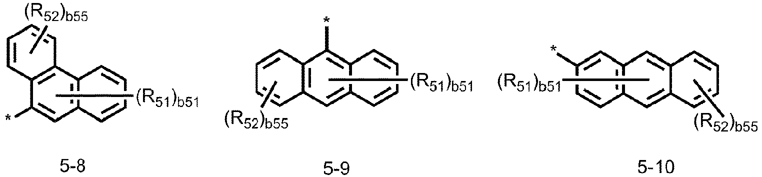 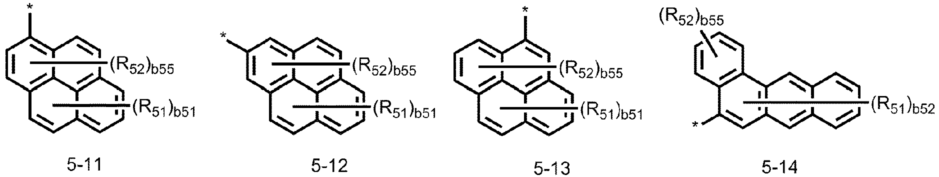 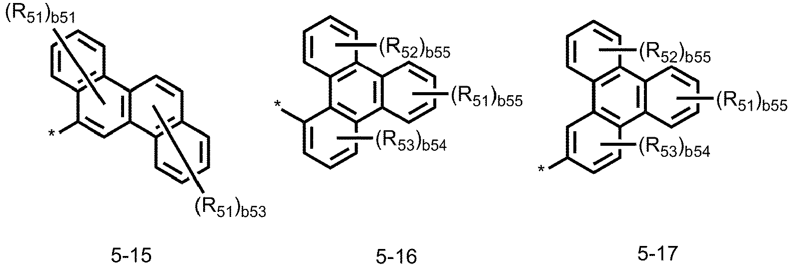 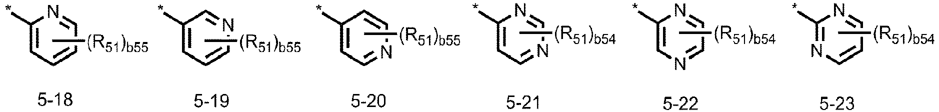 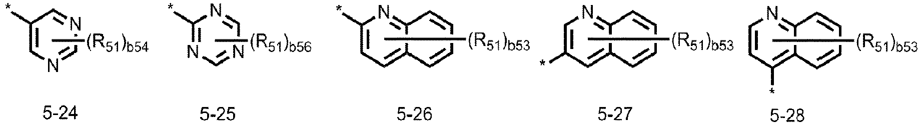 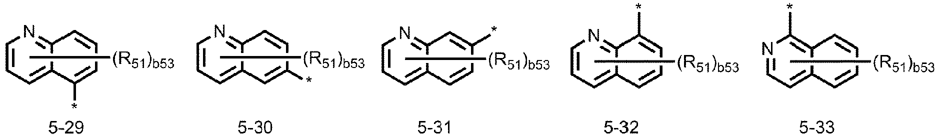 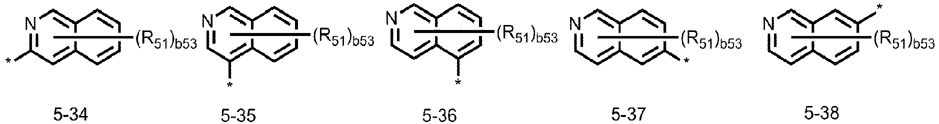 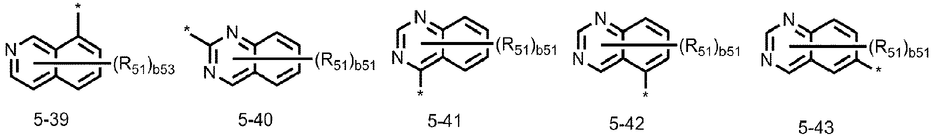 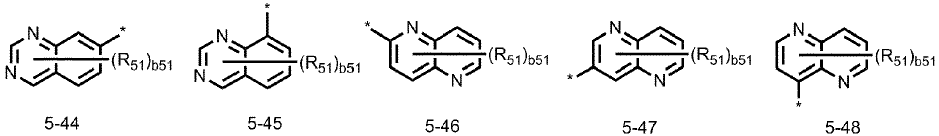 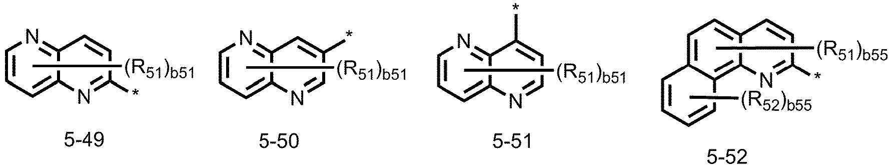 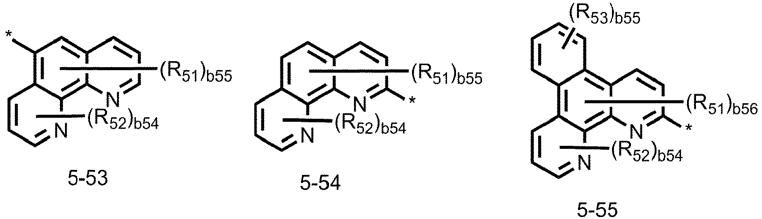 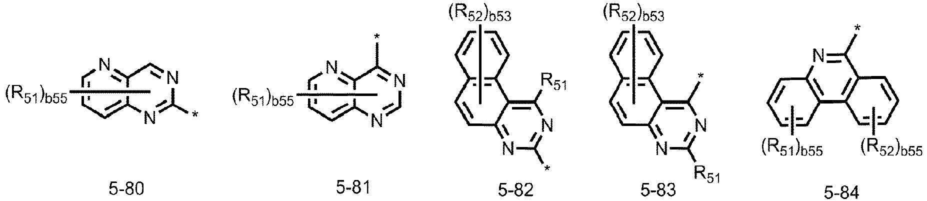 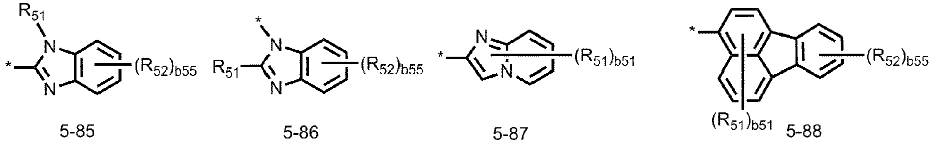 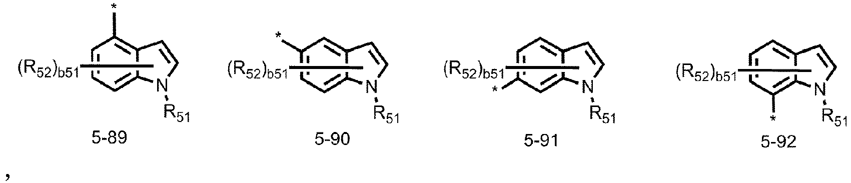 wherein, in Formulae 5-1 to 5-55 and 5-80 to 5-92,
R₅₁ to R₅₃ may each independently be selected from the group consisting of:
hydrogen, deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₃₁)(Q₃₂), and -Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, a quinolinyl group, an isoquinolinyl group, -N(Q₂₁)(Q₂₂), and -Si(Q₂₁)(Q₂₂)(Q₂₃),
wherein Q₂₁ to Q₂₃ and Q₃₁ to Q₃₃ may each independently be selected from a phenyl group, a biphenyl group, a terphenyl group, and a naphthyl group,
b51 may be selected from 1, 2, 3, 4, and 5,
b52 may be selected from 1, 2, 3, 4, 5, 6, and 7,
b53 may be selected from 1, 2, 3, 4, 5, and 6,
b54 may be selected from 1, 2, and 3,
b55 may be selected from 1, 2, 3, and 4,
b56 may be 1 or 2, and
^{∗} indicates a binding site to a neighboring atom.

R₁₀₁, R₁₀₂, R₈₅, and R₈₆ in Formulae 1, 1-1, 8-1, and 8-2 are each independently selected from hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), - S(=O)₂(Q₁), and -P(=O)(Q₁)(Q₂),
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

For example, R₁₀₁, R₁₀₂, R₈₅, and R₈₆ in Formulae 1, 1-1, 8-1, and 8-2 may each independently be selected from the group consisting of:
hydrogen, deuterium, -F, -Cl, -Br, -I, a cyano group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₃₀ aryl group, a C₆-C₃₀ aryloxy group, a C₆-C₃₀ arylthio group, a C₁-C₃₀ heteroaryl group, and -Si(Q₁)(Q₂)(Q₃);
a C₁-C₂₀ alkyl group and a C₃-C₁₀ cycloalkyl group, each substituted with at least one selected from deuterium, -F, -Cl, -Br, -I, a cyano group, and -Si(Q₃₁)(Q₃₂)(Q₃₃); and
a C₆-C₃₀ aryl group and a C₁-C₃₀ heteroaryl group, each substituted with at least one substituent selected from a C₁-C₂₀ alkyl group, a C₆-C₃₀ aryl group, and a C₁-C₃₀ heteroaryl group, each of which at least one substituent being substituted with at least one selected from deuterium, -F, -Cl, -Br, -I, a cyano group, and -Si(Q₂₁)(Q₂₂)(Q₂₃),
wherein Q₁ to Q₃, Q₂₁ to Q₂₃, and Q₃₁ to Q₃₃ may each independently be selected from a C₁-C₂₀ alkyl group, a C₆-C₃₀ aryl group, a C₁-C₃₀ heteroaryl group, a biphenyl group, and a terphenyl group, but embodiments are not limited thereto.

In various embodiments, R₁₀₁, R₁₀₂, R₈₅, and R₈₆ in Formulae 1, 1-1, 8-1, and 8-2 may each independently be selected from the group consisting of:
hydrogen, deuterium, -F, -Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a biphenyl group, a terphenyl group, a naphthyl group, a pyridinyl group, a pyrimidinyl group, a pyridazinyl group, a triazinyl group, a quinolinyl group, an isoquinolinyl group, and -Si(Q₁)(Q₂)(Q₃);
a methyl group, an ethyl group, an n-propyl group, an iso-propyl group, an n-butyl group, an iso-butyl group, a sec-butyl group, and a tert-butyl group, each substituted with at least one selected from deuterium, -F, -Cl, -Br, -I, a cyano group, and -Si(Q₃₁)(Q₃₂)(Q₃₃); and
a phenyl group, a biphenyl group, a terphenyl group, a naphthyl group, a pyridinyl group, a pyrimidinyl group, a pyridazinyl group, a triazinyl group, a quinolinyl group, and an isoquinolinyl group, each substituted with at least one substituent selected from a methyl group, an ethyl group, an n-propyl group, an iso-propyl group, an n-butyl group, an iso-butyl group, a sec-butyl group, a tert-butyl group, a phenyl group, a biphenyl group, a terphenyl group, a naphthyl group, a pyridinyl group, a pyrimidinyl group, a pyridazinyl group, a triazinyl group, a quinolinyl group, and an isoquinolinyl group, each of which at least one substituent being substituted with at least one selected from deuterium, -F, -Cl, -Br, -I, a cyano group, and -Si(Q₂₁)(Q₂₂)(Q₂₃),
wherein Q₁ to Q₃, Q₂₁ to Q₂₃, and Q₃₁ to Q₃₃ may each independently be selected from a methyl group and a phenyl group, but embodiments are not limited thereto.
b101, b102, b85, and b86 in Formulae 1, 1-1, 8-1, and 8-2 are each independently selected from 1, 2, 3, 4, 5, and 6. When b101 is two or more, a plurality of R₁₀₁(s) may be identical to or different from each other. Descriptions of b102, b85, and b86 may each independently be the same as the description provided in connection with b101.

The first compound is not 4,4'-bis(N-carbazolyl)-1,1'-biphenyl (CBP).

For example, in some embodiments, when m11 in Formula 1 is 1, n11 and n12 are both zero, X₁₁ is N[(L₁₃)ₐ₁₃-R₁₃], and R₁₃ is a group represented by Formula 8-2, then (L₁₃)ₐ₁₃ is not represented by Formula 10-1: 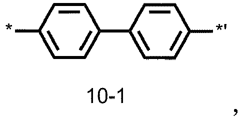 wherein ^{∗} and ^{∗}' in Formula 10-1 each independently indicate a binding site to a neighboring atom.

For example, a group represented by Formula 1-1 may be selected from groups represented by Formulae 1-11 to 1-67, but is not limited thereto: 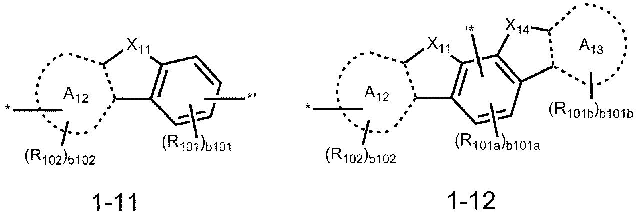 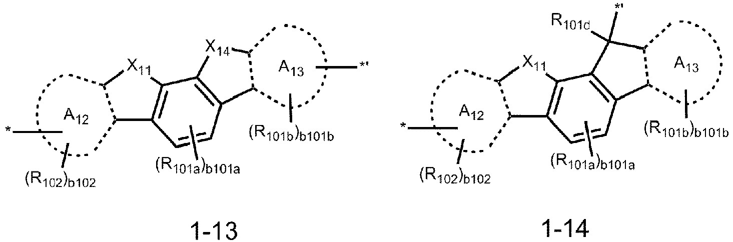 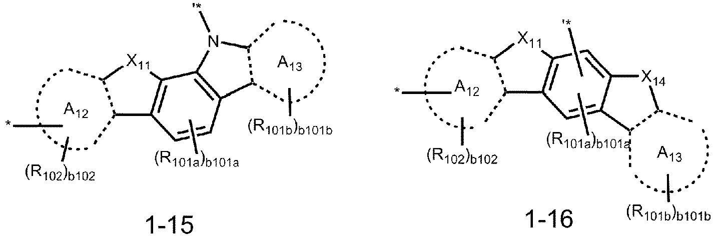 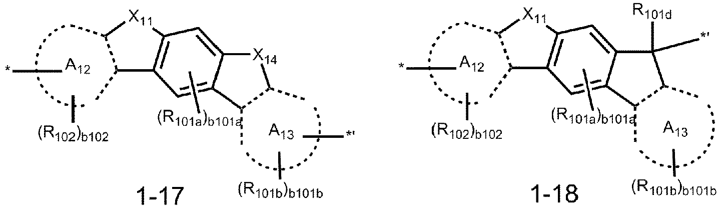 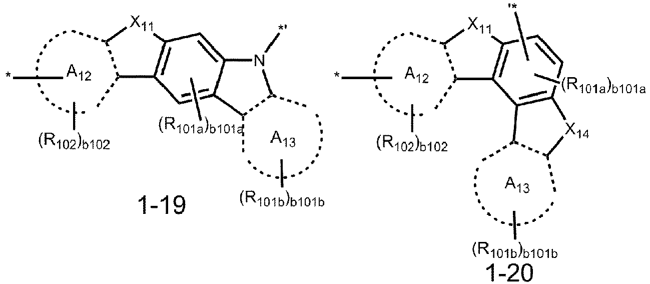 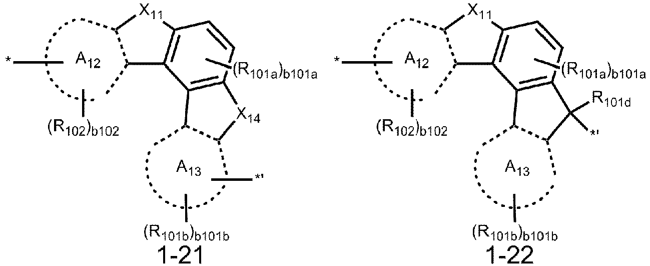 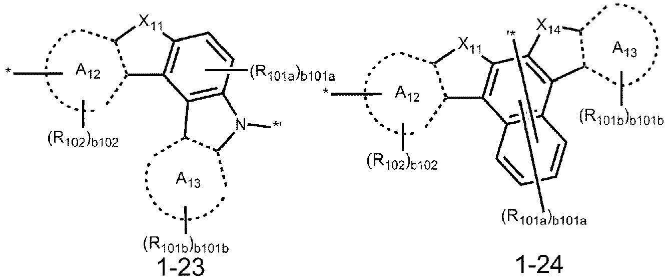 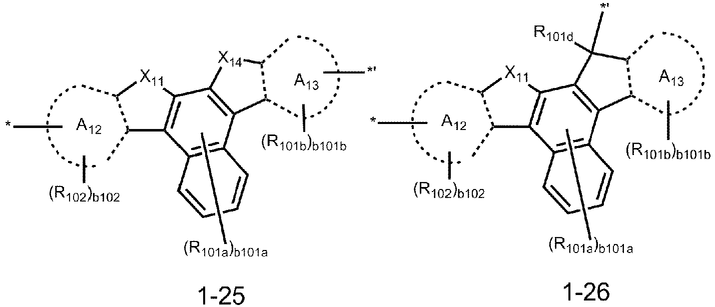 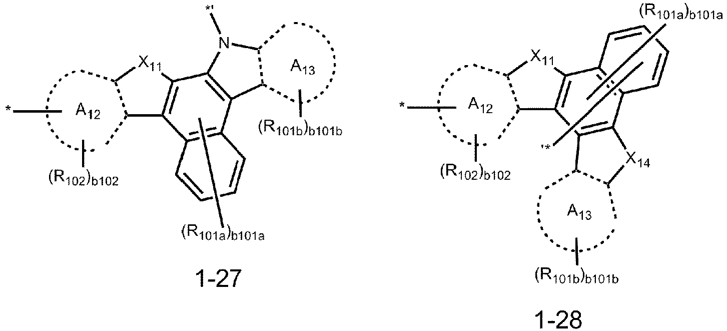 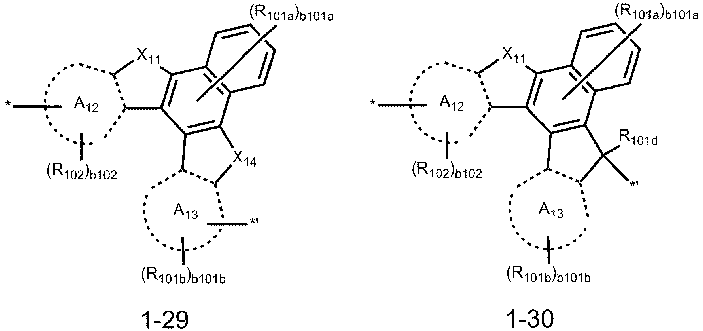 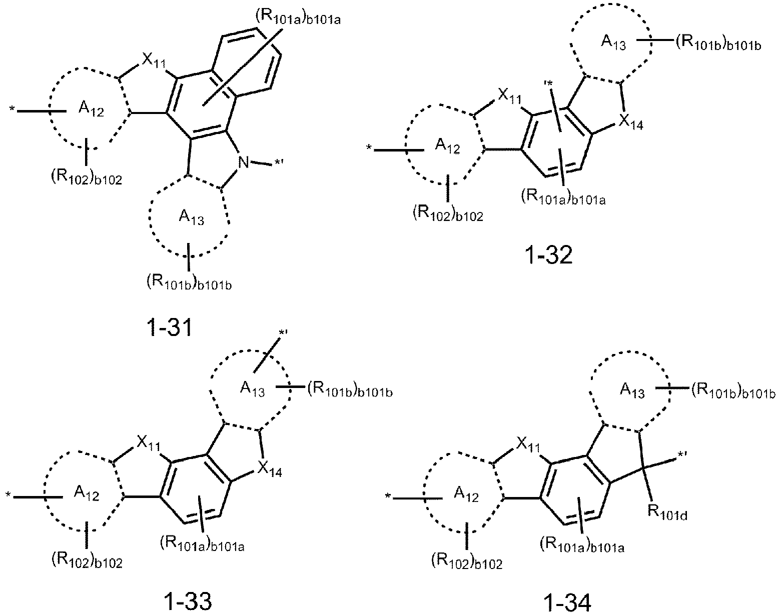 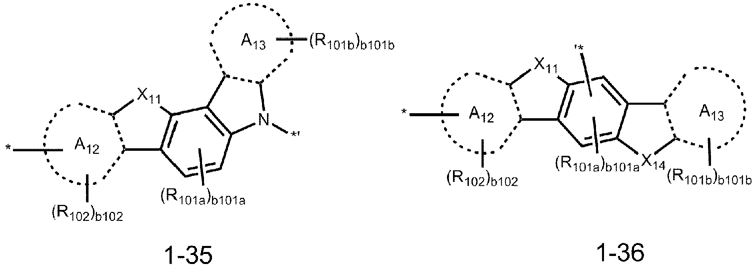 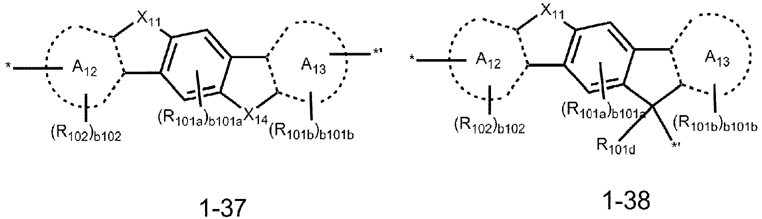 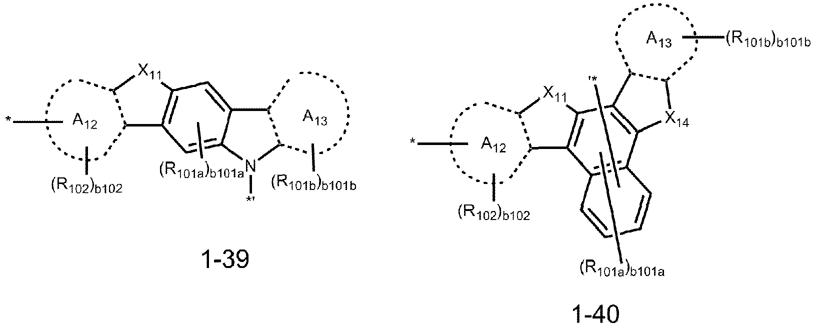 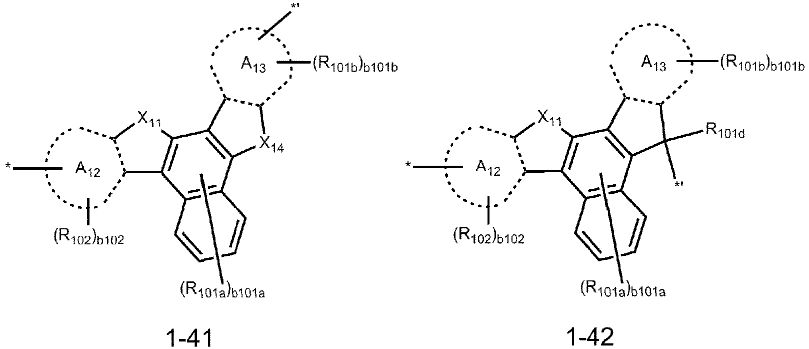 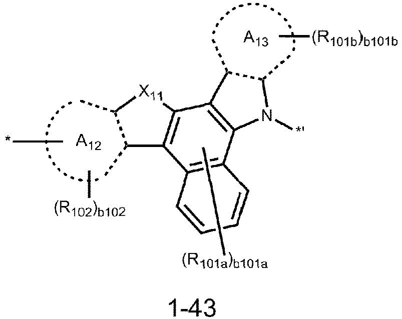 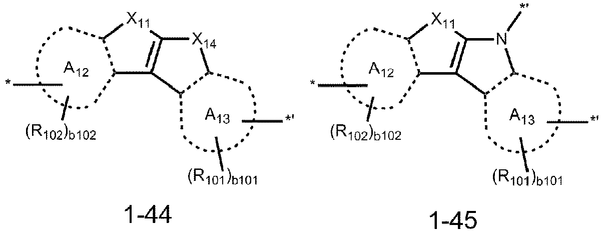 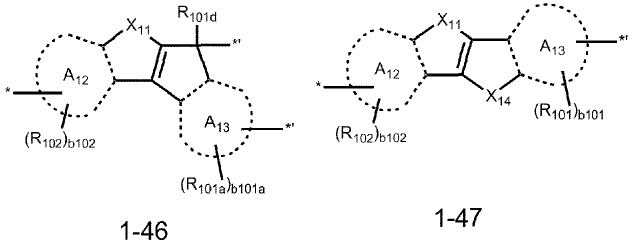 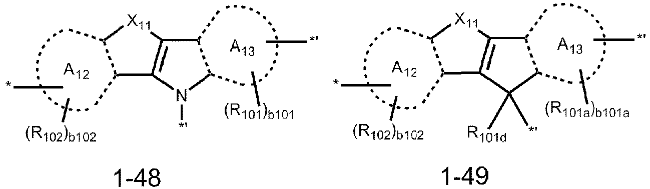 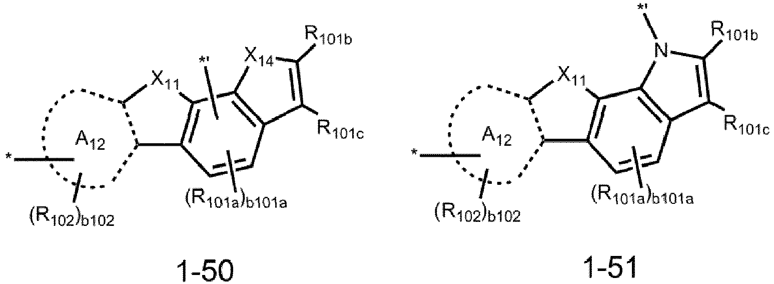 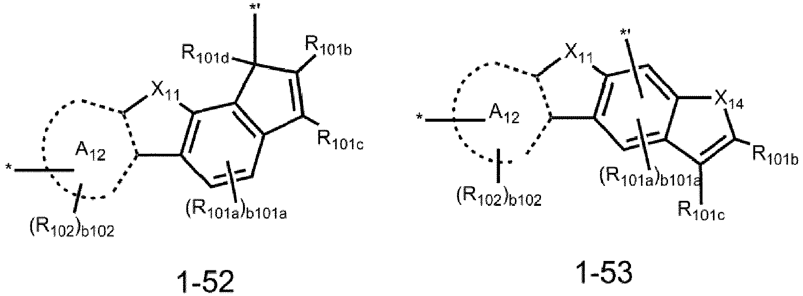 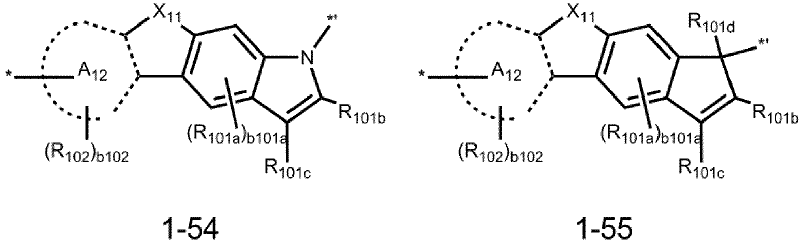 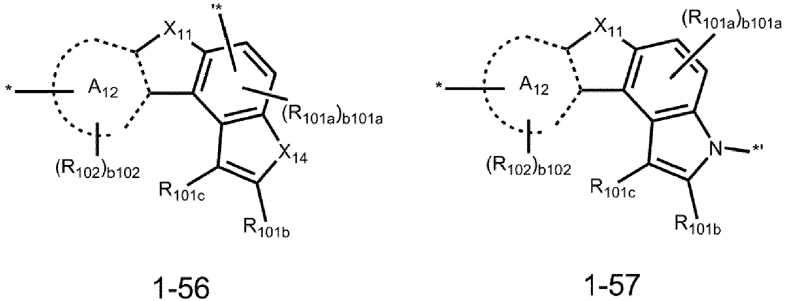 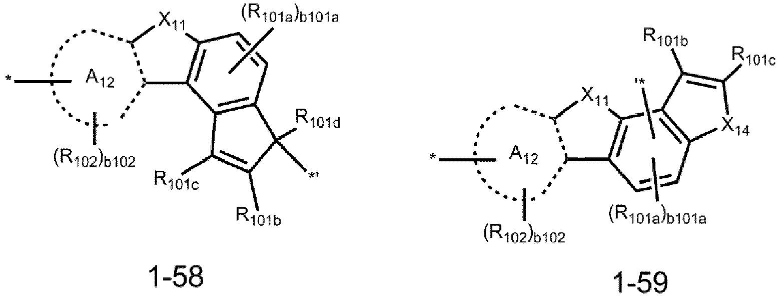 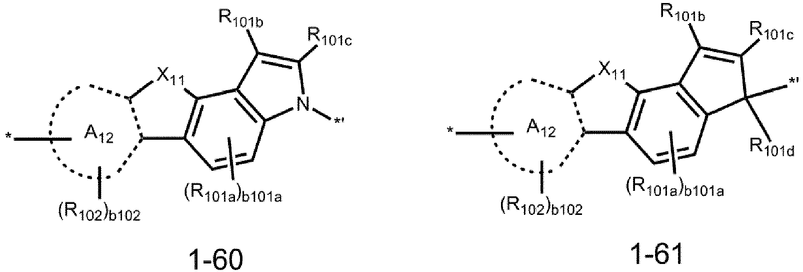 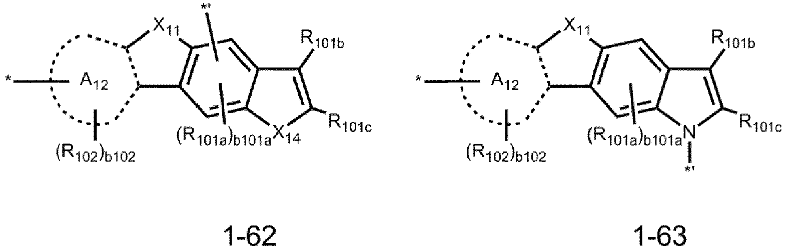 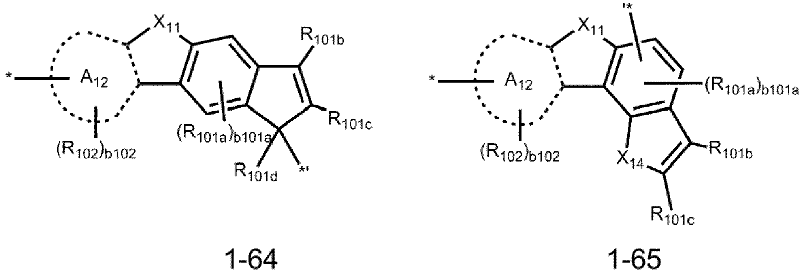 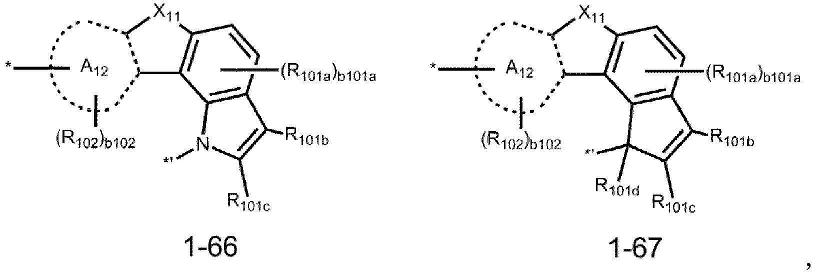 wherein, in Formulae 1-11 to 1-67,
A₁₁ and A₁₃ may each independently be selected from a benzene group, a naphthalene group, a pyridine group, a pyrimidine group, a pyrazine group, a quinoline group, an isoquinoline group, and a phenanthroline group,
X₁₁ may be selected from N[(L₁₃)ₐ₁₃-R₁₃], C[(L₁₃)ₐ₁₃-R₁₃][(L₁₄)ₐ₁₄R₁₄], O, and S,
X₁₄ may be selected from C(R_{101d})(R₁₀₁ₑ), N(R_{101d}), O, and S,
descriptions of L₁₃, L₁₄, a13, a14, R₁₃, R₁₄, R₁₀₁, R₁₀₂, b₁₀₁, and b102 are the same as those provided in connection with Formula 1,
descriptions of R₁₀₁ₐ, R_{101b}, R_{101c}, R_{101d}, and R₁₀₁ₑ are each independently the same as the description provided in connection with R₁₀₁ in Formula 1,
descriptions of bioia and b101b are each independently the same as the description provided in connection with b101 in Formula 1, and
^{∗} and ^{∗}' each independently indicate a binding site to a neighboring atom.

For example, a group represented by Formula 8-1 and a group represented by Formula 8-2 may each independently be selected from groups represented by Formulae 8-11 to 8-44, but are not limited thereto: 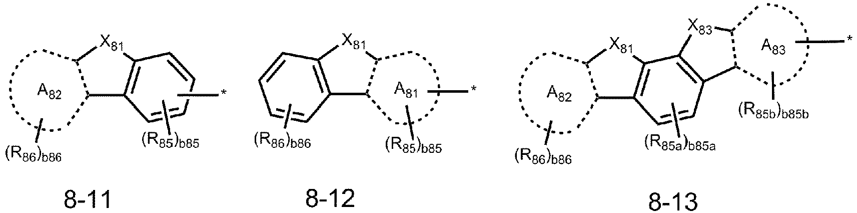 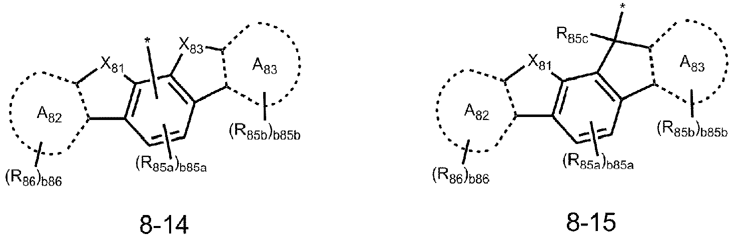 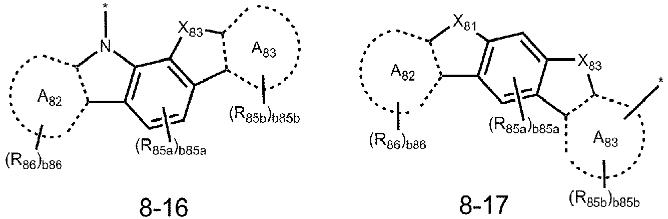 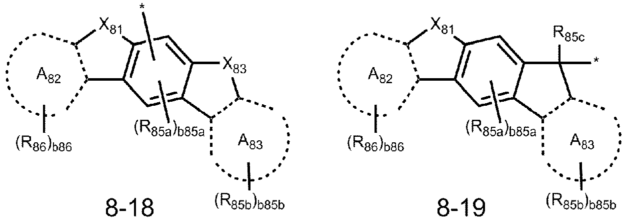 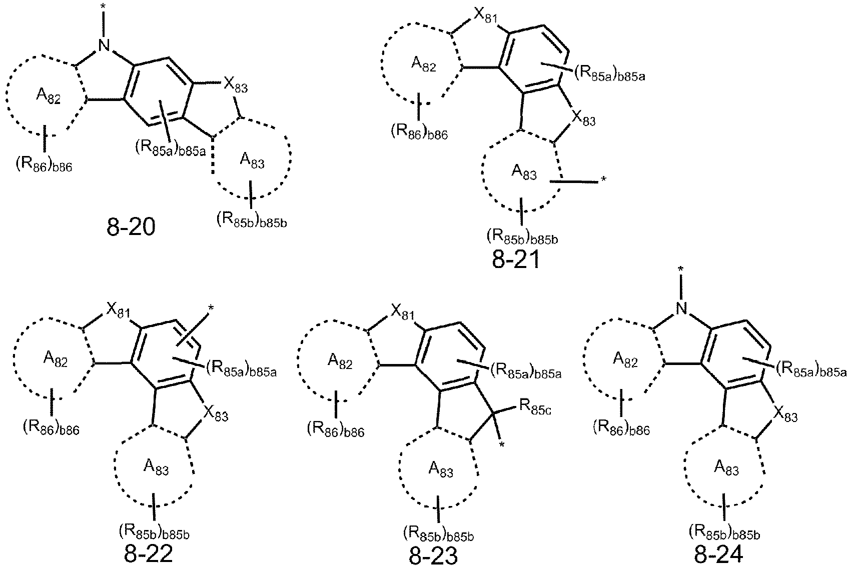 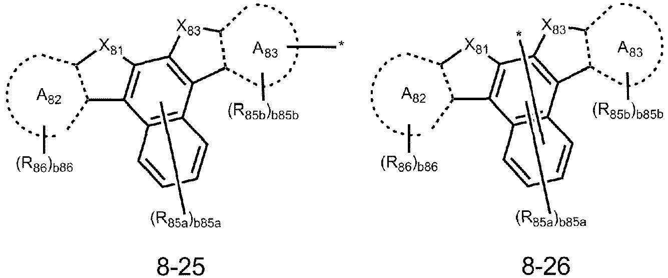 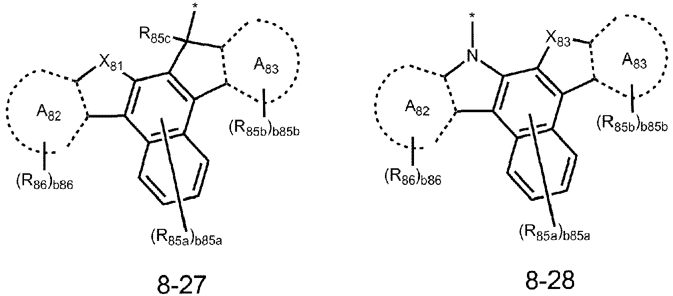 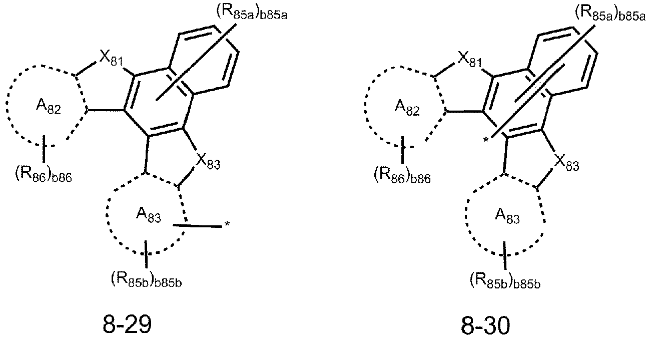 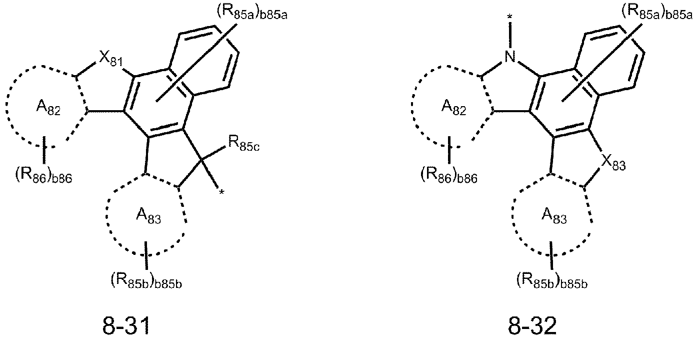 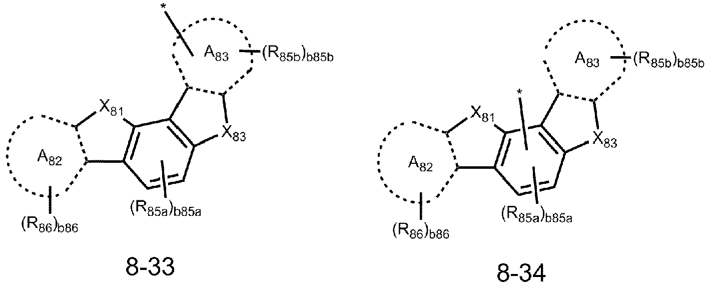 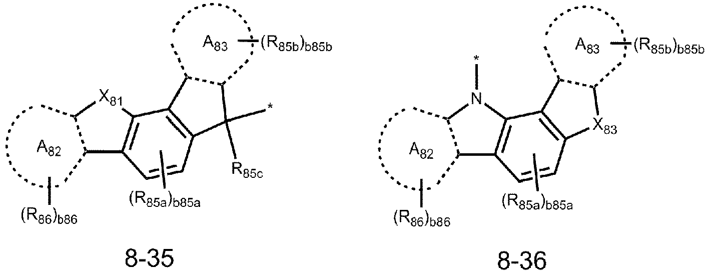 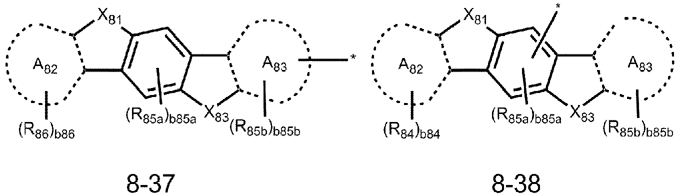 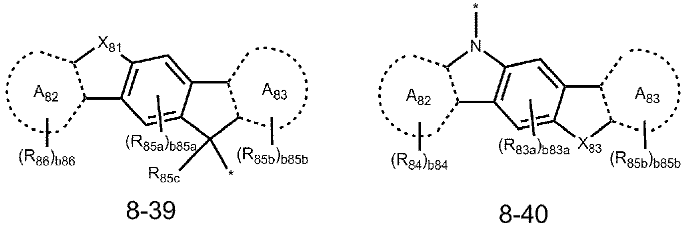 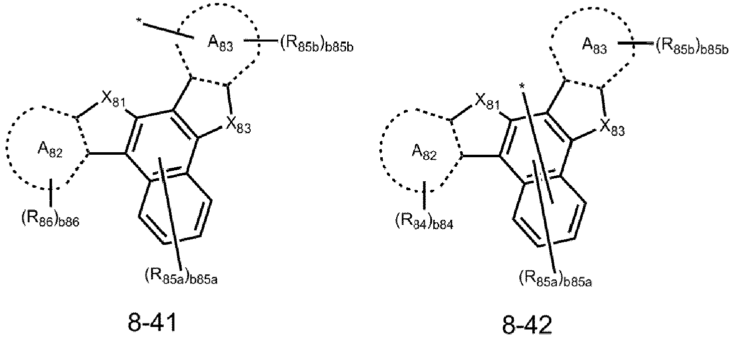 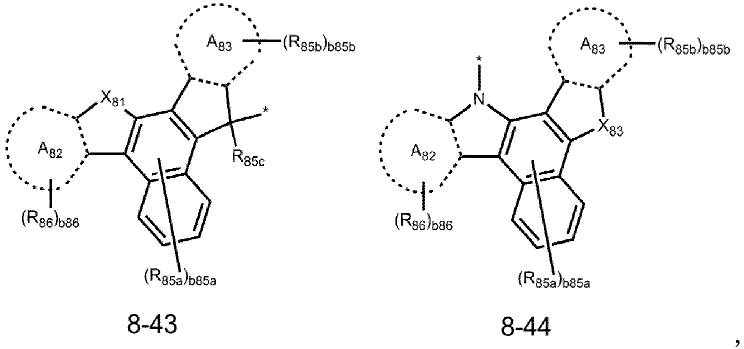 wherein, in Formulae 8-11 to 8-44,
A₈₁ and A₈₃ may each independently be selected from a benzene group, a naphthalene group, a pyridine group, a pyrimidine group, a pyrazine group, a quinoline group, an isoquinoline group, and a phenanthroline group,
X₈₁ may be selected from N[(L₈₁)ₐ₈₁-R₈₁], C[(L₈₁)ₐ₈₁-R₈₁][(L₈₂)ₐ₈₂-R₈₂], O, and S,
X₈₃ may be selected from C(R_{85c})(R_{85d}), N(R_{85c}), O, and S,
descriptions of L₈₁, L₈₂, a81, a82, R₈₁, R₈₂, B₈₅, B₈₆, b₈₅, and b86 are the same as those provided in connection with Formulae 8-1 and 8-2,
descriptions of R₈₅ₐ, R_{85b}, R_{85c}, and R_{85d} are each independently the same as the description provided in connection with R₈₅ in Formulae 8-1 and 8-2,
descriptions of b85a and b86b are each independently the same as the description provided in connection with b85 in Formula 8-1, and
^{∗} and ^{∗}' each independently indicate a binding site to a neighboring atom.

A₂₁ in Formula 2 is selected from a C₆-C₂₀ arene group and a C₁-C₂₀ heteroarene group.

For example, A₂₁ in Formula 2 may be selected from a benzene group, a naphthalene group, a phenanthrene group, an anthracene group, a pyridine group, a pyrazine group, a pyrimidine group, a triazine group, a quinoline group, an isoquinoline group, a quinoxaline group, and a quinazoline group, but is not limited thereto.

In various embodiments, A₂₁ in Formula 2 may be selected from a benzene group, a pyridine group, a pyrazine group, a pyrimidine group, and a triazine group, but is not limited thereto.

In Formula 2, X₂₁ is selected from N and C(R₂₁), X₂₂ is selected from N and C(R₂₂), X₂₃ is selected from N and C(R₂₃), X₂₄ is selected from N and C(R₂₄), and X₂₅ is selected from N and C(R₂₅), wherein at least one selected from X₂₁ to X₂₅ is N, and R₂₁ to R₂₅ are described below.

For example, in Formula 2, X₂₁ may be N, X₂₂ may be C(R₂₂), X₂₃ may be C(R₂₃), X₂₄ may be C(R₂₄), and X₂₅ may be C(R₂₅);
X₂₁ may be C(R₂₁), X₂₂ may be N, X₂₃ may be C(R₂₃), X₂₄ may be C(R₂₄), and X₂₅ may be C(R₂₅);
X₂₁ may be C(R₂₁), X₂₂ may be C(R₂₂), X₂₃ may be N, X₂₄ may be C(R₂₄), and X₂₅ may be C(R₂₅);
X₂₁ may be C(R₂₁), X₂₂ may be C(R₂₂), X₂₃ may be C(R₂₃), X₂₄ may be N, and X₂₅ may be C(R₂₅);
X₂₁ may be C(R₂₁), X₂₂ may be C(R₂₂), X₂₃ may be C(R₂₃), X₂₄ may be C(R₂₄), and X₂₅ may be N;
X₂₁ may be N, X₂₂ may be C(R₂₂), X₂₃ may be C(R₂₃), X₂₄ may be C(R₂₄), and X₂₅ may be N;
X₂₁ may be N, X₂₂ may be C(R₂₂), X₂₃ may be N, X₂₄ may be C(R₂₄), and X₂₅ may be C(R₂₅);
X₂₁ may be C(R₂₁), X₂₂ may be C(R₂₂), X₂₃ may be N, X₂₄ may be C(R₂₄), and X₂₅ may be N; or
X₂₁ may be N, X₂₂ may be C(R₂₂), X₂₃ may be N, X₂₄ may be C(R₂₄), and X₂₅ may be N, but embodiments are not limited thereto.

R₂₁ to R₂₆ in Formula 2 are each independently selected from a group represented by any of Formulae 9-1 to 9-3, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), -C(=O)(Q₁), - S(=O)2(Q₁), and -P(=O)(Q₁)(Q₂), and at least one selected from R₂₁ to R₂₆ is selected from the group represented by Formula 9-1 and the group represented by Formula 9-2,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

For example, R₂₁ to R₂₆ in Formula 2 may each independently be selected from the group consisting of:
a group represented by any of Formulae 9-1 to 9-3, hydrogen, a C₁-C₂₀ alkyl group, and a C₃-C₁₀ cycloalkyl group;
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group;
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each substituted with at least one substituent selected from a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each of which at least one substituent being substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and -Si(Q₂₁)(Q₂₂)(Q₂₃),

wherein Q₂₁ to Q₂₃ and Q₃₁ to Q₃₃ are each independently selected from a C₁-C₂₀ alkyl group and a C₆-C₃₀ aryl group, but embodiments are not limited thereto.

In various embodiments, R₂₁ to R₂₆ in Formula 2 may each independently be selected from the group consisting of:
a group represented by any of Formulae 9-1 to 9-3, hydrogen, a methyl group, an ethyl group, an n-propyl group, an iso-propyl group, an n-butyl group, an iso-butyl group, a sec-butyl group, a tert-butyl group, a cyclopentyl group, and a cyclohexyl group;
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, a benzoxazolyl group, a dibenzofuranyl group, a dibenzothiophenyl group, a carbazolyl group, a fluorenyl group, a spiro-cyclopentane-fluorenyl group, a spiro-bifluorenyl group, a benzonaphthofuranyl group, a benzonaphthothiophenyl group, a benzocarbazolyl group, and a benzofluorenyl group;
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, a benzoxazolyl group, a dibenzofuranyl group, a dibenzothiophenyl group, a carbazolyl group, a fluorenyl group, a spiro-cyclopentane-fluorenyl group, a spiro-bifluorenyl group, a benzonaphthofuranyl group, a benzonaphthothiophenyl group, a benzocarbazolyl group, and a benzofluorenyl group, each substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and - Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, a benzoxazolyl group, a dibenzofuranyl group, a dibenzothiophenyl group, a carbazolyl group, a fluorenyl group, a spiro-cyclopentane-fluorenyl group, a spiro-bifluorenyl group, a benzonaphtho furanyl group, a benzonaphthothiophenyl group, a benzocarbazolyl group, and a benzofluorenyl group, each substituted with at least one substituent selected from a phenyl group, a biphenyl group, a terphenyl group, a naphthyl group, a pyridinyl group, a pyrimidinyl group, a pyridazinyl group, and a triazinyl group, each of which at least one substituent being substituted with at least one selected from deuterium, -F, -Cl, - Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, - N(Q₂₁)(Q₂₂), and -Si(Q₂₁)(Q₂₂)(Q₂₃),
wherein Q₂₁ to Q₂₃ and Q₃₁ to Q₃₃ may each independently be selected from a methyl group, an ethyl group, a phenyl group, a biphenyl group, a terphenyl group, and a naphthyl group, but embodiments are not limited thereto.

In various embodiments, R₂₁ to R₂₆ in Formula 2 may each independently be selected from a group represented by any of Formulae 9-1 to 9-3, hydrogen, a methyl group, an ethyl group, an n-propyl group, an iso-propyl group, an n-butyl group, an iso-butyl group, a sec-butyl group, a tert-butyl group, a cyclopentyl group, a cyclohexyl group, and a group represented by any of Formulae 5-1 to 5-79, but are not limited thereto: 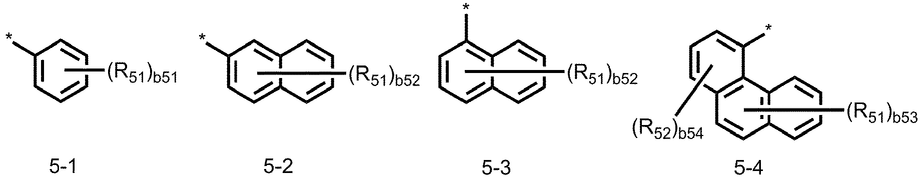 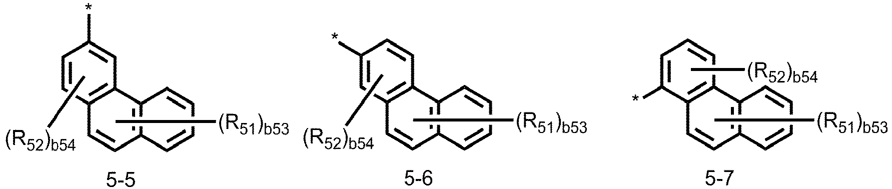 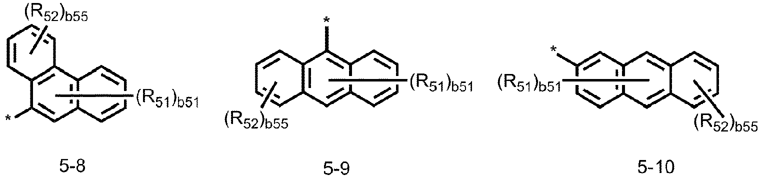 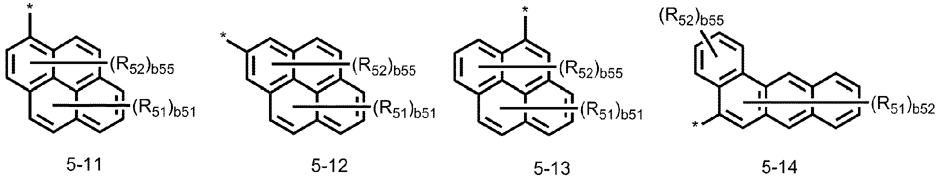 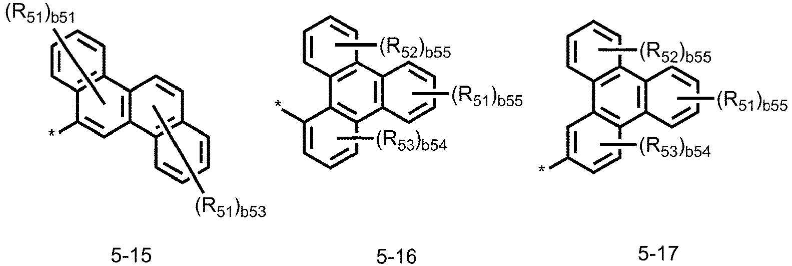 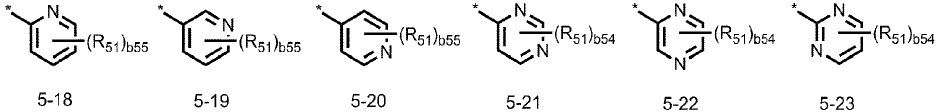 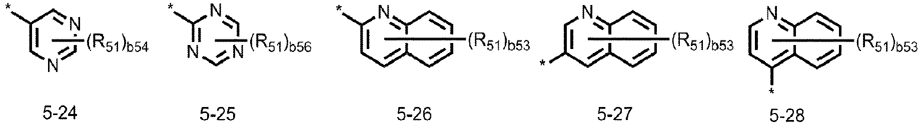 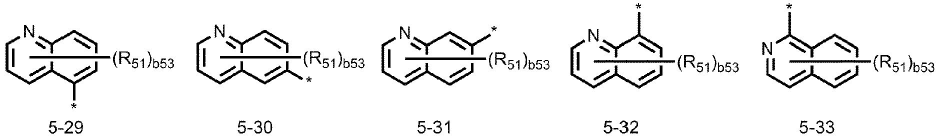 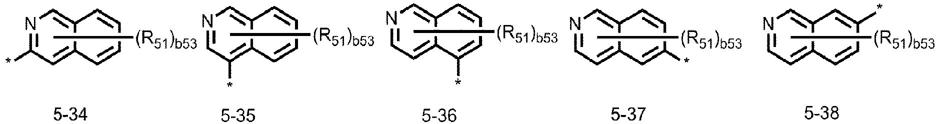 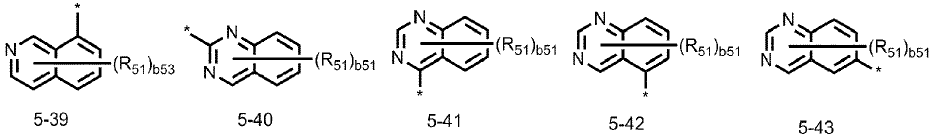 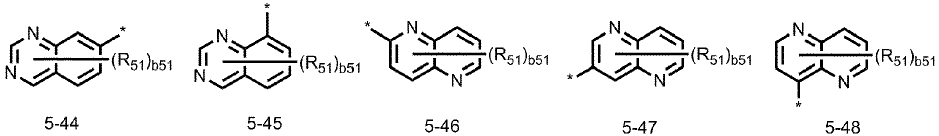 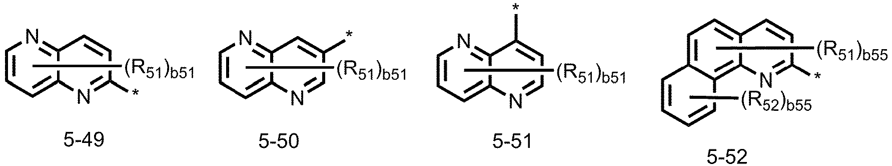 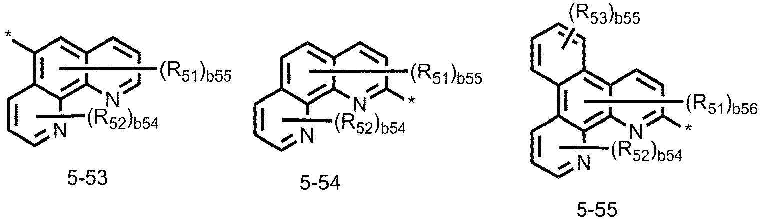 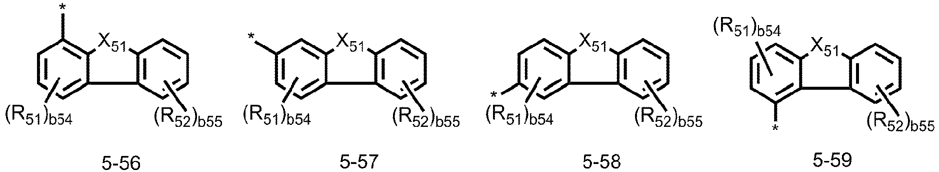 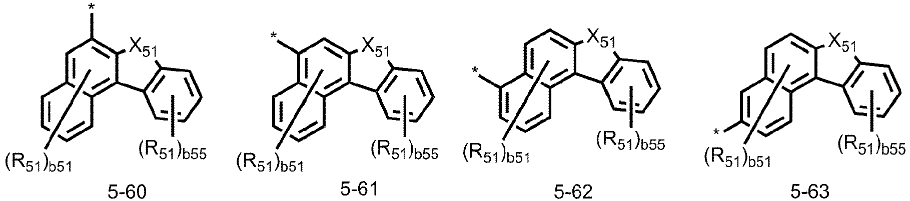 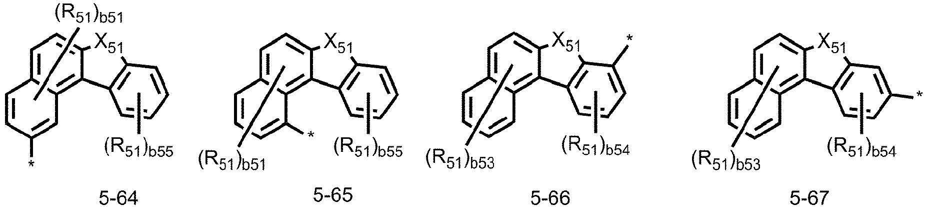 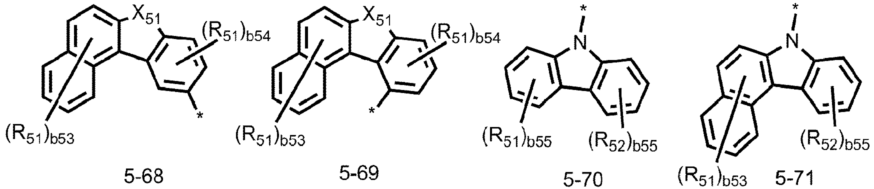 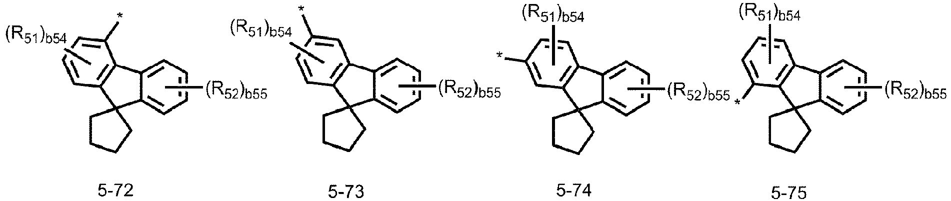 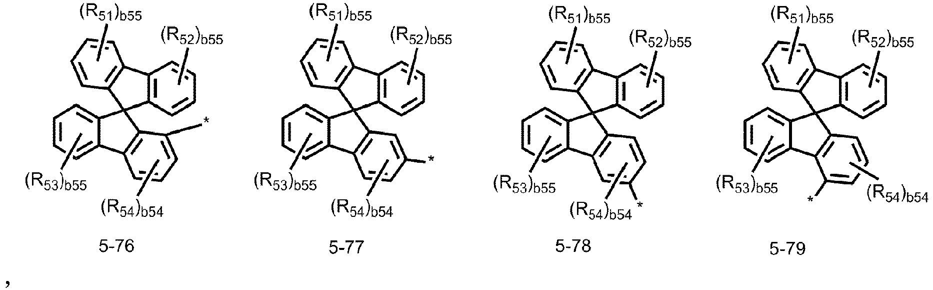 wherein, in Formulae 5-1 to 5-79,
X₅₁ may be selected from N(R₅₅), C(R₅₅)(R₅₆), O, and S,
R₅₁ to R₅₆ may each independently be selected from the group consisting of:
   hydrogen, deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
   a phenyl group, a biphenyl group, a terphenyl group, a naphthyl group, a pyridinyl group, a pyrimidinyl group, a pyridazinyl group, and a triazinyl group, each substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and - Si(Q₂₁)(Q₂₂)(Q₂₃),
   wherein Q₂₁ to Q₂₃ and Q₃₁ to Q₃₃ may each independently be selected from a methyl group, an ethyl group, a phenyl group, a biphenyl group, a terphenyl group, and a naphthyl group,
   b51 may be selected from 1, 2, 3, 4, and 5,
   b52 may be selected from 1, 2, 3, 4, 5, 6, and 7,
   b53 may be selected from 1, 2, 3, 4, 5, and 6,
   b54 may be selected from 1, 2, and 3,
   b55 may be selected from 1, 2, 3, and 4,
   b56 may be 1 or 2, and
   ^{∗} indicates a binding site to a neighboring atom.

b26 in Formula 2 indicates the number of R₂₆(s), and b26 is selected from 1, 2, 3, 4, 5, and 6. When b26 is two or more, a plurality of R₂₆(s) may be identical to or different from each other.

L₉₁ in Formula 9-1 is selected from a C₆-C₆₀ arylene group and a C₁-C₆₀ heteroarylene group, each substituted with a C₁-C₆₀ alkyl group and a C₃-C₁₀ cycloalkyl group.

For example, L₉₁ in Formula 9-1 may be selected from a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from a C₁-C₂₀ alkyl group, a cyclopentyl group, a cyclohexyl group, and a cycloheptyl group, but is not limited thereto.

In various embodiments, L₉₁ in Formula 9-1 may be selected from a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group, each substituted with at least one selected from a methyl group, an ethyl group, an n-propyl group, an iso-propyl group, an n-butyl group, an iso-butyl group, a sec-butyl group, a tert-butyl group, a cyclopentyl group, a cyclohexyl group, and a cycloheptyl group, but is not limited thereto.

In various embodiments, L₉₁ in Formula 9-1 may be selected from groups represented by Formulae 3-1 to 3-13 and 3-16 to 3-163: 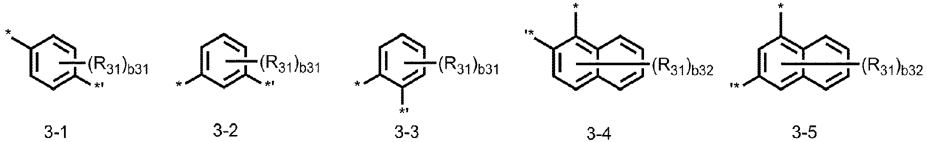 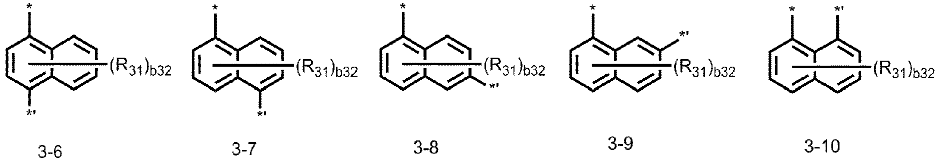 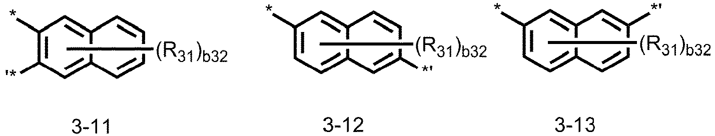 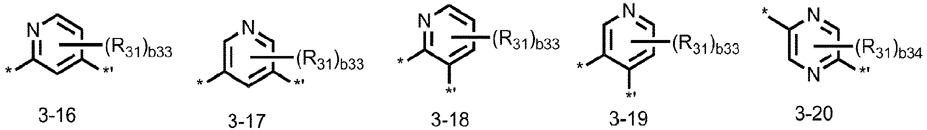 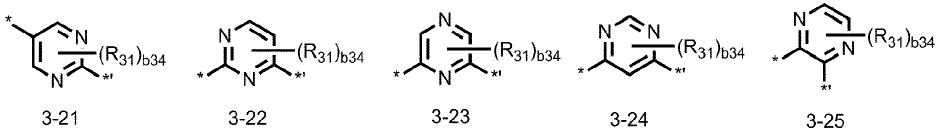 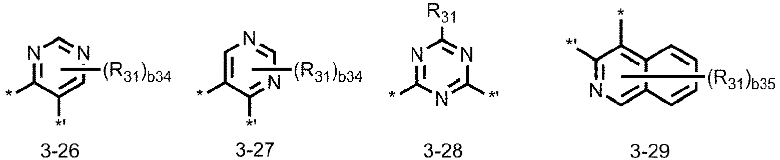 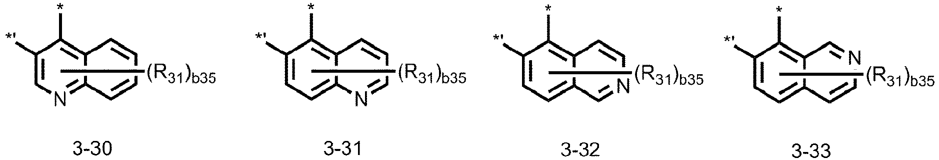 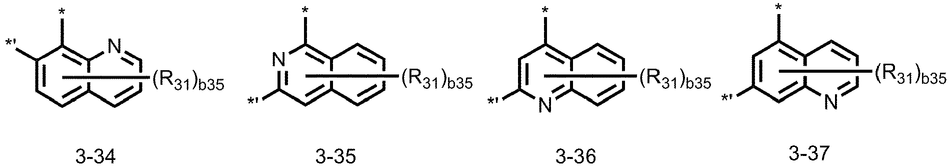 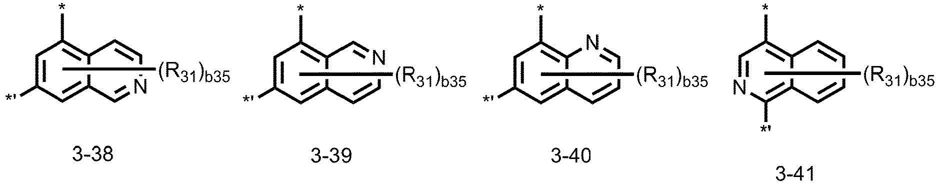 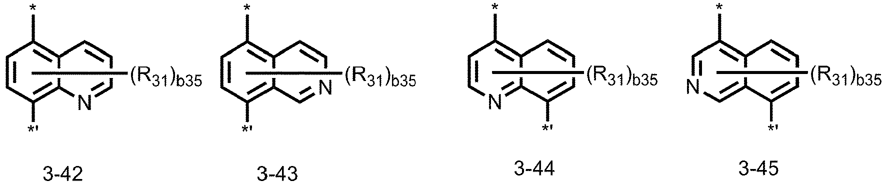 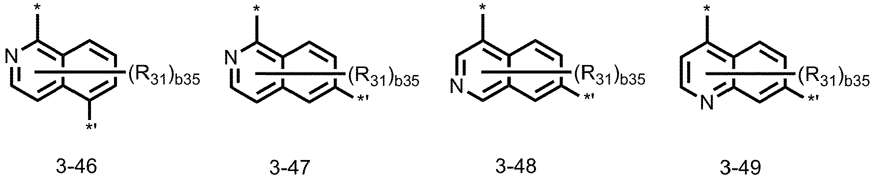 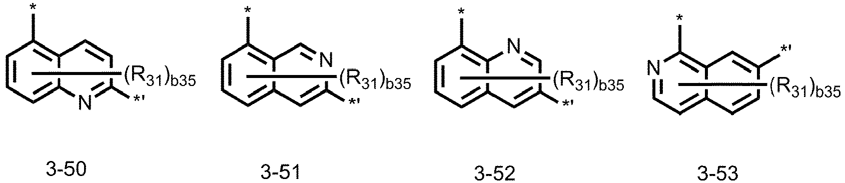 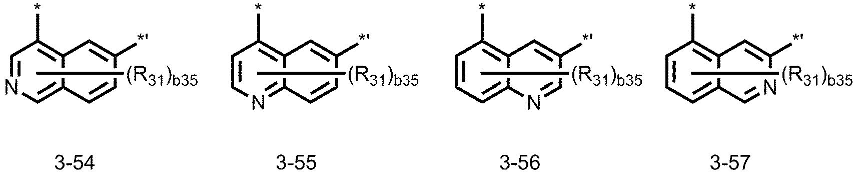 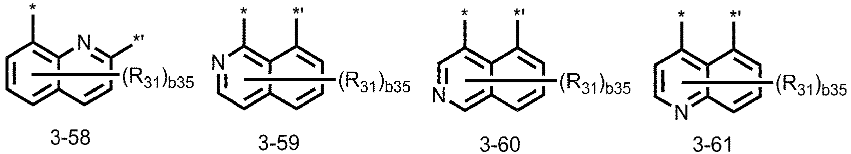 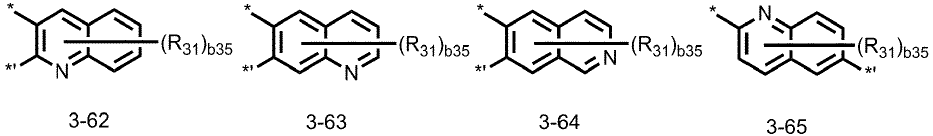 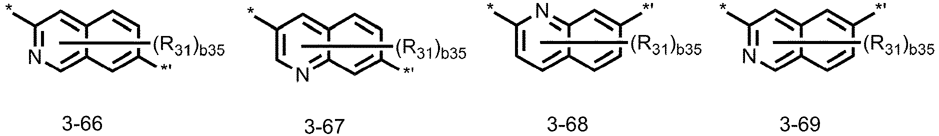 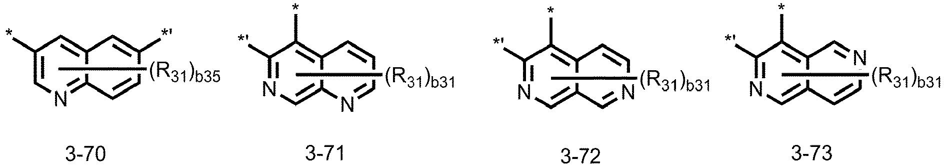 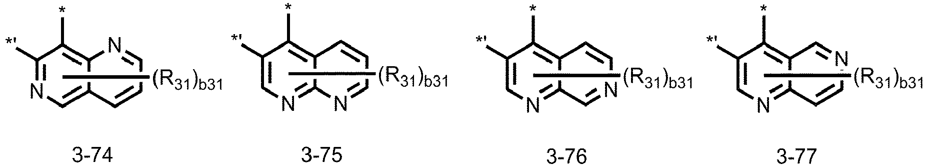 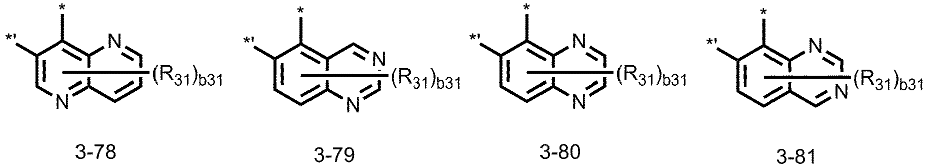 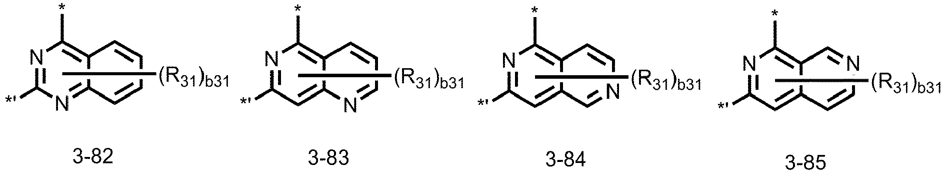 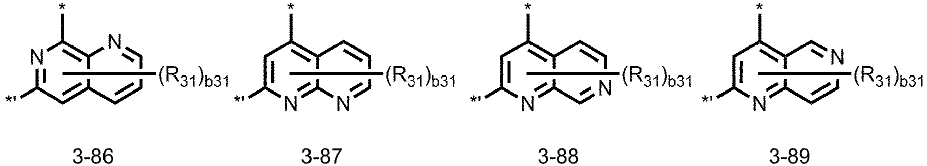 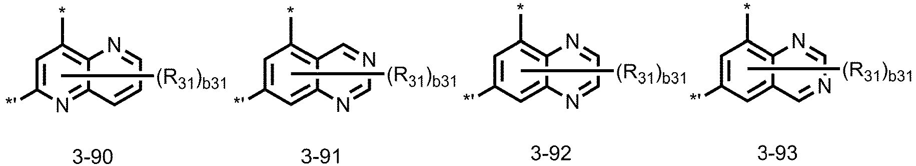 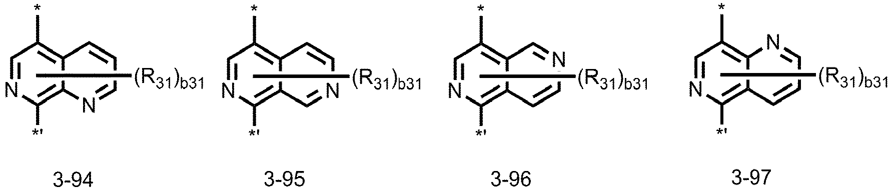 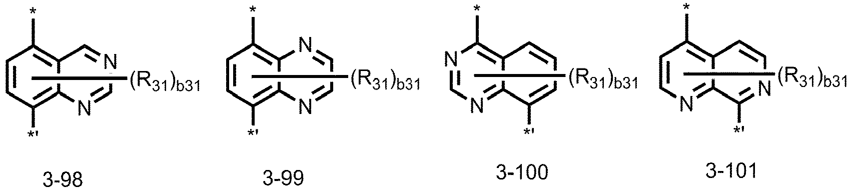 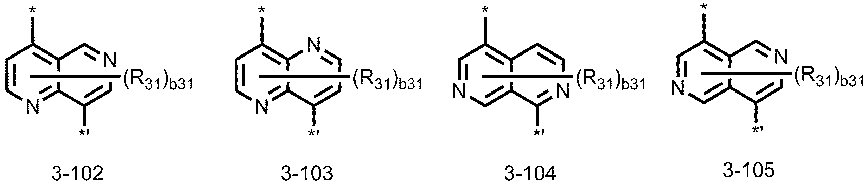 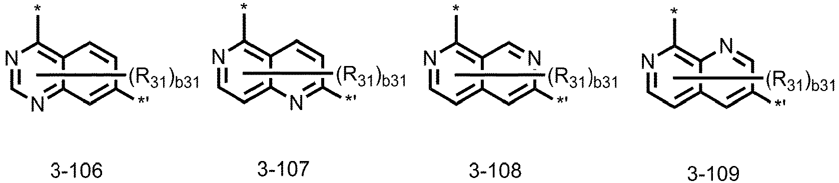 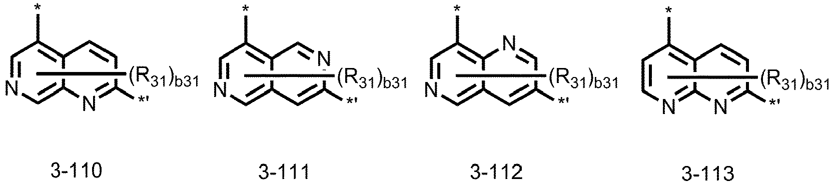 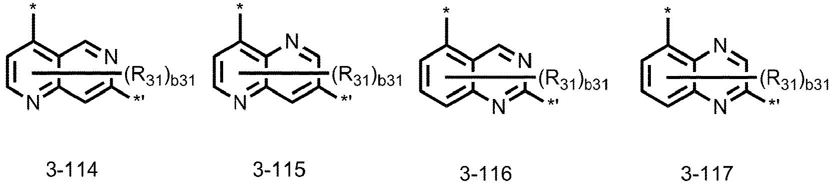 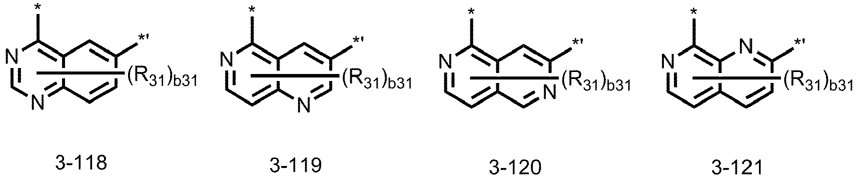 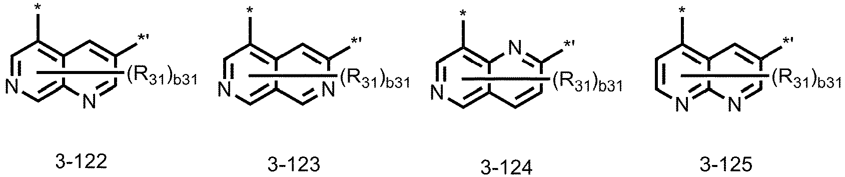 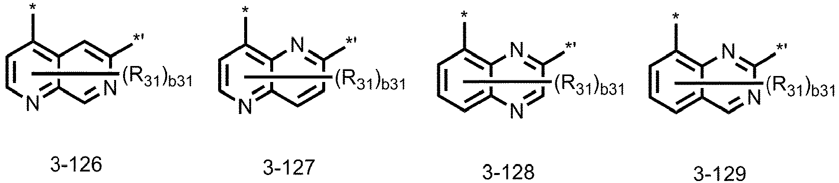 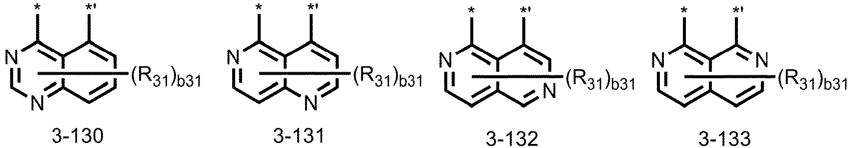 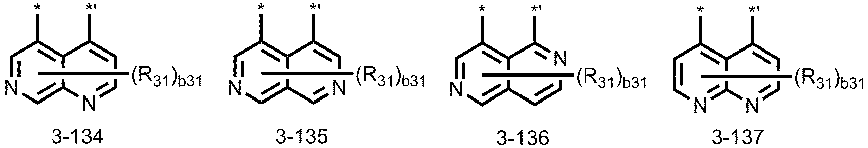 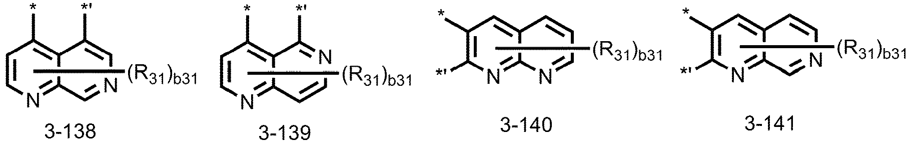 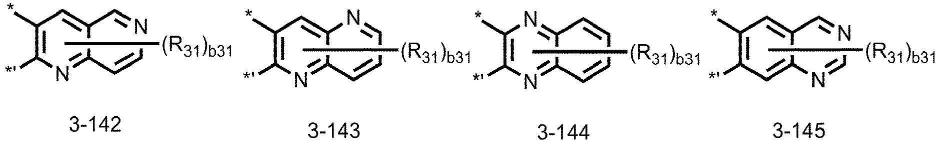 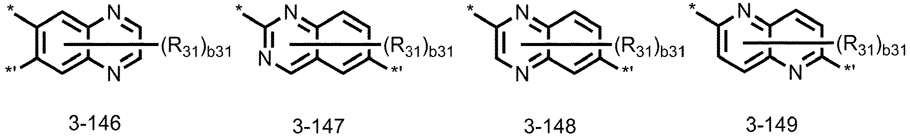 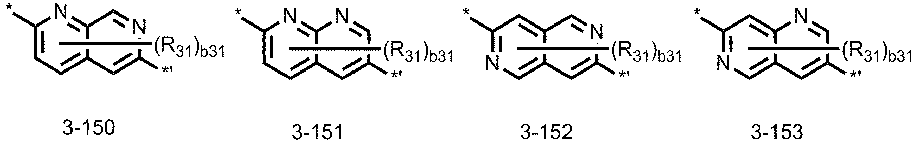 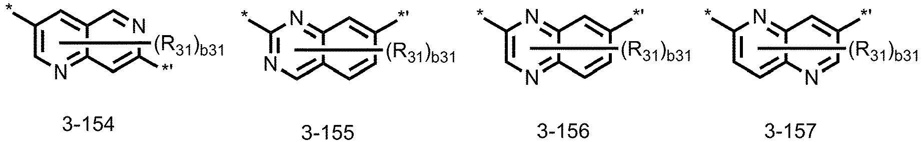 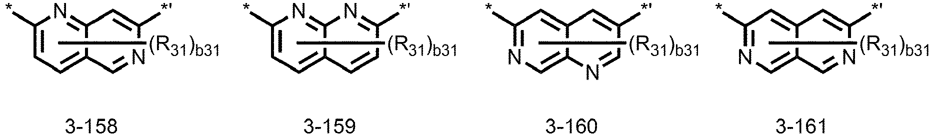 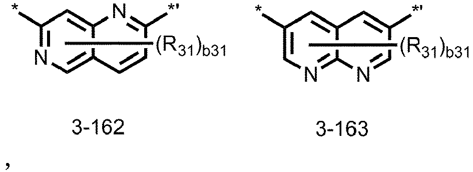 wherein, in Formulae 3-1 to 3-13 and 3-16 to 3-163,
R₃₁ may be selected from a methyl group, an ethyl group, an n-propyl group, an iso-propyl group, an n-butyl group, an iso-butyl group, a sec-butyl group, a tert-butyl group, a cyclopentyl group, a cyclohexyl group, and a cycloheptyl group,
b31 may be selected from 1, 2, 3, and 4,
b32 may be selected from 1, 2, 3, 4, 5, and 6,
b33 may be selected from 1, 2, and 3,
b34 may be selected from 1 and 2,
b35 may be selected from 1, 2, 3, 4, and 5, and
^{∗} and ^{∗}' each independently indicate a binding site to a neighboring atom.

L₉₂ and L₉₃ in Formulae 9-2 and 9-3 are each independently selected from a substituted or unsubstituted C₆-C₆₀ arylene group and a substituted or unsubstituted C₁-C₆₀ heteroarylene group.

For example, L₉₂ and L₉₃ in Formulae 9-2 and 9-3 may each independently be selected from the group consisting of:
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group;
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)2(Q₃₁), and - P(=O)(Q₃₁)(Q₃₂); and
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one substituent selected from a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each of which at least one substituent being substituted with at least one selected from deuterium, -F, -Cl, -Br, -I, a cyano group, a C₁-C₂₀ alkyl group, and a C₁-C₂₀ alkoxy group,
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group, but embodiments are not limited thereto.

In various embodiments, L₉₂ and L₉₃ in Formulae 9-2 and 9-3 may each independently be selected from the group consisting of:
a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group;
a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group, each substituted with at least one selected from deuterium, -F, -Cl, -Br, -I, a cyano group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, a triazinyl group, -Si(Q₃₁)(Q₃₂)(Q₃₃), -N(Q₃₁)(Q₃₂), -B(Q₃₁)(Q₃₂), - C(=O)(Q₃₁), -S(=O)2(Q₃₁), and -P(=O)(Q₃₁)(Q₃₂); and
a phenylene group, a naphthylene group, a pyridinylene group, a pyrazinylene group, a pyrimidinylene group, a quinolinylene group, an isoquinolinylene group, a naphthyridinylene group, a quinoxalinylene group, and a triazinylene group, each substituted with at least one substituent selected from a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, and a triazinyl group, each of which at least one substituent being substituted with at least one selected from deuterium, -F, - Cl, -Br, -I, a cyano group, a C₁-C₂₀ alkyl group, and a C₁₋C₂₀ alkoxy group,
wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group, but embodiments are not limited thereto.

In various embodiments, L₉₂ and L₉₃ in Formulae 9-2 and 9-3 may each independently be selected from groups represented by Formulae 3-1 to 3-13 and 3-16 to 3-163,
wherein, in Formulae 3-1 to 3-13 and 3-16 to 3-163,
R₃₁ may be selected from the group consisting of:
   hydrogen, deuterium, -F, -Cl, -Br, -I, a cyano group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, a triazinyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂); and
   a phenyl group, a naphthyl group, a pyridinyl group, a pyrazinyl group, a pyrimidinyl group, a quinolinyl group, an isoquinolinyl group, a naphthyridinyl group, a quinoxalinyl group, and a triazinyl group, each substituted with at least one substituent selected from a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a dibenzofuranyl group, a dibenzothiophenyl group, a carbazolyl group, and a triazinyl group, each of which at least one substituent being substituted with at least one selected from deuterium, -F, -Cl, -Br, -I, a cyano group, a C₁-C₂₀ alkyl group and a C₁-C₂₀ alkoxy group,
   wherein Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group,
   b31 may be selected from 1, 2, 3, and 4,
   b32 may be selected from 1, 2, 3, 4, 5, and 6,
   b33 may be selected from 1, 2, and 3,
   b34 may be selected from 1 and 2,
   b35 may be selected from 1, 2, 3, 4, and 5, and
   ^{∗} and ^{∗}' each independently indicate a binding site to a neighboring atom, but embodiments are not limited thereto.

a91 in Formula 9-1 indicates the number of L₉₁(s), and a91 is selected from 1 and 2. When a91 is two, two L₉₁(s) may be identical to or different from each other.

a92 and a93 in Formulae 9-2 and 9-3 are each independently selected from 0, 1, and 2. When a92 is zero, (L₉₂)ₐ₉₂ indicates a single bond, when a92 is two, two L₉₂(s) are identical to or different from each other. Description of a93 may be the same as the description of a92.

R₉₁ and R₉₃ in Formulae 9-1 and 9-3 are each independently selected from a substituted or unsubstituted C₆-C₆₀ aryl group and a substituted or unsubstituted C₁-C₆₀ heteroaryl group.

For example, R₉₁ and R₉₃ in Formulae 9-1 and 9-3 may each independently be selected from the group consisting of:
a C₆-C₃₀ aryl group and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one substituent selected from a C₆-C₃₀ aryl group and a C₁-C₃₀ heteroaryl group, each of which at least one substituent being substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₂₁)(Q₂₂), and - Si(Q₂₁)(Q₂₂)(Q₂₃),
wherein Q₂₁ to Q₂₃ and Q₃₁ to Q₃₃ may each independently be selected from a C₁-C₂₀ alkyl group and a C₆-C₃₀ aryl group, but embodiments are not limited thereto.

In various embodiments, R₉₁ and R₉₃ in Formulae 9-1 and 9-3 may each independently be selected from the group consisting of:
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group;
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, -N(Q₃₁)(Q₃₂), and -Si(Q₃₁)(Q₃₂)(Q₃₃); and
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one substituent selected from a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each of which at least one substituent being substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, -N(Q₂₁)(Q₂₂), and -Si(Q₂₁)(Q₂₂)(Q₂₃),
wherein Q₂₁ to Q₂₃ and Q₃₁ to Q₃₃ may each independently be selected from a phenyl group, a biphenyl group, a terphenyl group, and a naphthyl group, but are not limited thereto.

In various embodiments, R₉₁ and R₉₃ in Formulae 9-1 and 9-3 may each independently be selected from groups represented by Formulae 5-1 to 5-55,
wherein, in Formulae 5-1 to 5-55,
R₅₁ to R₅₃ may each independently be selected from the group consisting of:
   hydrogen, deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, -N(Q₃₁)(Q₃₂), and -Si(Q₃₁)(Q₃₂)(Q₃₃); and
   a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from deuterium, -F, -Cl, -Br, -I, a C₁-C₂₀ alkyl group, a phenyl group, a biphenyl group, a terphenyl group, a naphthyl group, a pyridinyl group, a pyrazinyl group, a pyrimidinyl group, a triazinyl group, -N(Q₂₁)(Q₂₂), and -Si(Q₂₁)(Q₂₂)(Q₂₃),
   wherein Q₂₁ to Q₂₃ and Q₃₁ to Q₃₃ may each independently be selected from a phenyl group, a biphenyl group, a terphenyl group, and a naphthyl group,
   b51 may be selected from 1, 2, 3, 4, and 5,
   b52 may be selected from 1, 2, 3, 4, 5, 6, and 7,
   b53 may be selected from 1, 2, 3, 4, 5, and 6,
   b54 may be selected from 1, 2, and 3,
   b55 may be selected from 1, 2, 3, and 4,
   b56 may be 1 or 2, and
   ^{∗} indicates a binding site to a neighboring atom, but embodiments are not limited thereto.

R₉₂ in Formula 9-2 is selected from a C₆-C₆₀ aryl group and a C₁-C₆₀ heteroaryl group, each substituted with at least one selected from a C₁-C₆₀ alkyl group and a C₃-C₁₀ cycloalkyl group.

For example, R₉₂ in Formula 9-2 may be selected from the group consisting of:
a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from a C₁-C₂₀ alkyl group, a cyclopentyl group, a cyclohexyl group, and a cycloheptyl group, but is not limited thereto.

In various embodiments, R₉₂ in Formula 9-2 may be selected from a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from a methyl group, an ethyl group, an n-propyl group, an iso-propyl group, an n-butyl group, an iso-butyl group, a sec-butyl group, a tert-butyl group, a cyclopentyl group, a cyclohexyl group, and a cycloheptyl group, but is not limited thereto.

In various embodiments, R₉₂ in Formula 9-2 may be selected from groups represented by Formulae 5-1 to 5-55,
wherein, in Formulae 5-1 to 5-55,
R₅₁ to R₅₃ may each independently be selected from a methyl group, an ethyl group, an n-propyl group, an iso-propyl group, an n-butyl group, an iso-butyl group, a sec-butyl group, a tert-butyl group, a cyclopentyl group, a cyclohexyl group, and a cycloheptyl group,
b51 may be selected from 1, 2, 3, 4, and 5,
b52 may be selected from 1, 2, 3, 4, 5, 6, and 7,
b53 may be selected from 1, 2, 3, 4, 5, and 6,
b54 may be selected from 1, 2, and 3,
b55 may be selected from 1, 2, 3, and 4,
b56 may be 1 or 2, and
^{∗} indicates a binding site to a neighboring atom, but embodiments are not limited thereto.

For example, the second compound represented by Formula 2 may be represented by Formula 2-1, but is not limited thereto:

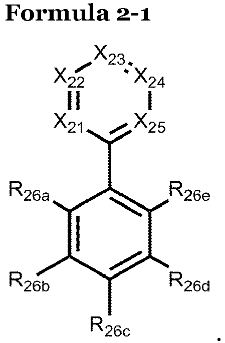

In Formula 2-1,
X₂₁ may be selected from N and C(R₂₁), X₂₂ may be selected from N and C(R₂₂), X₂₃ may be selected from N and C(R₂₃), X₂₄ may be selected from N and C(R₂₄), and X₂₅ may be selected from N and C(R₂₅), wherein at least one selected from X₂₁ to X₂₅ may be N,
R₂₁ to R₂₅ and R₂₆ₐ to R₂₆ₑ may each independently be selected from a group represented by any of Formulae 9-1 to 9-3, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂), and at least one selected from R₂₁ to R₂₅ and R₂₆ₐ to R₂₆ₑ may be selected from the group represented by Formula 9-1 and the group represented by Formula 9-2,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

In various embodiments, the second compound represented by Formula 2 may be represented by one selected from Formulae 2-11 to 2-22, but is not limited thereto: 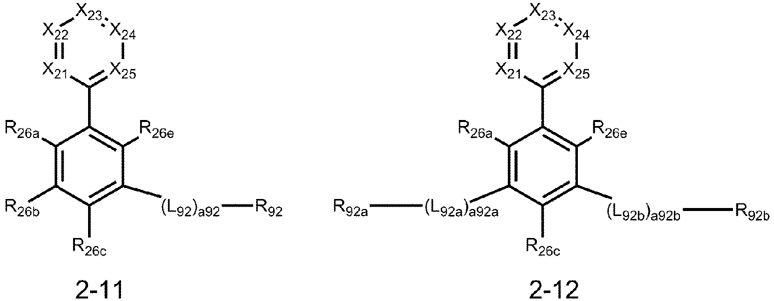 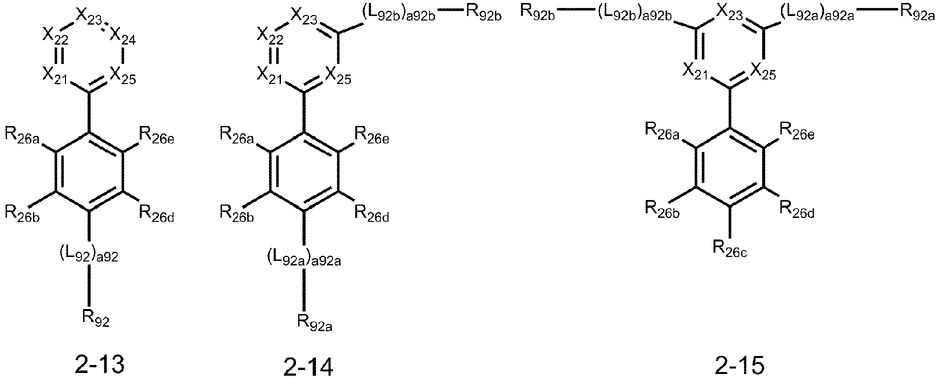 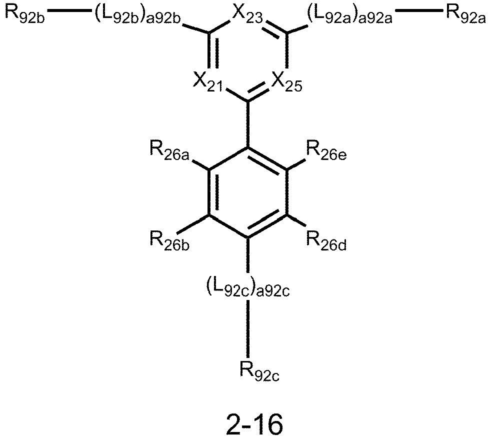 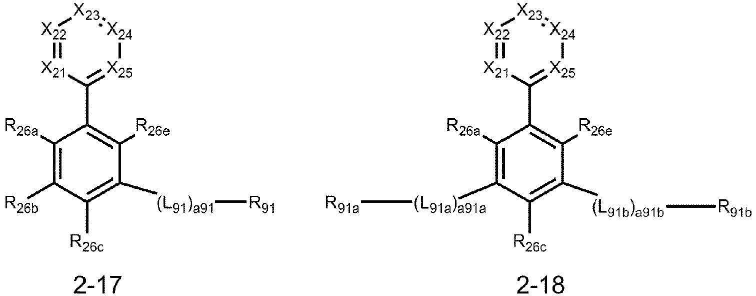 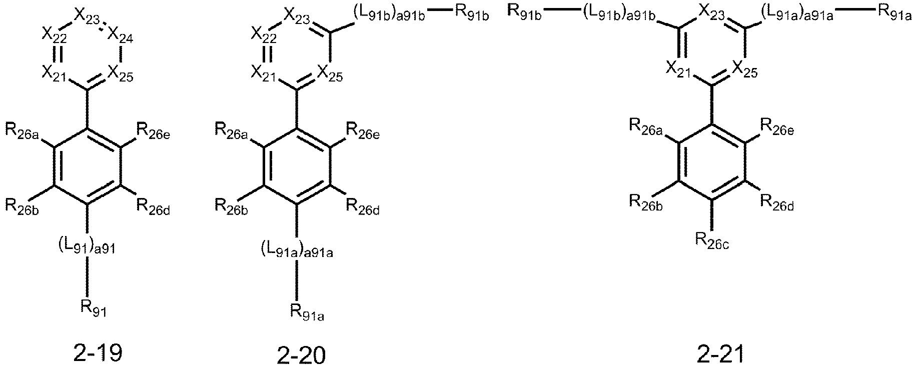 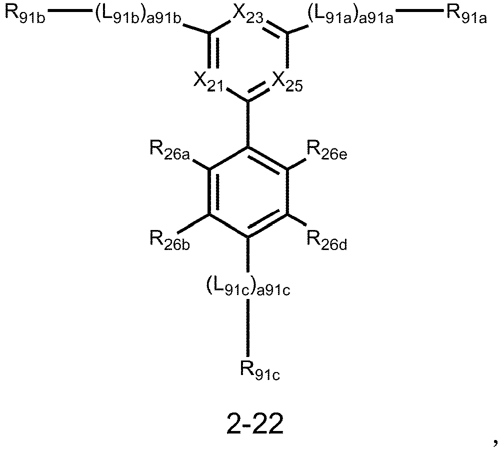 wherein, in Formulae 2-11 to 2-22,
X₂₁ may be selected from N and C(R₂₁), X₂₂ may be selected from N and C(R₂₂), X₂₃ may be selected from N and C(R₂₃), X₂₄ may be selected from N and C(R₂₄), and X₂₅ may be selected from N and C(R₂₅), wherein at least one selected from X₂₁ to X₂₅ may be N,
R₂₁ to R₂₅ and R₂₆ₐ to R₂₆ₑ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂),
L₉₁, L₉₁ₐ, L_{91b}, and L_{91c} may each independently be selected from a C₆-C₆₀ arylene group and a C₁-C₆₀ heteroarylene group, each substituted with at least one selected from a C₁-C₆₀ alkyl group and a C₃-C₁₀ cycloalkyl group,
L₉₂, L₉₂ₐ, L_{92b}, and L_{92c} may each independently be selected from a substituted or unsubstituted C₆-C₆₀ arylene group and a substituted or unsubstituted C₁-C₆₀ heteroarylene group,
a91, a91a, a91b, and a91c may each independently be selected from 1 and 2,
a92, a92a, a92b, and a92c may each independently be selected from 0, 1, and 2,
R₉₁, R₉₁ₐ, R_{91b}, and R_{91c} may each independently be selected from a substituted or unsubstituted C₆-C₆₀ aryl group and a substituted or unsubstituted C₁-C₆₀ heteroaryl group, and
R₉₂, R₉₂ₐ, R_{92b}, and R_{92c} may each independently be selected from a C₆-C₆₀ aryl group and a C₁-C₆₀ heteroaryl group, each substituted with at least one selected from a C₁-C₆₀ alkyl group and a C₃-C₁₀ cycloalkyl group,
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

The first compound represented by Formula 1 may be represented by any of Compounds 1-1 to 1-380, but is not limited thereto:

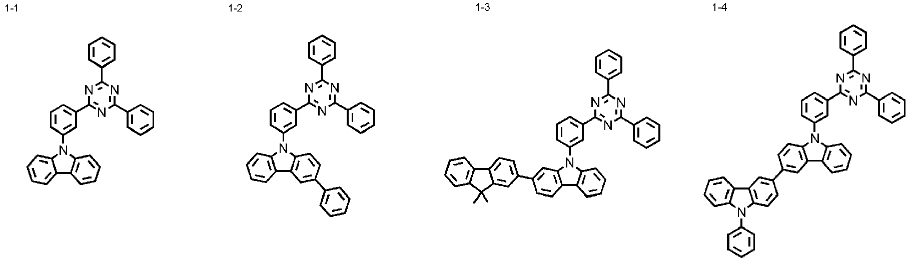

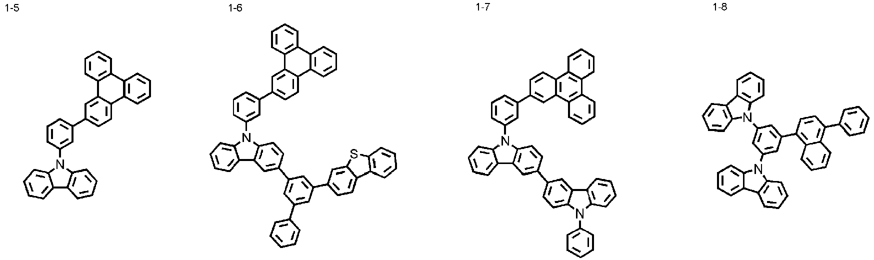

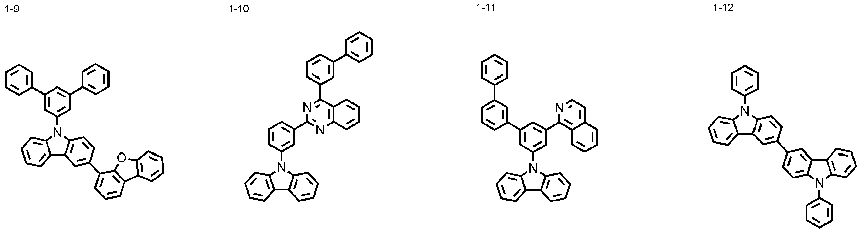

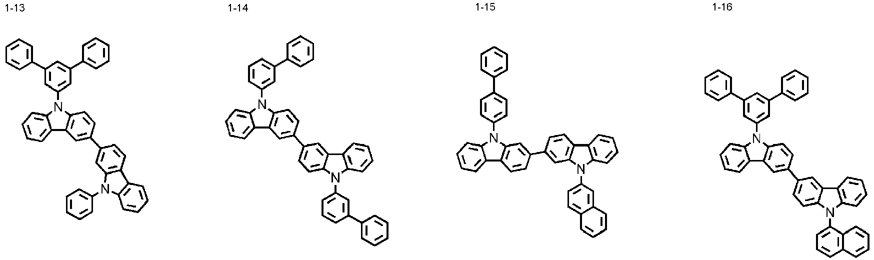

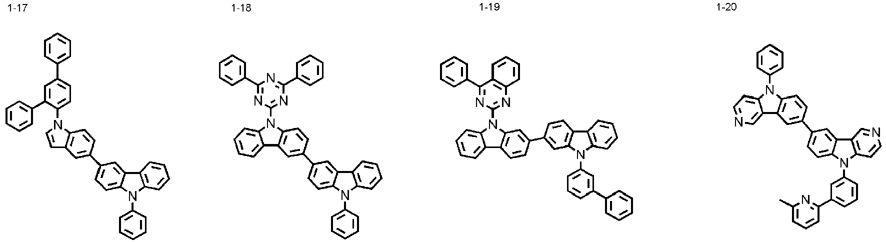

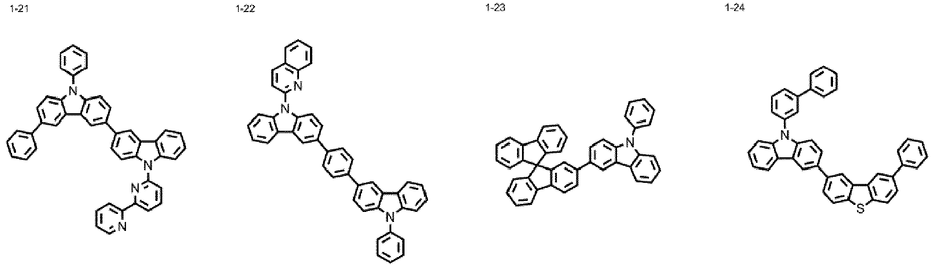

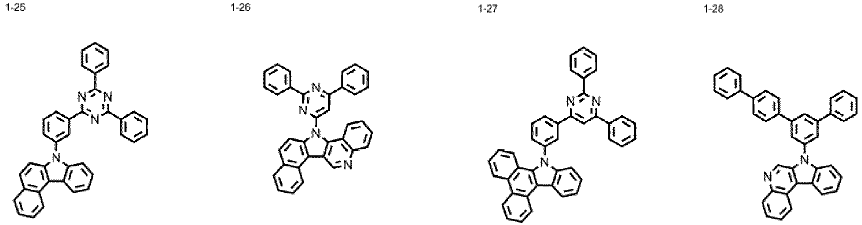

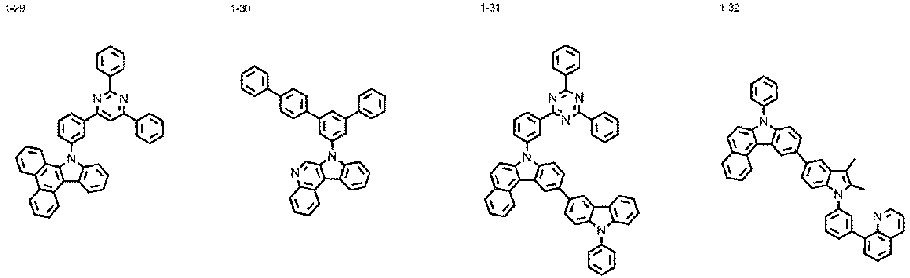

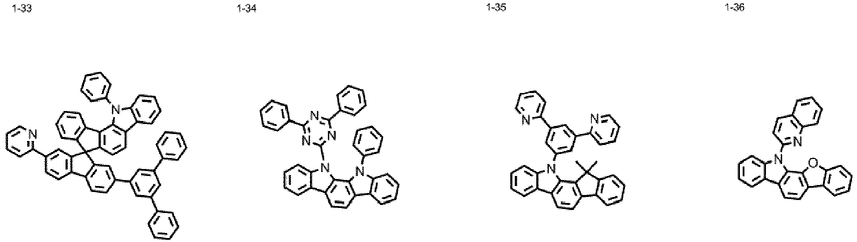

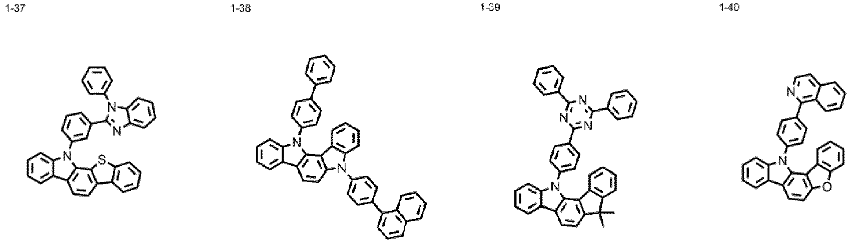

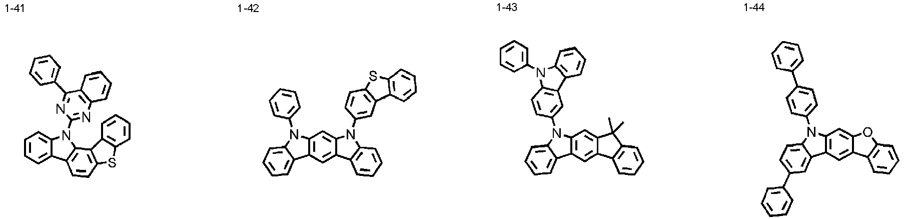

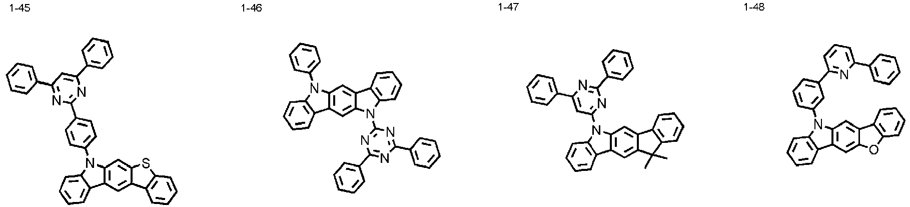

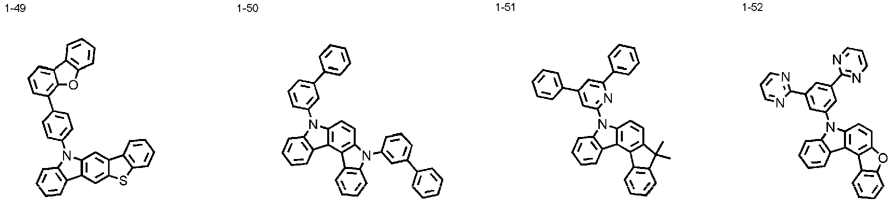

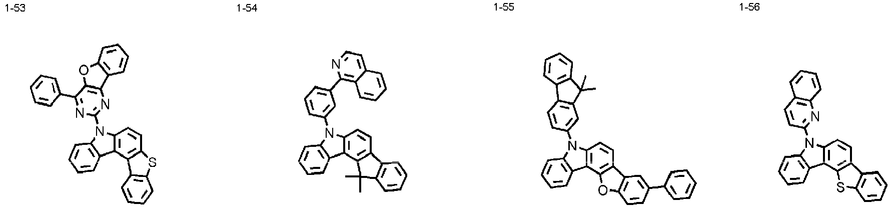

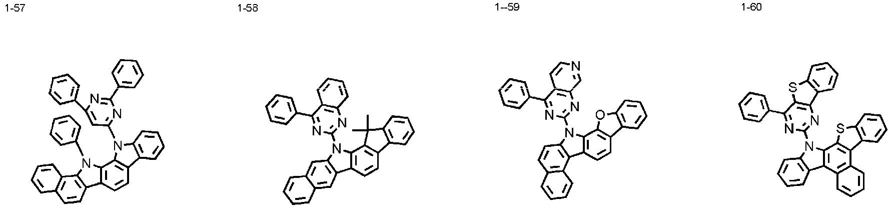

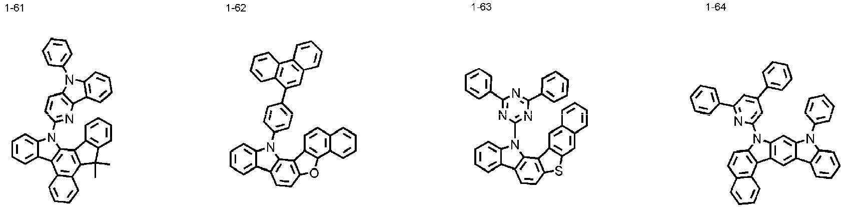

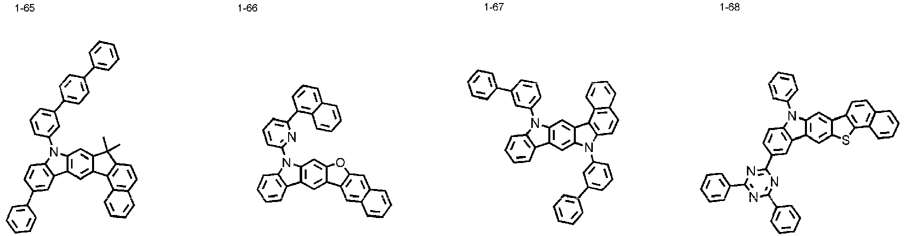

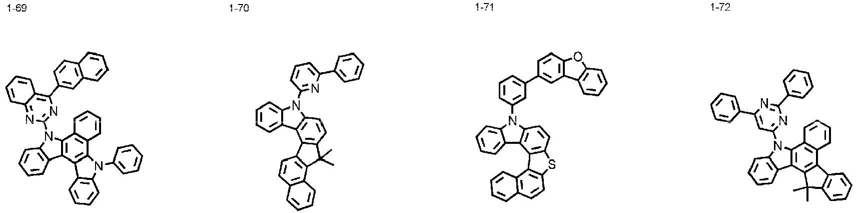

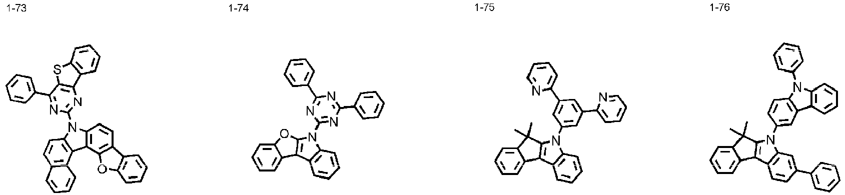

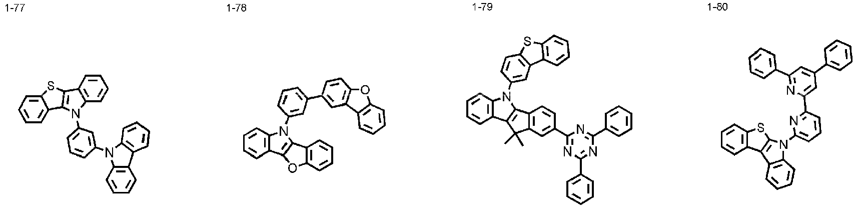

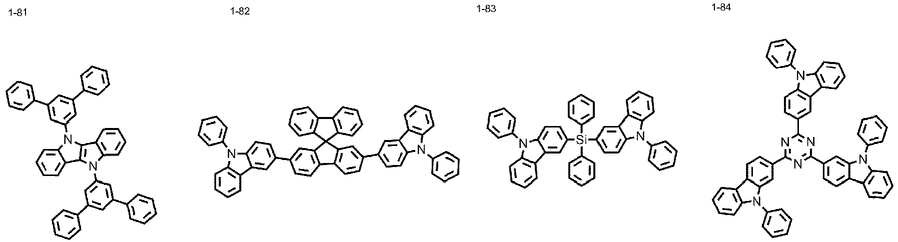

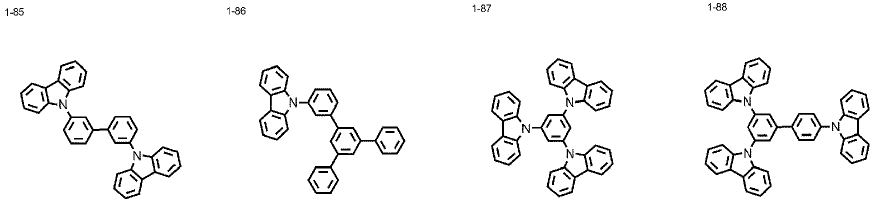

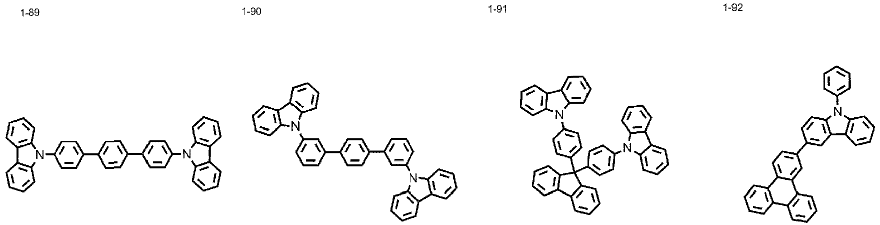

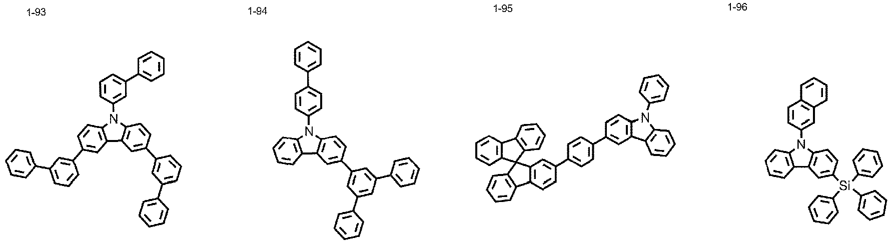

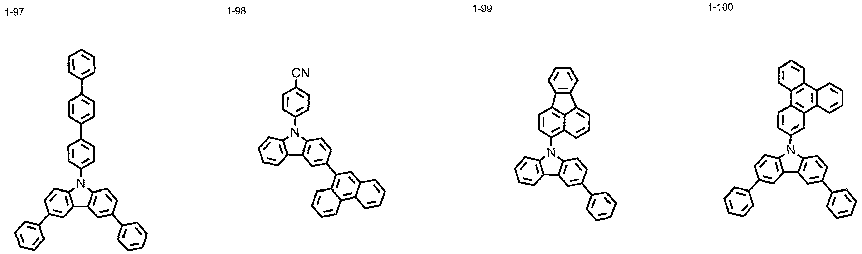

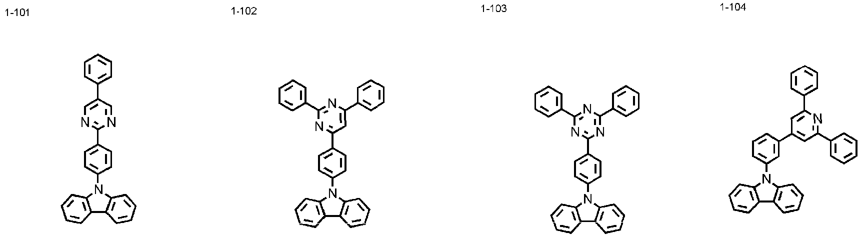

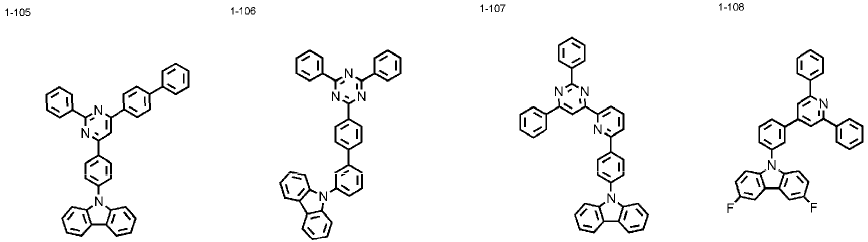

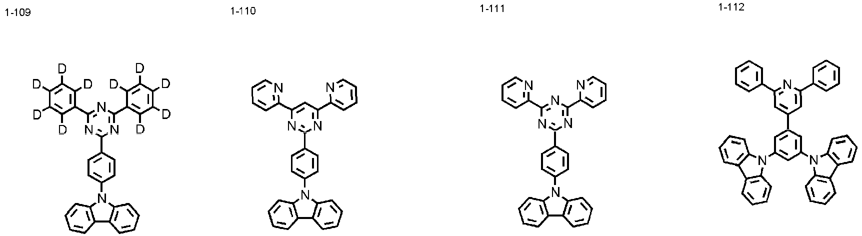

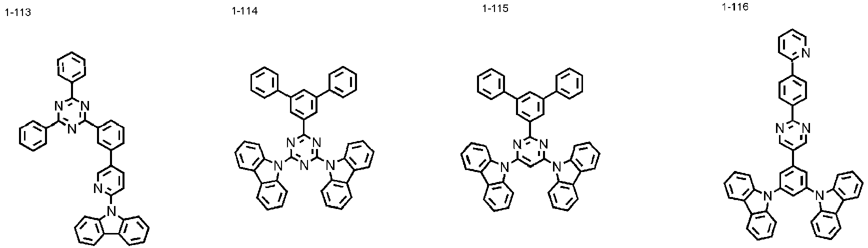

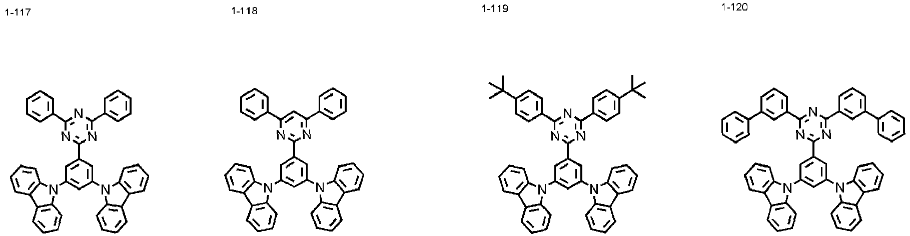

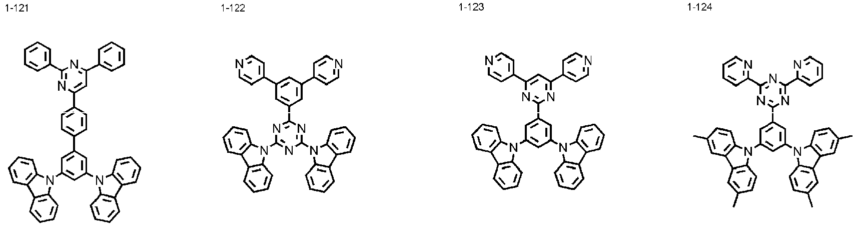

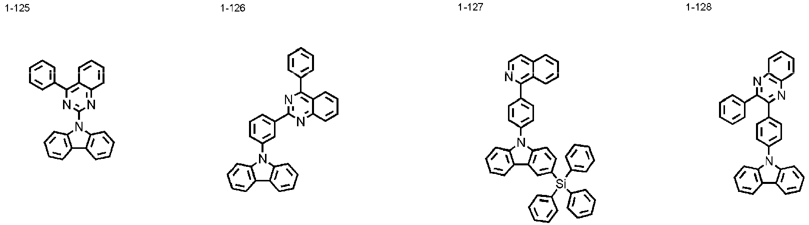

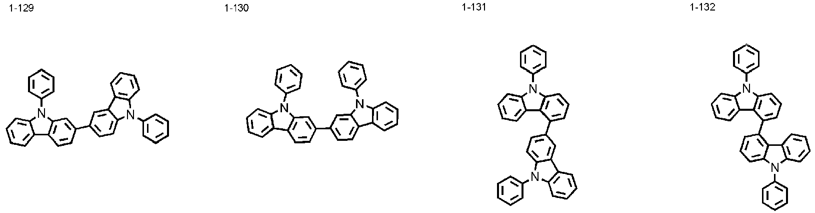

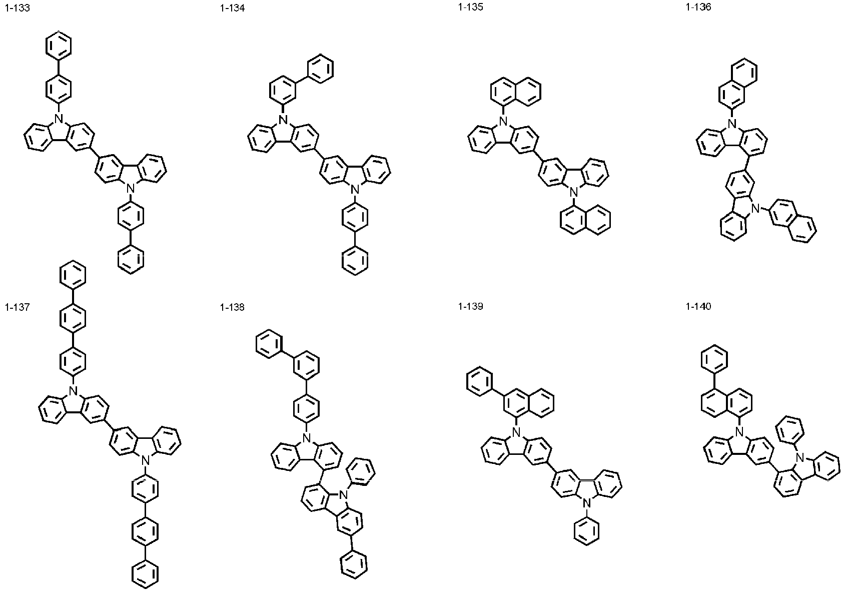

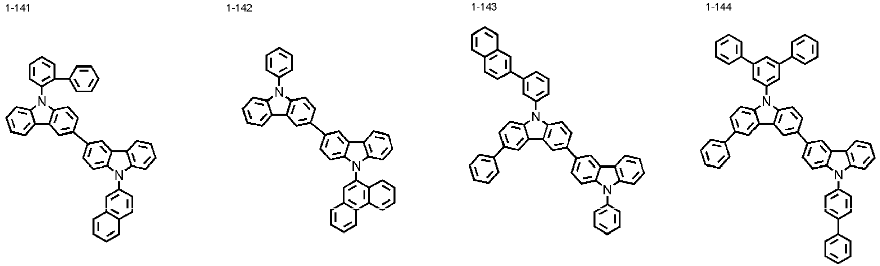

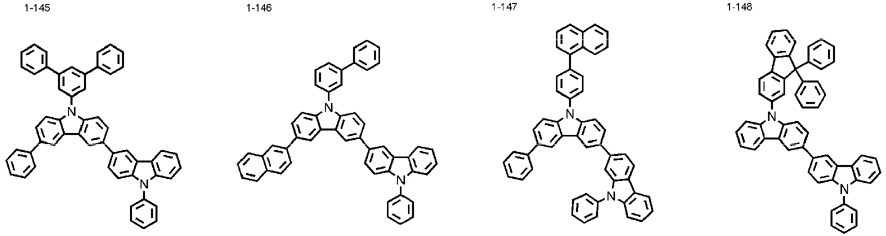

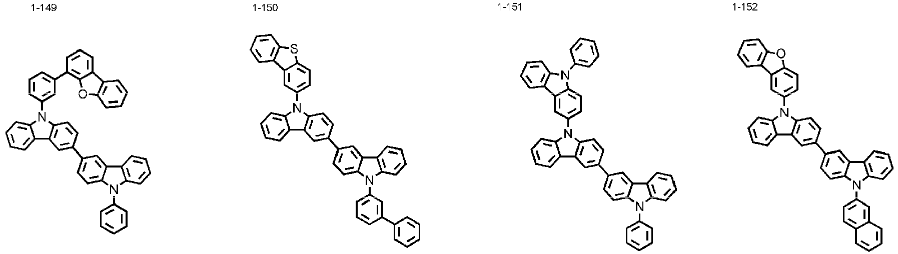

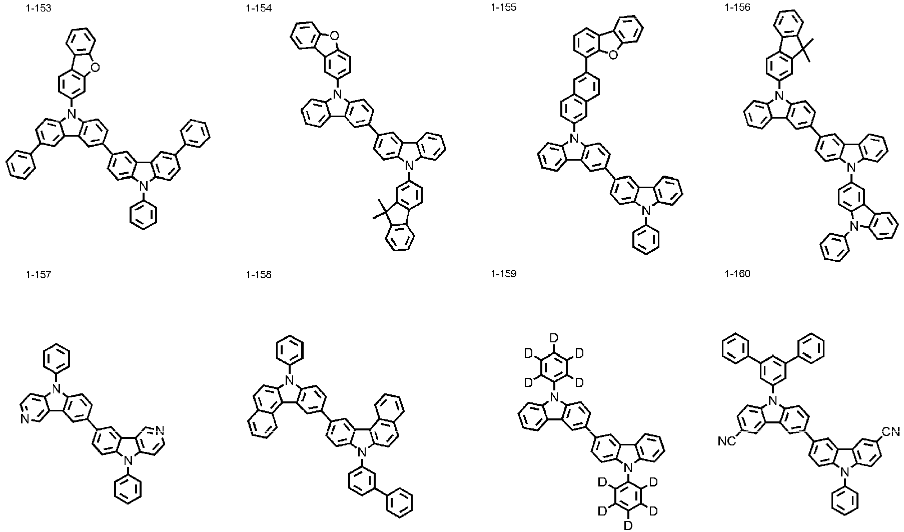

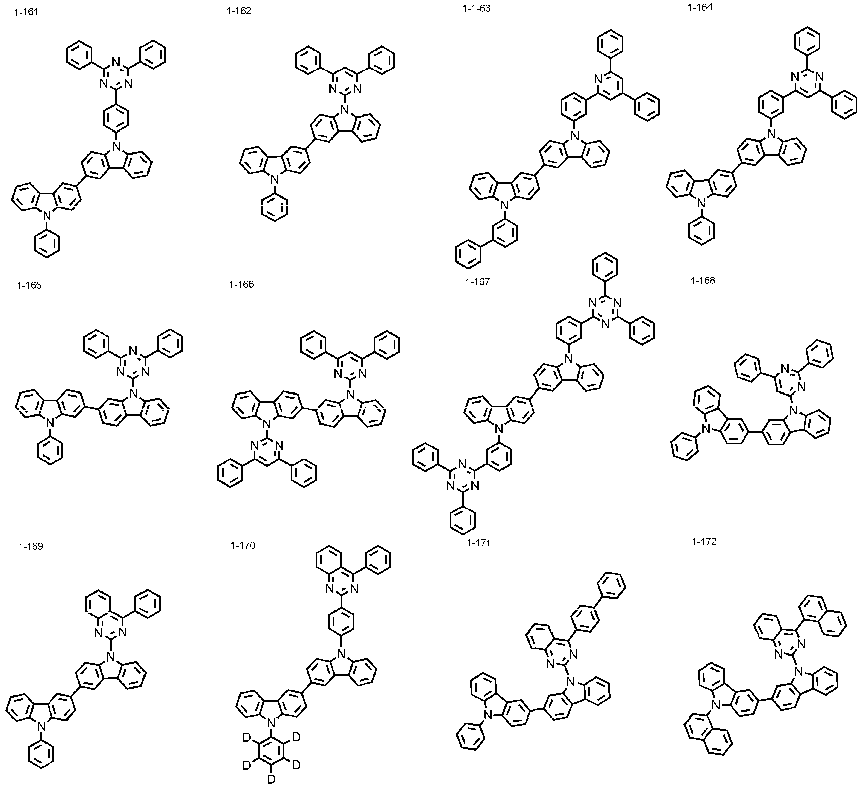

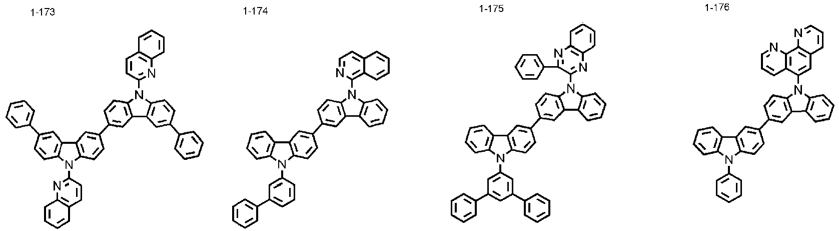

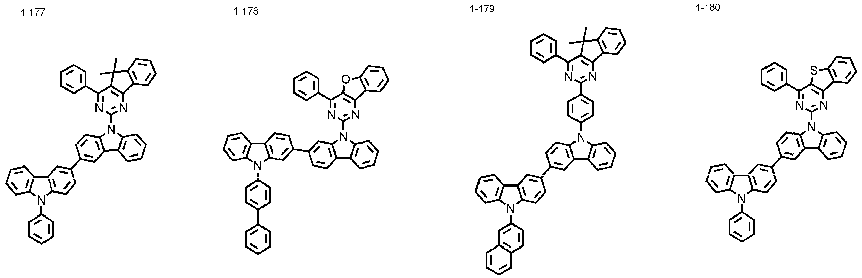

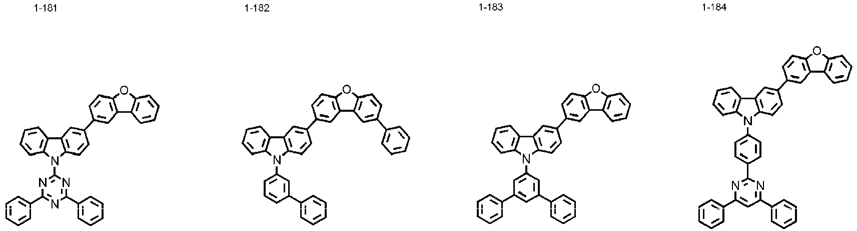

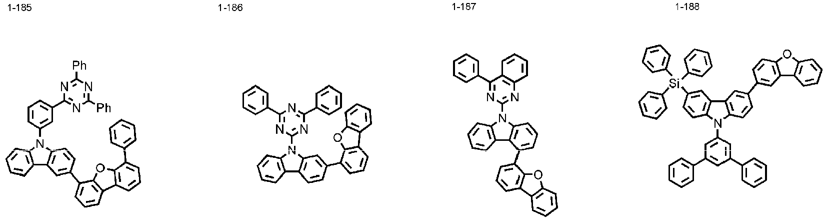

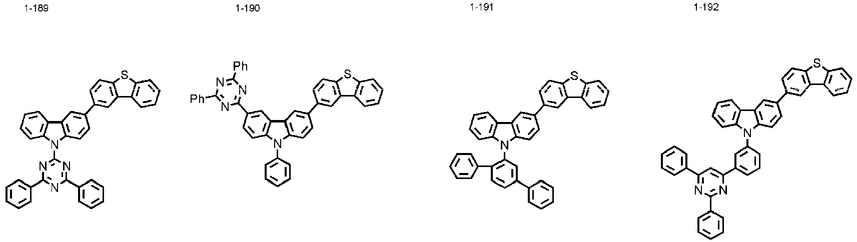

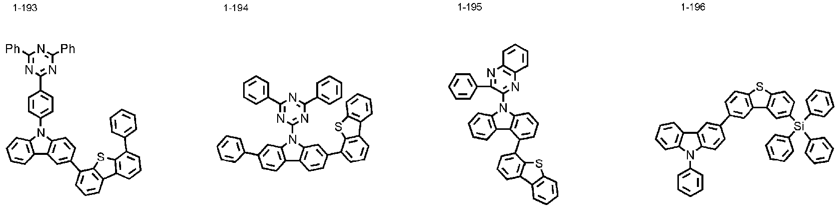

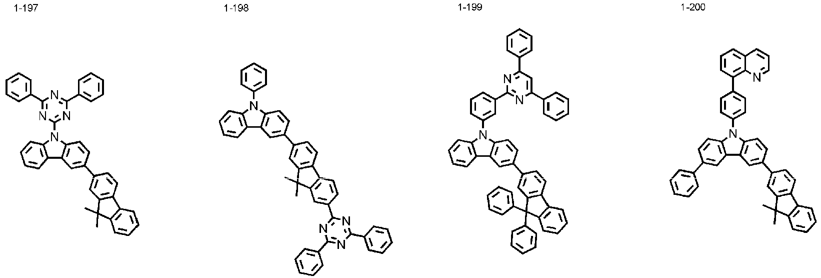

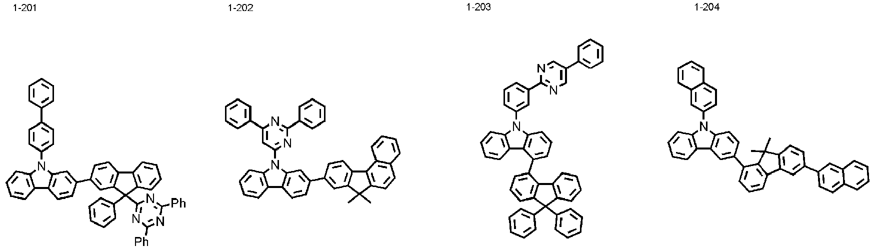

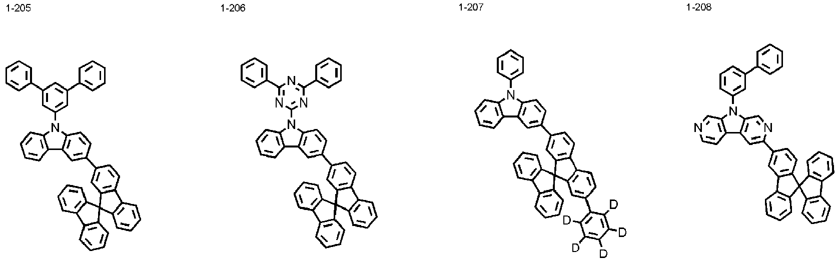

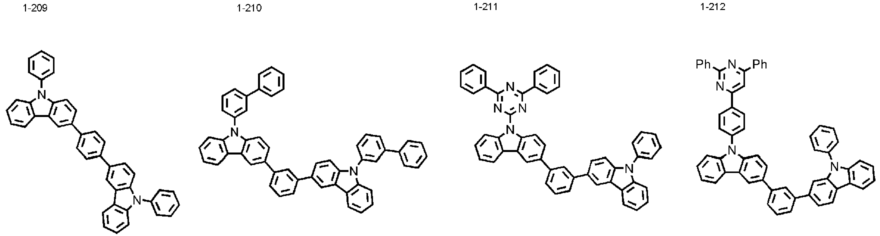

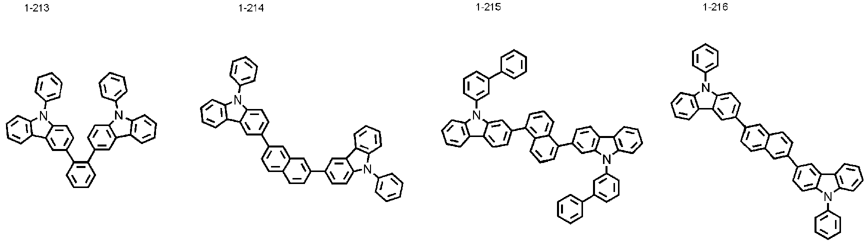

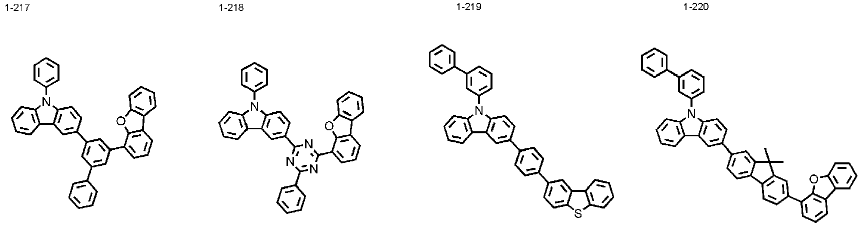

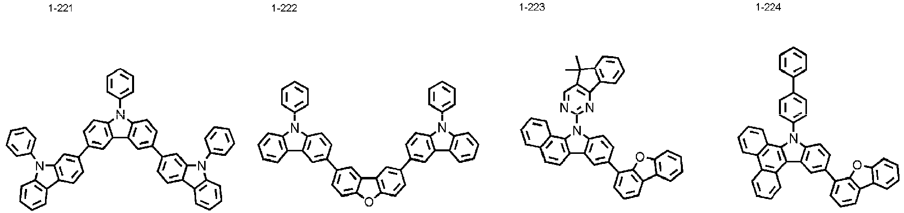

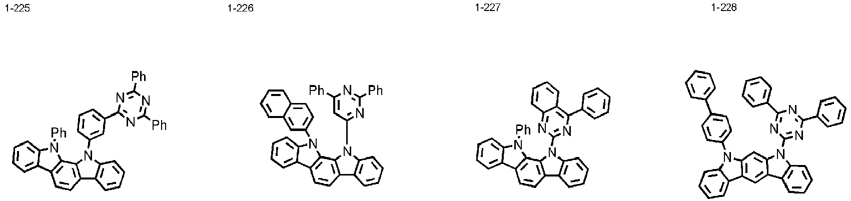

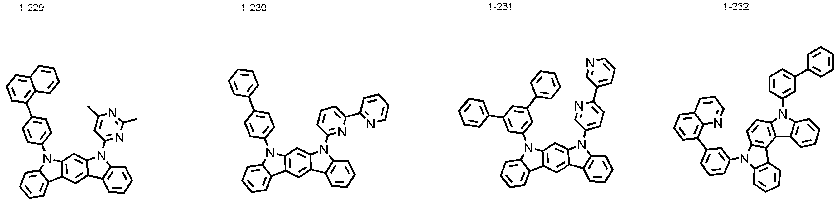

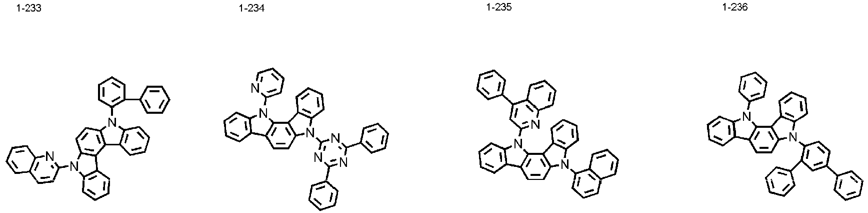

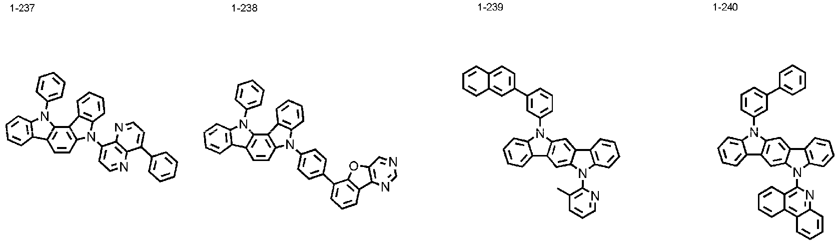

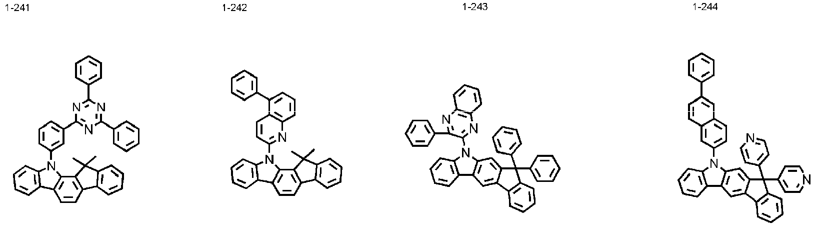

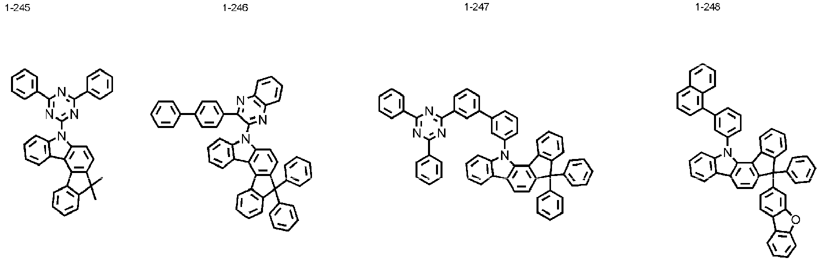

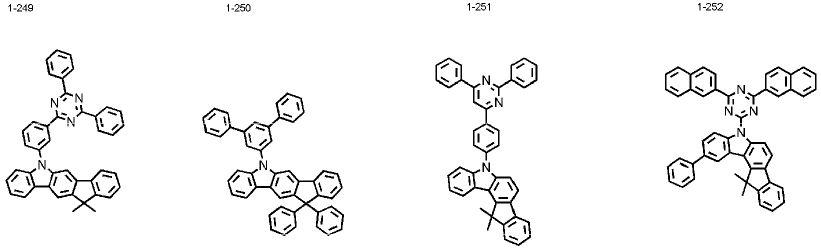

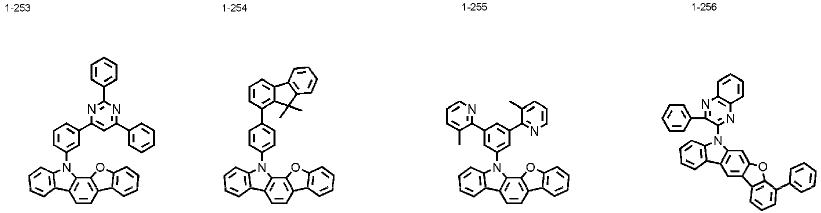

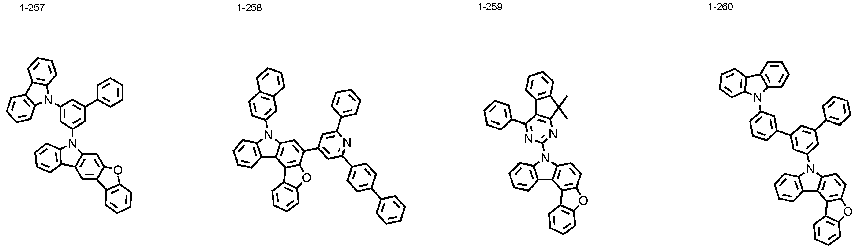

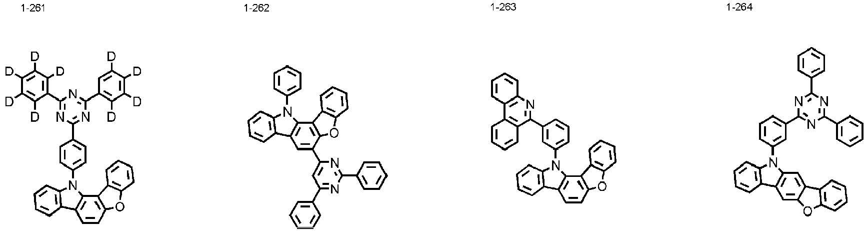

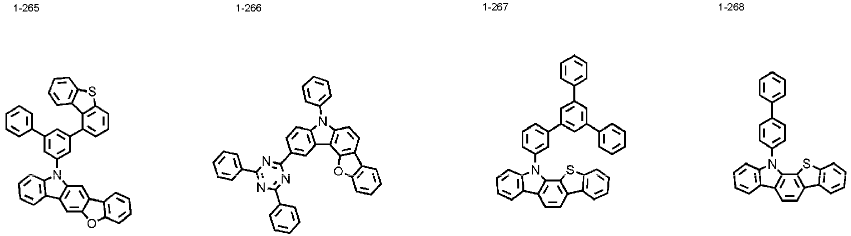

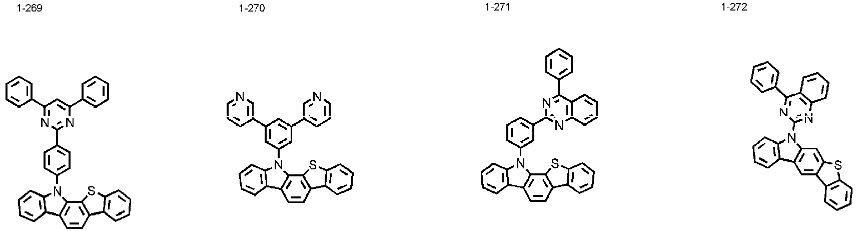

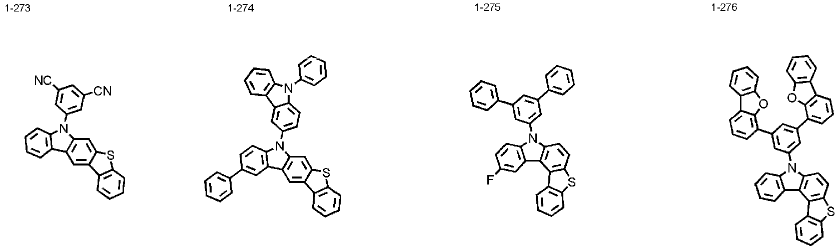

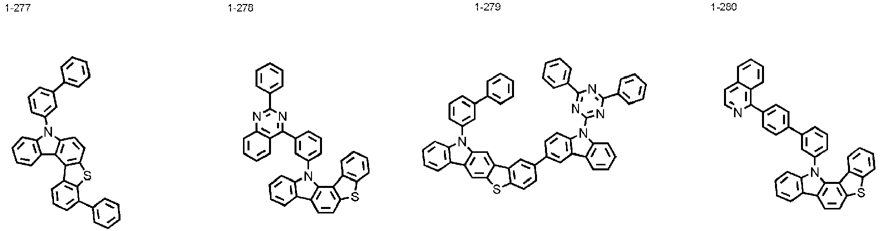

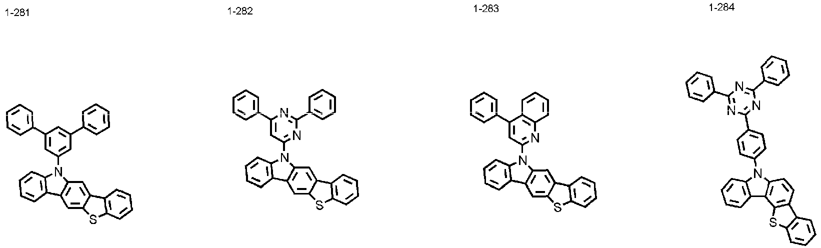

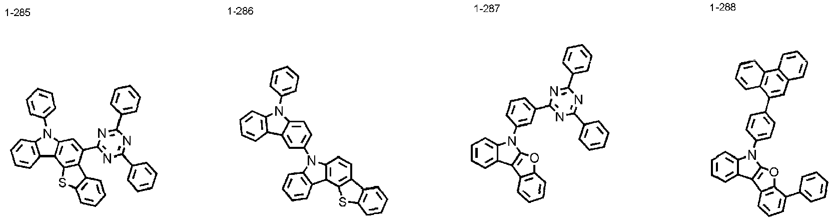

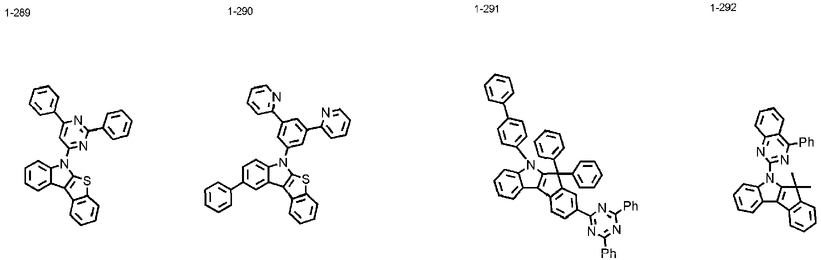

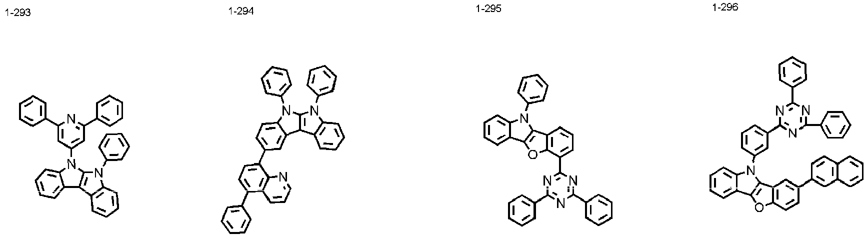

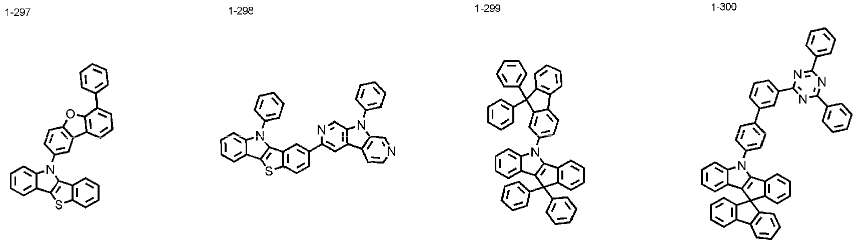

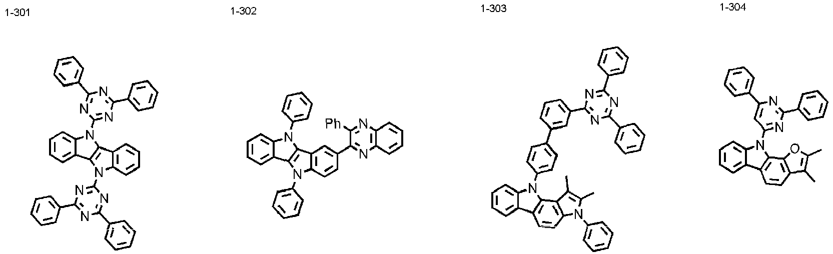

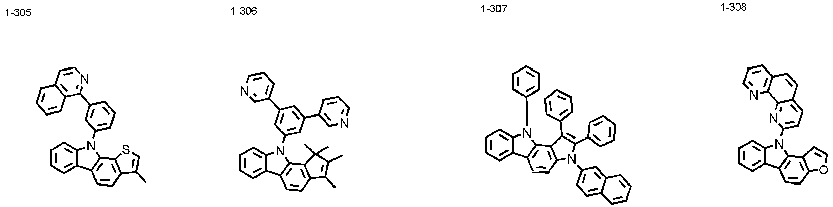

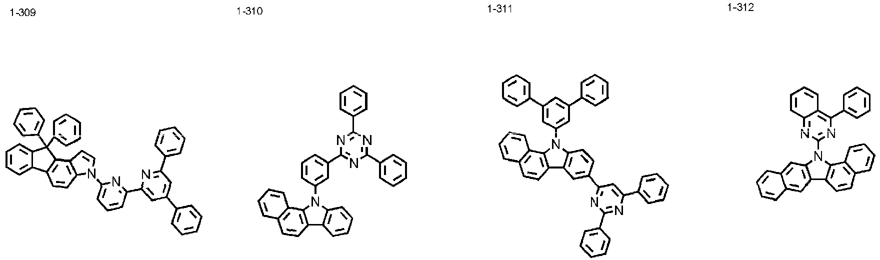

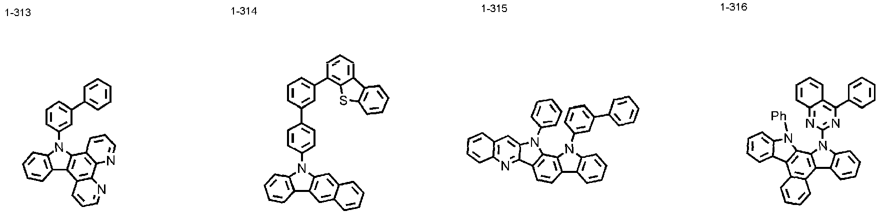

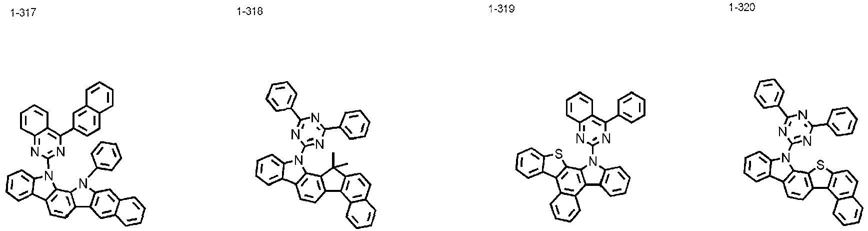

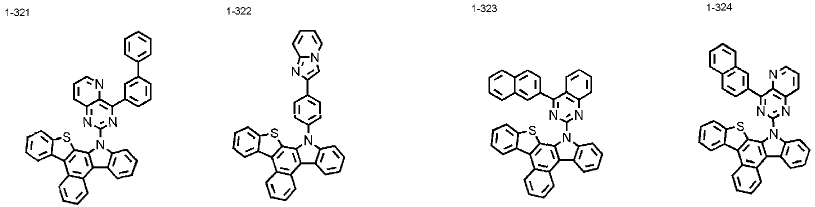

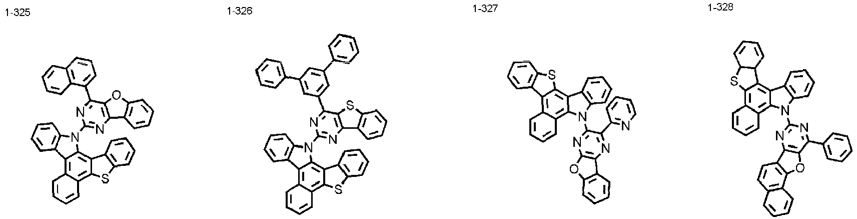

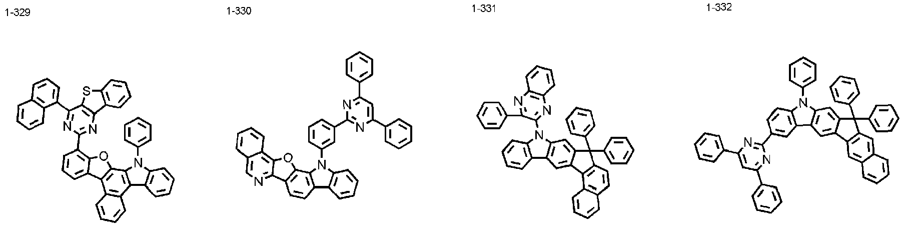

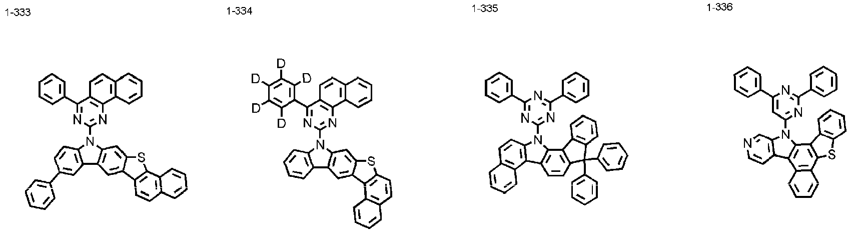

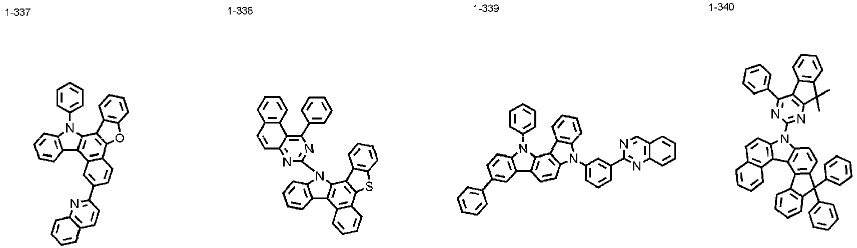

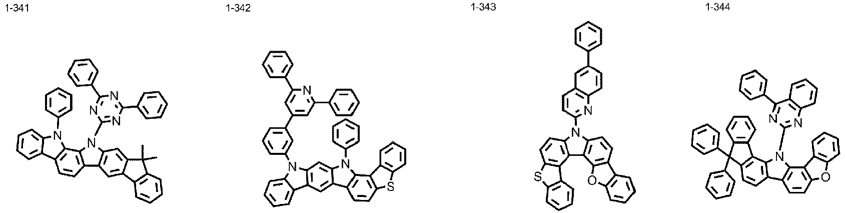

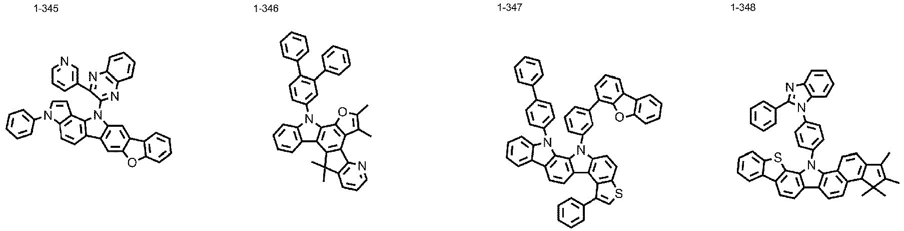

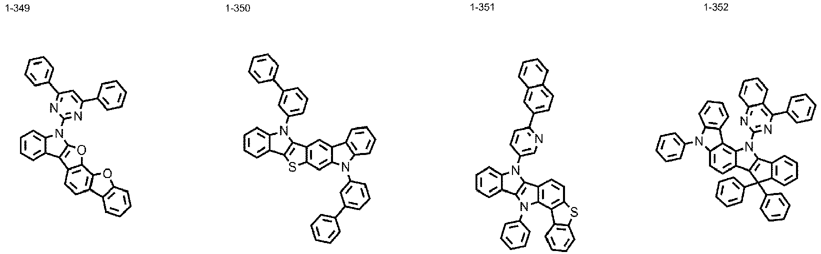

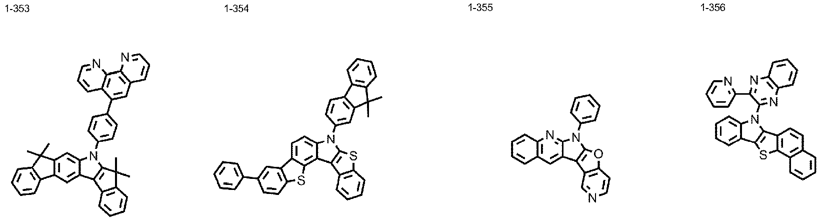

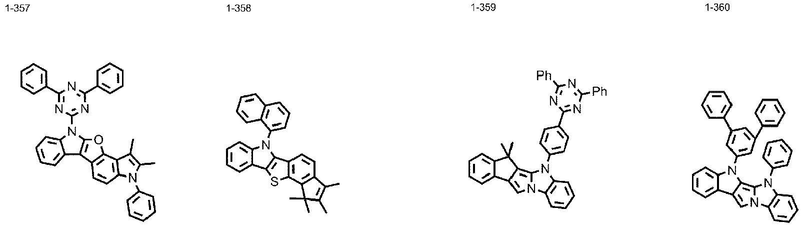

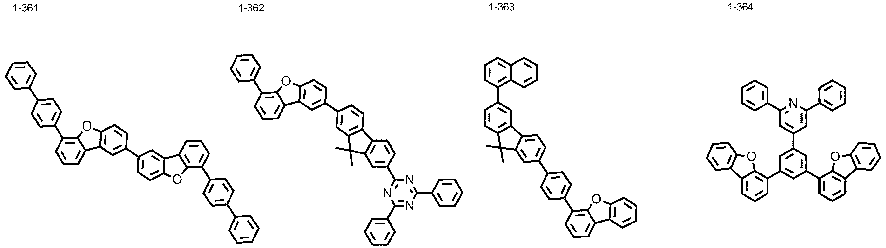

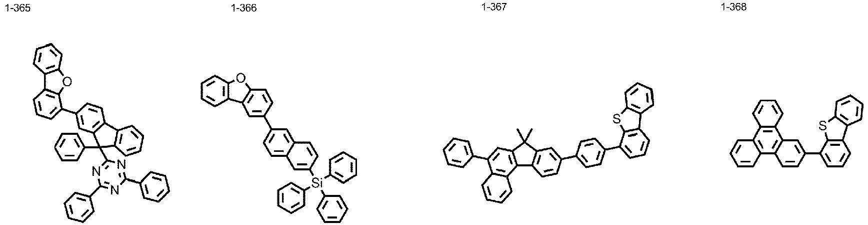

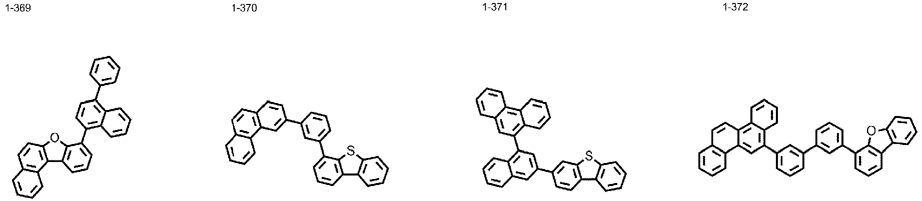

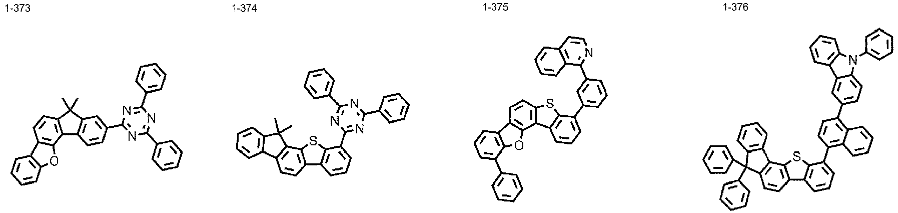

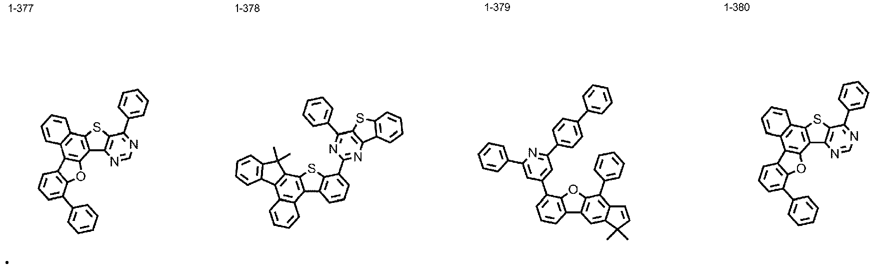

The second compound represented by Formula 2 may be selected from Compounds 2-1 to 2-192, but is not limited thereto:

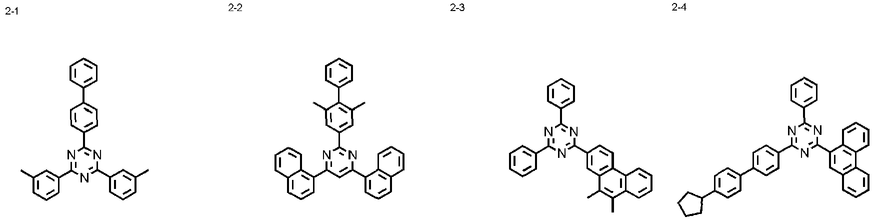

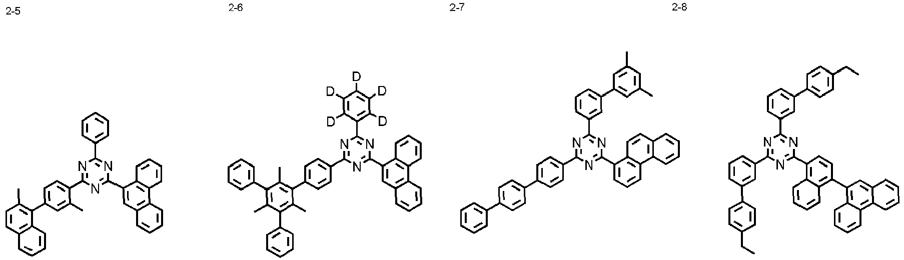

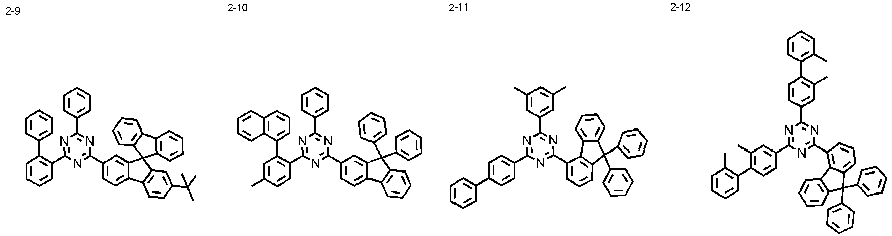

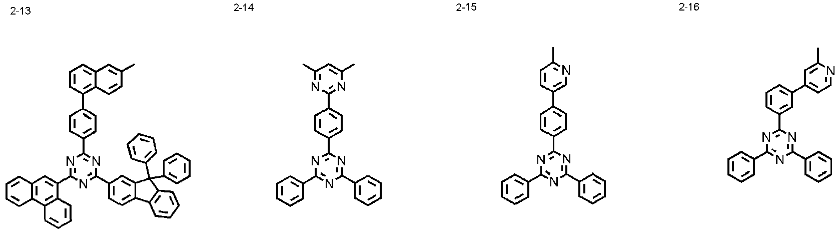

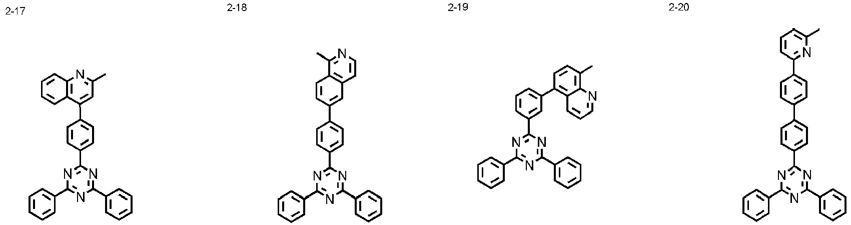

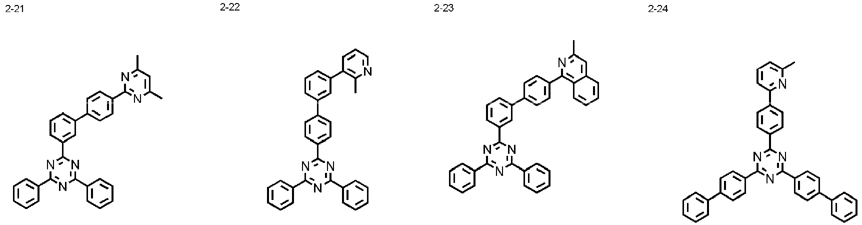

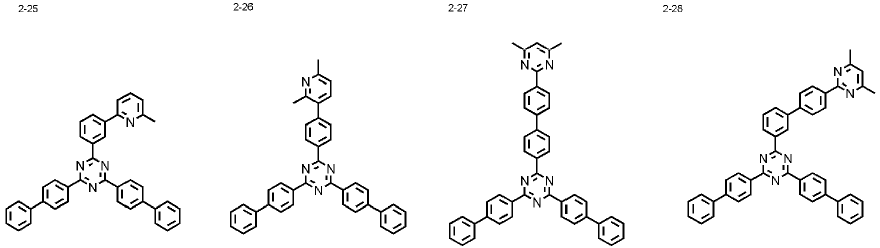

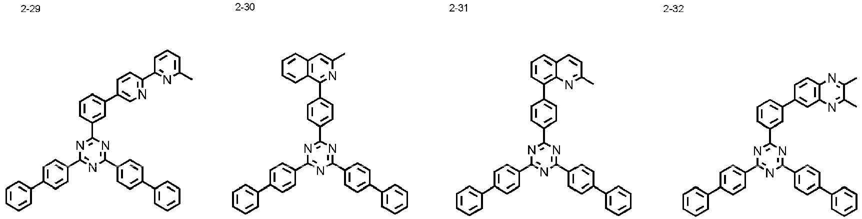

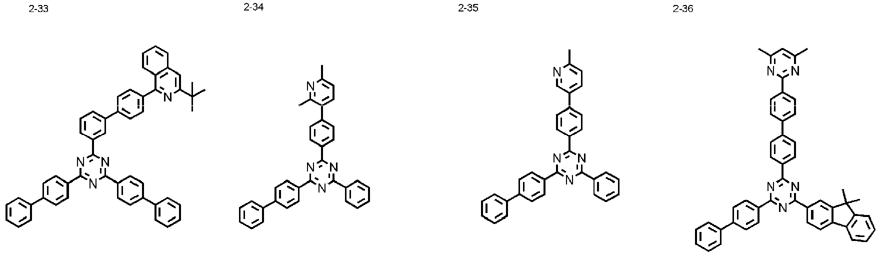

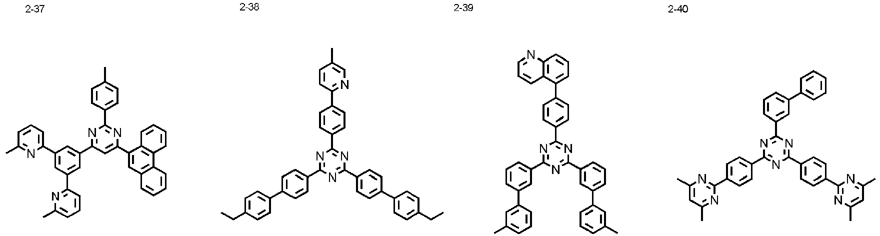

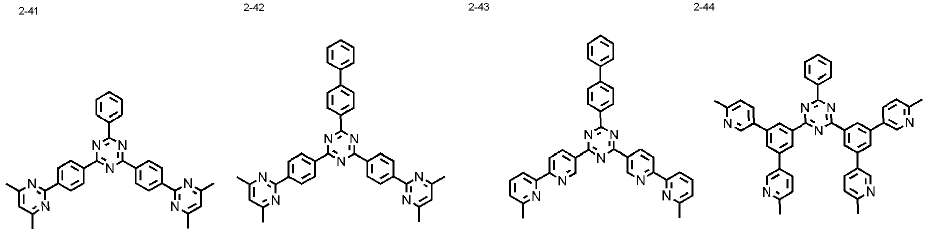

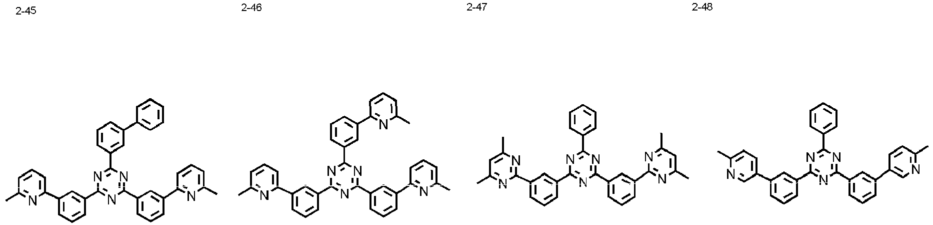

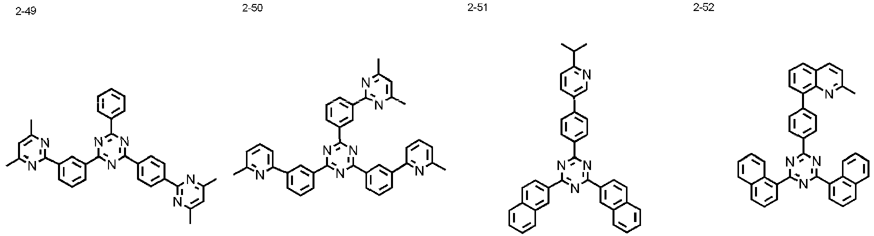

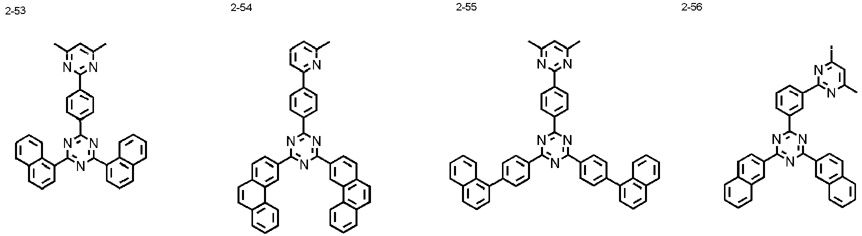

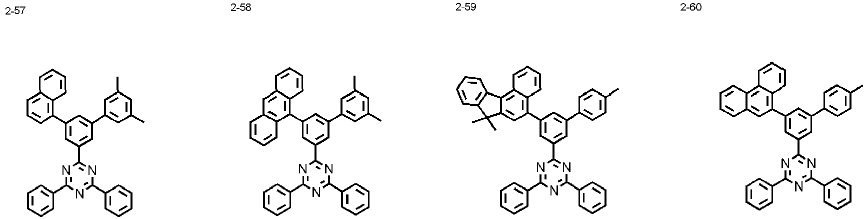

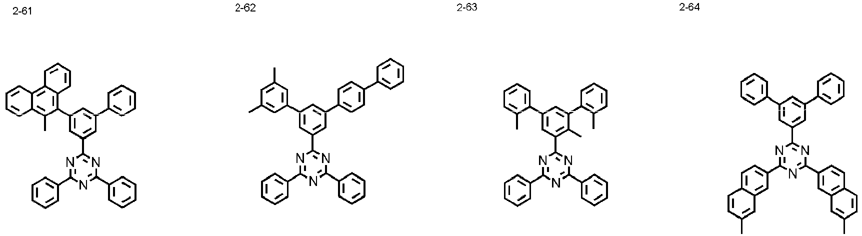

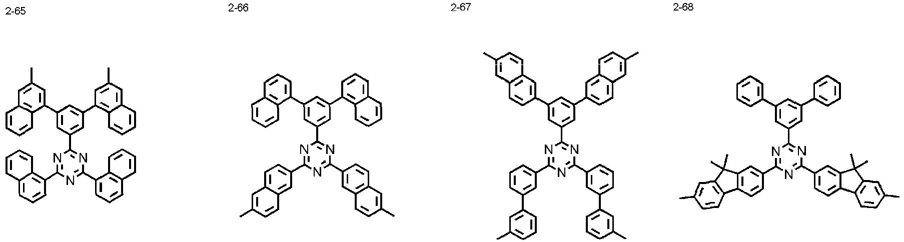

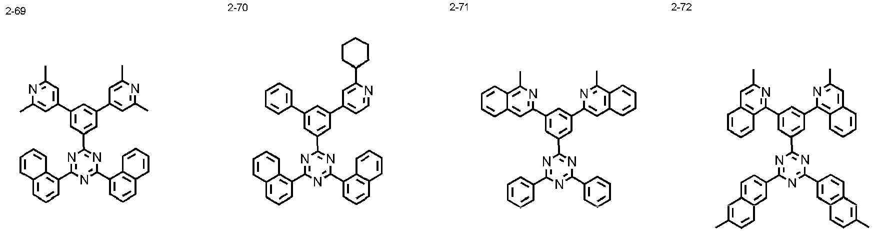

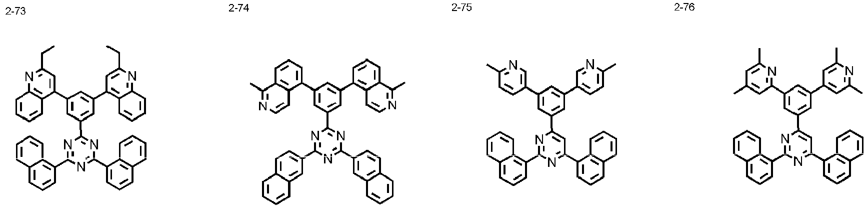

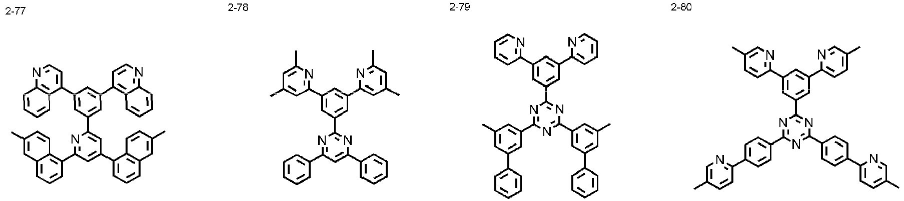

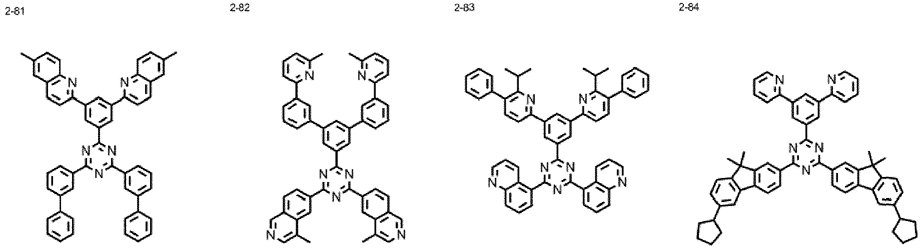

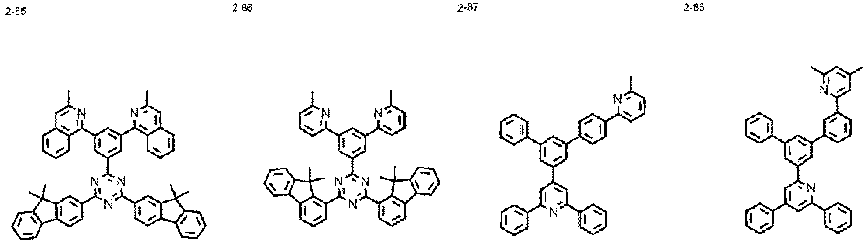

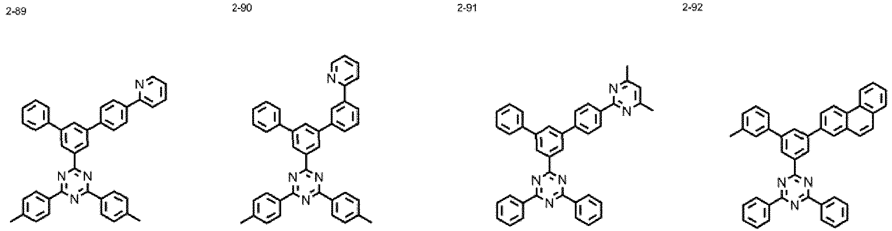

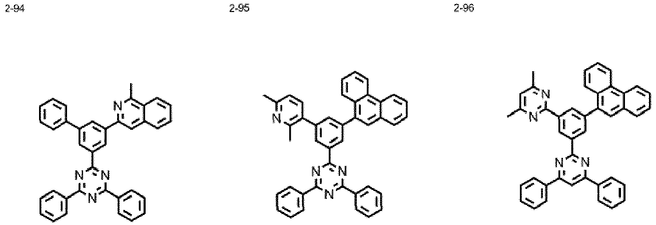

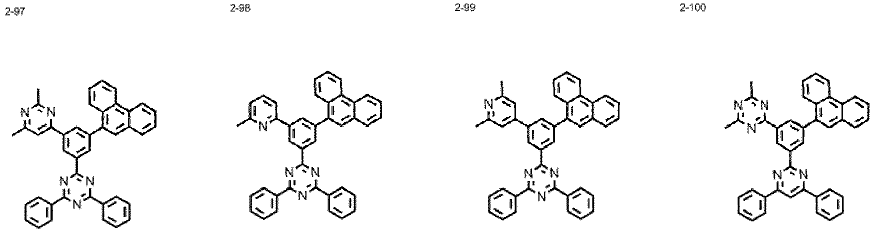

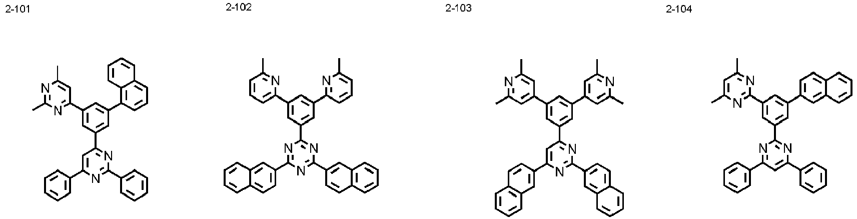

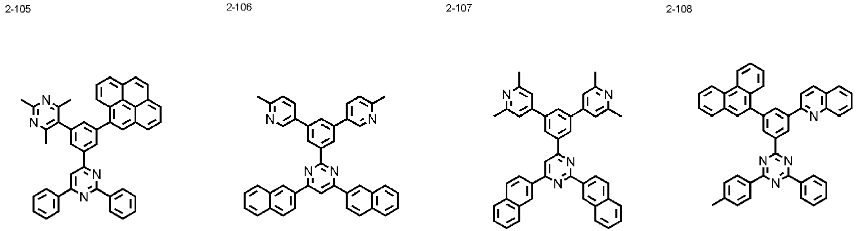

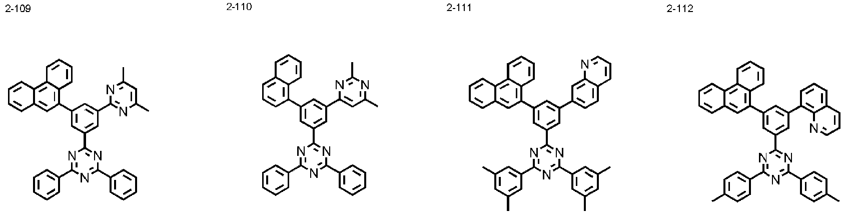

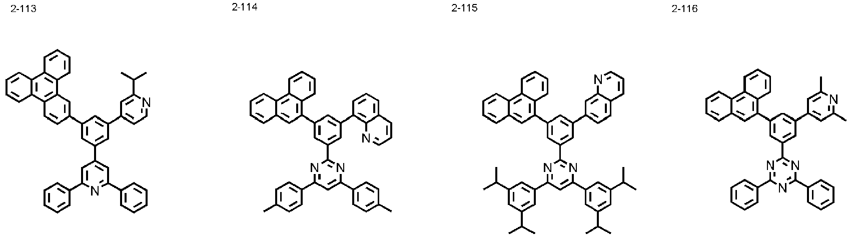

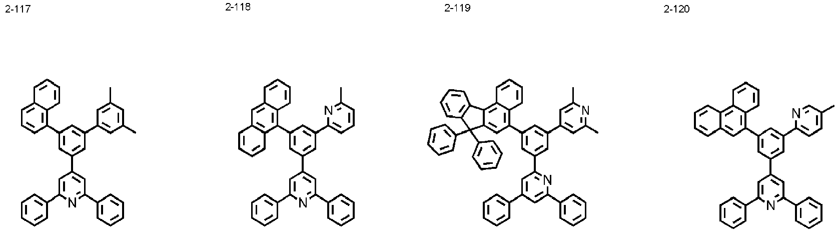

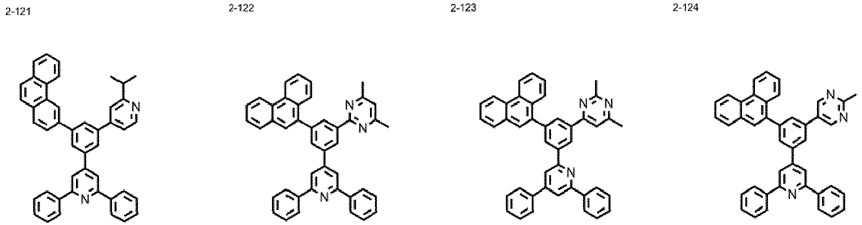

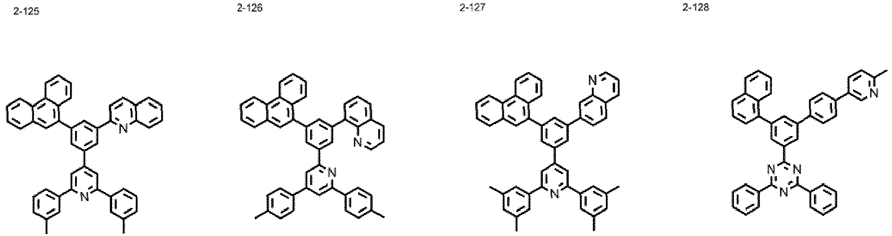

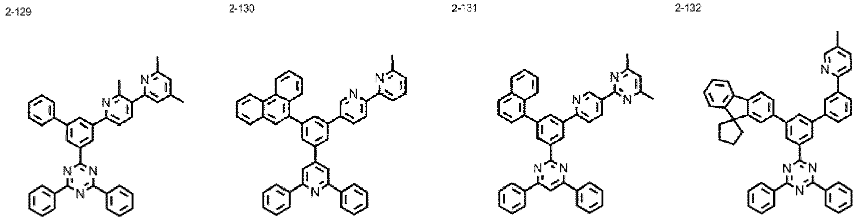

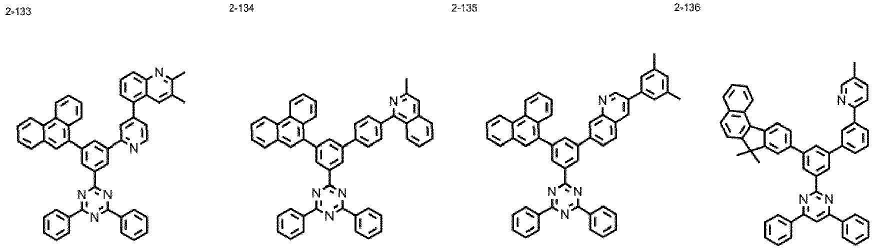

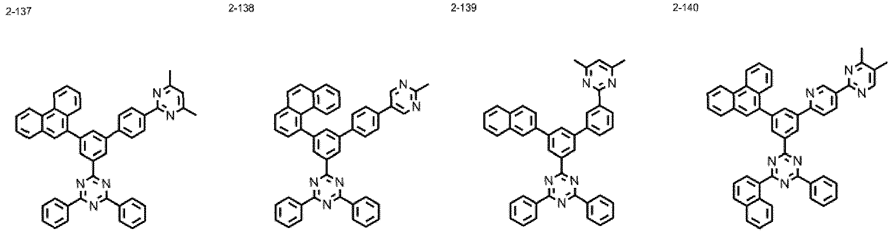

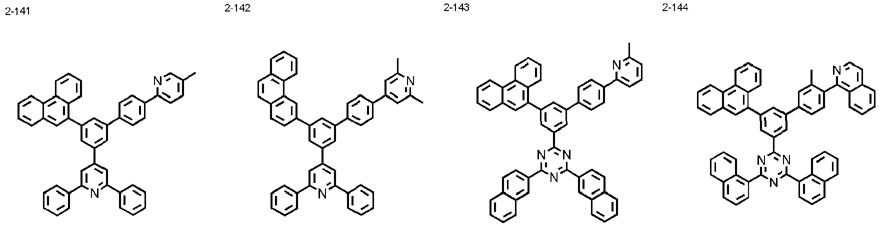

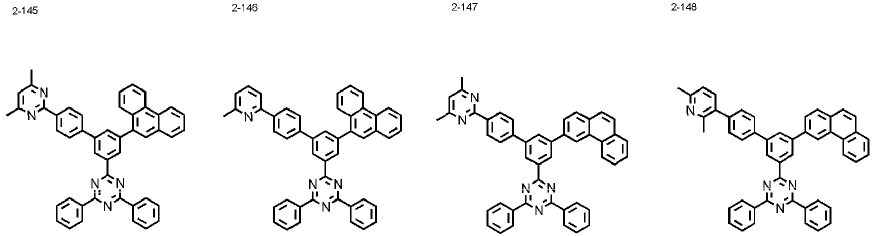

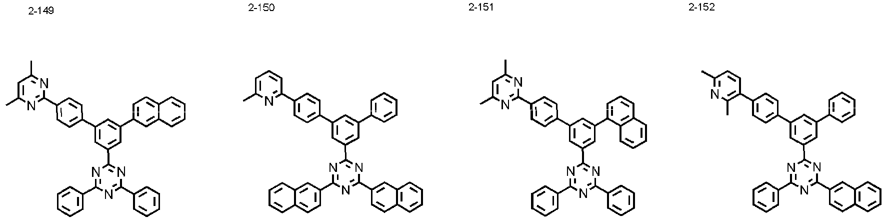

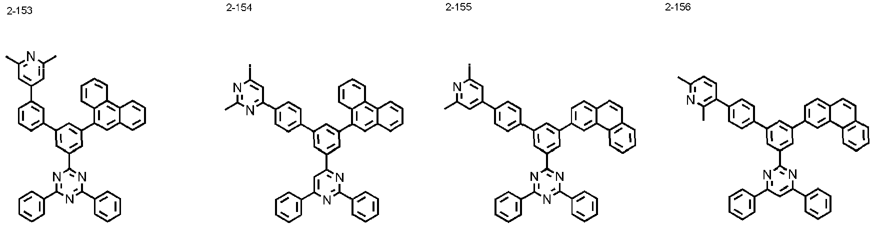

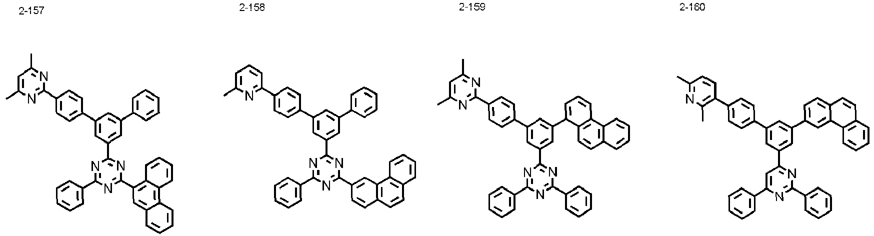

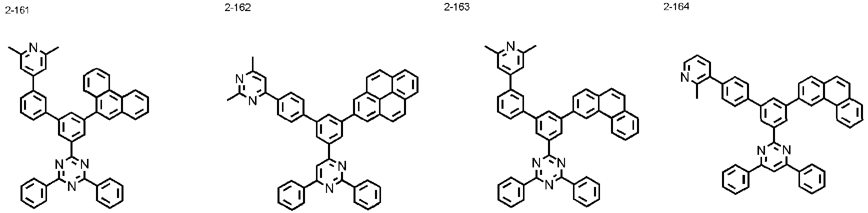

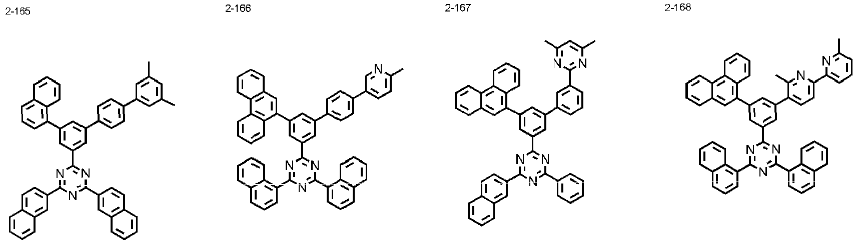

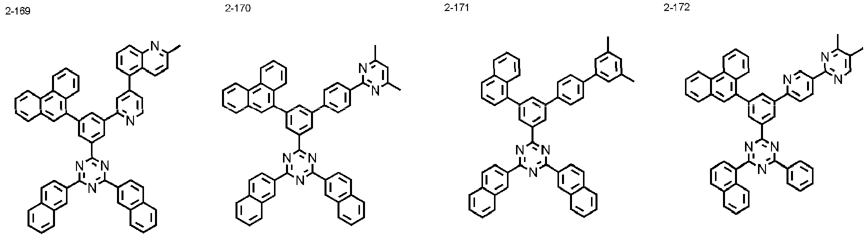

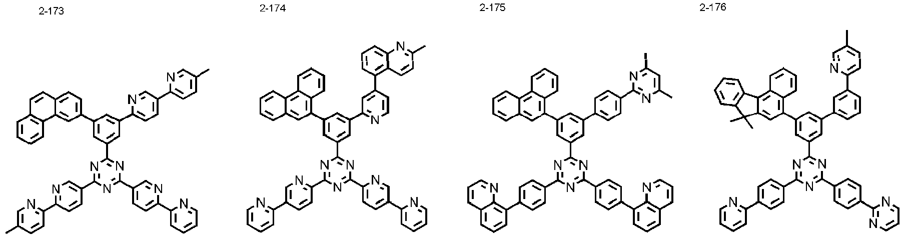

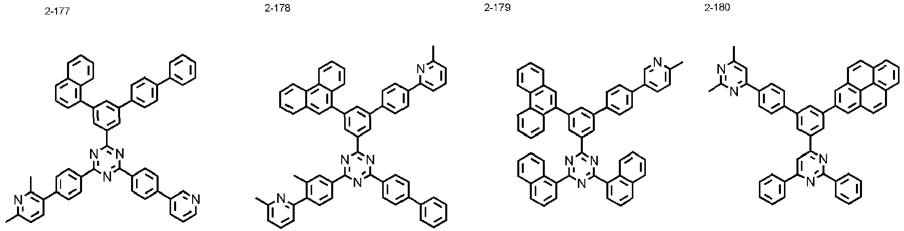

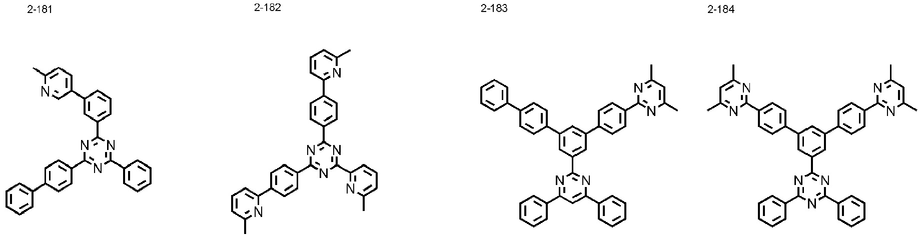

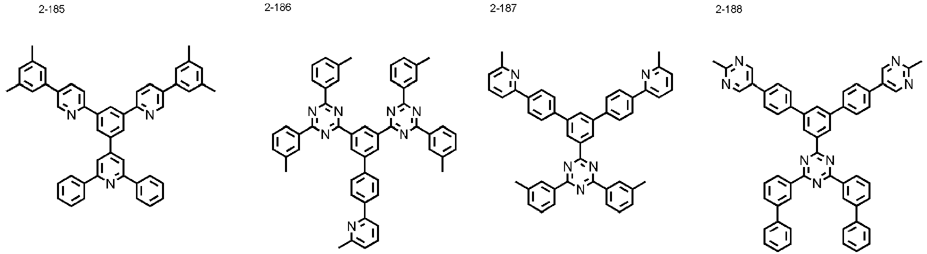

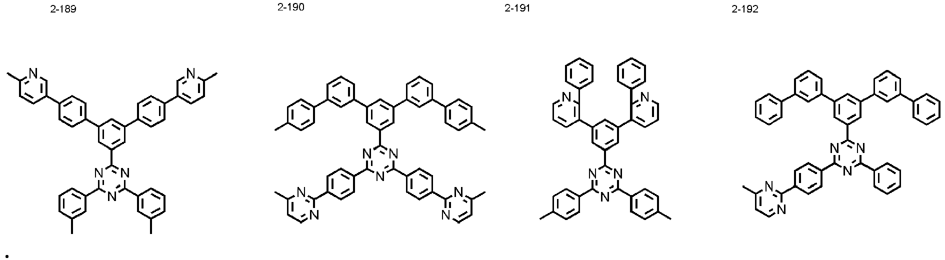

The first compound represented by Formula 1 may comprise i) a partial structure in which a 5-membered ring and a 6-membered ring are condensed (e.g., fused), for example, the first compound may comprise at least one indole group or carbazole group, and ii) various substituents having hole transporting capabilities and substituents having electron transporting capabilities. Therefore, in an organic light-emitting device in which the first compound represented by Formula 1 is comprised in an emission layer (e.g., as a host in the emission layer) and/or a buffer layer, a balance of charges (a balance of holes and electrons) in the emission layer may be excellent (or suitable) and charges may be smoothly injected into the emission layer, thereby improving efficiency of the organic light-emitting device.

When the second compound represented by Formula 2 comprises an alkyl group and/or a cycloalkyl group, the second compound may have low crystallinity. Accordingly, when an organic layer is formed using the second compound represented by Formula 2, quality of the organic layer (e.g., film-forming characteristics of the organic layer) may be improved. Also, since the alkyl group group and/or the cycloalkyl group may function as an intermolecular or intramolecular electron donor, the second compound represented by Formula 2 comprising the alkyl group and/or the cycloalkyl group may have improved electrochemical stability. Accordingly, the organic light-emitting device comprising the second compound represented by Formula 2 may have high efficiency and a long lifespan.

Therefore, the organic light-emitting device comprising the first compound and the second compound may have high efficiency and a long lifespan that is at least in part due to the balance of charges in the emission layer and the improved stability of the compounds.

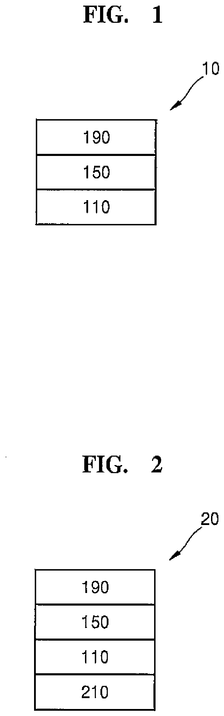

### Description of FIG. 1

FIG. 1 is a schematic view of an organic light-emitting device 10 according to an embodiment of the present disclosure. The organic light-emitting device 10 comprises a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### First electrode 110

In FIG. 1, a substrate may be additionally disposed (e.g., positioned) under the first electrode 110 or above the second electrode 190. The substrate may be a glass substrate or a plastic substrate, each having excellent (or suitable) mechanical strength, thermal stability, transparency, surface smoothness, ease of handling, and/or water-resistance.

The first electrode 110 may be formed by depositing or sputtering a material for forming the first electrode 110 on the substrate. When the first electrode 110 is an anode, the material for forming the first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode may be selected from indium tin oxide (ITO), indium zinc oxide (IZO), tin oxide (SnO₂), zinc oxide (ZnO), and combinations thereof, but is not limited thereto. In various embodiments, when the first electrode 110 is a semi-transmissive electrode or a reflective electrode, a material for forming the first electrode may be selected from magnesium (Mg), silver (Ag), aluminum (Al), aluminum-lithium (Al-Li), calcium (Ca), magnesium-indium (Mg-In), magnesium-silver (Mg-Ag), and combinations thereof, but is not limited thereto.

The first electrode 110 may have a single-layered structure, or a multi-layered structure comprising two or more layers. For example, the first electrode 110 may have a three-layered structure of ITO/Ag/ITO, but the structure of the first electrode 110 is not limited thereto.

### Organic layer 150

The organic layer 150 may be disposed on the first electrode 110. The organic layer 150 comprises an emission layer.

The organic layer 150 may further comprise a hole transport region between the first electrode 110 and the emission layer, and comprises an electron transport region between the emission layer and the second electrode 190.

### Hole transport region in organic layer 150

The hole transport region may have i) a single-layered structure having a single layer including a single material, ii) a single-layered structure having a single layer comprising a plurality of different materials, or iii) a multi-layered structure having a plurality of layers comprising a plurality of different materials.

The hole transport region may comprise at least one layer selected from a hole injection layer (HIL), a hole transport layer (HTL), an emission auxiliary layer, and an electron blocking layer (EBL).

For example, the hole transport region may have a single-layered structure having a single layer comprising a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer, or hole injection layer/hole transport layer/electron blocking layer, wherein for each structure, constituting layers are sequentially stacked from the first electrode 110 in this stated order, but the structure of the hole transport region is not limited thereto.
The hole transport region may comprise at least one selected from m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (Pani/PSS), a compound represented by Formula 201, and a compound represented by Formula 202:

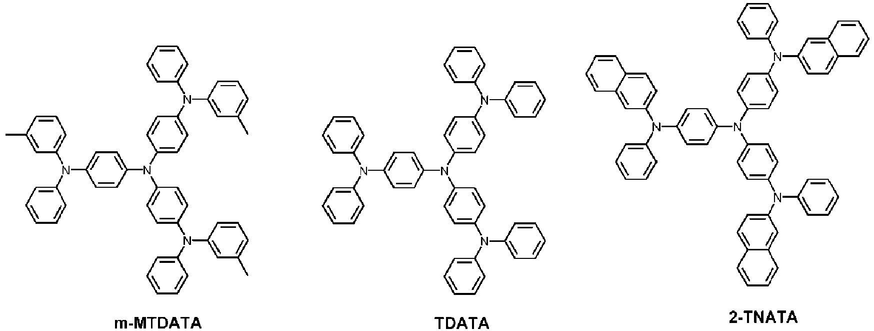

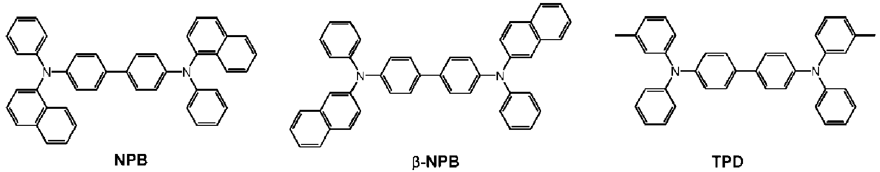

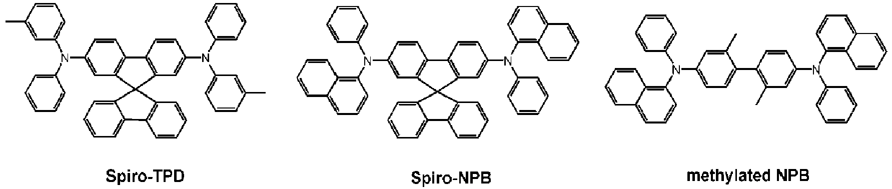

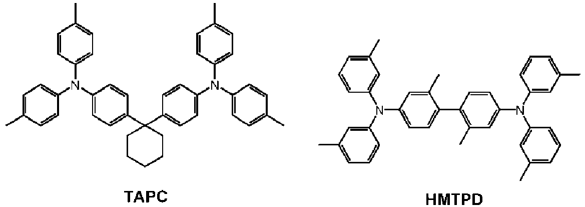

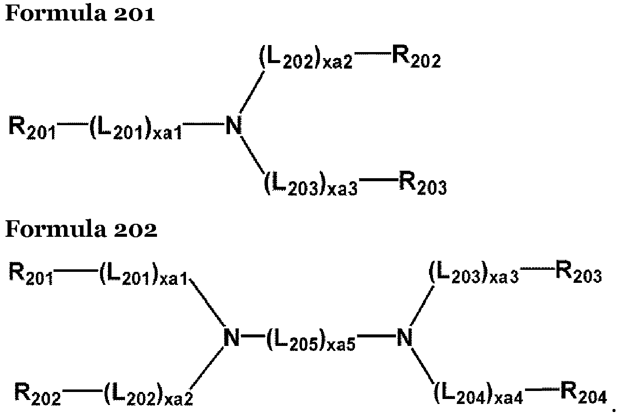

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
L₂₀₅ may be selected from ^{∗}-O-^{∗}', ^{∗}-S-^{∗}', ^{∗}-N(Q₂₀₁)-^{∗}', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, R₂₀₁ and R₂₀₂ in Formula 202 may be optionally connected to each other via a single bond, a dimethyl-methylene group, or a diphenyl-methylene group; and R₂₀₃ and R₂₀₄ may be optionally connected to each other via a single bond, a dimethyl-methylene group, or a diphenyl-methylene group.

In various embodiments, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In various embodiments, xa1 to xa4 may each independently be 0, 1, or 2.

In various embodiments, xa5 may be 1, 2, 3, or 4.

In various embodiments, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ are the same as described herein.

In various embodiments, at least one selected from R₂₀₁ to R₂₀₃ in Formula 201 may each independently be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments are not limited thereto.

In various embodiments, in Formula 202, i) R₂₀₁ and R₂₀₂ may be connected to each other via a single bond and/or ii) R₂₀₃ and R₂₀₄ may be connected to each other via a single bond.

In various embodiments, at least one selected from R₂₀₁ to R₂₀₄ in Formula 202 may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments are not limited thereto.

The compound represented by Formula 201 may be represented by Formula 201A:

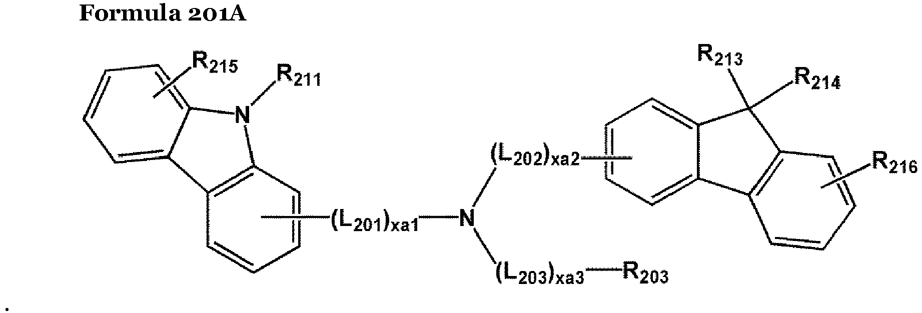

In various embodiments, the compound represented by Formula 201 may be represented by Formula 201A(1), but is not limited thereto:

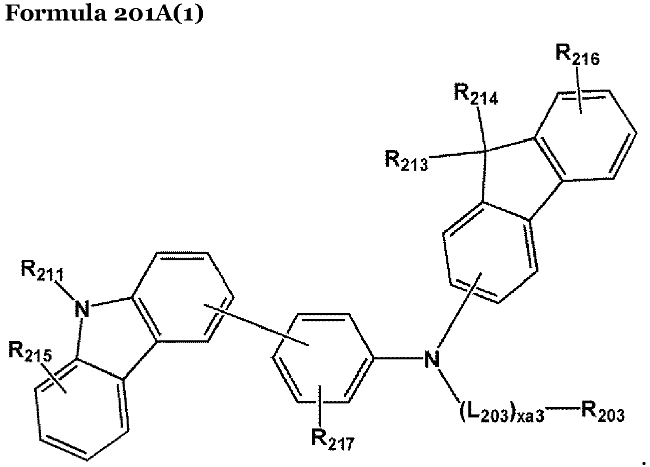

In various embodiments, the compound represented by Formula 201 may be represented by Formula 201A-1, but is not limited thereto:

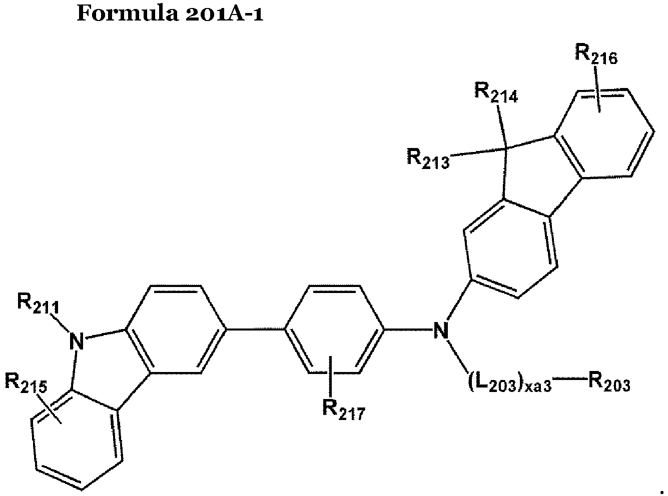

In various embodiments, the compound represented by Formula 202 may be represented by Formula 202A:

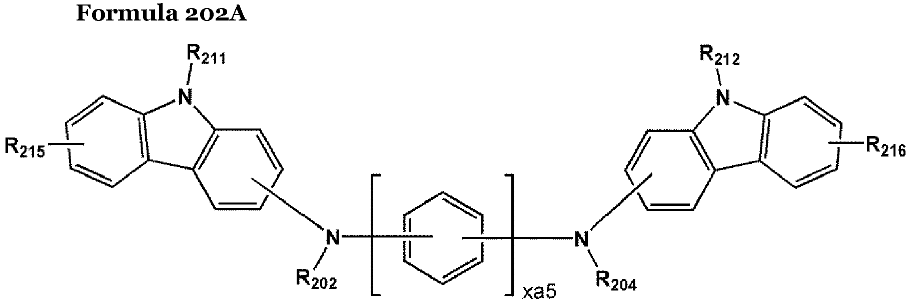

In various embodiments, the compound represented by Formula 202 may be represented by Formula 202A-1:

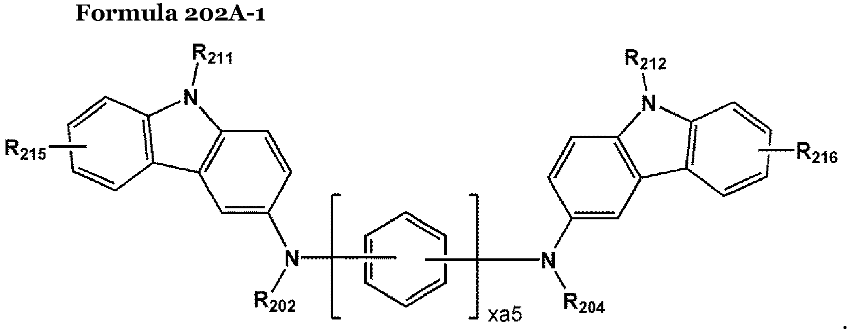

In Formulae 201A, 201A(1), 201A-1, 202A, and 202A-1,
descriptions of L₂₀₁ to L₂₀₃, xa1 to xa3, xa5, and R₂₀₂ to R₂₀₄ are the same as those provided herein,
descriptions of R₂₁₁ and R₂₁₂ are each independently the same as the description provided in connection with R₂₀₃,
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may comprise at least one compound selected from Compounds HT1 to HT39, but is not limited thereto:

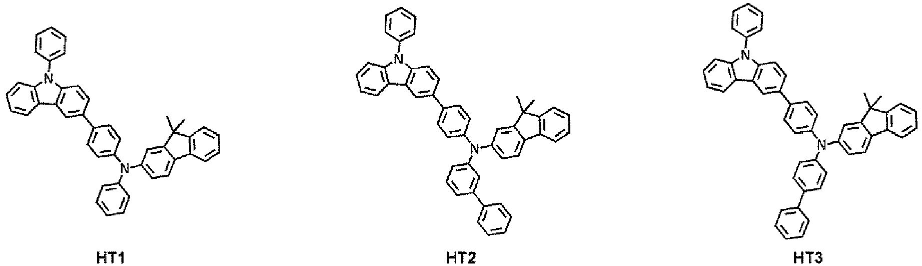

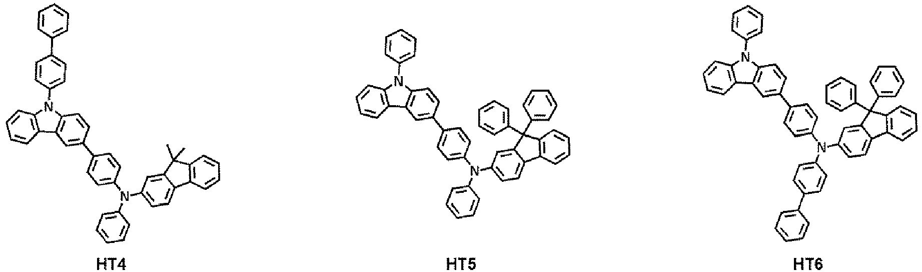

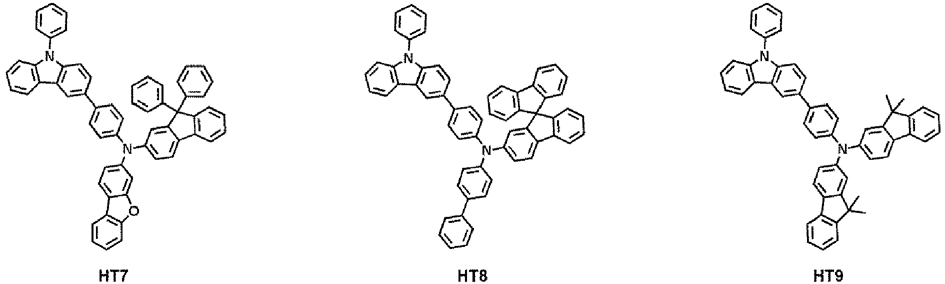

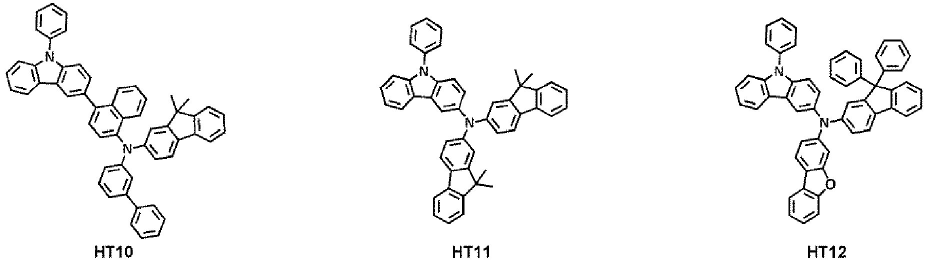

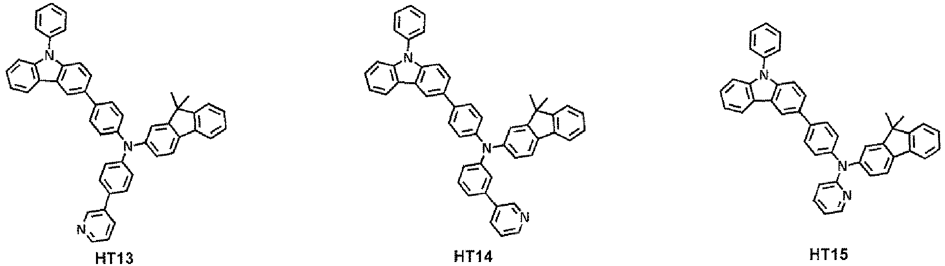

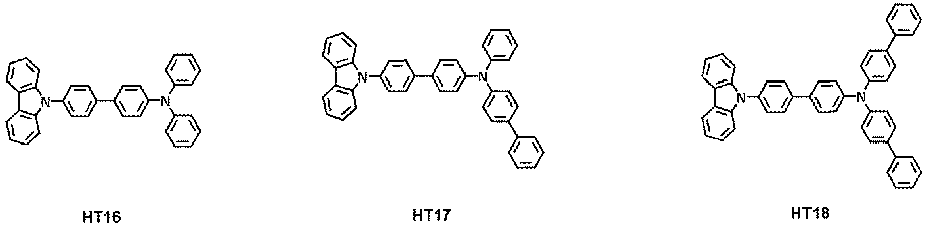

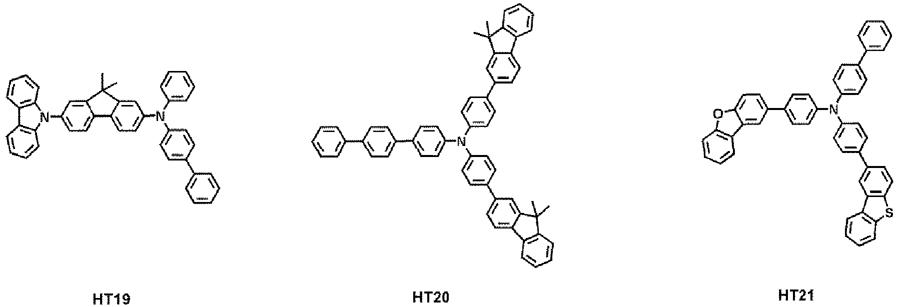

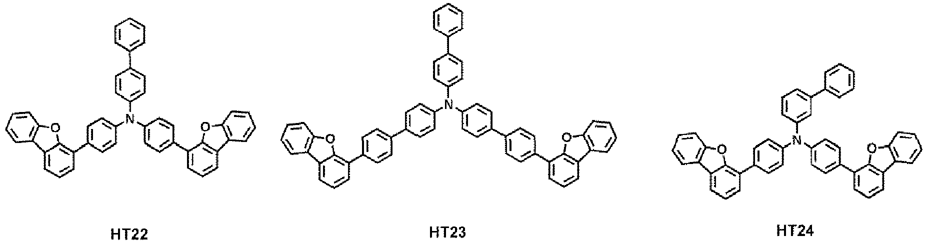

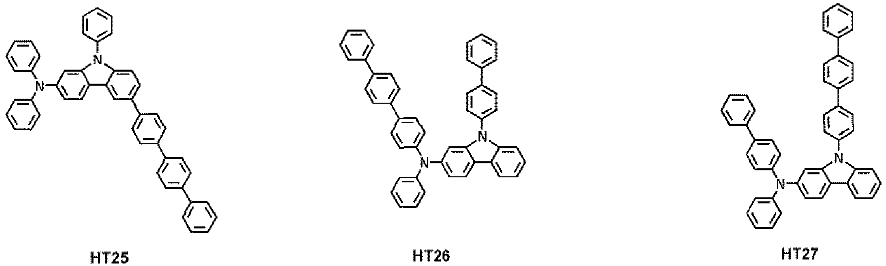

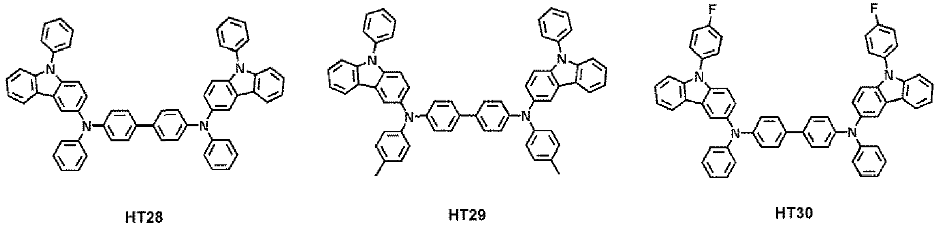

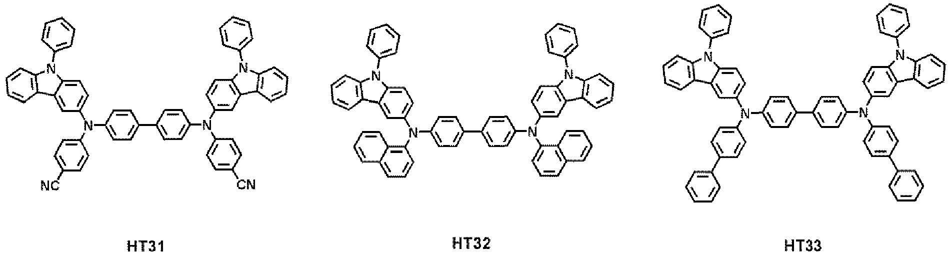

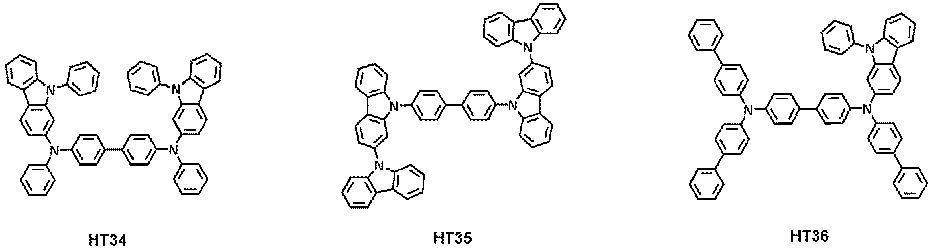

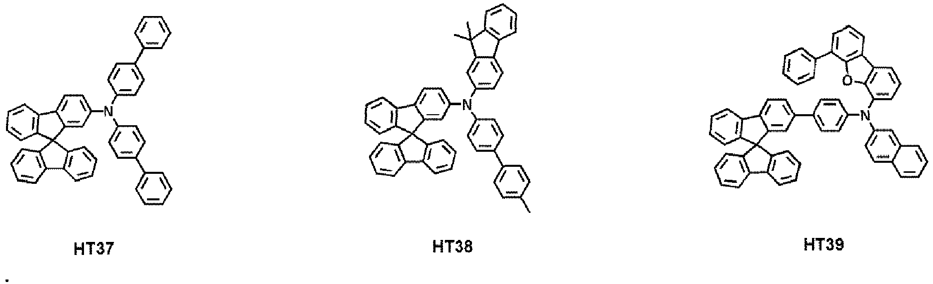

A thickness of the hole transport region may be in a range of about 100 Å to about 10,000 Å, for example, about 100 Å to about 1,000 Å. When the hole transport region comprises at least one of a hole injection layer and a hole transport layer, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within any of these ranges, satisfactory (or suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the flow of electrons from an electron transport region. The emission auxiliary layer and the electron blocking layer may comprise any of the materials as described above.

### p-dopant

The hole transport region may further comprise, in addition to the materials described above, a charge-generation material for the improvement of conductive properties. The charge-generation material may be homogeneously or non-homogeneously dispersed in the hole transport region.

The charge-generation material may be, for example, a p-dopant.

In various embodiments, the p-dopant may have a lowest unoccupied molecular orbital (LUMO) energy level of -3.5 eV or less.

The p-dopant may comprise at least one selected from a quinone derivative, a metal oxide, and a cyano group-containing compound, but embodiments are not limited thereto.

For example, the p-dopant may comprise at least one selected from the group consisting of:
a quinone derivative, such as tetracyanoquinodimethane (TCNQ) and/or 2,3,5,6-tetrafluoro-7,7,8,8-tetracyanoquinodimethane (F4-TCNQ);
a metal oxide, such as tungsten oxide and/or molybdenum oxide;
1,4,5,8,9,11-hexaazatriphenylene-hexacarbonitrile (HAT-CN); and
a compound represented by Formula 221,
but is not limited thereto:

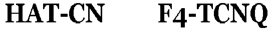

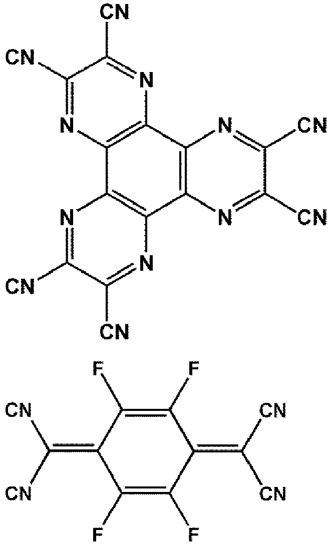

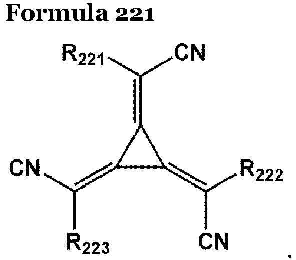

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, wherein at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full-color organic light-emitting device, the emission layer may be patterned into a red emission layer, a green emission layer, and/or a blue emission layer, according to a sub-pixel. In various embodiments, the emission layer may have a stacked structure of two or more layers selected from a red emission layer, a green emission layer, and a blue emission layer, in which the two or more layers contact each other or are separated from each other. In various embodiments, the emission layer may comprise two or more materials selected from a red-light emission material, a green-light emission material, and a blue-light emission material, in which the two or more materials are mixed with each other in a single layer to emit white light.

In various embodiments, the emission layer of the organic light-emitting device 10 may be a first-color-light emission layer, and
the organic layer may further comprise at least one second-color-light emission layer,
where the first color light and the second color light may be identical to or different from each other, and
the first color light and the second color light may be emitted as mixed light.

Herein, when the first color light is different from the second color light, a maximum luminance wavelength of the first color light is different from a maximum luminance wavelength of the second color light.

For example, the mixed light may be white light, but is not limited thereto.

In various embodiments, the emission layer of the organic light-emitting device 10 may be a first-color-light emission layer, and
the organic layer may further comprise at least one second-color-light emission layer and at least one third-color-light-emission layer,
where the first color light, the second color light, and the third color light may be identical to or different from one another, and
the first color light, the second color light, and the third color light may be emitted as mixed light.

Herein, when the first color light, the second color light, and the third color light are different from one another, a maximum luminance wavelength of the first color light, a maximum luminance wavelength of the second color light, a maximum luminance wavelength of the third color light are different from one another.

For example, the mixed light may be white light, but is not limited thereto.

As used herein the maximum luminescence wavelength of an emission layer is the wavelength of light emitted by the emission layer with maximum intensity.

The emission layer may comprise a host and a dopant. The dopant may comprise at least one selected from a phosphorescent dopant and a fluorescent dopant.

An amount of the dopant in the emission layer may be, for example, in a range of about 0.01 to about 15 parts by weight based on 100 parts by weight of the host, but is not limited thereto.

A thickness of the emission layer may be in a range of about 100 Å to about 1,000 Å, for example, about 200 Å to about 600 Å When the thickness of the emission layer is within any of these ranges, excellent (or suitable) light-emission characteristics may be obtained without a substantial increase in driving voltage.

### Host in emission layer

The host may comprise the first compound represented by Formula 1.

In various embodiments, the host may comprise the first compound represented by Formula 1and may futher comprise a compound represented by Formula 301 below.

In various embodiments, the emission layer comprises a first host and a second host,
the first host may be the first compound, and
the first host may be different from the second host, but embodiments are not limited thereto.

   **Formula 301** [Ar₃₀₁]_{xb11}-[(L_{g301})_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xb1 may be an integer selected from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₃₀₁₎(Q₃₀₂)(Q₃₀₃), -N(Q₃₀₁₎(Q₃₀₂), -B(Q₃₀₁)(Q₃₀₂), - C(=O)(Q₃₀₁), -S(=O)₂(Q₃₀₁), and -P(=O)(Q₃₀₁)(Q₃₀₂), and
xb2i may be an integer selected from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments are not limited thereto.

In various embodiments, Ar₃₀₁ in Formula 301 may be selected from the group consisting of:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂),
wherein Q₃₁ to Q₃₃ are each independently selected from a C₁-C₁₀ alkyl group, a C₁-C₁₀ alkoxy group, a phenyl group, a biphenyl group, a terphenyl group, and a naphthyl group, but embodiments are not limited thereto.

When xb11 in Formula 301 is two or more, two or more Ar₃₀₁(s) may be connected to each other via a single bond.

In various embodiments, the compound represented by Formula 301 may be represented by Formula 301-1 or 301-2: 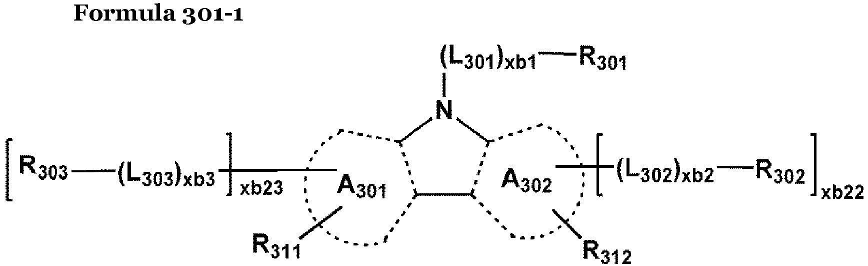 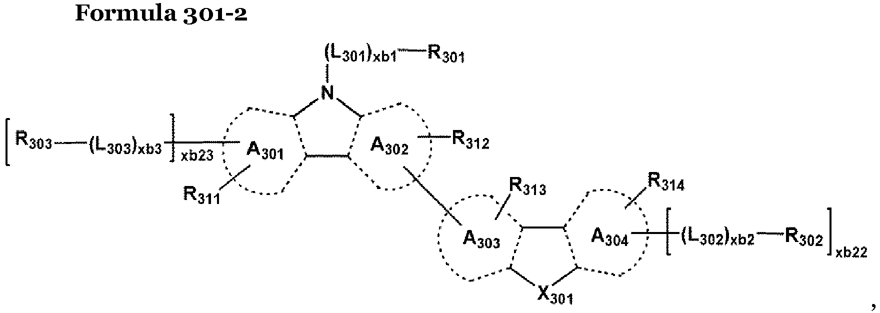 wherein in Formulae 301-1 to 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
xb22 and xb23 may each independently be 0, 1, or 2,
descriptions of L₃₀₁, xb1, R₃₀₁, and Q₃₁ to Q₃₃ may be the same as those provided above,
descriptions of L₃₀₂ to L₃₀₄ may each independently be the same as the description provided in connection with the L₃₀₁,
descriptions of xb2 to xb4 may each independently be the same as the description provided in connection with xb1,
descriptions of R₃₀₂ to R₃₀₄ may each independently be the same as the description provided in connection with R₃₀₁.

For example, L₃₀₁ to L₃₀₄ in Formulae 301, 301-1, and 301-2 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ are the same as described herein.

In various embodiments, R₃₀₁ to R₃₀₄ in Formulae 301, 301-1, and 301-2 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ are the same as described herein.

In various embodiments, the host may comprise an alkaline earth-metal complex. For example, the host may be selected from a Be complex (e.g., Compound H₅₅), a Mg complex, and a Zn complex.

The host may comprise at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but is not limited thereto:

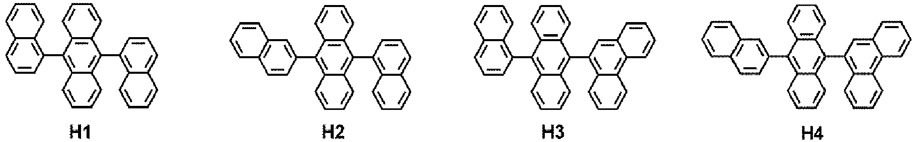

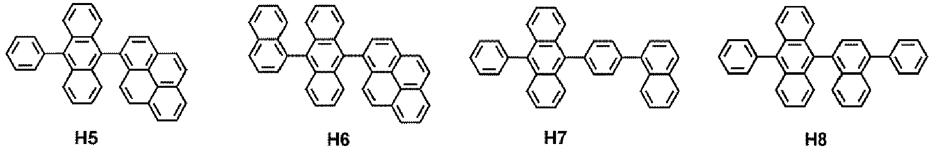

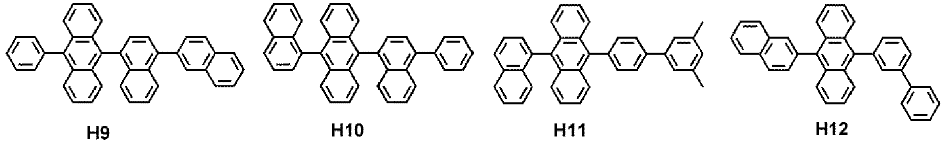

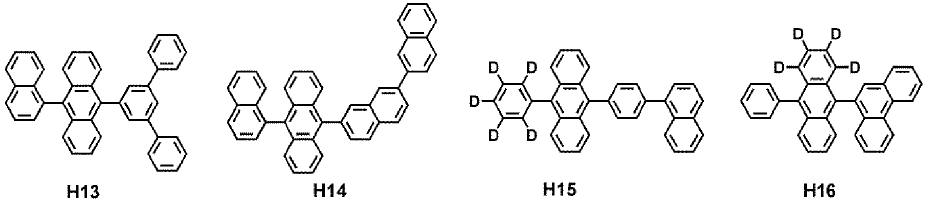

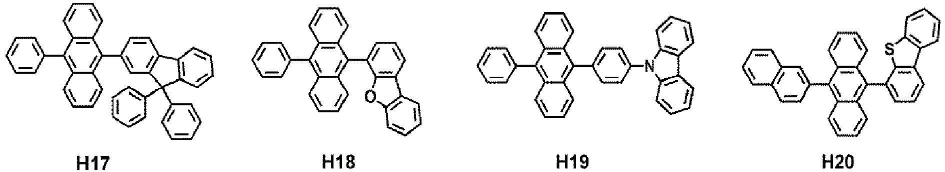

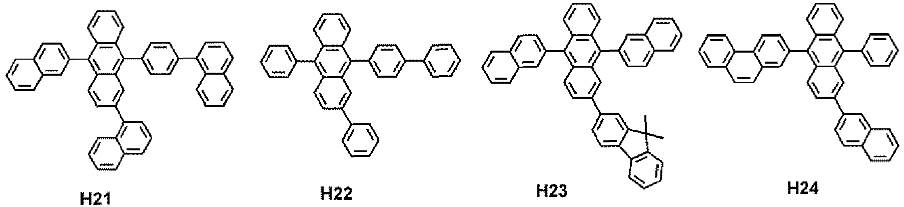

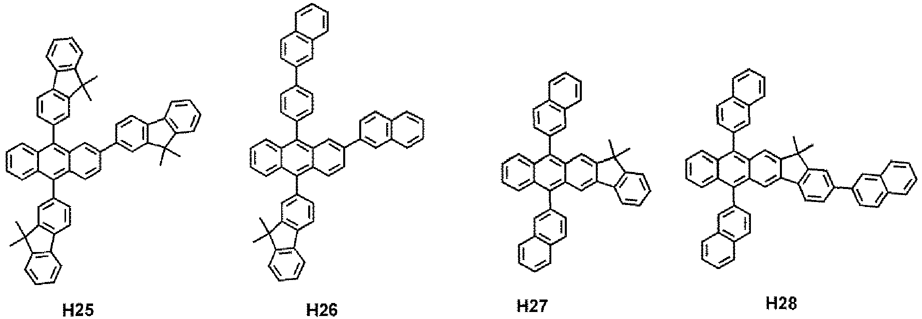

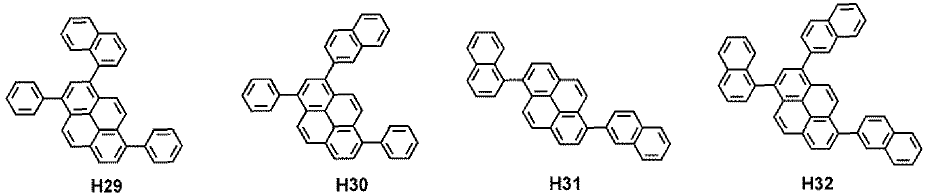

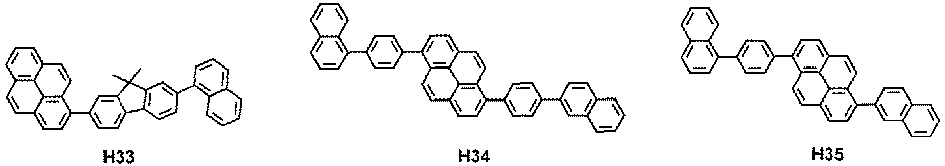

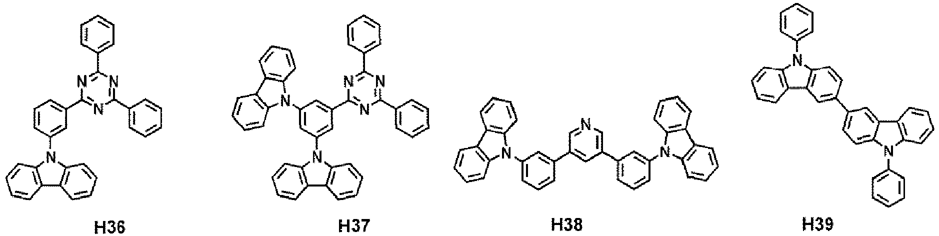

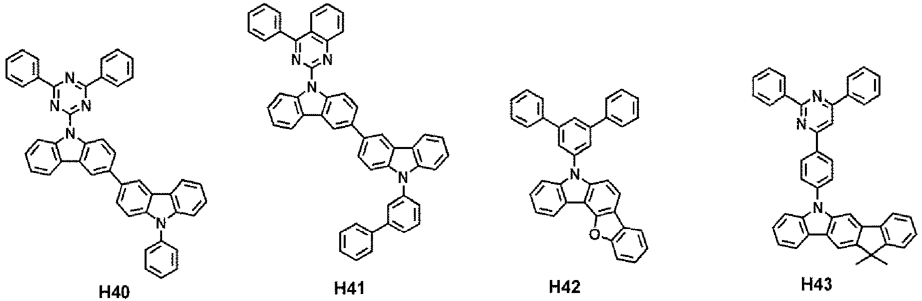

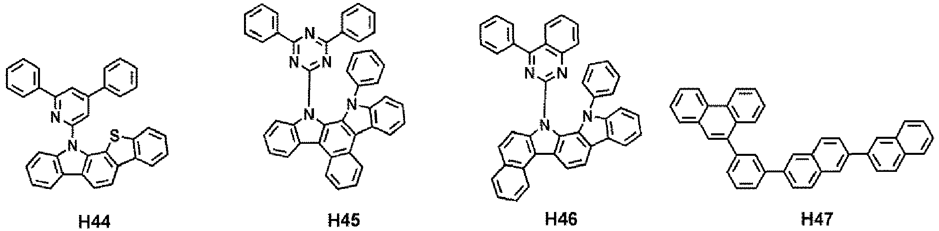

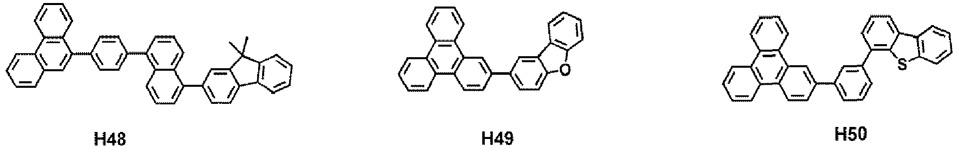

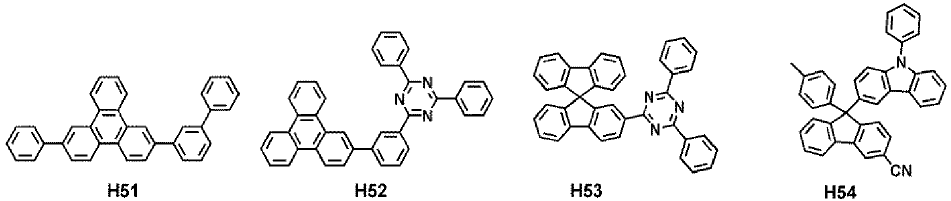

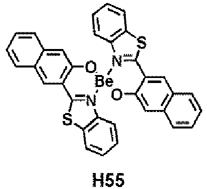

### Phosphorescent dopant included in emission layer in organic layer 150

The phosphorescent dopant may comprise an organometallic complex represented by Formula 401 below:

**Formula 401** M(L₄₀₁)_{xc1}(L₄₀₂)_{xc2}

in which L₄₀₁ may be selected from ligands represented by Formula 402:

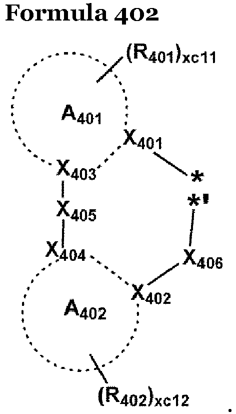

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3, wherein when xc1 is two or more, two or more L₄₀₁(s) may be identical to or different from each other,
L₄₀₂ may be an organic ligand, and xc2 may be an integer selected from 0 to 4, wherein when xc2 is two or more, two or more L₄₀₂(s) may be identical to or different from each other,
X₄₀₁ to X₄₀₄ may each independently be nitrogen or carbon,
X₄₀₁ and X₄₀₃ may be connected to each other via a single bond or a double bond, and X₄₀₂ and X₄₀₄ may be connected to each other via a single bond or a double bond,
A₄₀₁ and A₄₀₂ may each independently be a C₅-C₆₀ carbocyclic group or a C₁-C₆₀ heterocyclic group,
X₄₀₅ may be a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, or =C(Q₄₁₁)=, wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, - F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₂), -B(Q₄₀₁)(Q₄₀₂), - C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
^{∗} and ^{∗}' in Formula 402 each independently indicate a binding site to M in Formula 401.

In various embodiments, A₄₀₁, and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In various embodiments, in Formula 402, i) X₄₀₁ may be nitrogen and X₄₀₂ may be carbon, or ii) both X₄₀₁ and X₄₀₂ may be nitrogen.

In various embodiments, R₄₀₁ and R₄₀₂ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments are not limited thereto.

In various embodiments, when xc1 in Formula 401 is two or more, two A₄₀₁(s) selected from two or more L₄₀₁(s) may be optionally connected to each other via a linking group X₄₀₇, or two A₄₀₂(s) may be connected to each other via a linking group X₄₀₈ (see e.g., Compounds PD1 to PD4 and PD7 below). X₄₀₇ and X₄₀₈ may each independently be a single bond, ^{∗}-O-^{∗}', ^{∗}-S-^{∗}, ^{∗}-C(=O)-^{∗}', ^{∗}-N(Q₄₁₃)-^{∗}', ^{∗}-C(Q₄₁₃)(Q₄₁₄)-^{∗}', or ^{∗}-C(Q₄₁₃)=C(Q₄₁₄)-^{∗}' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but are not limited thereto.

L₄₀₂ in Formula 401 may be any suitable monovalent, divalent, or trivalent organic ligand. For example, L₄₀₂ may be selected from a halogen ligand, a diketone ligand (e.g., an acetylacetonate), a carboxylic acid ligand (e.g., a picolinate), -C(=O), an isonitrile, -CN, and a phosphorus ligand (e.g., phosphine and/or phosphite), but is not limited thereto.

In various embodiments, the phosphorescent dopant may be selected from, for example, Compounds PD1 to PD25, but is not limited thereto:

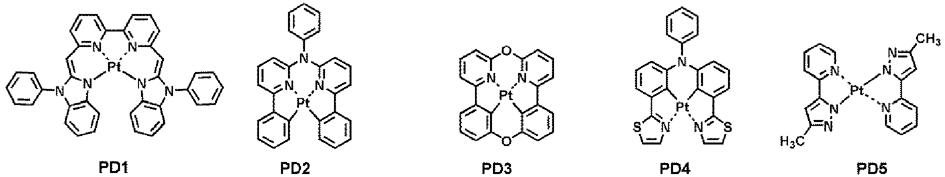

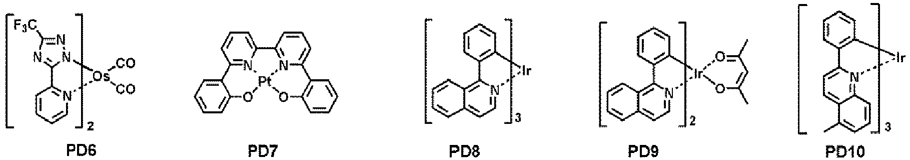

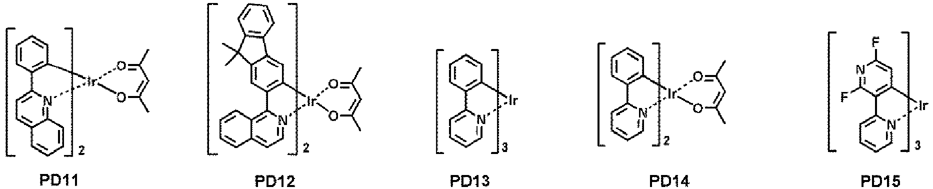

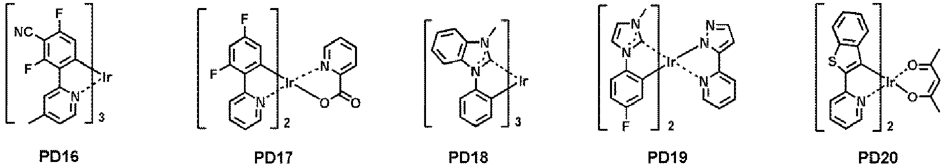

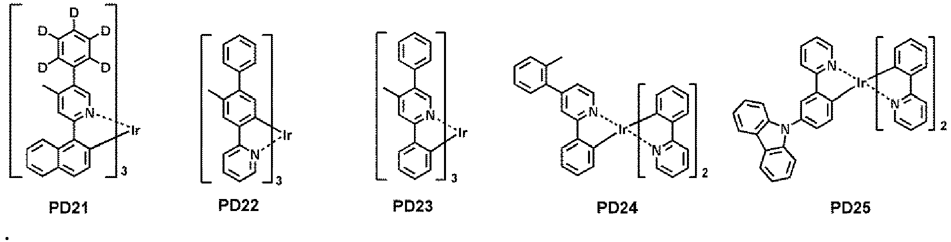

### Fluorescent dopant in emission layer

The fluorescent dopant may comprise an arylamine compound or a styrylamine compound.

The fluorescent dopant may comprise a compound represented by Formula 501 below.

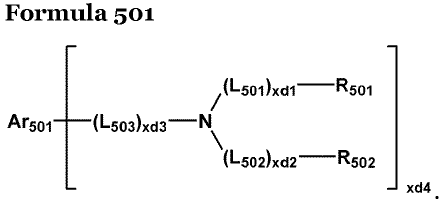

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xd1 to xd3 may each independently be an integer selected from 0 to 3,
R₅₀₁ to R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arythio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, and
xd4 may be an integer selected from 1 to 6.

In various embodiments, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In various embodiments, L₅₀₁ to L₅₀₃ in Formula 501 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In various embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In various embodiments, xd4 in Formula 501 may be 2, but is not limited thereto.

For example, the fluorescent dopant may be selected from Compounds FD1 to FD22:

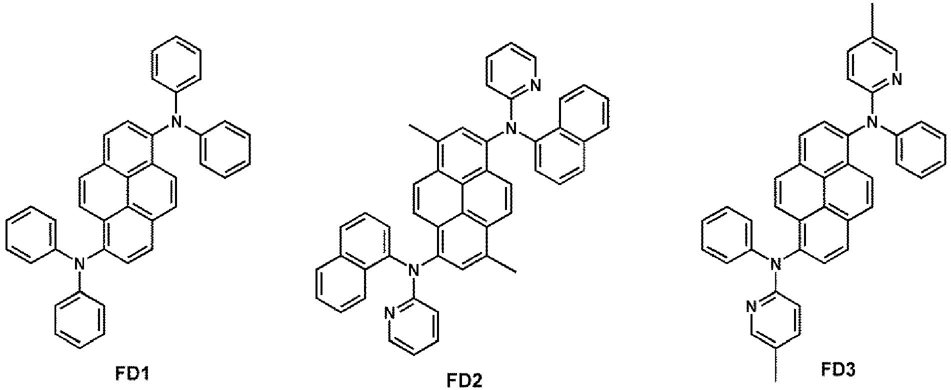

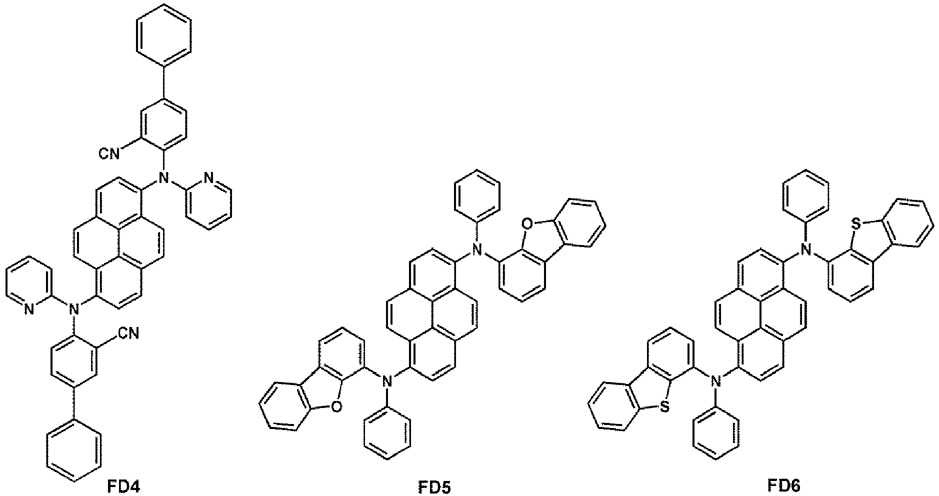

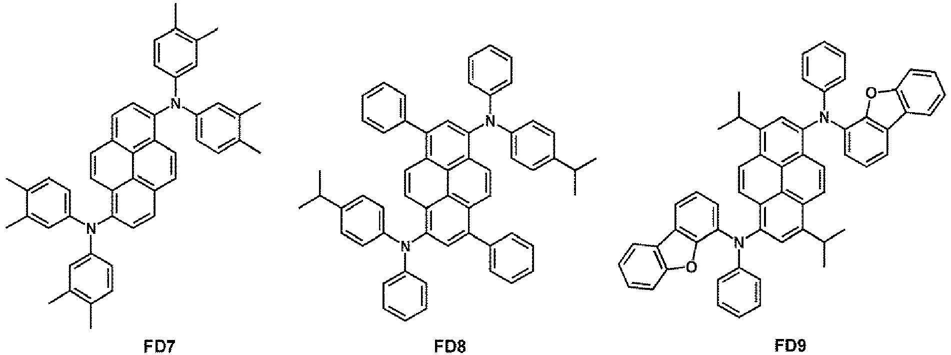

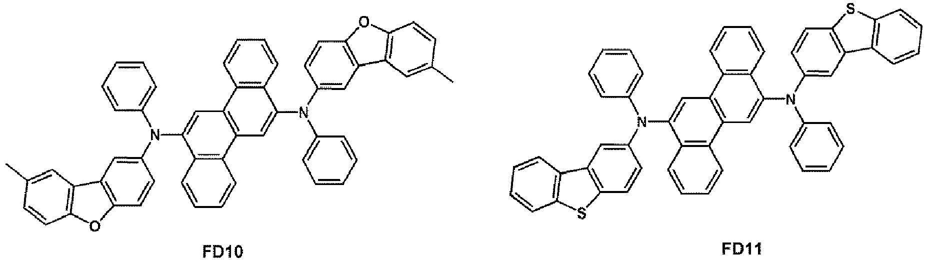

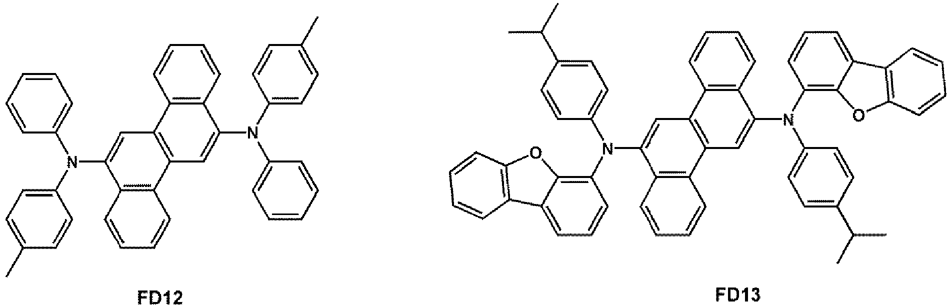

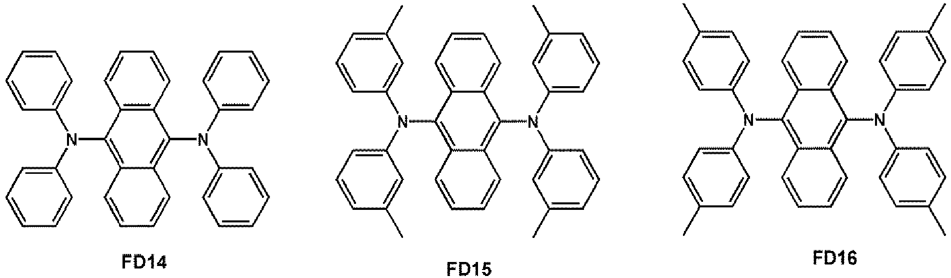

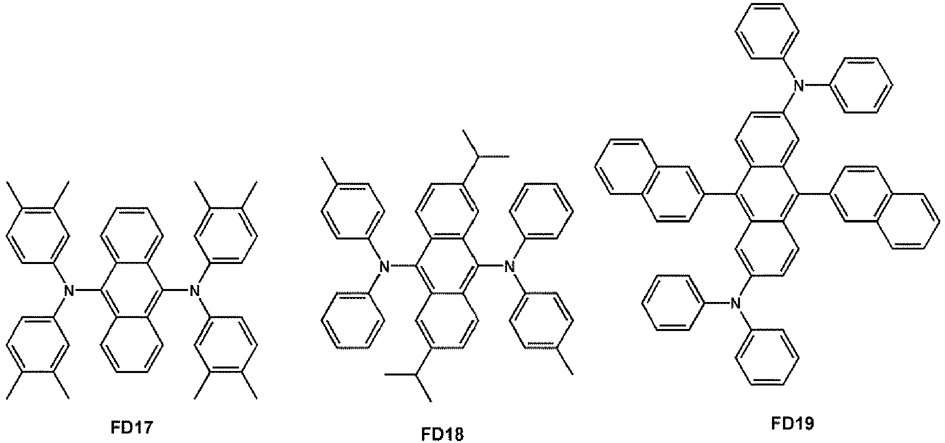

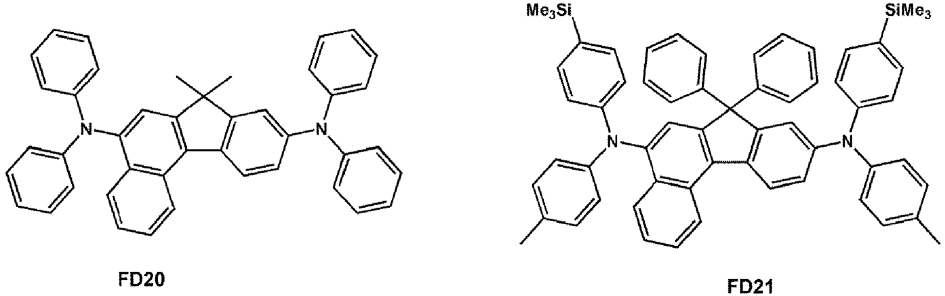

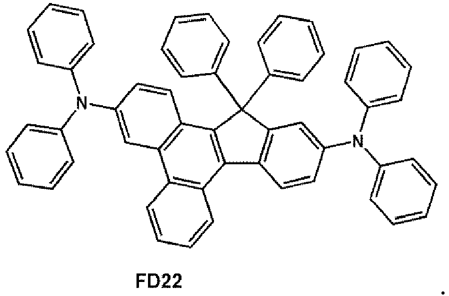

In various embodiments, the fluorescent dopant may be selected from compounds illustrated below, but is not limited thereto:

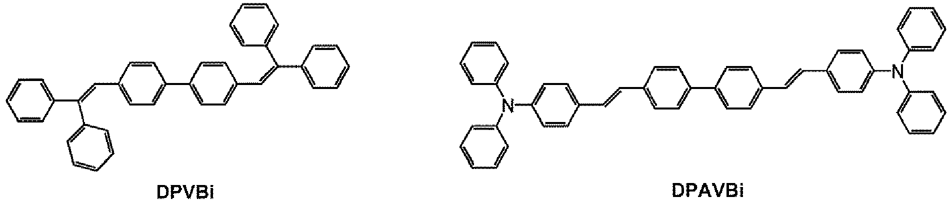

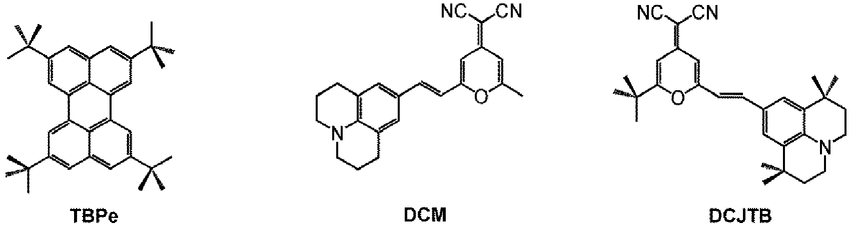

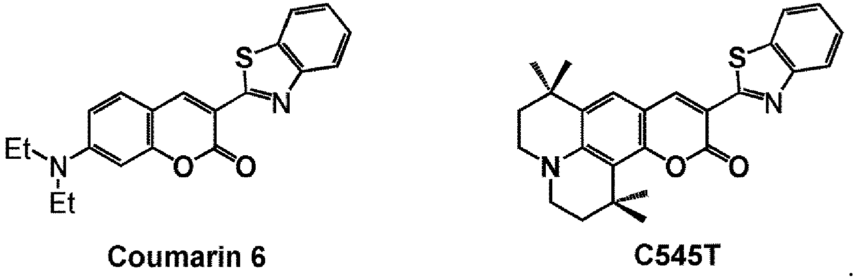

### Electron transport region in organic layer 150

The electron transport region may have i) a single-layered structure having a single layer including a single material, ii) a single-layered structure having a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer, and an electron injection layer, but is not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein in each of these structures, constituting layers are sequentially stacked in this stated order from an emission layer. However, the structure of the electron transport region is not limited thereto.

The electron transport region (e.g., a buffer layer, a hole blocking layer, an electron control layer, and/or an electron transport layer in the electron transport region) may comprise a metal-free compound containing at least one π electron-depleted nitrogen-containing ring.

The term "π electron-depleted nitrogen-containing ring" as used herein may refer to a C₁-C₆₀ heterocyclic group having at least one ^{∗}-N=^{∗}' moiety as a ring-forming moiety.

For example, the "π electron-depleted nitrogen-containing ring" may be i) a 5-membered to 7-membered hetero monocyclic group having at least one ^{∗}-N=^{∗}' moiety, ii) a hetero polycyclic group in which two or more 5-membered to 7-membered hetero monocyclic groups, each having at least one ^{∗}-N=^{∗}' moiety, are condensed (e.g., fused) with each other, or iii) a hetero polycyclic group in which at least one of 5-membered to 7-membered hetero monocyclic groups, each having at least one ^{∗}-N=^{∗}' moiety, is condensed (e.g., fused) with at least one C₅-C₆₀ carbocyclic group.

Examples of the π electron-depleted nitrogen-containing ring include an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, but are not limited thereto.

For example, the electron transport region may comprise a compound represented by Formula 601 (described below).

For example, the electron transport region (e.g., a buffer layer, a hole blocking layer, an electron control layer, and/or an electron transport layer in the electron transport region) may comprise the second compound represented by Formula 2.

For example, the electron transport region (e.g., a buffer layer, a hole blocking layer, an electron control layer, and/or an electron transport layer in the electron transport region) may comprise the first compound represented by Formula 1 and the second compound represented by Formula 2.

In various embodiments, the electron transport region may comprise a first layer, and the first layer may comprise the second compound represented by Formula 2, but embodiments are not limited thereto. In this regard, the first layer may be an electron transport layer.

In various embodiments, the electron transport region may comprise a first layer and a second layer, the first layer being between the emission layer and the second layer, and the first layer may comprise the second compound represented by Formula 2, but embodiments are not limited thereto. In this regard, the first layer may be a buffer layer, and the second layer may be an electron transport layer.

In various embodiments, the electron transport region may comprise a first layer and a second layer, the first layer being between the emission layer and the second layer, and the first layer may comprise the first compound represented by Formula 1 and the second layer may comprise the second compound represented by Formula 2, but embodiments are not limited thereto. In this regard, the first layer may be a buffer layer, and the second layer may be an electron transport layer.

In various embodiments, the electron transport region may comprise a first layer and a second layer, the first layer being between the emission layer and the second layer, the first layer may comprise the second compound represented by Formula 2, the second layer may comprise the second compound represented by Formula 2, and the second compound comprised in the first layer may be different from the second compound comprised in the second layer, but embodiments are not limited thereto. In this regard, the first layer may be a buffer layer, and the second layer may be an electron transport layer.

The electron transport region may further comprise, in addition to the second compound represented by Formula 2, or in addition to the first compound represented by Formula 1 and the second compound represented by Formula 2, a compound represented by Formula 601.

**Formula 601** [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₆₀₁)(Q₆₀₂)(Q₆₀₃), -C(=O)(Q₆₀₁), -S(=O)₂(Q₆₀₁), and - P(=O)(Q₆₀₁₎(Q₆₀₂),
where Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe2i may be an integer selected from 1 to 5.

In various embodiments, xe11 number of Ar₆₀₁(s) and/or xe2i number of R₆₀₁(s) may comprise the π electron-depleted nitrogen-containing ring as described herein.

In various embodiments, Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be connected to each other via a single bond.

In various embodiments, Ar₆₀₁ in Formula 601 may be an anthracene group.

In various embodiments, a compound represented by Formula 601 may be represented by Formula 601-1:

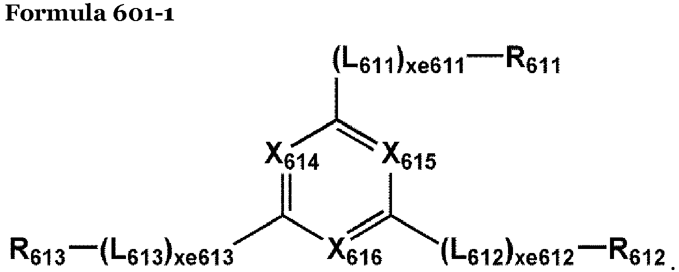

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
descriptions of L₆₁₁ to L₆₁₃ may each independently be the same as the description provided in connection with L₆₀₁,
descriptions of xe611 to xe613 may each independently be the same as the description provided in connection with xei,
descriptions of R₆₁₁ to R₆₁₃ may each independently be the same as the description provided in connection with R₆₀₁,
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In various embodiments, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments are not limited thereto.

In various embodiments, xe1 and xe611 to xe613 in Formulae 601 and 601-1 may each independently be 0, 1, or 2.

In various embodiments, R₆₀₁, and R₆₁₁ to R₆₁₃ in Formulae 601 and 601-1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

   -S(=O)₂(Q₆₀₁) and -P(=O)(Q₆₀₁)(Q₆₀₂),

   wherein Q₆₀₁ and Q₆₀₂ are the same as described herein.

The electron transport region may comprise at least one compound selected from Compounds ET1 to ET36, but is not limited thereto:

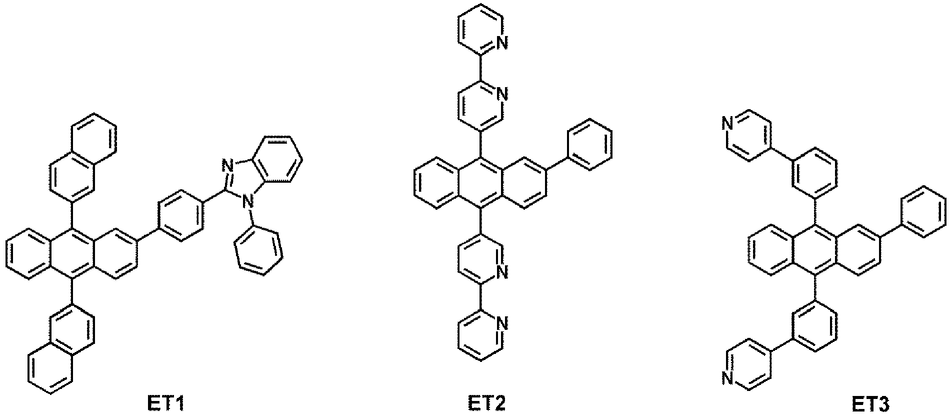

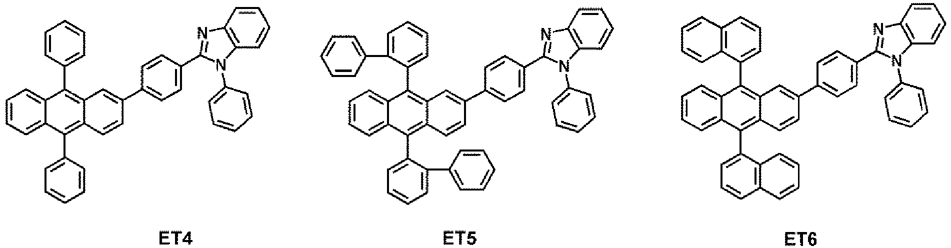

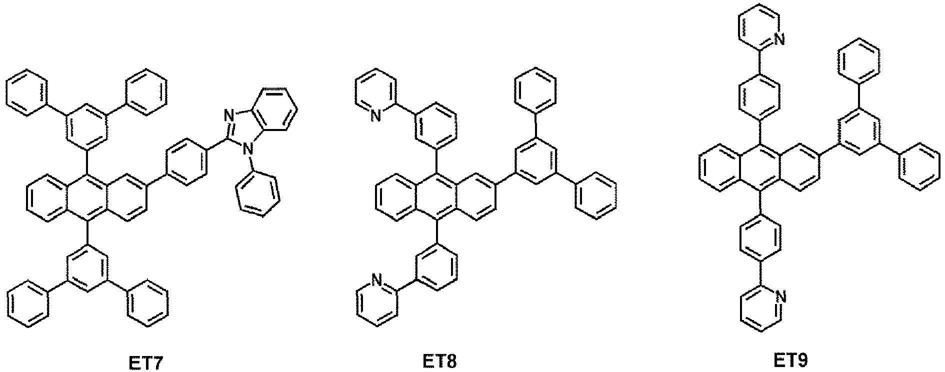

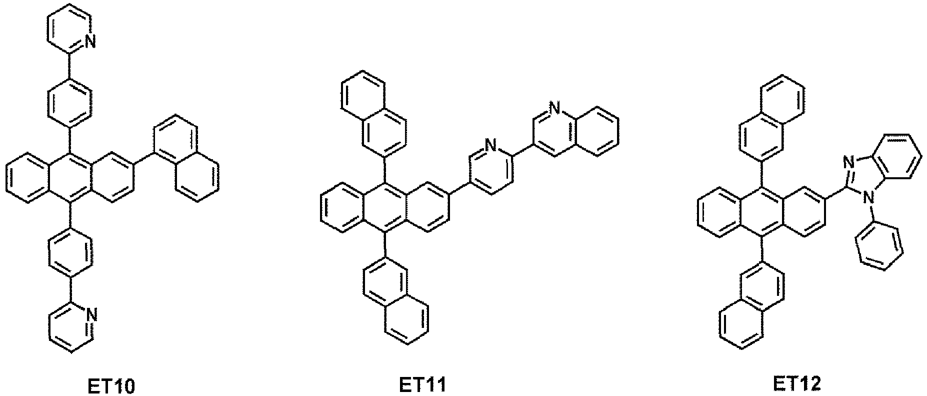

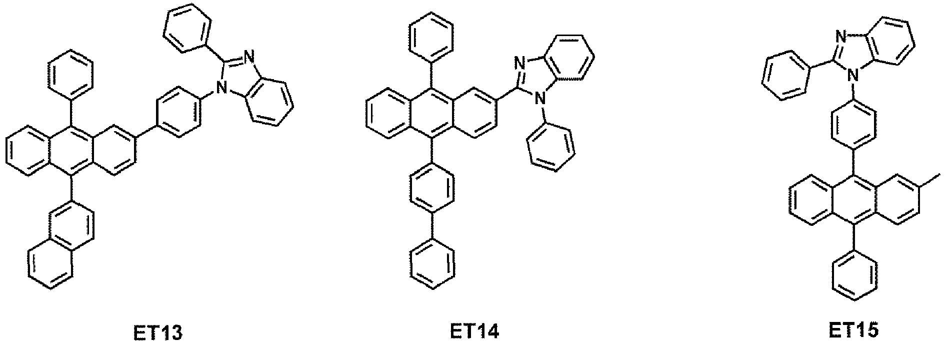

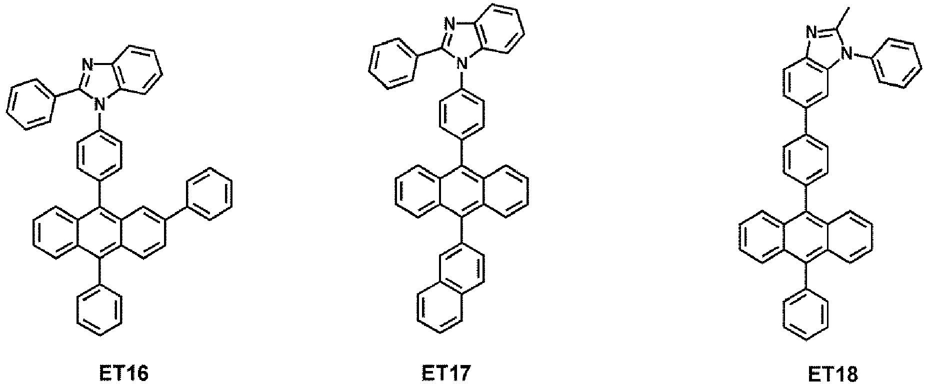

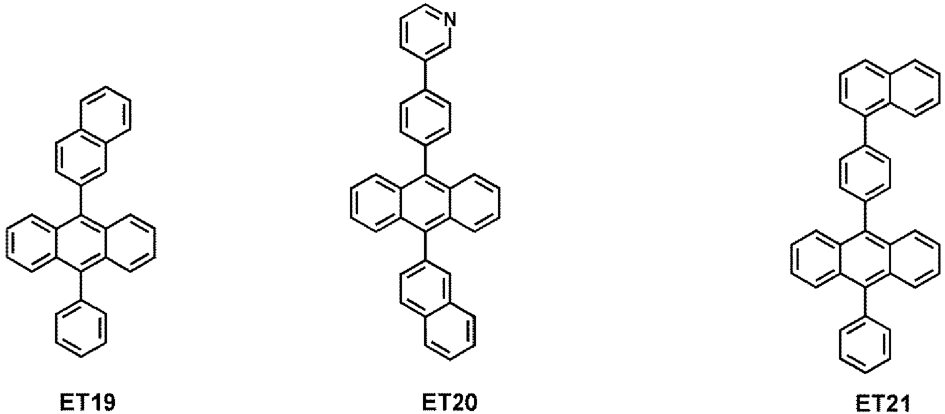

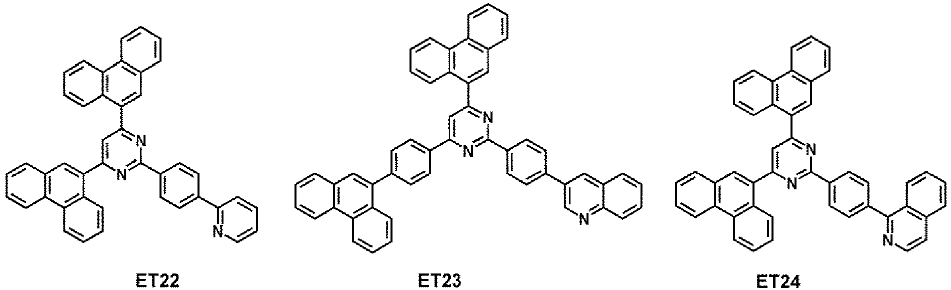

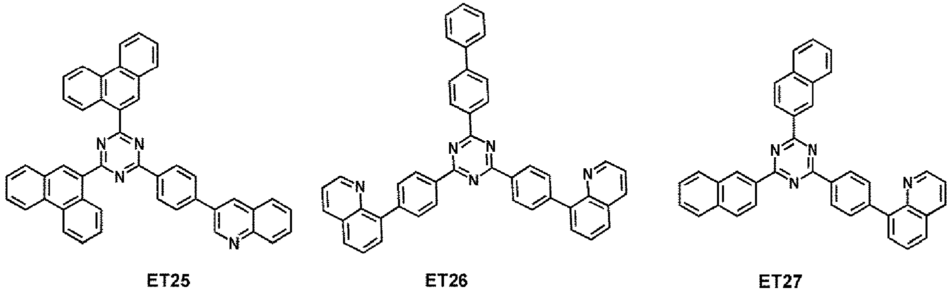

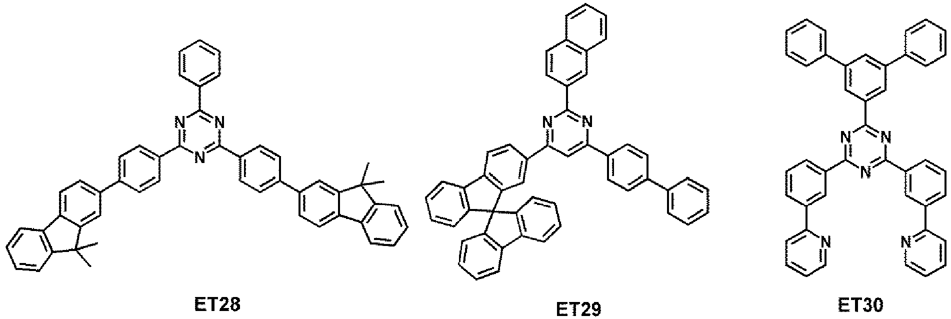

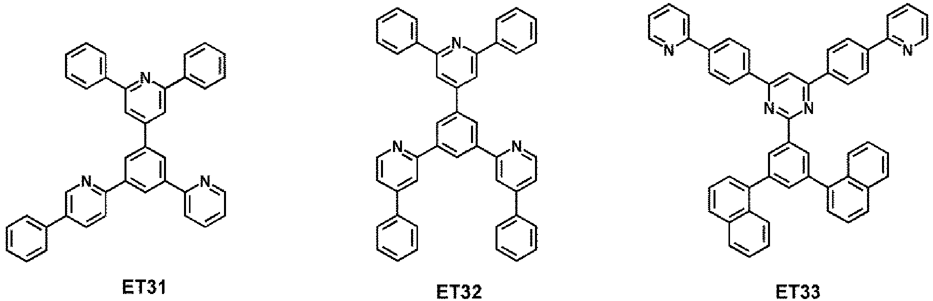

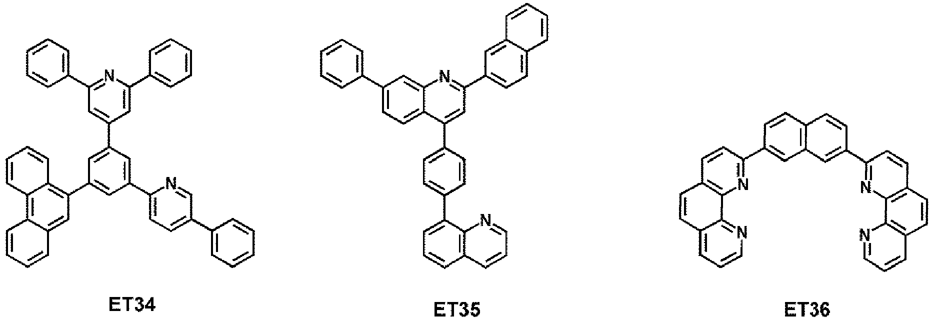

In various embodiments, the electron transport region may comprise at least one selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

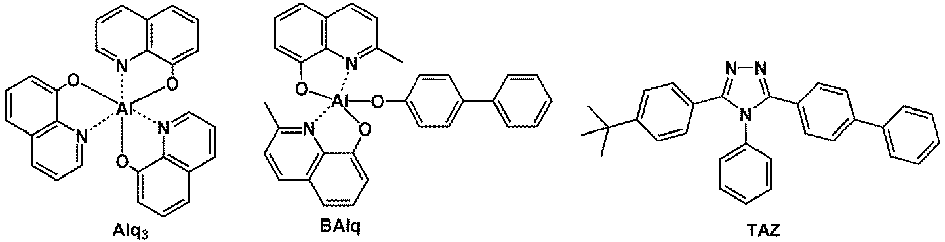

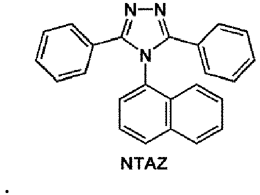

A thickness of the buffer layer, the hole blocking layer, and the electron control layer may each independently be in a range of about 20 Å to about 1,000 Å, for example, about 30 Å to about 300 Å. When the thicknesses of the buffer layer, the hole blocking layer, and the electron control layer are within any of these ranges, the electron transport region may have excellent (or suitable) hole blocking characteristics and/or electron control characteristics without a substantial increase in driving voltage.

A thickness of the electron transport layer may be in a range of about 100 Å to about 1,000 Å, for example, about 150 Å to about 500 Å. When the thickness of the electron transport layer is within any of the ranges described above, the electron transport layer may have satisfactory (or suitable) electron transport characteristics without a substantial increase in driving voltage.

The electron transport region (e.g., the electron transport layer in the electron transport region) may further comprise, in addition to the materials described above, a metal-containing material.

The metal-containing material may comprise at least one selected from an alkaline metal complex and an alkaline earth-metal complex. The alkaline metal complex may comprise a metal ion selected from a Li ion, a Na ion, a K ion, a Rb ion, and a Cs ion; and the alkaline earth-metal complex may comprise a metal ion selected from a Be ion, a Mg ion, a Ca ion, a Sr ion, and a Ba ion. A ligand coordinated with the metal ion of the alkaline metal complex or the alkaline earth-metal complex may each independently be selected from a hydroxy quinoline, a hydroxy isoquinoline, a hydroxy benzoquinoline, a hydroxy acridine, a hydroxy phenanthridine, a hydroxy phenylan oxazole, a hydroxy phenylthiazole, a hydroxy diphenylan oxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but is not limited thereto.

For example, the metal-containing material may comprise a Li complex. The Li complex may comprise, for example, Compound ET-Di (lithium quinolate, LiQ) and/or Compound ET-D2:

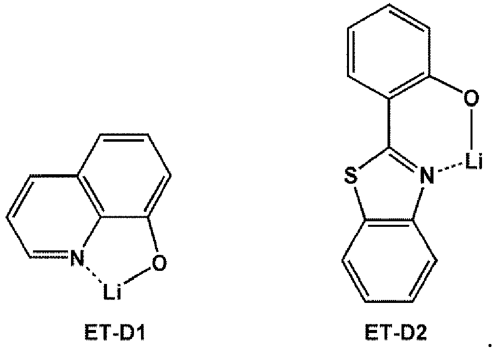

The electron transport region may comprise an electron injection layer that facilitates injection of electrons from the second electrode 190. The electron injection layer may directly contact the second electrode 190.

The electron injection layer may have i) a single-layered structure having a single layer including a single material, ii) a single-layered structure having a single layer comprising a plurality of different materials, or iii) a multi-layered structure having a plurality of layers comprising a plurality of different materials.

The electron injection layer may comprise an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof.

The alkaline metal may be selected from Li, Na, K, Rb, and Cs. In various embodiments, the alkaline metal may be Li, Na, or Cs. In various embodiments, the alkaline metal may be Li or Cs, but is not limited thereto.

The alkaline earth metal may be selected from Mg, Ca, Sr, and Ba.

The rare-earth metal may be selected from Sc, Y, Ce, Tb, Yb, Gd, and Tb.

The alkaline metal compound, the alkaline earth-metal compound, and the rare-earth metal compound may be selected from oxides and halides (e.g., fluorides, chlorides, bromides, and/or iodines) of the alkaline metal, the alkaline earth-metal and the rare-earth metal, respectively.

The alkaline metal compound may be selected from alkaline metal oxides (such as Li₂O, Cs₂O, and/or K₂O) and alkaline metal halides (such as LiF, NaF, CsF, KF, LiI, NaI, CsI, and/or KI). In various embodiments, the alkaline metal compound may be selected from LiF, Li₂O, NaF, LiI, NaI, CsI, and KI, but is not limited thereto.

The alkaline earth-metal compound may be selected from, for example, BaO, SrO, CaO, BaₓSr₁₋ₓO (0<x<1), and BaₓCa₁₋ₓO (0<x<1). In various embodiments, the alkaline earth-metal compound may be selected from BaO, SrO, and CaO, but is not limited thereto.

The rare-earth metal compound may be selected from YbF₃, ScF₃, ScO₃, Y₂O₃, Ce₂O₃, GdF₃, and TbF₃. In various embodiments, the rare-earth metal compound may be selected from YbF₃, ScF₃, TbF₃, YbI₃, ScI₃, and TbI₃, but is not limited thereto.

The alkaline metal complex, the alkaline earth-metal complex, and the rare-earth metal complex may comprise an ion of the alkaline metal, an ion of the alkaline earth metal, and an ion of the rare-earth metal, respectively, as described above, and a ligand coordinated with the ion of the alkaline metal complex, the alkaline earth-metal complex, and the rare-earth metal complex may each independently be selected from a hydroxy quinoline, a hydroxy isoquinoline, a hydroxy benzoquinoline, a hydroxy acridine, a hydroxy phenanthridine, a hydroxy phenylan oxazole, a hydroxy phenylthiazole, a hydroxy diphenylan oxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but is not limited thereto.

The electron injection layer may comprise an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof, as described above. In various embodiments, the electron injection layer may further comprise an organic material. When the electron injection layer further comprises an organic material, an alkaline metal, an alkaline earth metal, a rare-earth metal, an alkaline metal compound, an alkaline earth-metal compound, a rare-earth metal compound, alkaline metal complex, an alkaline earth-metal complex, a rare-earth metal complex, or a combination thereof may be homogeneously or non-homogeneously dispersed in a matrix comprising the organic material.

A thickness of the electron injection layer may be in a range of about 1 Å to about 100 Å, for example, about 3 Å to about 90 Å. When the thickness of the electron injection layer is within any of the ranges described above, the electron injection layer may have satisfactory (or suitable) electron injection characteristics without a substantial increase in driving voltage.

### Second electrode 190

The second electrode 190 may be disposed (e.g., positioned) on the organic layer 150 having the structure according to embodiments of the present disclosure. The second electrode 190 may be a cathode, which is an electron injection electrode, and in this regard, a material for forming the second electrode 190 may be selected from a metal, an alloy, an electrically conductive compound, and a mixture thereof, which have a relatively low work function.

In some embodiments, the second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but is not limited thereto. The second electrode 190 may be a transmissive electrode, a semi-transmissive electrode, or a reflective electrode.

The second electrode 190 may have a single-layered structure, or a multi-layered structure comprising two or more layers.

### Description of FIGS. 2 to 4

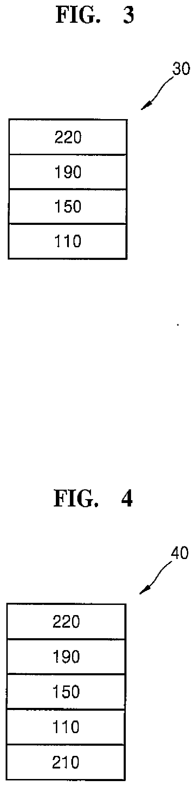

An organic light-emitting device 20 of FIG. 2 comprises a first capping layer 210, a first electrode 110, an organic layer 150, and a second electrode 190 which are sequentially stacked in this stated order; an organic light-emitting device 30 of FIG. 3 comprises a first electrode 110, an organic layer 150, a second electrode 190, and a second capping layer 220 which are sequentially stacked in this stated order; and an organic light-emitting device 40 of FIG. 4 comprises a first capping layer 210, a first electrode 110, an organic layer 150, a second electrode 190, and a second capping layer 220 which are sequentially stacked in this stated order.

Regarding FIGS. 2 to 4, descriptions of the first electrode 110, the organic layer 150, and the second electrode 190 may be understood by referring to the descriptions thereof presented in connection with FIG. 1.

In the organic layer 150 of each of the organic light-emitting devices 20 and 40, light generated in an emission layer may pass through the first electrode 110 (which may be a semi-transmissive electrode or a transmissive electrode) and the first capping layer 210 toward the outside; and in the organic layer 150 of each of the organic light-emitting devices 30 and 40, light generated in an emission layer may pass through the second electrode 190 (which may be a semi-transmissive electrode or a transmissive electrode) and the second capping layer 220 toward the outside.

The first capping layer 210 and the second capping layer 220 may increase external luminescent efficiency according to the principle of constructive interference.

The first capping layer 210 and the second capping layer 220 may each independently be an organic capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from carbocyclic compounds, heterocyclic compounds, amine-based compounds, porphine derivatives, phthalocyanine derivatives, naphthalocyanine derivatives, alkaline metal complexes, and alkaline earth-based complexes. The carbocyclic compound, the heterocyclic compound, and the amine-based compound may be optionally substituted with a substituent containing at least one element selected from O, N, S, Se, Si, F, Cl, Br, and I. In various embodiments, at least one selected from the first capping layer 210 and the second capping layer 220 may comprise an amine-based compound.

In one embodiment, at least one selected from the first capping layer 210 and the second capping layer 220 may comprise the compound represented by Formula 201 or the compound represented by Formula 202.

In various embodiments, at least one selected from the first capping layer 210 and the second capping layer 220 may comprise a compound selected from Compounds HT28 to HT33 and Compounds CP1 to CP5, but is not limited thereto:

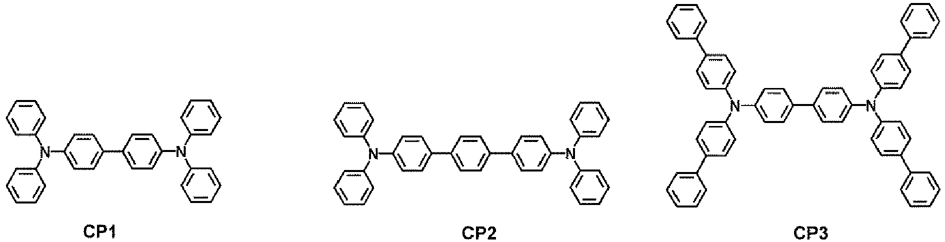

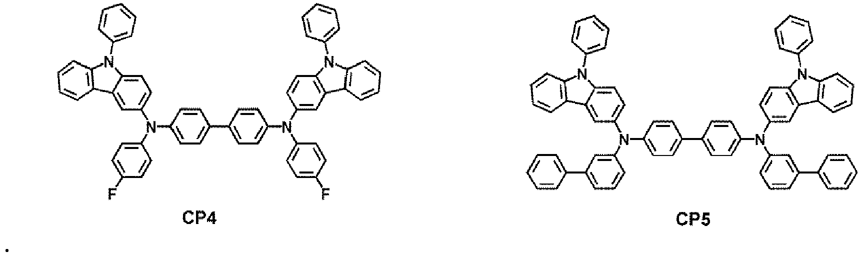

Hereinbefore, the organic light-emitting device according to an embodiment of the present disclosure has been described in connection with FIGS. 1 to 4. However, present embodiments are not limited thereto.

Layers constituting the hole transport region, the emission layer, and layers constituting the electron transport region may each independently be formed in a certain region by using one or more suitable methods such as vacuum deposition, spin coating, casting, langmuir-blodgett (LB) deposition, ink-jet printing, laser-printing, and/or laser-induced thermal imaging.

When layers constituting the hole transport region, the emission layer, and layers constituting the electron transport region are each independently formed by vacuum deposition, for example, the vacuum deposition may be performed at a deposition temperature of about 100 to about 500□, at a vacuum degree of about 10⁻⁸ to about 10⁻³ torr, and at a deposition rate of about 0.01 to about 100 Å/sec, by taking into account a compound to be comprised in a layer to be formed, and a structure of a layer to be formed.

When layers constituting the hole transport region, the emission layer, and layers constituting the electron transport region are each independently formed by spin coating, for example, the spin coating may be performed at a coating speed of about 2,000 rpm to about 5,000 rpm and at a heat treatment temperature of about 80°C to 200°C, by taking into account a compound to be comprised in a layer to be formed, and the structure of a layer to be formed.

### General definition of substituents

The term "C₁-C₆₀ alkyl group," as used herein, may refer to a linear or branched aliphatic saturated hydrocarbon monovalent group having 1 to 60 carbon atoms e.g. 1 to 30 carbon atoms, 1 to 20 carbon atoms, 1 to 10 carbon atoms, 1 to 6 carbon atoms or 1 to 4 carbon atoms. Non-limiting examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group," as used herein, may refer to a divalent group having the same structure as the C₁-C₆₀ alkyl group.

The term "C₂-C₆₀ alkenyl group," as used herein, may refer to a hydrocarbon group having at least one carbon-carbon double bond at one or more positions along the hydrocarbon chain of the C₂-C₆₀ alkyl group (e.g., in the middle and/or at the terminus of the C₂-C₆₀ alkyl group), and non-limiting examples thereof include an ethenyl group, a propenyl group, and a butenyl group. The term "C₂-C₆₀ alkenylene group," as used herein, may refer to a divalent group having the same structure as the C₂-C₆₀ alkenyl group.

The term "C₂-C₆₀ alkynyl group," as used herein, may refer to a hydrocarbon group having at least one carbon-carbon triple bond at one or more positions along the hydrocarbon chain of the C₂-C₆₀ alkyl group (e.g., in the middle and/or at the terminus of the C₂-C₆₀ alkyl group), and non-limiting examples thereof include an ethynyl group and a propynyl group. The term "C₂-C₆₀ alkynylene group," as used herein, may refer to a divalent group having the same structure as the C₂-C₆₀ alkynyl group.

The term "C₁-C₆₀ alkoxy group," as used herein, may refer to a monovalent group represented by -OA₁₀₁ (wherein A₁₀₁ is the C₁-C₆₀ alkyl group), and non-limiting examples thereof include a methoxy group, an ethoxy group, and an isopropoxy group.

The term "C₃-C₁₀ cycloalkyl group," as used herein, may refer to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group," as used herein, may refer to a divalent group having the same structure as the C₃-C₁₀ cycloalkyl group.

The term "C₁-C₁₀ heterocycloalkyl group," as used herein, may refer to a monovalent monocyclic group having at least one heteroatom (e.g. 1, 2, 3, 4 or 5 hereoatoms) selected from N, O, Si, P, and S as a ring-forming atom, and 1 to 10 carbon atoms, and non-limiting examples thereof include a tetrahydrofuranyl group and a tetrahydrothiophenyl group. The term "C₁-C₁₀ heterocycloalkylene group," used herein, may refer to a divalent group having the same structure as the C₁-C₁₀ heterocycloalkyl group.

The term "C₃-C₁₀ cycloalkenyl group," as used herein, may refer to a monovalent monocyclic group that has 3 to 10 carbon atoms and at least one carbon-carbon double bond in the ring thereof and does not have aromaticity, and non-limiting examples thereof include a cyclopentenyl group, a cyclohexenyl group, and a cycloheptenyl group. The term "C₃-C₁₀ cycloalkenylene group," used herein, may refer to a divalent group having the same structure as the C₃-C₁₀ cycloalkenyl group.

The term "C₁-C₁₀ heterocycloalkenyl group," as used herein, may refer to a monovalent monocyclic group that has at least one heteroatom (e.g. 1, 2, 3, 4 or 5 hereoatoms) selected from N, O, Si, P, and S as a ring-forming atom, 1 to 10 carbon atoms, and at least one double bond in its ring. Non-limiting examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," used herein, may refer to a divalent group having the same structure as the C₁-C₁₀ heterocycloalkenyl group.

The term "C₆-C₆₀ aryl group," as used herein, may refer to a monovalent group having a carbocyclic aromatic system having 6 to 60 carbon atoms, e.g. 6 to 20 ring carbon atoms, 6 to 14 ring cabon atoms or 6 to 10 ring carbon atoms. A C₆-C₆₀ arylene group," as used herein, may refer to a divalent group having a carbocyclic aromatic system having 6 to 60 carbon atoms e.g. 6 to 20 ring carbon atoms, 6 to 14 ring cabon atoms or 6 to 10 ring carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently comprise two or more rings, the respective rings may be fused to each other.

The term "C₁-C₆₀ heteroaryl group," as used herein, may refer to a monovalent group having a carbocyclic aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. A C₁-C₆₀ heteroarylene group," as used herein, may refer to a divalent group having an aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently comprise two or more rings, the respective rings may be fused to each other.

The term "C₆-C₆₀ aryloxy group," used herein, may refer to a monovalent group represented by -OA₁₀₂ (wherein A₁₀₂ is the C₆-C₆₀ aryl group), and the term "C₆-C₆₀ arylthio group" may refer to a monovalent group represented by -SA₁₀₃ (wherein A₁₀₃ is the C₆-C₆₀ aryl group).

The term "monovalent non-aromatic condensed C8-C60 polycyclic group," as used herein, may refer to a monovalent group that has two or more rings condensed (e.g., fused) with each other, 8 to 60 carbon atoms as the only ring-forming atoms (e.g., 8 to 20, 8 to 14 or 8 to 10 ring carbon atoms), and non-aromaticity in the entire molecular structure (e.g., does not have overall aromaticity). A non-limiting examples of the monovalent non-aromatic condensed C8-C60 polycyclic group include a fluorenyl group and a spiro-bifluorenyl grou. The term "divalent non-aromatic condensed C8-C60 polycyclic group," used herein, may refer to a divalent group having the same structure as the monovalent non-aromatic condensed C8-C60 polycyclic group.

The term "monovalent non-aromatic condensed 8- to 60-membered heteropolycyclic group," as used herein, may refer to a monovalent group that has two or more rings condensed (e.g., fused) to each other, has at least one heteroatom (e.g. 1, 2, 3, 4 or 5 hereoatoms) selected from N, O, Si, P, and S, other than carbon atoms (e.g., 1 to 59, 2 to 59, 2 to 19, 2 to 13 or 2 to 9 ring carbon atoms), as ring-forming atoms, and has non-aromaticity in the entire molecular structure (e.g., does not have overall aromaticity). A non-limiting example of the monovalent non-aromatic condensed 8- to 60-membered heteropolycyclic group is a carbazolyl group. The term "divalent non-aromatic condensed 8- to 60-membered heteropolycyclic group," used herein, may refer to a divalent group having the same structure as the monovalent non-aromatic condensed 8- to 60-membered heteropolycyclic group.

The term "C₅-C₆₀ carbocyclic group," as used herein, may refer to a monocyclic or polycyclic group having 5 to 60 carbon atoms e.g. 5 to 20 ring carbon atoms, 5 to 14 ring cabon atoms or 5 to 10 ring carbon atoms, in which ring-forming atoms are carbon atoms only. The C₅-C₆₀ carbocyclic group may be an aromatic carbocyclic group or a non-aromatic carbocyclic group. The C₅-C₆₀ carbocyclic group may be a ring (such as a benzene group), a monovalent group (such as a phenyl group), or a divalent group (such as a phenylene group). In various embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group," as used herein, may refer to a group having the same structure as the C₅-C₆₀ carbocyclic group, except that as a ring-forming atom, at least one heteroatom selected (e.g. 1, 2, 3, 4 or 5 hereoatoms) from N, O, Si, P, and S is used in addition to carbon atoms (e.g., the number of carbon atoms may be in a range of 1 to 60, e.g. 1 to 19 ring carbon atoms, 1 to 13 ring cabon atoms or 1 to 9 ring carbon atoms).

The term "C₆-C₆₀ arene group," as used herein, may refer to an aromatic monocyclic or polycyclic group having 6 to 60 carbon atoms (e.g. 6 to 20 ring carbon atoms, 6 to 14 ring cabon atoms or 6 to 10 ring carbon atoms) in which ring-forming atoms are carbon atoms only. The C₆-C₆₀ arene group may be a ring (such as a benzene group), a monovalent group (such as a phenyl group), or a divalent group (such as a phenylene group). In various embodiments, depending on the number of substituents connected to the C₆-C₆₀ arene group, the C₆-C₆₀ arene group may be a trivalent group or a quadrivalent group.

The term "C₁-C₆₀ heteroarene group," as used herein, may refer to a group having the same structure as the C₆-C₆₀ arene group, except that as a ring-forming atom, at least one heteroatom (e.g. 1, 2, 3, 4 or 5 hereoatoms) selected from N, O, Si, P, and S is used in addition to carbon atoms (e.g., the number of carbon atoms may be in a range of 1 to 60, e.g. 1 to 19 ring carbon atoms, 1 to 13 ring cabon atoms or 1 to 9 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium(-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

The term "Ph" used herein may refer to a phenyl group, the term "Me" used herein may refer to a methyl group, the term "Et" used herein may refer to an ethyl group, the term "ter-Bu" or "Bu^{t}" used herein may refer to a tert-butyl, the term "OMe" used herein may refer to a methoxy group, and "D" as used herein may refer to deuterium.

The term "biphenyl group" used therein may refer to a monovalent group having two benzene rings linked to each other via a single bond. For example, the "biphenyl group" may be "a phenyl group substituted with a phenyl group." The "biphenyl group" may also be "a substituted phenyl group" having "a C₆-C₆₀ aryl group" as a substituent.

The term "terphenyl group" used herein may refer to a monovalent group having three benzene rings in which adjacent benzenes are linked to each other via a single bond. For example, the "terphenyl group" may be "a phenyl group substituted with a biphenyl group." The "terphenyl group" may also be "a substituted phenyl group" having "a C₆-C₆₀ aryl group substituted with a C₆-C₆₀ aryl group" as a substituent.

^{∗} and ^{∗}' used herein, unless defined otherwise, each independently refer to a binding site to a neighboring atom in a corresponding formula.

Hereinafter, a compound according to embodiments of the present disclosure and an organic light-emitting device according to the embodiments will be described in more detail with reference to Synthesis Examples and Examples. However, these examples are for illustrative purposes only and are not intended to limit the scope of the present invention. The expression "B was used instead of A" used in describing Synthesis Examples may refer to an identical number of molar equivalents of A being used in place of molar equivalents of B.

### Examples

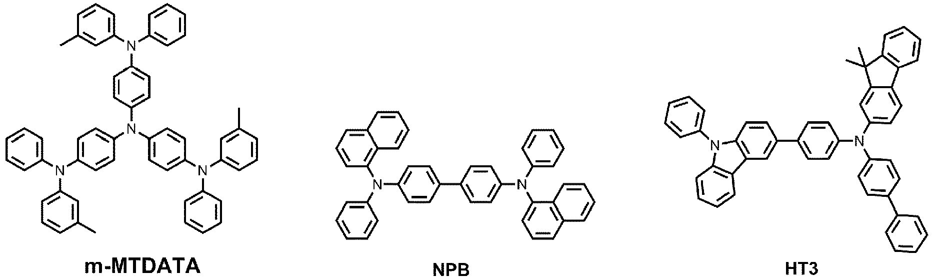

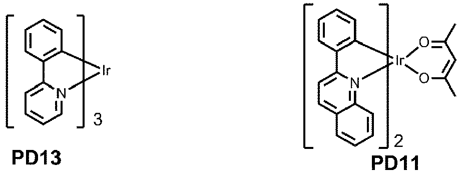

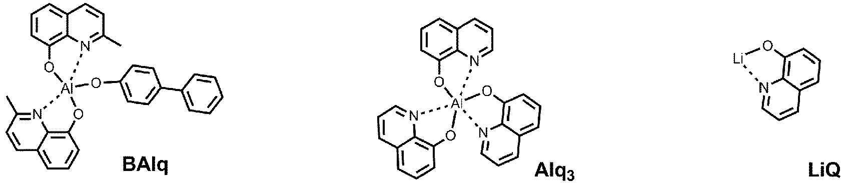

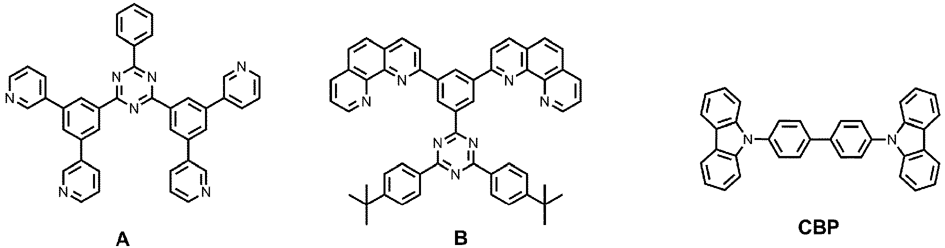

### Example 1-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compound 1-1 (as a host) and Compound PD13 (as a dopant) were co-deposited on the hole transport region at a weight ratio of 95:5 to form an emission layer having a thickness of 300 Å.

Compound 2-38 was deposited on the emission layer to form an electron transport layer having a thickness of 200 Å, and then, LiF was deposited on the electron transport layer to form an electron injection layer having a 10 Å, thereby forming an electron transport region. Then, A1 was vacuum-deposited on the electron transport region to form a cathode having a thickness of 2,000 Å, thereby completing the manufacture of an organic light-emitting device.

### Examples 1-2 to 1-4 and Comparative Examples 1-1 to 1-3

Organic light-emitting devices were manufactured in the same (or substantially the same) manner as in Example 1, except that compounds listed in Table 1 were respectively used instead of Compounds 1-1 and 2-38 in forming an emission layer and an electron transport layer.

**Table 1**

| Example | Host for emission layer | Electron transport layer |
|---|---|---|
| Example 1-1 | 1-1 | 2-38 |
| Example 1-2 | 1-12 | 2-44 |
| Example 1-3 | 1-34 | 2-137 |
| Example 1-4 | 1-262 | 2-92 |
| Comparative Example 1-1 | 1-12 | A |
| Comparative Example 1-2 | CBP | 2-44 |
| Comparative Example 1-3 | CBP | B |

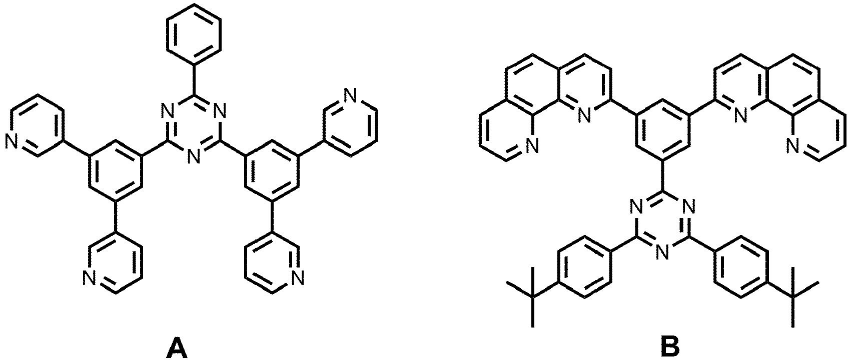

### Example 2-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compound 1-35 (as a host) and Compound PD11 (as a dopant) were co-deposited on the hole transport region at a weight ratio of 97:3 to form an emission layer having a thickness of 300 Å.

Compound 2-44 was deposited on the emission layer to form an electron transport layer having a thickness of 200 Å, and then, LiF was deposited on the electron transport layer to form an electron injection layer having a 10 Å, thereby forming an electron transport region. Then, Al was vacuum-deposited on the electron transport region to form a cathode having a thickness of 2,000 Å, thereby completing the manufacture of an organic light-emitting device.

### Examples 2-2 to 2-4 and Comparative Examples 2-1 to 2-3

Organic light-emitting devices were manufactured in the same (or substantially the same) manner as in Example 2-1, except that compounds listed in Table 2 were respectively used instead of Compounds 1-35 and 2-44 in forming an emission layer and an electron transport layer.

**Table 2**

| Example | Host for emission layer | Electron transport layer |
|---|---|---|
| Example 2-1 | 1-35 | 2-44 |
| Example 2-2 | 1-60 | 2-137 |
| Example 2-3 | 1-68 | 2-38 |
| Example 2-4 | 1-187 | 2-69 |
| Comparative Example 2-1 | 1-60 | A |
| Comparative Example 2-2 | CBP | 2-137 |
| Comparative Example 2-3 | CBP | B |

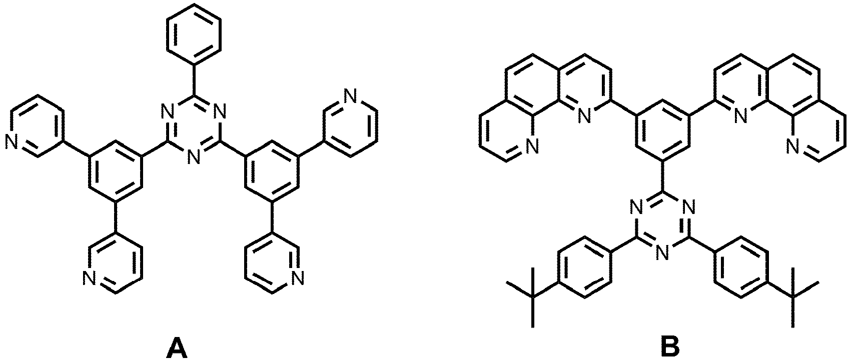

### Example 3-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compound 1-1 (as a host) and Compound PD13 (as a dopant) were co-deposited on the hole transport region at a weight ratio of 95:5 to form an emission layer having a thickness of 300 Å.

Compound 1-1 was deposited on the emission layer to form a buffer layer having a thickness of 100 Å, and then, Compound 2-38 was deposited on the buffer layer to form an electron transport layer having a thickness of 200 Å. Then, Li was deposited on the electron transport layer to form an electron injection layer having a thickness of 10 Å, thereby forming an electron transport region. Then, Al was vacuum-deposited on the electron transport region to form a cathode having a thickness of 2,000 Å, thereby completing the manufacture of an organic light-emitting device.

### Examples 3-2 to 3-5 and Comparative Example 3-1

Organic light-emitting devices were manufactured in the same (or substantially the same) manner as in Example 3-1, except that compounds listed in Table 3 were respectively used instead of Compounds 1-1 and 2-38 in forming an emission layer, a buffer layer, and an electron transport layer.

**Table 3**

| Example | Host for emission layer | Buffer layer | Electron transport layer |
|---|---|---|---|
| Example 3-1 | 1-1 | 1-1 | 2-38 |
| Example 3-2 | 1-12 | 1-1 | 2-38 |
| Example 3-3 | 1-34 | 1-1 | 2-87 |
| Example 3-4 | 1-34 | 1-34 | 2-87 |
| Example 3-5 | 1-35 | 1-1 | 2-87 |
| Comparative Example 3-1 | CBP | BAlq | Alq₃ |

### Example 4-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compound 1-60 (as a host) and Compound PD11 (as a dopant) were co-deposited on the hole transport region at a weight ratio of 97:3 to form an emission layer having a thickness of 300 Å.

Compound 1-1 was deposited on the emission layer to form a buffer layer having a thickness of 100 Å, and then, Compound 2-137 was deposited on the buffer layer to form an electron transport layer having a thickness of 200 Å. Then, LiF was deposited on the electron transport layer to form an electron injection layer having a thickness of 10 Å, thereby forming an electron transport region. Then, A1 was vacuum-deposited on the electron transport region to form a cathode having a thickness of 2,000 Å, thereby completing the manufacture of an organic light-emitting device.

### Example 4-2 and Comparative Example 4-1

Organic light-emitting devices were manufactured in the same (or substantially the same) manner as in Example 4-1, except that compounds listed in Table 4 were respectively used instead of Compounds 1-60, 1-1, and 2-137 in forming an emission layer, a buffer layer, and an electron transport layer.

**Table 4**

| Example | Host for emission layer | Buffer layer | Electron transport layer |
|---|---|---|---|
| Example 4-1 | 1-60 | 1-1 | 2-137 |
| Example 4-2 | 1-68 | 1-1 | 2-137 |
| Comparative Example 4-1 | CBP | BAlq | Alq₃ |

### Example 5-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compound 1-1 (as a host) and Compound PD13 (as a dopant) were co-deposited on the hole transport region at a weight ratio of 95:5 to form an emission layer having a thickness of 300 Å.

Compound 1-1 was deposited on the emission layer to form a buffer layer having a thickness of 100 Å, and then, Compound 2-38 and LiQ were co-deposited on the buffer layer at a weight ratio of 50:50 to form an electron transport layer having a thickness of 200 Å. Then, LiF was deposited on the electron transport layer to form an electron injection layer having a thickness of 10 Å, thereby forming an electron transport region. Then, Al was vacuum-deposited on the electron transport region to form a cathode having a thickness of 2,000 Å, thereby completing the manufacture of an organic light-emitting device.

### Example ₅-2

Organic light-emitting device was manufactured in the same (or substantially the same) manner as in Example 5-1, except that compounds listed in Table 5 were respectively used instead of Compounds 1-1 and 2-38 in forming an emission layer, a buffer layer, and an electron transport layer.

**Table 5**

| Example | Host for emission layer | Buffer layer | Electron transport layer |
|---|---|---|---|
| Example 5-1 | 1-1 | 1-1 | 2-38:LiQ |
| Example 5-2 | 1-35 | 1-1 | 2-87:LiQ |

### Example 6-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 ÅÅ. Then, Compound HT3 was vacuum-deposited on the hole injection layer to form a hole transport layer having a thickness of 100 Å, thereby forming a hole transport region.

Compound 1-60 (as a host) and Compound PD11 (as a dopant) were co-deposited on the hole transport region at a weight ratio of 97:3 to form an emission layer having a thickness of 300 Å.

Compound 1-1 was deposited on the emission layer to form a buffer layer having a thickness of 100 Å, and then, Compound 2-87 and LiQ were co-deposited on the buffer layer at a weight ratio of 50:50 to form an electron transport layer having a thickness of 200 Å. Then, LiF was deposited on the electron transport layer to form an electron injection layer having a thickness of 10 Å, thereby forming an electron transport region. Then, Al was vacuum-deposited on the electron transport region to form a cathode having a thickness of 2,000 Å, thereby completing the manufacture of an organic light-emitting device.

### Example 7-1

An anode was prepared by cutting a glass substrate, on which ITO was deposited to a thickness of 1,200 Å, to a size of 50 mm × 50 mm × 0.4 mm, ultrasonically cleaning the glass substrate (anode) using isopropyl alcohol and pure water, each for 10 minutes, and then, exposing the glass substrate (anode) to irradiation of UV light for 10 minutes and ozone to clean. Then, the resulting glass substrate (anode) was loaded into a vacuum deposition apparatus.

Compound m-MTDTA was vacuum-deposited on the glass substrate (anode) to form a hole injection layer having a thickness of 700 Å. Then, Compound HT3 was vacuum-deposited on the hole injection layer to form a hole transport layer having a thickness of 100 Å, thereby forming a hole transport region.

Compounds 1-1 and 1-34 (as a host), and Compound PD13 (as a dopant) were co-deposited on the hole transport region at a weight ratio of 47.5:47.5:5 to form an emission layer having a thickness of 300 Å.

Compound 2-19 was deposited on the emission layer to form a buffer layer having a thickness of 100 Å, and then, Compound 2-87 and LiQ were co-deposited on the buffer layer at a weight ratio of 50:50 to form an electron transport layer having a thickness of 200 Å. Then, LiF was deposited on the electron transport layer to form an electron injection layer having a thickness of 10 Å, thereby forming an electron transport region. Then, Al was vacuum-deposited on the electron transport region to form a cathode having a thickness of 2,000 Å, thereby completing the manufacture of an organic light-emitting device.

### Example 7-2

Organic light-emitting device was manufactured in the same (or substantially the same) manner as in Example 7-1, except that compounds listed in Table 6 were respectively used instead of Compounds 1-1, 1-34, 2-19, and 2-87 in forming an emission layer, a buffer layer, and an electron transport layer.

**Table 6**

| Example | Host for emission layer | Buffer layer | Electron transport layer |
|---|---|---|---|
| Example 7-1 | 1-1,1-34 | 2-19 | 2-87: LiQ |
| Example 7-2 | 1-1,1-34 | 2-45 | 2-137:LiQ |

### Evaluation Example

The driving voltage, current density, efficiency, and lifespan of the organic light-emitting devices of Examples 1-1 to 1-4, 2-1 to 2-4, 3-1 to 3-5, 4-1, 4-2,5-1,5-2, 6-1, 7-1, and 7-2, and Comparative Examples 1-1 to 1-3, 2-1 to 2-3, 3-1, and 4-1 were evaluated by using a Keithley SMU 236 meter a PR650 luminance measuring meter. The lifespan results were obtained by measuring the time until the luminance was reduced to 97% of the initial luminance. Results thereof are shown in Table 7.

**Table 7**

| | Emission host | Buffer layer | Electron transport layer | Driving voltage (V) | Efficiency (cd/A) | Lifespan (hours) |
|---|---|---|---|---|---|---|
| Example 1-1 | 1-1 | - | 2-38 | 5.6 | 39.5 | 110 |
| Example 1-2 | 1-12 | - | 2-44 | 5.6 | 41 | 95 |
| Example 1-3 | 1-34 | - | 2-137 | 5.5 | 40.3 | 103 |
| Example 1-4 | 1-162 | - | 2-92 | 5.5 | 40 | 100 |
| Example 2-1 | 1-35 | - | 2-44 | 5.8 | 42 | 192 |
| Example 2-2 | 1-60 | - | 2-137 | 5.7 | 25 | 185 |
| Example 2-3 | 1-68 | - | 2-38 | 5.8 | 26 | 200 |
| Example 2-4 | 1-187 | - | 2-69 | 5.9 | 25 | 205 |
| Example 3-1 | 1-1 | 1-1 | 2-38 | 5.7 | 41.5 | 105 |
| Example 3-2 | 1-12 | 1-1 | 2-38 | 5.7 | 41 | 99 |
| Example 3-3 | 1-34 | 1-1 | 2-87 | 5.6 | 43 | 122 |
| Example 3-4 | 1-34 | 1-34 | 2-87 | 5.4 | 42 | 109 |
| Example 3-5 | 1-35 | 1-1 | 2-87 | 5.8 | 40.2 | 100 |
| Example 4-1 | 1-60 | 1-1 | 2-137 | 5.9 | 25 | 210 |
| Example 4-2 | 1-68 | 1-1 | 2-137 | 5.8 | 24.5 | 230 |
| Example 5-1 | 1-1 | 1-1 | 2-38:LiQ | 5.5 | 41 | 200 |
| Example 5-2 | 1-35 | 1-1 | 2-87:LiQ | 5.3 | 41 | 165 |
| Example 6-1 | 1-60 | 1-1 | 2-87:LiQ | 5.7 | 25.5 | 220 |
| Example 7-1 | 1-12,1-34 | 2-19 | 2-87:LiQ | 5.2 | 45 | 220 |
| Example 7-2 | 1-12,1-34 | 2-45 | 2-137:LiQ | 5.2 | 44 | 180 |
| Comparative Example 1-1 | 1-12 | - | A | 5.8 | 38.5 | 77 |
| Comparative Example 1-2 | CBP | - | 2-44 | 6.0 | 35.3 | 72 |
| Comparative Example 1-3 | CBP | - | B | 5.9 | 35 | 75 |
| Comparative Example 2-1 | 1-60 | - | A | 6.0 | 23.5 | 130 |
| Comparative Example 2-2 | CBP | - | 2-137 | 6.3 | 20.5 | 131 |
| Comparative Example 2-3 | CBP | - | B | 6.2 | 20 | 140 |
| Comparative Example 3-1 | CBP | BAlq | Alq₃ | 6.1 | 36.1 | 60 |
| Comparative Example 4-1 | CBP | BAlq | Alq₃ | 6.2 | 21.6 | 125 |

Referring to Table 7, it was confirmed that the organic light-emitting devices of Examples 1-1 to 1-4, 2-1 to 2-4, 3-1 to 3-5, 4-1, 4-2, 5-1, 5-2, 6-1, 7-1, and 7-2 each had high efficiency and a long lifespan, compared to those of the organic light-emitting devices of Comparative Examples 1-1 to 1-3, 2-1 to 2-3, 3-1, and 4-1, respectively.

An organic light-emitting device according to embodiments of the present disclosure may have low driving voltage, high efficiency, and a long lifespan.

As used herein, the terms "use," "using," and "used" may be considered synonymous with the terms "utilize," "utilizing," and "utilized," respectively.

In addition, as used herein, the terms "substantially," "about," and similar terms are used as terms of approximation and not as terms of degree, and are intended to account for the inherent deviations in measured or calculated values that would be recognized by those of ordinary skill in the art.

It will be understood that when an element such as a layer, film, region, or substrate is referred to as being "on" another element, it can be directly on the other element or intervening elements may also be present. In contrast, when an element is referred to as being "directly on" or "directly contacting" another element, there are no intervening elements present.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present invention as defined by the following claims.

## Claims

1. An organic light-emitting device comprising:
a first electrode;
a second electrode; and
an organic layer between the first electrode and the second electrode, the organic layer comprising an emission layer, and further comprising an electron transporting region between the emission layer and the second electrode,
wherein the emission layer comprises a first compound represented by Formula 1: 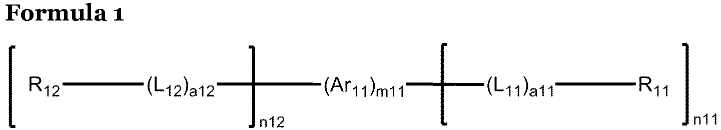
in which Ar₁₁ is a group represented by Formula 1-1, 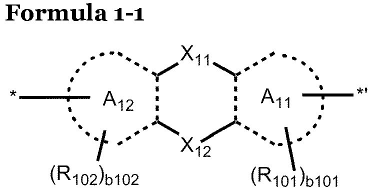
provided that the first compound is not 4,4'-bis(N-carbazolyl)-1,1'-biphenyl (CBP);
and wherein the electron transporting region comprises a second compound represented by Formula 2, wherein the second compound comprises a group represented by Formula 9-1 and/or a group represented by Formula 9-2, and the second compound comprises an alkyl group and/or a cycloalkyl group, 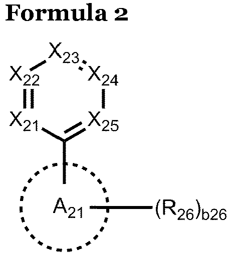
wherein, in Formulae 1,1-1, and 2,
m11 is selected from 1 and 2,
X₁₁ is selected from N[(L₁₃)ₐ₁₃-R₁₃], C[(L₁₃)ₐ₁₃-R₁₃][(L₁₄)ₐ₁₄-R₁₄], O, and S,
X₁₂ is selected from a single bond, N[(L₁₅)ₐ₁₅-R₁₅], C[(L₁₅)ₐ₁₅-R₁₅][(L₁₆)ₐ₁₆-R₁₆], O, and S,
X₂₁ is selected from N and C(R₂₁), X₂₂ is selected from N and C(R₂₂), X₂₃ is selected from N and C(R₂₃), X₂₄ is selected from N and C(R₂₄), X₂₅ is selected from N and C(R₂₅), at least one selected from X₂₁ to X₂₅ is N,
R₁₁ to R₁₆ are each independently selected from a group represented by Formula 8-1, a group represented by Formula 8-2, hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and -P(=O)(Q₁)(Q₂), wherein when R₁₃ and R₁₄ are both present and a13 and a14 are both equal to zero, R₁₃ and R₁₄ are optionally connected to each other to form a C₅-C₂₀ carbocyclic group or a C₁-C₂₀ heterocyclic group, and when R₁₅ and R₁₆ are both present and a₁₅ and a16 are both equal to zero, R₁₅ and R₁₆ are optionally connected to each other to form a C₅-C₂₀ carbocyclic group or a C₁-C₂₀ heterocyclic group, 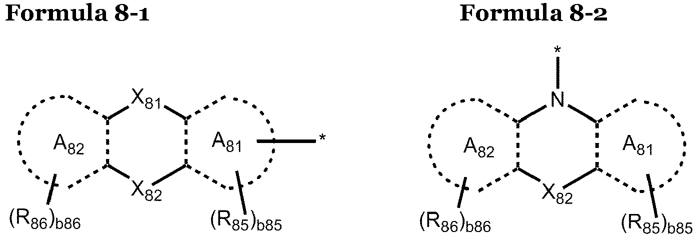
R₂₁ to R₂₆ are each independently selected from a group represented by any of Formulae 9-1 to 9-3, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
**Formula 9-1** ^{∗}-(L₉₁)ₐ₉₁₋R₉₁
**Formula 9-2** ^{∗}-(L₉₂)ₐ₉₂-R₉₂
**Formula 9-3** ^{∗}-(L₉₃)ₐ₉₃-R₉₃,
X₈₁ is selected from N[(L₈₁)ₐ₈₁-R₈₁], C[(L₈₁)ₐ₈₁-R₈₁][(L₈₂)ₐ₈₂-R₈₂], O, and S,
X₈₂ is selected from a single bond, N[(L₈₃)ₐ₈₃-R₈₃], C[(L₈₃)ₐ₈₃-R₈₃][(L₈₄)ₐ₈₄-R₈₄], O, and S,
A₁₁, A₁₂, A₈₁, and A₈₂ are each independently selected from a C₅-C₂₀ carbocyclic group and a C₁-C₂₀ heterocyclic group,
L₁₁ to L₁₆ and L₈₁ to L₈₄ are each independently selected from ^{∗}-O-^{∗}', ^{∗}-S-^{∗}', ^{∗}-C(=O)-^{∗}', ^{∗}-P(=O)(Q₁)-^{∗}', ^{∗}-Si(Q₁)(Q₂)-^{∗}', a substituted or unsubstituted C₆-C₆₀ arylene group, and a substituted or unsubstituted C₁-C₆₀ heteroarylene group,
a11 to a16 and a81 to a84 are each independently selected from 0, 1, 2, and 3,
n11 and n12 are each independently selected from 0, 1, 2, 3, and 4,
R₈₁ to R₈₄ are each independently selected from hydrogen, deuterium, -F, -Cl, - Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and -P(=O)(Q₁)(Q₂), wherein when R₈₁ and R₈₂ are both present and a81 and a82 are both equal to zero, R₈₁ and R₈₂ are optionally connected to each other to form a C₅-C₂₀ carbocyclic group or a C₁-C₂₀ heterocyclic group, and when R₈₃ and R₈₄ are both present and a83 and a84 are both equal to zero, R₈₃ and R₈₄ are optionally connected to each other to form a C₅-C₂₀ carbocyclic group or a C₁-C₂₀ heterocyclic group,
R₁₀₁, R₁₀₂, R₈₅, and R₈₆ are each independently selected from hydrogen, deuterium, -F, -Cl, -Br, -I, a cyano group, a nitro group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, -Si(Q₁)(Q₂)(Q₃), -B(Q₁)(Q₂), -C(=O)(Q₁), -S(=O)₂(Q₁), and - P(=O)(Q₁)(Q₂),
b101, b102, b26, b85, and b86 are each independently selected from 1, 2, 3, 4, 5, and 6,
A21 is selected from a C₆-C₂₀ arene group and a C₁-C₂₀ heteroarene group,
L₉₁ is selected from a C₆-C₆₀ arylene group and a C₁-C₆₀ heteroarylene group, each substituted with at least one selected from a C₁-C₆₀ alkyl group and a C₃-C₁₀ cycloalkyl group,
L₉₂ and L₉₃ are each independently selected from a substituted or unsubstituted C₆-C₆₀ arylene group and a substituted or unsubstituted C₁-C₆₀ heteroarylene group,
a91 is selected from 1 and 2,
a92 and a93 are each independently selected from 0, 1, and 2,
R₉₁ and R₉₃ are each independently selected from a substituted or unsubstituted C₆-C₆₀ aryl group and a substituted or unsubstituted C₁-C₆₀ heteroaryl group,
R₉₂ is selected from a C₆-C₆₀ aryl group and a C₁-C₆₀ heteroaryl group, each substituted with at least one selected from a C₁-C₆₀ alkyl group and a C₃-C₁₀ cycloalkyl group,
wherein Q₁ to Q₃ are each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, and
^{∗}and^{∗}' each independently indicate a binding site to a neighboring atom.

2. The organic light-emitting device of claim 1, wherein
A₁₁, A₁₂, A₈₁, and A₈₂ are each independently selected from a benzene group, a naphthalene group, a phenanthrene group, an anthracene group, a triphenylene group, a pyrene group, a chrysene group, a furan group, a thiophene group, a pyrrole group, a pyridine group, a pyrazine group, a pyrimidine group, a pyridazine group, a triazine group, a quinoline group, an isoquinoline group, a 2,6-naphthyridine group, a 1,8-naphthyridine group, a 1,5-naphthyridine group, a 1,6-naphthyridine group, a 1,7-naphthyridine group, a 2,7-naphthyridine group, a quinoxaline group, a quinazoline group, a phenanthridine group, a phenanthroline group, a benzofuran group, a benzothiophene group, an indene group, an indole group, a furopyridine group, a thienopyridine group, a cyclopentapyridine group, a pyrrolopyridine group, a dibenzofuran group, a dibenzothiophene group, a fluorene group, a carbazole group, a benzofuropyrrole group, a benzothienopyrrole group, an indenopyrrole group, an indolopyrrole group, a benzofurothiophene group, a benzothienothiophene group, an indenothiophene group, an indolothiophene group, a benzofurofuran group, a benzothienofuran group, an indenofuran group, an indolofuran group, a benzofuropyridine group, a benzothienopyridine group, an indenopyridine group, an indolopyridine group, a benzofuropyrimidine group, a benzothienopyrimidine group, an indenopyrimidine group, an indolopyrimidine group, a benzofuroindole group, a benzothienoindole group, an indenoindole group, an indoloindole group, a benzofurobenzofuran group, a benzothienobenzofuran group, an indenobenzofuran group, an indolobenzofuran group, a benzofurobenzothiophene group, a benzothienobenzothiophene group, an indenobenzothiophene group, an indolobenzothiophene group, a benzofuronquinoline group, a benzothienoquinoline group, an indenoquinoline group, an indoloquinoline group, a benzonaphthofuran group, a benzonaphthothiophene group, a benzofluorene group, a benzocarbazole group, a dinaphthofuran group, a dinaphthothiophene group, a dibenzofluorene group, a dibenzocarbazole group, a benzoxazole group, a benzothiazole group, a benzimidazole group, a naphthofuran group, a naphthothiophene group, a cyclopentanaphthalene group, a spiro-bifluorene group, and a spiro-fluorene-indene group.

3. The organic light-emitting device of claim 1 or claim 2, wherein
L₁₁ to L₁₆ and L₈₁ to L₈₄ are each independently selected from the group consisting of:
^{∗}-Si(CH₃)₂^{∗}', ^{∗}-Si(CH₃)(Ph)-^{∗}', ^{∗}-Si(Ph)₂-^{∗}', a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group;
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂); and
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one substituent selected from a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each of which at least one substituent being substituted with at least one selected from deuterium, -F, -Cl, -Br, -I, a cyano group, a C₁-C₂₀ alkyl group, a C₁-C₂₀ alkoxy group, a phenyl group, a biphenyl group, and a terphenyl group,
wherein Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group.

4. The organic light-emitting device of any one of the preceding claims, wherein
R₁₁ to R₁₆ are each independently selected from the group consisting of:
a group represented by Formula 8-1, a group represented by Formula 8-2, a C₁-C₂₀ alkyl group, a C₆-C₃₀ aryl group, and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one substituent selected from a C₆-C₃₀ aryl group and a C₁-C₃₀ heteroaryl group, each of which at least one substituent being substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₂₁)(Q₂₂), and - Si(Q₂₁)(Q₂₂)(Q₂₃),
wherein Q₂₁ to Q₂₃ and Q₃₁ to Q₃₃ are each independently selected from a C₁-C₂₀ alkyl group and a C₆-C₃₀ aryl group.

5. The organic light-emitting device of any one of the preceding claims, wherein
the sum of n11 and n12 is selected from 0 and 1.

6. The organic light-emitting device of any one of the preceding claims, wherein
R₈₁ to R₈₄ are each independently selected from the group consisting of:
a C₁-C₂₀ alkyl group, a C₆-C₃₀ aryl group, and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one substituent selected from a C₆-C₃₀ aryl group and a C₁-C₃₀ heteroaryl group, each of which at least one substituent being substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₂₁)(Q₂₂), and - Si(Q₂₁)(Q₂₂)(Q₂₃),
wherein Q₂₁ to Q₂₃ and Q₃₁ to Q₃₃ are each independently selected from a C₁-C₂₀ alkyl group and a C₆-C₃₀ aryl group.

7. The organic light-emitting device of any one of the preceding claims, wherein
A₂₁ is selected from a benzene group, a naphthalene group, a phenanthrene group, an anthracene group, a pyridine group, a pyrazine group, a pyrimidine group, a triazine group, a quinoline group, an isoquinoline group, a quinoxaline group, and a quinazoline group.

8. The organic light-emitting device of any one of the preceding claims, wherein
R₂₁ to R₂₆ are each independently selected from the group consisting of:
a group represented by any of Formulae 9-1 to 9-3, hydrogen, a C₁-C₂₀ alkyl group, and a C₃-C₁₀ cycloalkyl group;
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group;
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each substituted with at least one substituent selected from a C₆-C₃₀ aryl group, a C₁-C₃₀ heteroaryl group, a monovalent non-aromatic condensed C8-C60 polycyclic group, and a monovalent non-aromatic condensed 8- to 60-membered heteropolycyclic group, each of which at least one substituent being substituted with at least one selected from deuterium, -F, -Cl, -Br, -I, a C₁-C₂₀ alkyl group, a C₃-C₁₀ cycloalkyl group, a C₆-C₃₀ aryl group, a C₁-C₃₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and -Si(Q₂₁)(Q₂₂)(Q₂₃),
wherein Q₂₁ to Q₂₃ and Q₃₁ to Q₃₃ are each independently selected from a C₁-C₂₀ alkyl group and a C₆-C₃₀ aryl group.

9. The organic light-emitting device of any one of the preceding claims, wherein
L₉₁ is selected from a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from a C₁-C₂₀ alkyl group, a cyclopentyl group, a cyclohexyl group, and a cycloheptyl group.

10. The organic light-emitting device of any one of the preceding claims, wherein
L₉₂ and L₉₃ are each independently selected from the group consisting of:
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group;
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁XQ₃₂), -B(Q₃₁)(Q₃₂), -C(=O)(Q₃₁), -S(=O)₂(Q₃₁), and - P(=O)(Q₃₁)(_{Q32}); and
a phenylene group, a naphthylene group, a phenanthrenylene group, an anthracenylene group, a triphenylenylene group, a pyrenylene group, a chrysenylene group, a pyridinylene group, a pyrazinylene group, a pyrimidinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one substituent selected from a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, each of which at least one substituent being substituted with at least one selected from deuterium, -F, -Cl, -Br, -I, a cyano group, a C₁-C₂₀ alkyl group, a C₁-C₂₀ alkoxy group,
wherein Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group.

11. The organic light-emitting device of any one of the preceding claims, wherein
R₉₁ and R₉₃ are each independently selected from the group consisting of:
a C₆-C₃₀ aryl group and a C₁-C₃₀ heteroaryl group;
a C₆-C₃₀ aryl group and a C₁-C₃₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₃₁)(Q₃₂), and -Si(Q₃₁)(Q₃₂)(Q₃₃); and
a C₆-C₃₀ aryl group and a C₁-C₃₀ heteroaryl group, each substituted with at least one substituent selected from a C₆-C₃₀ aryl group and a C₁-C₃₀ heteroaryl group, each of which at least one substituent being substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₃₀ aryl group, a C₁-C₃₀ heteroaryl group, -N(Q₂₁)(Q₂₂), and - Si(Q₂₁)(Q₂₂)(Q₂₃),
wherein Q₂₁ to Q₂₃ and Q₃₁ to Q₃₃ are each independently selected from a C₁-C₂₀ alkyl group and a C₆-C₃₀ aryl group.

12. The organic light-emitting device of any one of the preceding claims, wherein
R₉₂ is selected from a phenyl group, a biphenyl group, a terphenyl group, a naphthyl group, an anthracenyl group, a triphenylenyl group, a phenanthrenyl group, a pyrenyl group, a tetraphenyl group, a chrysenyl group, a pyrrolyl group, a furanyl group, a thiophenyl group, a pyridinyl group, a pyrazinyl group, a pyrimidinyl group, a triazinyl group, a quinolinyl group, an isoquinolinyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzophenanthrolinyl group, a thiazolyl group, an oxazolyl group, an imidazolyl group, a triazolyl group, an indolyl group, a benzimidazolyl group, a benzofuranyl group, a benzothiophenyl group, and a benzoxazolyl group, each substituted with at least one selected from a C₁-C₂₀ alkyl group, a cyclopentyl group, a cyclohexyl group, and a cycloheptyl group.

13. The organic light-emitting device of any one of the preceding claims, wherein
the second compound represented by Formula 2 is represented by Formula 2-1: 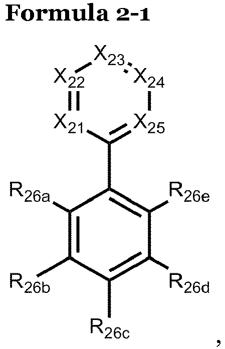 wherein, in Formula 2-1,
X₂₁ is selected from N and C(R₂₁), X₂₂ is selected from N and C(R₂₂), X₂₃ is selected from N and C(R₂₃), X₂₄ is selected from N and C(R₂₄), and X₂₅ is selected from N and C(R₂₅), wherein at least one selected from X₂₁ to X₂₅ is N, and
R₂₁ to R₂₅ are as defined in claim 1 and R₂₆ₐ to R₂₆ₑ are each independently as defined for R₂₆ in claim 1, whrein at least one selected from R₂₁ to R₂₅ and R₂₆ₐ to R₂₆ₑ is selected from a group represented by Formula 9-1 and a group represented by Formula 9-2 as defined in claim 1, and comprises an alkyl group and/or a cycloalkyl group.

14. The organic light-emitting device of any one of the preceding claims, wherein
the emission layer comprises the first compound and a dopant, and
the dopant comprises an organometallic complex represented by Formula 401:
**Formula 401** M(L₄₀₁)_{xc1}(L₄₀₂)_{xc2}
in which L₄₀₁ is a ligand represented by Formula 402, 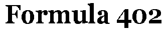 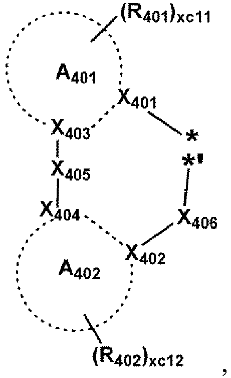
wherein, in Formulae 401 and 402,
M is selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
and xc1 is 1, 2, or 3, wherein when xc1 is two or more, two or more L₄₀₁(s) are identical to or different from each other,
L₄₀₂ is an organic ligand, and xc2 is an integer selected from 0 to 4, wherein when xc2 is two or more, two or more L₄₀₁(s) are identical to or different from each other,
X₄₀₁ to X₄₀₄ are each independently nitrogen or carbon,
X₄₀₁ and X₄₀₃ are connected to each other via a single bond or a double bond, and X₄₀₂ and X₄₀₄ are connected to each other via a single bond or a double bond,
A₄₀₁ and A₄₀₂ are each independently a C₅-C₆₀ carbocyclic group or a C₁-C₆₀ heterocyclic group,
X₄₀₅ is selected from a single bond, -O-, -S-, -C(=O)-, -N(Q₄₁₁)-, -C(Q₄₁₁)(Q₄₁₂)-, - C(Q₄₁₁)=C(Q₄₁₂)-, -C(Q₄₁₁)=, and =C(Q₄₁₁)=, wherein Q₄₁₁ and Q₄₁₂ are each independently selected from hydrogen, deuterium, a C₁-C₂₀ alkyl group, a C₁-C₂₀ alkoxy group, a phenyl group, a biphenyl group, a terphenyl group, and a naphthyl group,
X₄₀₆ is selected from a single bond, O, and S,
R₄₀₁ and R₄₀₂ are each independently selected from hydrogen, deuterium, -F, -Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C₈-C₆₀ polycyclic group, a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₁), -B(Q₄₀₁)(Q₄₀₂), - C(=O)(Q₄₀₁), -S(=O)₂(Q₄₀₁), and -P(=O)(Q₄₀₁)(Q₄₀₂), wherein Q₄₀₁ to Q₄₀₃ are each independently selected from a C₁-C₁₀ alkyl group, a C₁-C₁₀ alkoxy group, a C₆-C₂₀ aryl group, and a C₁-C₂₀ heteroaryl group,
xc11 and xc12 are each independently an integer selected from 0 to 10, and
^{∗}and^{∗}' in Formula 402 each independently indicate a binding site to M in Formula 401.

15. The organic light-emitting device of any one of the preceding claims, wherein:
(a) the organic layer comprises an electron transport region between the emission layer and the second electrode, the electron transport region comprises an electron transport layer and an electron injection layer, and the electron transport layer comprises at least one selected from an alkaline metal complex and an alkaline earth-metal complex; and/or
(b) the organic layer comprises an electron transport region between the emission layer and the second electrode, the electron transport region comprises an electron transport layer and an electron injection layer, and the electron injection layer comprises an alkaline metal, an alkaline earth metal, a rare-earth metal, an alkaline metal compound, an alkaline earth-metal compound, a rare-earth metal compound, an alkaline metal complex, an alkaline earth-metal complex, a rare-earth metal complex, or a combination thereof; and/or
(c) the emission layer is a first-color-light emission layer, the organic layer further comprises i) at least one second-color-light emission layer, wherein the first color light and the second color light are identical to or different from each other, or ii) at least one second-color-light emission layer and at least one third-color-light-emission layer, wherein the first color light, the second color light, and third color light are identical to or different from one another, and when the organic light-emitting device operates, mixed light comprising the first color light and the second color light is emitted, or mixed light comprising the first color light, the second color light, and the third color light is emitted; and/or
(d) the emission layer comprises a first host and a second host, the first host comprises the first compound, and the first host and the second host are different from each other.

## Patentansprüche

1. Organische lichtemittierende Vorrichtung, umfassend:
eine erste Elektrode;
eine zweite Elektrode; und
eine organische Schicht zwischen der ersten Elektrode und der zweiten Elektrode, wobei die organische Schicht eine Emissionsschicht umfasst, und ferner einen Elektronentransportbereich zwischen der Emissionsschicht und der zweiten Elektrode umfassend,
wobei die Emissionsschicht eine erste Verbindung, dargestellt durch Formel 1, umfasst: 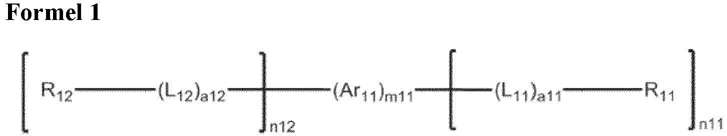
wobei A₁₁ eine Gruppe, dargestellt durch Formel 1-1, ist, 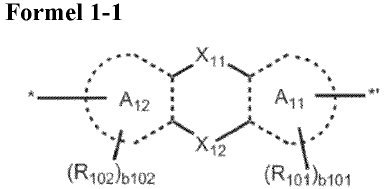
mit der Maßgabe, dass die erste Verbindung nicht 4,4'-Bis(N-carbazolyl)-1,1'-biphenyl (CBP) ist;
und wobei der Elektronentransportbereich eine zweite Verbindung, dargestellt durch Formel 2, umfasst, wobei die zweite Verbindung eine Gruppe, dargestellt durch Formel 9-1, und/oder eine Gruppe, dargestellt durch Formel 9-2, umfasst und die zweite Verbindung eine Alkylgruppe und/oder eine Cycloalkylgruppe umfasst, 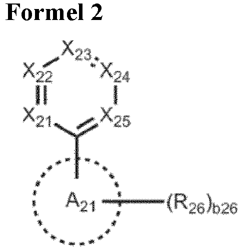
wobei in den Formeln 1, 1-1 und 2
m11 ausgewählt ist aus 1 und 2,
X₁₁ ausgewählt ist aus N[(L₁₃)ₐ₁₃-R₁₃], C[(L₁₃)ₐ₁₃-R₁₃][(L₁₄)ₐ₁₄-R₁₄], O und S,
X₁₂ ausgewählt ist aus einer Einfachbindung, N[(L₁₅)ₐ₁₅-R₁₅], C[(L₁₅)ₐ₁₅-R₁₅][(L₁₆)ₐ₁₆-R₁₆], O und S,
X₂₁ ausgewählt ist aus N und C(R₂₁), X₂₂ ausgewählt ist aus N und C(R₂₂), X₂₃ ausgewählt ist aus N und C(R₂₃), X₂₄ ausgewählt ist aus N und C(R₂₄), X₂₅ ausgewählt ist aus N und C(R₂₅), wenigstens eines, ausgewählt aus X₂₁ bis X₂₅, N ist,
R₁₁ bis R₁₆ jeweils unabhängig ausgewählt sind aus einer Gruppe, dargestellt durch Formel 8-1, einer Gruppe, dargestellt durch Formel 8-2, Wasserstoff, Deuterium, -F, -Cl, -Br, -I, einer Cyanogruppe, einer Nitrogruppe, einer substituierten oder unsubstituierten C₁-C₆₀-Alkylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, -Si(Q₁)(Q₂)(Q₃), -B(Q₁)(Q₂), -C(=O)(Q₁), -S(=O)₂(Q₁) und - P(=O)(Q₁)(Q₂), wobei, wenn R₁₃ und R₁₄ beide vorhanden sind und a13 und a14 beide gleich null sind, R₁₃ und R₁₄ optional miteinander verbunden sind, um eine carbocyclische C₅-C₂₀-Gruppe oder eine heterocyclische C₁-C₂₀-Gruppe zu bilden, und, wenn R₁₅ und R₁₆ beide vorhanden sind und a15 und a16 beide gleich null sind, R₁₅ und R₁₆ optional miteinander verbunden sind, um eine carbocyclische C₅-C₂₀-Gruppe oder eine heterocyclische C₁-C₂₀-Gruppe zu bilden, 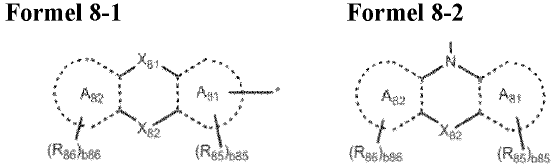
R₂₁ bis R₂₆ jeweils unabhängig ausgewählt sind aus einer Gruppe, dargestellt durch eine der Formeln 9-1 bis 9-3, Wasserstoff, Deuterium, -F, -Cl, -Br, -I, eine Hydroxygruppe, eine Cyanogruppe, eine Nitrogruppe, eine Amidinogruppe, eine Hydrazinogruppe, eine Hydrazonogruppe, eine substituierte oder unsubstituierte C₁-C₆₀-Alkylgruppe, eine substituierte oder unsubstituierte C₁-C₆₀-Alkoxygruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte einwertige nichtaromatische kondensierte polycyclische C₈-C₆₀-Gruppe, eine substituierte oder unsubstituierte einwertige nichtaromatische kondensierte 8- bis 60-gliedrige heteropolycyclische Gruppe, -Si(Q₁)(Q₂)(Q₃), -N(Q₁)(Q₂), -B(Q₁)(Q₂), -C(=O)(Q₁), - S(=O)₂(Q₁) und -P(=O)(Q₁)(Q₂),
**Formel 9-1** ^{∗}-(L₉₁)ₐ₉₁-R₉₁
**Formel 9-2** ^{∗}-(L₉₂)a₉₂-R₉₂
**Formel 9-3** ^{∗}-(L₉₃)ₐ₉₃-R₉₃,
X₈₁ ausgewählt ist aus N[(L₈₁)ₐ₈₁-R₈₁], C[(L₈₁)ₐ₈₁-R₈₁][(L₈₂)ₐ₈₂-R₈₂], O und S,
X₈₂ ausgewählt ist aus einer Einfachbindung, N[(L₈₃)ₐ₈₃-R₈₃], C[(L₈₃)ₐ₈₃-R-₈₃][(L₈₄)ₐ₈₄-R₈₄], O und S,
A₁₁, A₁₂, A₈₁ und A₈₂ jeweils unabhängig ausgewählt sind aus einer carbocyclischen C₅-C₂₀-Gruppe und einer heterocyclischen C₁-C₂₀-Gruppe,
L₁₁ bis L₁₆ und L₈₁ bis L₈₄ jeweils unabhängig ausgewählt sind aus ^{∗}-O-^{∗}', ^{∗}-S-^{∗}', ^{∗}-C(=O)-^{∗}', ^{∗}-P(=O)(Q₁)-^{∗}' ^{∗}-Si(Q₁)(Q₂)-^{∗}', einer substituierten oder unsubstituierten C₆-C₆₀-Arylengruppe und einer substituierten oder unsubstituierten C₁-C₆₀-Heteroarylengruppe,
a11 bis a16 und a81 bis a84 jeweils unabhängig ausgewählt sind aus 0, 1, 2 und 3,
n11 und n12 jeweils unabhängig ausgewählt sind aus 0, 1, 2, 3 und 4,
R₈₁ bis R₈₄ jeweils unabhängig ausgewählt sind aus Wasserstoff, Deuterium, -F, -Cl, - Br, -I, einer Cyanogruppe, einer Nitrogruppe, einer substituierten oder unsubstituierten C₁-C₆₀-Alkylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, -Si(Q₁)(Q₂)(Q₃), -B(Q₁)(Q₂), -C(=O)(Q₁), -S(=O)₂(Q₁) und - P(=O)(Q₁)(Q₂), wobei, wenn R₈₁ und R₈₂ beide vorhanden sind und a81 und a82 beide gleich null sind, R₈₁ und R₈₂ optional miteinander verbunden sind, um eine carbocyclische C₅-C₂₀-Gruppe oder eine heterocyclische C₁-C₂₀-Gruppe zu bilden, und, wenn R₈₃ und R₈₄ beide vorhanden sind und a83 und a84 beide gleich null sind, R₈₃ und R₈₄ optional miteinander verbunden sind, um eine carbocyclische C₅-C₂₀-Gruppe oder eine heterocyclische C₁-C₂₀-Gruppe zu bilden,
R₁₀₁, R₁₀₂, R₈₅ und R₈₆ jeweils unabhängig ausgewählt sind aus Wasserstoff, Deuterium, -F, -Cl, -Br, -I, einer Cyanogruppe, einer Nitrogruppe, einer substituierten oder unsubstituierten C₁-C₆₀-Alkylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, -Si(Q₁)(Q₂)(Q₃), -B(Q₁)(Q₂), -C(=O)(Q₁), - S(=O)₂(Q₁) und -P(=O)(Q₁)(Q₂),
b101, b102, b26, b85 und b86 jeweils unabhängig ausgewählt sind aus 1, 2, 3, 4, 5 und 6,
A₂₁ ausgewählt ist aus einer C₆-C₂₀-Arengruppe und einer C₁-C₂₀-Heteroarengruppe,
L₉₁ ausgewählt ist aus einer C₆-C₆₀-Arylengruppe und einer C₁-C₆₀-Heteroarylengruppe, jeweils substituiert mit wenigstens einem, ausgewählt aus einer C₁-C₆₀-Alkylgruppe und einer C₃-C₁₀-Cycloalkylgruppe,
L₉₂ und L₉₃ jeweils unabhängig ausgewählt sind aus einer substituierten oder unsubstituierten C₆-C₆₀-Arylengruppe und einer substituierten oder unsubstituierten C₁-C₆₀-Heteroarylengruppe,
a91 ausgewählt ist aus 1 und 2,
a92 und a93 jeweils unabhängig ausgewählt sind aus 0, 1 und 2,
R₉₁ und R₉₃ jeweils unabhängig ausgewählt sind aus einer substituierten oder unsubstituierten C₆-C₆₀-Arylgruppe und einer substituierten oder unsubstituierten C₁-C₆₀-Heteroarylgruppe,
R₉₂ ausgewählt ist aus einer C₆-C₆₀-Arylgruppe und einer C₁-C₆₀-Heteroarylgruppe, jeweils substituiert mit wenigstens einem, ausgewählt aus einer C₁-C₆₀-Alkylgruppe und einer C₃-C₁₀-Cycloalkylgruppe,
wobei Q₁ bis Q₃ jeweils unabhängig ausgewählt sind aus Wasserstoff, Deuterium, -F, - Cl, -Br, -I, einer Hydroxygruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, einer Biphenylgruppe und einer Terphenylgruppe und
^{∗}und^{∗}' jeweils unabhängig eine Bindungsstelle mit einem Nachbaratom angeben.

2. Organische lichtemittierende Vorrichtung nach Anspruch 1, wobei
A₁₁, A₁₂, A₈₁ und A₈₂ jeweils unabhängig ausgewählt sind aus einer Benzengruppe, einer Naphthalengruppe, einer Phenanthrengruppe, einer Anthracengruppe, einer Triphenylengruppe, einer Pyrengruppe, einer Chrysengruppe, einer Furangruppe, einer Thiophengruppe, einer Pyrrolgruppe, einer Pyridingruppe, einer Pyrazingruppe, einer Pyrimidingruppe, einer Pyridazingruppe, einer Triazingruppe, einer Chinolingruppe, einer Isochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Chinazolingruppe, einer Phenanthridingruppe, einer Phenanthrolingruppe, einer Benzofurangruppe, einer Benzothiophengruppe, einer Indengruppe, einer Indolgruppe, einer Furopyridingruppe, einer Thienopyridingruppe, einer Cyclopentapyridingruppe, einer Pyrrolopyridingruppe, einer Dibenzofurangruppe, einer Dibenzothiophengruppe, einer Fluorengruppe, einer Carbazolgruppe, einer Benzofuropyrrolgruppe, einer Benzothienopyrrolgruppe, einer Indenopyrrolgruppe, einer Indolopyrrolgruppe, einer Benzofurothiophengruppe, einer Benzothienothiophengruppe, einer Indenothiophengruppe, einer Indolothiophengruppe, einer Benzofurofurangruppe, einer Benzothienofurangruppe, einer Indenofurangruppe, einer Indolofurangruppe, einer Benzofuropyridingruppe, einer Benzothienopyridingruppe, einer Indenopyridingruppe, einer Indolopyridingruppe, einer Benzofuropyrimidingruppe, einer Benzothienopyrimidingruppe, einer Indenopyrimidingruppe, einer Indolopyrimidingruppe, einer Benzofuroindolgruppe, einer Benzothienoindolgruppe, einer Indenoindolgruppe, einer Indoloindolgruppe, einer Benzofurobenzofurangruppe, einer Benzothienobenzofurangruppe, einer Indenobenzofurangruppe, einer Indolobenzofurangruppe, einer Benzofurobenzothiophengruppe, einer Benzothienobenzothiophengruppe, einer Indenobenzothiophengruppe, einer Indolobenzothiophengruppe, einer Benzofuronchinolingruppe, einer Benzothienochinolingruppe, einer Indenochinolingruppe, einer Indolochinolingruppe, einer Benzonaphthofurangruppe, einer Benzonaphthothiophengruppe, einer Benzofluorengruppe, einer Benzocarbazolgruppe, einer Dinaphthofurangruppe, einer Dinaphthothiophengruppe, einer Dibenzofluorengruppe, einer Dibenzocarbazolgruppe, einer Benzoxazolgruppe, einer Benzothiazolgruppe, einer Benzimidazolgruppe, einer Naphthofurangruppe, einer Naphthothiophengruppe, einer Cyclopentanaphthalengruppe, einer Spirobifluorengruppe und einer Spiro-Fluoren-IndenGruppe.

3. Organische lichtemittierende Vorrichtung nach Anspruch 1 oder Anspruch 2, wobei
L₁₁ bis L₁₆ und L₈₁ bis L₈₄ jeweils unabhängig ausgewählt sind aus der Gruppe bestehend aus:
^{∗}-Si(CH₃)₂^{∗}', ^{∗}-Si(CH₃)(Ph)-^{∗}', ^{∗}-Si(Ph)₂-^{∗}', einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe;
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe, jeweils substituiert mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂); und
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe, jeweils substituiert mit wenigstens einem Substituenten, ausgewählt aus einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe, wobei jeder dieses wenigstens einen Substituenten substituiert ist mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe, einer Phenylgruppe, einer Biphenylgruppe und einer Terphenylgruppe,
wobei Q₃₁ bis Q₃₃ jeweils unabhängig ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe.

4. Organische lichtemittierende Vorrichtung nach einem der vorangehenden Ansprüche, wobei
R₁₁ bis R₁₆ jeweils unabhängig ausgewählt sind aus der Gruppe bestehend aus:
einer Gruppe, dargestellt durch Formel 8-1, einer Gruppe, dargestellt durch Formel 8-2, einer C₁-C₂₀-Alkylgruppe, einer C₆-C₃₀-Arylgruppe und einer C₁-C₃₀-Heteroarylgruppe;
einer C₆-C₃₀-Arylgruppe und einer C₁-C₃₀-Heteroarylgruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₃₁)(Q₃₂) und -Si(Q₃₁)(Q₃₂)(Q₃₃); und
einer C₆-C₃₀-Arylgruppe und einer C₁-C₃₀-Heteroarylgruppe, jeweils substituiert mit wenigstens einem Substituenten, ausgewählt aus einer C₆-C₃₀-Arylgruppe und einer C₁-C₃₀-Heteroarylgruppe, wobei jeder dieses wenigstens einen Substituenten substituiert ist mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₂₁)(Q₂₂) und -Si(Q₂₁)(Q₂₂)(Q₂₃),
wobei Q₂₁ bis Q₂₃ und Q₃₁ bis Q₃₃ jeweils unabhängig ausgewählt sind aus einer C₁-C₂₀-Alkylgruppe und einer C₆-C₃₀-Arylgruppe.

5. Organische lichtemittierende Vorrichtung nach einem der vorangehenden Ansprüche, wobei
die Summe von n11 und n12 ausgewählt ist aus 0 und 1.

6. Organische lichtemittierende Vorrichtung nach einem der vorangehenden Ansprüche, wobei
R₈₁ bis R₈₄ jeweils unabhängig ausgewählt sind aus der Gruppe bestehend aus:
einer C₁-C₂₀-Alkylgruppe, einer C₆-C₃₀-Arylgruppe und einer C₁-C₃₀-Heteroarylgruppe;
einer C₆-C₃₀-Arylgruppe und einer C₁-C₃₀-Heteroarylgruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₃₁)(Q₃₂) und -Si(Q₃₁)(Q₃₂)(Q₃₃); und
einer C₆-C₃₀-Arylgruppe und einer C₁-C₃₀-Heteroarylgruppe, jeweils substituiert mit wenigstens einem Substituenten, ausgewählt aus einer C₆-C₃₀-Arylgruppe und einer C₁-C₃₀-Heteroarylgruppe, wobei jeder dieses wenigstens einen Substituenten substituiert ist mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₂₁)(Q₂₂) und -Si(Q₂₁)(Q₂₂)(Q₂₃),
wobei Q₂₁ bis Q₂₃ und Q₃₁ bis Q₃₃ jeweils unabhängig ausgewählt sind aus einer C₁-C₂₀-Alkylgruppe und einer C₆-C₃₀-Arylgruppe.

7. Organische lichtemittierende Vorrichtung nach einem der vorangehenden Ansprüche, wobei
A₂₁ ausgewählt ist aus einer Benzengruppe, einer Naphthalengruppe, einer Phenanthrengruppe, einer Anthracengruppe, einer Pyridingruppe, einer Pyrazingruppe, einer Pyrimidingruppe, einer Triazingruppe, einer Chinolingruppe, einer Isochinolingruppe, einer Chinoxalingruppe und einer Chinazolingruppe.

8. Organische lichtemittierende Vorrichtung nach einem der vorangehenden Ansprüche, wobei
R₂₁ bis R₂₆ jeweils unabhängig ausgewählt sind aus der Gruppe bestehend aus:
einer Gruppe, dargestellt durch eine der Formeln 9-1 bis 9-3, Wasserstoff, einer C₁-C₂₀-Alkylgruppe und einer C₃-C₁₀-Cycloalkylgruppe;
einer C₆-C₃₀-Arylgruppe, einer C₁-C₃₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe;
einer C₆-C₃₀-Arylgruppe, einer C₁-C₃₀-Heteroarylgruppe, einer einwertigen nichtaromatischen kondensierten polycyclischen C₈-C₆₀ Gruppe und einer einwertigen nichtaromatischen kondensierten 8- bis 60-gliedrigen heteropolycyclischen Gruppe, jeweils substituiert mit wenigstens einem, ausgewählt aus Deuterium, -F, -Cl, -Br, -I, einer C₁-C₂₀-Alkylgruppe, einer C₃-C₁₀-Cycloalkylgruppe, einer C₆-C₃₀-Arylgruppe, einer C₁-C₃₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₃₁)(Q₃₂) und -Si(Q₃₁)(Q₃₂)(Q₃₃); und
einer C₆-C₃₀-Arylgruppe, einer C₁-C₃₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem Substituenten, ausgewählt aus einer C₆-C₃₀-Arylgruppe, einer C₁-C₃₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, wobei jeder dieses wenigstens einen Substituenten substituiert ist mit wenigstens einem, ausgewählt aus Deuterium, -F, -Cl, -Br, - I, einer C₁-C₂₀-Alkylgruppe, einer C₃-C₁₀-Cycloalkylgruppe, einer C₆-C₃₀-Arylgruppe, einer C₁-C₃₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₂₁)(Q₂₂) und -Si(Q₂₁)(Q₂₂)(Q₂₃),
wobei Q₂₁ bis Q₂₃ und Q₃₁ bis Q₃₃ jeweils unabhängig ausgewählt sind aus einer C₁-C₂₀-Alkylgruppe und einer C₆-C₃₀-Arylgruppe.

9. Organische lichtemittierende Vorrichtung nach einem der vorangehenden Ansprüche, wobei
L₉₁ ausgewählt ist aus einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, ein Phenanthrolinylengruppe und einer Triazinylengruppe, jeweils substituiert mit wenigstens einem, ausgewählt aus einer C₁-C₂₀-Alkylgruppe, einer Cyclopentylgruppe, einer Cyclohexylgruppe und einer Cycloheptylgruppe.

10. Organische lichtemittierende Vorrichtung nach einem der vorangehenden Ansprüche, wobei
L₉₂ und L₉₃ jeweils unabhängig ausgewählt sind aus der Gruppe bestehend aus:
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe;
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe, jeweils substituiert mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂); und
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyridinylengruppe, einer Pyrazinylengruppe, einer Pyrimidinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe, jeweils substituiert mit wenigstens einem Substituenten, ausgewählt aus einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe, wobei jeder dieses wenigstens einen Substituenten substituiert ist mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe,
wobei Q₃₁ bis Q₃₃ jeweils unabhängig ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe.

11. Organische lichtemittierende Vorrichtung nach einem der vorangehenden Ansprüche, wobei
R₉₁ und R₉₃ jeweils unabhängig ausgewählt sind aus der Gruppe bestehend aus:
einer C₆-C₃₀-Arylgruppe und einer C₁-C₃₀-Heteroarylgruppe;
einer C₆-C₃₀-Arylgruppe und einer C₁-C₃₀-Heteroarylgruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₃₁)(Q₃₂) und -Si(Q₃₁)(Q₃₂)(Q₃₃); und
einer C₆-C₃₀-Arylgruppe und einer C₁-C₃₀-Heteroarylgruppe, jeweils substituiert mit wenigstens einem Substituenten, ausgewählt aus einer C₆-C₃₀-Arylgruppe und einer C₁-C₃₀-Heteroarylgruppe, wobei jeder dieses wenigstens einen Substituenten substituiert ist mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₃₀-Arylgruppe, einer C₁-C₃₀-Heteroarylgruppe, -N(Q₂₁)(Q₂₂) und -Si(Q₂₁)(Q₂₂)(Q₂₃),
wobei Q₂₁ bis Q₂₃ und Q₃₁ bis Q₃₃ jeweils unabhängig ausgewählt sind aus einer C₁-C₂₀-Alkylgruppe und einer C₆-C₃₀-Arylgruppe.

12. Organische lichtemittierende Vorrichtung nach einem der vorangehenden Ansprüche, wobei
R₉₂ ausgewählt ist aus einer Phenylgruppe, einer Biphenylgruppe, einer Terphenylgruppe, einer Naphthylgruppe, einer Anthracenylgruppe, einer Triphenylenylgruppe, einer Phenanthrenylgruppe, einer Ppyrenylgruppe, einer Tetraphenylgruppe, einer Chrysenylgruppe, einer Pyrrolylgruppe, einer Furanylgruppe, einer Thiophenylgruppe, einer Pyridinylgruppe, einer Pyrazinylgruppe, einer Pyrimidinylgruppe, einer Triazinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzophenanthrolinylgruppe, einer Thiazolylgruppe, einer Oxazolylgruppe, einer Imidazolylgruppe, einer Triazolylgruppe, einer Indolylgruppe, einer Benzimidazolylgruppe, einer Benzofuranylgruppe, einer Benzothiophenylgruppe und einer Benzoxazolylgruppe, jeweils substituiert mit wenigstens einem, ausgewählt aus einer C₁-C₂₀-Alkylgruppe, einer Cyclopentylgruppe, einer Cyclohexylgruppe und einer Cycloheptylgruppe.

13. Organische lichtemittierende Vorrichtung nach einem der vorangehenden Ansprüche, wobei
die zweite Verbindung, die durch Formel 2 dargestellt wird, durch Formel 2-1 dargestellt wird: 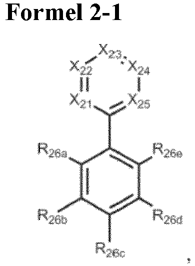 wobei, in Formel 2-1,
X₂₁ ausgewählt ist aus N und C(R₂₁), X₂₂ ausgewählt ist aus N und C(R₂₂), X₂₃ ausgewählt ist aus N und C(R₂₃), X₂₄ ausgewählt ist aus N und C(R₂₄) und X₂₅ ausgewählt ist aus N und C(R₂₅), wobei wenigstens eines, ausgewählt aus X₂₁ bis X₂₅, N ist, und
R₂₁ bis R₂₅ der Definition in Anspruch 1 entsprechen und R₂₆ₐ bis R₂₆ₑ jeweils unabhängig der Definition für R₂₆ in Anspruch 1 entsprechen, wobei wenigstens eines, ausgewählt aus R₂₁ bis R₂₅ und R₂₆ₐ bis R₂₆ₑ, ausgewählt ist aus einer Gruppe, dargestellt durch Formel 9-1, und einer Gruppe, dargestellt durch Formel 9-2, wie in Anspruch 1 definiert, und eine Alkylgruppe und/oder eine Cycloalkylgruppe umfasst.

14. Organische lichtemittierende Vorrichtung nach einem der vorangehenden Ansprüche, wobei
die Emissionsschicht die erste Verbindung und einen Dotierstoff umfasst und
der Dotierstoff einen metallorganischen Komplex, dargestellt durch Formel 401, umfasst:
**Formel 401** M(L₄₀₁)_{xc1}(L₄₀₂)_{xc2}
wobei L₄₀₁ ein Ligand, dargestellt durch Formel 402, ist 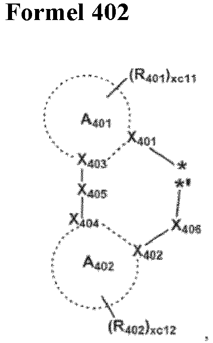
wobei in den Formeln 401 und 402
M ausgewählt ist aus Iridium (Ir), Platin (Pt), Palladium (Pd), Osmium (Os), Titan (Ti), Zirconium (Zr), Hafnium (Hf), Europium (Eu), Terbium (Tb), Rhodium (Rh) und Thulium (Tm),
und xc1 1, 2 oder 3 ist, wobei, wenn xc1 zwei oder mehr ist, zwei oder mehr L₄₀₁ gleich oder voneinander verschieden sind,
L₄₀₂ ein organischer Ligand ist und xc2 eine ganze Zahl, ausgewählt aus 0 bis 4, ist, wobei, wenn xc2 zwei oder mehr ist, zwei oder mehr L₄₀₂ gleich oder voneinander verschieden sind,
X₄₀₁ bis X₄₀₄ jeweils unabhängig Stickstoff oder Kohlenstoff sind,
X₄₀₁ und X₄₀₃ über eine Einfachbindung oder eine Doppelbindung miteinander verbunden sind und X₄₀₂ und X₄₀₄ über eine Einfachbindung oder eine Doppelbindung miteinander verbunden sind,
A₄₀₁ und A₄₀₂ jeweils unabhängig eine carbocyclische C₅-C₆₀-Gruppe oder eine heterocyclische C₁-C₆₀-Gruppe sind,
X₄₀₅ ausgewählt ist aus einer Einfachbindung, -O-, -S-, -C(=O)-, -N(Q₄₁₁)-, - C(Q₄₁₁)(Q₄₁₂)-, C(Q₄₁₁)=C(Q₄₁₂)-, -C(Q₄₁₁)= und =C(Q₄₁₁)=, wobei Q₄₁₁ und Q₄₁₂ jeweils unabhängig ausgewählt sind aus Wasserstoff, Deuterium, einer C₁-C₂₀-Alkylgruppe, einer C₁-C₂₀-Alkoxygruppe, einer Phenylgruppe, einer Biphenylgruppe, einer Terphenylgruppe und einer Naphthylgruppe,
X₄₀₆ ausgewählt ist aus einer Einfachbindung, O und S,
R₄₀₁ und R₄₀₂ jeweils unabhängig ausgewählt sind aus Wasserstoff, Deuterium, -F, -Cl, -Br, -I, -CD₃, -CF₃, einer Hydroxygruppe, einer Cyanogruppe, einer Nitrogruppe, einer Amidinogruppe, einer Hydrazinogruppe, einer Hydrazonogruppe, einer substituierten oder unsubstituierten C₁-C₂₀-Alkylgruppe, einer substituierten oder unsubstituierten C₁-C₂₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen C₈-C₆₀-Gruppe, einer substituierten oder unsubstituierten einwertigen nichtaromatischen kondensierten 8- bis 60-gliedrigen heteropolycyclischen Gruppe, -Si(Q₄₀₁)(Q₄₀₂)(Q₄₀₃), -N(Q₄₀₁)(Q₄₀₂), - B(Q₄₀₁)(Q₄₀₂), -C(=O)(Q₄₀₁), -S(=O)₂(Q₄₀₁) und -P(=O)(Q₄₀₁)(Q₄₀₂), wobei Q₄₀₁ bis Q₄₀₃ jeweils unabhängig ausgewählt sind aus einer C₁-C₁₀-Alkylgruppe, einer C₁-C₁₀-Alkoxygruppe, einer C₆-C₂₀-Arylgruppe und einer C₁-C₂₀-Heteroarylgruppe,
xc11 und xc12 jeweils unabhängig eine ganze Zahl, ausgewählt aus 0 bis 10, sind und ^{∗} und ^{∗}' in Formel 402 jeweils unabhängig eine Bindungsstelle mit M in Formel 401 angeben.

15. Organische lichtemittierende Vorrichtung nach einem der vorangehenden Ansprüche, wobei:
(a) die organische Schicht einen Elektronentransportbereich zwischen der Emissionsschicht und der zweiten Elektrode umfasst, der Elektronentransportbereich eine Elektronentransportschicht und eine Elektroneninjektionsschicht umfasst und die Elektronentransportschicht wenigstens eines, ausgewählt aus einem Alkalimetallkomplex und einem Erdalkalimetallkomplex, umfasst; und/oder
(b) die organische Schicht einen Elektronentransportbereich zwischen der Emissionsschicht und der zweiten Elektrode umfasst, der Elektronentransportbereich eine Elektronentransportschicht und eine Elektroneninjektionsschicht umfasst und die Elektroneninjektionsschicht ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst; und/oder
(c) die Emissionsschicht eine Erstfarblicht-Emissionsschicht ist, die organische Schicht ferner umfasst: i) wenigstens eine Zweitfarblicht-Emissionsschicht, wobei das Erstfarblicht und das Zweitfarblicht gleich oder voneinander verschieden sind, oder ii) wenigstens eine Zweitfarblicht-Emissionsschicht und wenigstens eine Drittfarblicht-Emissionsschicht, wobei das Erstfarblicht, das Zweitfarblicht und das Drittfarblicht gleich oder voneinander verschieden sind und, wenn die organische lichtemittierende Vorrichtung in Betrieb ist, gemischtes Licht, welches das Erstfarblicht und das Zweitfarblicht umfasst, emittiert wird oder gemischtes Licht, welches das Erstfarblicht, das Zweitfarblicht und das Drittfarblicht umfasst, emittiert wird; und/oder
(d) die Emissionsschicht ein erstes Wirtsmaterial und ein zweites Wirtsmaterial umfasst, das erste Wirtsmaterial die erste Verbindung umfasst und das erste Wirtsmaterial und das zweite Wirtsmaterial voneinander verschieden sind.

## Revendications

1. Dispositif électroluminescent organique comprenant :
une première électrode ;
une deuxième électrode ; et
une couche organique entre la première électrode et la deuxième électrode, la couche organique comprenant une couche d'émission, et comprenant en outre une région de transport d'électrons entre la couche d'émission et la deuxième électrode,
dans lequel la couche d'émission comprend un premier composé représenté par la formule 1 : 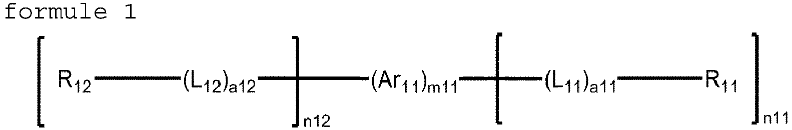
dans laquelle Ar₁₁ est un groupe représenté par la formule 1-1, 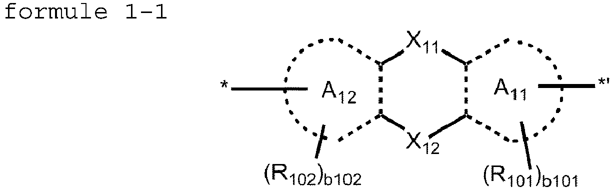
sous réserve que le premier composé ne soit pas le 4,4'-bis(N-carbazolyl)-1,1'-biphényle (CBP) ;
et dans lequel la région de transport d'électrons comprend un deuxième composé représenté par la formule 2, dans lequel le deuxième composé comprend un groupe représenté par la formule 9-1 et/ou un groupe représenté par la formule 9-2, et le deuxième composé comprend un groupe alkyle et/ou un groupe cycloalkyle, 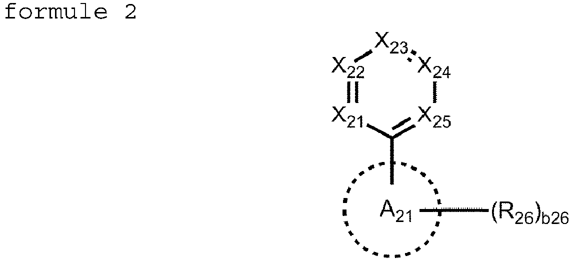
où, dans les formules 1, 1-1 et 2,
m11 est choisi parmi 1 et 2,
X₁₁ est choisi parmi N[(L₁₃)ₐ₁₃-R₁₃], C[(L₁₃)ₐ₁₃-R₁₃][(L₁₄)ₐ₁₄-R₁₄], O, et S,
X₁₂ est choisi parmi une liaison simple, N[(L₁₅)ₐ₁₅-R₁₅], C[(L₁₅)ₐ₁₅-R₁₅][(L₁₆)ₐ₁₆-R₁₆], O, et S,
X₂₁ est choisi parmi N et C(R₂₁), X₂₂ est choisi parmi N et C(R₂₂), X₂₃ est choisi parmi N et C(R₂₃), X₂₄ est choisi parmi N et C(R₂₄), X₂₅ est choisi parmi N et C(R₂₅), au moins l'un choisi parmi X₂₁ à X₂₅ est N,
chacun de R₁₁ à R₁₆ est indépendamment choisi parmi un groupe représenté par la formule 8-1, un groupe représenté par la formule 8-2, l'hydrogène, le deutérium, -F, -Cl, -Br, -I, un groupe cyano, un groupe nitro, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, Si(Q₁)(Q₂)(Q₃), -B(Q₁)(Q₂), -C(=O)(Q₁), -S(=O)₂(Q₁), et -P(=O)(Q₁)(Q₂), où, quand R₁₃ et R₁₄ sont tous deux présents et a13 et a14 sont tous deux égaux à zéro, R₁₃ et R₁₄ sont éventuellement connectés l'un à l'autre pour former un groupe carbocyclique en C₅ à C₂₀ ou un groupe hétérocyclique en C₁ à C₂₀, et, quand R₁₅ et R₁₆ sont tous deux présents et a15 et a16 sont tous deux égaux à zéro, R₁₅ et R₁₆ sont éventuellement connectés l'un à l'autre pour former un groupe carbocyclique en C₅ à C₂₀ ou un groupe hétérocyclique en C₁ à C₂₀, 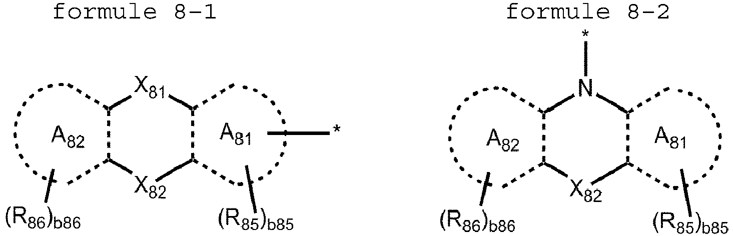
chacun de R₂₁ à R₂₆ est indépendamment choisi parmi un groupe représenté par l'une quelconque des formules 9-1 à 9-3, l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, un groupe hétéropolycyclique à 8 à 60 chaînons condensé non aromatique monovalent substitué ou non substitué, -Si(Q₁)(Q₂)(Q₃), -N (Q₁)(Q₂), -B (Q₁)(Q₂), -C (=O)(Q₁), -S (=O)₂(Q₁), et -P(=O)(Q₁)(Q₂),
formule 9-1 *-(L₉₁)ₐ₉₁-P₉₁
formule 9-2 *-(L₉₂)ₐ₉₂-R₉₂
formule 9-3 *-(L₉₃)ₐ₉₃-P₉₃
X₈₁ est choisi parmi N[(L₈₁)ₐ₈₁-R₈₁], C[(L₈₁)ₐ₈₁-R₈₁][(L₈₂)ₐ₈₂-R₈₂], O, et S,
X₈₂ est choisi parmi une liaison simple, N[(L₈₃)ₐ₈₃-R₈₃], C[(L₈₃)ₐ₈₃-R₈₃][(L₈₄)ₐ₈₄-R₈₄], O, et S,
chacun de A₁₁, A₁₂, A₈₁ et A₈₂ est indépendamment choisi parmi un groupe carbocyclique en C₅ à C₂₀ et un groupe hétérocyclique en C₁ à C₂₀,
chacun de L₁₁ à L₁₆ et de L₈₁ à L₈₄ est indépendamment choisi parmi *-O-*', *-S-*', *-C(=O)-*', *-P(=O)(Q1)-*', *-Si(Q₁)(Q₂)-*', un groupe arylène en C₆ à C₆₀ substitué ou non substitué, et un groupe hétéroarylène en C₁ à C₆₀ substitué ou non substitué,
chacun de a11 à al6 et de a81 à a84 est indépendamment choisi parmi 0, 1, 2 et 3,
chacun de n11 et n12 est indépendamment choisi parmi 0, 1, 2, 3 et 4,
chacun de R₈₁ à R₈₄ est indépendamment choisi parmi l'hydrogène, le deutérium, -F, -Cl, -Br, -I, un groupe cyano, un groupe nitro, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, -Si(Q₁)(Q₂)(Q₃), -B(Q₁)(Q₂), -C(=O)(Q₁), -S (=O)₂(Q₁), et -P(=O)(Q₁)(Q₂), où, quand R₈₁ et R₈₂ sont tous deux présents et a81 et a82 sont tous deux égaux à zéro, R₈₁ et R₈₂ sont éventuellement connectés l'un à l'autre pour former un groupe carbocyclique en C₅ à C₂₀ ou un groupe hétérocyclique en C₁ à C₂₀, et, quand R₈₃ et R₈₄ sont tous deux présents et a83 et a84 sont tous deux égaux à zéro, R₈₃ et R₈₄ sont éventuellement connectés l'un à l'autre pour former un groupe carbocyclique en C₅ à C₂₀ ou un groupe hétérocyclique en C₁ à C₂₀,
chacun de R₁₀₁, R₁₀₂, R₈₅ et R₈₆ est indépendamment choisi parmi l'hydrogène, le deutérium, -F, -Cl, -Br, -I, un groupe cyano, un groupe nitro, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, -Si(Q₁)(Q₂)(Q₃), -B(Q₁)(Q₂), -C (=O)(Q₁), -S (=O)₂(Q₁), et -P(=O)(Q₁)(Q₂),
chacun de b101, bl02, b26, b85 et b86 est indépendamment choisi parmi 1, 2, 3, 4, 5 et 6,
A₂₁ est choisi parmi un groupe arène en C₆ à C₂₀ et un groupe hétéroarène en C₁ à C₂₀,
L₉₁ est choisi parmi un groupe arylène en C₆ à C₆₀ et un groupe hétéroarylène en C₁ à C₆₀, chacun substitué par au moins l'un choisi parmi un groupe alkyle en C₁ à C₆₀ et un groupe cycloalkyle en C₃ à C₁₀,
chacun de L₉₂ et L₉₃ est indépendamment choisi parmi un groupe arylène en C₆ à C₆₀ substitué ou non substitué et un groupe hétéroarylène en C₁ à C₆₀ substitué ou non substitué,
a91 est choisi parmi 1 et 2,
chacun de a92 et a93 est indépendamment choisi parmi 0, 1 et 2,
chacun de R₉₁ et R₉₃ est indépendamment choisi parmi un groupe aryle en C₆ à C₆₀ substitué ou non substitué et un groupe hétéroaryle en C₁ à C₆₀ substitué ou non substitué,
R₉₂ est choisi parmi un groupe aryle en C₆ à C₆₀ et un groupe hétéroaryle en C₁ à C₆₀, chacun substitué par au moins l'un choisi parmi un groupe alkyle en C₁ à C₆₀ et un groupe cycloalkyle en C₃ à C₁₀,
dans lequel chacun de Q₁ à Q₃ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle, et un groupe terphényle, et
chacun de * et *' indique indépendamment un site de liaison à un atome voisin.

2. Dispositif électroluminescent organique selon la revendication 1, dans lequel
chacun de A₁₁, A₁₂, A₈₁ et A₈₂ est indépendamment choisi parmi un groupe benzène, un groupe naphtalène, un groupe phénanthrène, un groupe anthracène, un groupe triphénylène, un groupe pyrène, un groupe chrysène, un groupe furane, un groupe thiophène, un groupe pyrrole, un groupe pyridine, un groupe pyrazine, un groupe pyrimidine, un groupe pyridazine, un groupe triazine, un groupe quinoline, un groupe isoquinoline, un groupe 2,6-naphtyridine, un groupe 1,8-naphtyridine, un groupe 1,5-naphtyridine, un groupe 1,6-naphtyridine, un groupe 1,7-naphtyridine, un groupe 2,7-naphtyridine, un groupe quinoxaline, un groupe quinazoline, un groupe phénanthridine, un groupe phénanthroline, un groupe benzofurane, un groupe benzothiophène, un groupe indène, un groupe indole, un groupe furopyridine, un groupe thiénopyridine, un groupe cyclopentapyridine, un groupe pyrrolopyridine, un groupe dibenzofurane, un groupe dibenzothiophène, un groupe fluorène, un groupe carbazole, un groupe benzofuropyrrole, un groupe benzothiénopyrrole, un groupe indénopyrrole, un groupe indolopyrrole, un groupe benzofurothiophène, un groupe benzothiénothiophène, un groupe indénothiophène, un groupe indolothiophène, un groupe benzofurofurane, un groupe benzothiénofurane, un groupe indénofurane, un groupe indolofurane, un groupe benzofuropyridine, un groupe benzothiénopyridine, un groupe indénopyridine, un groupe indolopyridine, un groupe benzofuropyrimidine, un groupe benzothiénopyrimidine, un groupe indénopyrimidine, un groupe indolopyrimidine, un groupe benzofuroindole, un groupe benzothiénoindole, un groupe indénoindole, un groupe indoloindole, un groupe benzofurobenzofurane, un groupe benzothiénobenzofurane, un groupe indénobenzofurane, un groupe indolobenzofurane, un groupe benzofurobenzothiophène, un groupe benzothiénobenzothiophène, un groupe indénobenzothiophène, un groupe indolobenzothiophène, un groupe benzofuranequinoline, un groupe benzothiénoquinoline, un groupe indénoquinoline, un groupe indoloquinoline, un groupe benzonaphtofurane, un groupe benzonaphtothiophène, un groupe benzofluorène, un groupe benzocarbazole, un groupe dinaphtofurane, un groupe dinaphtothiophène, un groupe dibenzofluorène, un groupe dibenzocarbazole, un groupe benzoxazole, un groupe benzothiazole, un groupe benzimidazole, un groupe naphtofurane, un groupe naphtothiophène, un groupe cyclopentanaphtalène, un groupe spirobifluorène, et un groupe spirofluorène-indène.

3. Dispositif électroluminescent organique selon la revendication 1 ou la revendication 2, dans lequel
chacun de L₁₁ à L₁₆ et de L₈₁ à L₈₄ est indépendamment choisi dans l'ensemble constitué par :
*-Si(CH₃)₂*', *-Si(CH₃)(Ph)-*', *-Si(Ph)₂-*', un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène ;
un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène, chacun substitué par au moins l'un choisi parmi le deutérium, -F, -Cl, -Br, -I, un groupe cyano, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spirobifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂) ; et
un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un triazinylène, chacun substitué par au moins un substituant choisi parmi un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spirobifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle, chaque au moins un substituant étant substitué par au moins l'un choisi parmi le deutérium, -F, -Cl, -Br, -I, un groupe cyano, un groupe alkyle en C₁ à C₂₀, un groupe alkoxy en C₁ à C₂₀, un groupe phényle, un groupe biphényle, et un groupe terphényle,
dans lequel chacun de Q₃₁ à Q₃₃ est indépendamment choisi parmi l'hydrogène, un groupe méthyle, un groupe éthyle, un groupe n-propyle, un groupe isopropyle, un groupe tert-butyle, un groupe phényle, un groupe biphényle, et un groupe terphényle.

4. Dispositif électroluminescent organique selon l'une quelconque des revendications précédentes, dans lequel
chacun de R₁₁ à R₁₆ est indépendamment choisi dans l'ensemble constitué par :
un groupe représenté par la formule 8-1, un groupe représenté par la formule 8-2, un groupe alkyle en C₁ à C₂₀, un groupe aryle en C₆ à C₃₀, et un groupe hétéroaryle en C₁ à C₃₀ ;
un groupe aryle en C₆ à C₃₀ et un groupe hétéroaryle en C₁ à C₃₀, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₃₁) (Q₃₂), et -Si(Q₃₁)(Q₃₂)(Q₃₃) ; et
un groupe aryle en C₆ à C₃₀ et un groupe hétéroaryle en C₁ à C₃₀, chacun substitué par au moins un substituant choisi parmi un groupe aryle en C₆ à C₃₀ et un groupe hétéroaryle en C₁ à C₃₀, chaque au moins un substituant étant substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₂₁)(Q₂₂), et -Si(Q₂₁)(Q₂₂)(Q₂₃),
dans lequel chacun de Q₂₁ à Q₂₃ et de Q₃₁ à Q₃₃ est indépendamment choisi parmi un groupe alkyle en C₁ à C₂₀ et un groupe aryle en C₆ à C₃₀.

5. Dispositif électroluminescent organique selon l'une quelconque des revendications précédentes, dans lequel
la somme de n11 et n12 est choisie parmi 0 et 1.

6. Dispositif électroluminescent organique selon l'une quelconque des revendications précédentes, dans lequel
chacun de R₈₁ à R₈₂ est indépendamment choisi dans l'ensemble constitué par :
un groupe alkyle en C₁ à C₂₀, un groupe aryle en C₆ à C₃₀, et un groupe hétéroaryle en C₁ à C₃₀ ;
un groupe aryle en C₆ à C₃₀ et un groupe hétéroaryle en C₁ à C₃₀, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₃₁)(Q₃₂), et -Si(Q₃₁)(Q₃₂)(Q₃₃) ; et
un groupe aryle en C₆ à C₃₀ et un groupe hétéroaryle en C₁ à C₃₀, chacun substitué par au moins un substituant choisi parmi un groupe aryle en C₆ à C₃₀ et un groupe hétéroaryle en C₁ à C₃₀, chaque au moins un substituant étant substitué par au moins l'un parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₂₁)(Q₂₂), et -Si(Q₂₁)(Q₂₂) (Q₂₃),
dans lequel chacun de Q₂₁ à Q₂₃ et de Q₃₁ à Q₃₃ est indépendamment choisi parmi un groupe alkyle en C₁ à C₂₀ et un groupe aryle en C₆ à C₃₀.

7. Dispositif électroluminescent organique selon l'une quelconque des revendications précédentes, dans lequel
A₂₁ est choisi parmi un groupe benzène, un groupe naphtalène, un groupe phénanthrène, un groupe anthracène, un groupe pyridine, un groupe pyrazine, un groupe pyrimidine, un groupe triazine, un groupe quinoline, un groupe isoquinoline, un groupe quinoxaline, et un groupe quinazoline.

8. Dispositif électroluminescent organique selon l'une quelconque des revendications précédentes, dans lequel
chacun de R₂₁ à R₂₆ est indépendamment choisi dans l'ensemble constitué par :
un groupe représenté par l'une quelconque des formules 9-1 à 9-3, l'hydrogène, un groupe alkyle en C₁ à C₂₀, et un groupe cycloalkyle en C₃ à C₁₀ ;
un groupe aryle en C₆ à C₃₀, un groupe hétéroaryle en C₁ à C₃₀, un groupe polycyclique en C₈ à C₆₀ condensé non aromatique monovalent, et un groupe hétéropolycyclique à 8 à 60 chaînons condensé non aromatique monovalent ;
un groupe aryle en C₆ à C₃₀, un groupe hétéroaryle en C₁ à C₃₀, un groupe polycyclique en C₈ à C₆₀ condensé non aromatique monovalent, et un groupe hétéropolycyclique à 8 à 60 chaînons condensé non aromatique monovalent, chacun substitué par au moins l'un choisi parmi le deutérium, -F, -Cl, -Br, -I, un groupe alkyle en C₁ à C₂₀, un groupe cycloalkyle en C₃ à C₁₀, un groupe aryle en C₆ à C₃₀, un groupe hétéroaryle en C₁ à C₃₀, un groupe polycyclique en C₈ à C₆₀ condensé non aromatique monovalent, un groupe hétéropolycyclique à 8 à 60 chaînons condensé non aromatique monovalent, -N(Q₃₁) (Q₃₂), et -Si (Q₃₁)(Q₃₂) (Q₃₃) ; et
un groupe aryle en C₆ à C₃₀, un groupe hétéroaryle en C₁ à C₃₀, un groupe polycyclique en C₈ à C₆₀ condensé non aromatique monovalent, et un groupe hétéropolycyclique à 8 à 60 chaînons condensé non aromatique monovalent, chacun substitué par au moins un substituant choisi parmi un groupe aryle en C₆ à C₃₀, un groupe hétéroaryle en C₁ à C₃₀, un groupe polycyclique en C₈ à C₆₀ condensé non aromatique monovalent, et un groupe hétéropolycyclique à 8 à 60 chaînons condensé non aromatique monovalent, chaque au moins un substituant étant substitué par au moins l'un choisi parmi le deutérium, -F, -Cl, -Br, -I, un groupe alkyle en C₁ à C₂₀, un groupe cycloalkyle en C₃ à C₁₀, un groupe aryle en C₆ à C₃₀, un groupe hétéroaryle en C₁ à C₃₀, un groupe polycyclique en C₈ à C₆₀ condensé non aromatique monovalent, un groupe hétéropolycyclique à 8 à 60 chaînons condensé non aromatique monovalent, -N(Q₂₁)(Q₂₂), et -Si(Q₂₁)(Q₂₂)(Q₂₃),
dans lequel chacun de Q₂₁ à Q₂₃ et de Q₃₁ à Q₃₃ est indépendamment choisi parmi un groupe alkyle en C₁ à C₂₀ et un groupe aryle en C₆ à C₃₀.

9. Dispositif électroluminescent organique selon l'une quelconque des revendications précédentes, dans lequel
L₉₁ est choisi parmi un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène, chacun substitué par au moins l'un choisi parmi un groupe alkyle en C₁ à C₂₀, un groupe cyclopentyle, un groupe cyclohexyle, et un groupe cycloheptyle.

10. Dispositif électroluminescent organique selon l'une quelconque des revendications précédentes, dans lequel
chacun de L₉₂ et L₉₃ est indépendamment choisi dans l'ensemble constitué par :
un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène ;
un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène, chacun substitué par au moins l'un choisi parmi le deutérium, -F, -Cl, -Br, -I, un groupe cyano, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spirobifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂) ; et
un groupe phénylène, un groupe naphtylène, un groupe phénanthrénylène, un groupe anthracénylène, un groupe triphénylénylène, un groupe pyrénylène, un groupe chrysénylène, un groupe pyridinylène, un groupe pyrazinylène, un groupe pyrimidinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène, chacun substitué par au moins un substituant choisi parmi un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spirobifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, et un groupe dibenzocarbazolyle, chaque au moins un substituant étant substitué par au moins l'un choisi parmi le deutérium, -F, -Cl, -Br, -I, un groupe cyano, un groupe alkyle en C₁ à C₂₀, un groupe alkoxy en C₁ à C₂₀,
dans lequel chacun de Q₃₁ à Q₃₃ est indépendamment choisi parmi l'hydrogène, un groupe méthyle, un groupe éthyle, un groupe n-propyle, un groupe isopropyle, un groupe tert-butyle, un groupe phényle, un groupe biphényle, et un groupe terphényle.

11. Dispositif électroluminescent organique selon l'une quelconque des revendications précédentes, dans lequel
chacun de R₉₁ et R₉₃ est indépendamment choisi dans l'ensemble constitué par :
un groupe aryle en C₆ à C₃₀ et un groupe hétéroaryle en C₁ à C₃₀ ;
un groupe aryle en C₆ à C₃₀ et un groupe hétéroaryle en C₁ à C₃₀, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₃₁) (Q₃₂), et -Si(Q₃₁)(Q₃₂)(Q₃₃) ; et
un groupe aryle en C₆ à C₃₀ et un groupe hétéroaryle en C₁ à C₃₀, chacun substitué par au moins un substituant choisi parmi un groupe aryle en C₆ à C₃₀ et un groupe hétéroaryle en C₁ à C₃₀, chaque au moins un substituant étant substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₃₀, un groupe hétéroaryle en C₁ à C₃₀, -N(Q₂₁)(Q₂₂), et -Si(Q₂₁)(Q₂₂)(Q₂₃),
dans lequel chacun de Q₂₁ à Q₂₃ et de Q₃₁ à Q₃₃ est indépendamment choisi parmi un groupe alkyle en C₁ à C₂₀ et un groupe aryle en C₆ à C₃₀.

12. Dispositif électroluminescent organique selon l'une quelconque des revendications précédentes, dans lequel
R₉₂ est choisi parmi un groupe phényle, un groupe biphényle, un groupe terphényle, un groupe naphtyle, un groupe anthracényle, un groupe triphénylényle, un groupe phénanthrényle, un groupe pyrényle, un groupe tétraphényle, un groupe chrysényle, un groupe pyrrolyle, un groupe furanyle, un groupe thiophényle, un groupe pyridinyle, un groupe pyrazinyle, un groupe pyrimidinyle, un groupe triazinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe phénanthridinyle, un groupe acridinyle, un groupe phénanthrolinyle, un groupe phénazinyle, un groupe benzophénanthrolinyle, un groupe thiazolyle, un groupe oxazolyle, un groupe imidazolyle, un groupe triazolyle, un groupe indolyle, un groupe benzimidazolyle, un groupe benzofuranyle, un groupe benzothiophényle, et un groupe benzoxazolyle, chacun substitué par au moins l'un choisi parmi un groupe alkyle en C₁ à C₂₀, un groupe cyclopentyle, un groupe cyclohexyle, et un groupe cycloheptyle.

13. Dispositif électroluminescent organique selon l'une quelconque des revendications précédentes, dans lequel
le deuxième composé représenté par la formule 2 est représenté par la formule 2-1 : 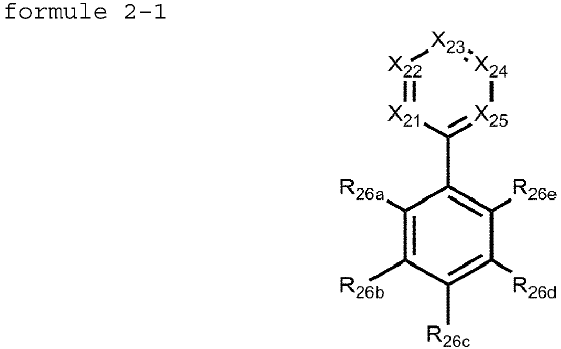 où, dans la formule 2-1,
X₂₁ est choisi parmi N et C(R₂₁), X₂₂ est choisi parmi N et C(R₂₂), X₂₃ est choisi parmi N et C(R₂₃), X₂₄ est choisi parmi N et C(R₂₄), et X₂₅ est choisi parmi N et C(R₂₅), où au moins l'un choisi parmi X₂₁ à X₂₅ est N, et
R₂₁ à R₂₅ sont tels que définis dans la revendication 1 et chacun de R₂₆ₐ à R₂₆ₑ est indépendamment tel que défini à propos de R₂₆ dans la revendication 1, où au moins l'un choisi parmi R₂₁ à R₂₅ et R₂₆ₐ à R₂₆ₑ est choisi parmi un groupe représenté par la formule 9-1 et un groupe représenté par la formule 9-2 telles que définies dans la revendication 1, et comprend un groupe alkyle et/ou un groupe cycloalkyle.

14. Dispositif électroluminescent organique selon l'une quelconque des revendications précédentes, dans lequel
la couche d'émission comprend le premier composé et un dopant, et
le dopant comprend un complexe organométallique représenté par la formule 401 :
formule 401 M(L₄₀₁)_{xc1}(L₄₀₂)_{xc2}
dans laquelle L₄₀₁ est un ligand représenté par la formule 402, 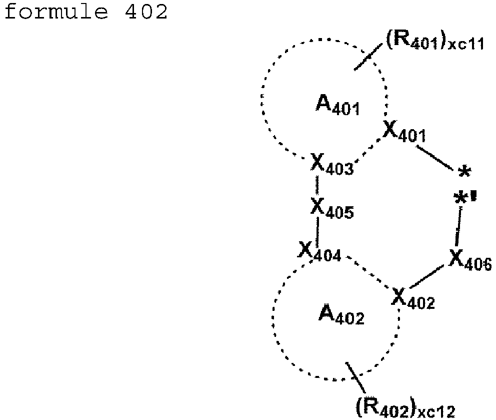
où, dans les formules 401 et 402,
M est choisi parmi l'iridium (Ir), le platine (Pt), le palladium (Pd), l'osmium (Os), le titane (Ti), le zirconium (Zr), le hafnium (Hf), l'europium (Eu), le terbium (Tb), le rhodium (Rh) et le thulium (Tm),
et xcl vaut 1, 2 ou 3, où quand xcl vaut deux ou plus, deux ou plus de deux L₄₀₁ sont identiques ou différents,
L₄₀₂ est un ligand organique, et xc2 est un entier choisi parmi 0 à 4, où quand xc2 vaut deux ou plus, deux ou plus de deux L₄₀₂ sont identiques ou différents,
chacun de X₄₀₁ à X₄₀₄ est indépendamment l'azote ou le carbone,
X₄₀₁ et X₄₀₃ sont connectés l'un à l'autre via une liaison simple ou une double liaison, et X₄₀₂ et X₄₀₄ sont connectés l'un à l'autre via une liaison simple ou une double liaison,
chacun de A₄₀₁ et A₄₀₂ est indépendamment un groupe carbocyclique en C₅ à C₆₀ ou un groupe hétérocyclique en C₁ à C₆₀,
X₄₀₅ est choisi parmi une liaison simple, -O-, -S-, -C(=O)-, -N(Q₄₁₁)-, -C(Q₄₁₁) (Q₄₁₂)-, -C(Q₄₁₁)=C(Q₄₁₂)-, -C(Q₄₁₁)=, et =C(Q₄₁₁)=, où chacun de Q₄₁₁ et Q₄₀₂ est indépendamment choisi parmi l'hydrogène, le deutérium, un groupe alkyle en C₁ à C₂₀, un groupe alkoxy en C₁ à C₂₀, un groupe phényle, un groupe biphényle, un groupe terphényle, et un groupe naphtyle,
X₄₀₆ est choisi parmi une liaison simple, O, et S,
chacun de R₄₀₁ et R₄₀₂ est indépendamment choisi parmi l'hydrogène, le deutérium, -F, -Cl, -Br, -I, -CD₃, -CF₃, un groupe hydroxyle, un groupe cyano, un groupe nitro, un groupe amidino, un groupe hydrazino, un groupe hydrazono, un groupe alkyle en C₁ à C₂₀ substitué ou non substitué, un groupe alkoxy en C₁ à C₂₀ substitué ou non substitué, un groupe cycloalkyle en C₃ à C₁₀ substitué ou non substitué, un groupe hétérocycloalkyle en C₁ à C₂₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un group aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, un groupe hétéropolycyclique à 8 à 60 chaînons condensé non aromatique monovalent substitué ou non substitué, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), et -P(=O)(Q₄₀₁)(Q₄₀₂), où chacun de Q₄₀₁ à Q₄₀₃ est indépendamment choisi parmi un groupe alkyle en C₁ à C₁₀, un groupe alkoxy en C₁ à C₁₀, un groupe aryle en C₆ à C₂₀, et un groupe hétéroaryle en C₁ à C₂₀,
chacun de xc11 et xc12 est indépendamment un entier choisi parmi 0 à 10, et
chacun de * et *' dans la formule 402 indique un site de liaison M dans la formule 401.

15. Dispositif électroluminescent organique selon l'une quelconque des revendications précédentes, dans lequel :
(a) la couche organique comprend une région de transport d'électrons entre la couche d'émission et la deuxième électrode, la région de transport d'électrons comprend une couche de transport d'électrons et une couche d'injection d'électrons, et la couche de transport d'électrons comprend au moins l'un choisi parmi un complexe de métal alcalin et un complexe de métal alcalino-terreux ; et/ou
(b) la couche organique comprend une région de transport d'électrons entre la couche d'émission et la deuxième électrode, la région de transport d'électrons comprend une couche de transport d'électrons et une couche d'injection d'électrons, et la couche d'injection d'électrons comprend un métal alcalin, un métal alcalino-terreux, un métal des terres rares, un composé de métal alcalin, un composé de métal alcalino-terreux, un composé de métal des terres rares, un complexe de métal alcalin, un complexe de métal alcalino-terreux, un complexe de métal des terres rares, ou une de leurs combinaisons ; et/ou
(c) la couche d'émission est une couche d'émission de lumière d'une première couleur, la couche organique comprend en outre i) au moins une couche d'émission de lumière d'une deuxième couleur, la lumière d'une première couleur et la lumière d'une deuxième couleur étant identiques ou différentes, ou ii) au moins une couche d'émission de lumière d'une deuxième couleur et au moins une couche d'émission de lumière d'une troisième couleur, la lumière d'une première couleur, la lumière d'une deuxième couleur et la lumière d'une troisième couleur étant identiques ou différentes, et quand le dispositif électroluminescent organique fonctionne, une lumière mixte comprenant la lumière d'une première couleur et la lumière d'une deuxième couleur est émise, ou une lumière mixte comprenant la lumière d'une première couleur, la lumière d'une deuxième couleur et la lumière d'une troisième couleur est émise ; et/ou
(d) la couche d'émission comprend un premier hôte et un deuxième hôte, le premier hôte comprend le premier composé, et le premier hôte et le deuxième hôte sont différents.
